# EUROPEAN PATENT SPECIFICATION

(11) **EP 4 406 958 B1**
(45) Date of publication and mention of the grant of the patent: **08.10.2025**
(21) Application number: 24154472.5
(22) Date of filing: 29.01.2024
(51) Int. Cl.: C07F 5/02, C09K 11/06, H10K 50/11, H10K 85/30, H10K 85/60

(54) **LIGHT EMITTING ELEMENT AND FUSED POLYCYCLIC COMPOUND FOR LIGHT EMITTING ELEMENT**
LICHTEMITTIERENDES ELEMENT UND KONDENSIERTE POLYCYCLISCHE VERBINDUNG FÜR LICHTEMITTIERENDES ELEMENT
ÉLÉMENT ÉLECTROLUMINESCENT ET COMPOSÉ POLYCYCLIQUE FUSIONNÉ POUR ÉLÉMENT ÉLECTROLUMINESCENT

(30) Priority: 30.01.2023 KR 20230011632
(43) Date of publication of application: 31.07.2024
(73) Proprietor: Samsung Display Co., Ltd., Yongin-si, Gyeonggi-do (KR)
(72) Inventor: HOSHI, Keigo, Yokohama (JP); KUWABARA, Hirokazu, Yokohama (JP); SUZAKI, Yuji, Yokohama (JP)
(74) Representative: Marks & Clerk LLP

(56) References cited:
- WO-A1-2022/257817
- JP-A- 2022 115 606

## Description

### BACKGROUND

### 1. Field

One or more embodiments of the present disclosure relate to a light emitting element and a fused polycyclic compound utilized therein.

### 2. Description of Related Art

As image display devices, organic electroluminescence display devices and/or the like have been actively developed currently. Unlike liquid crystal display devices, and/or the like, the organic electroluminescence display devices are self-luminescent display devices in which holes and electrons respectively (e.g., separately) injected from a first electrode and a second electrode recombine in an emission layer of the organic electroluminescence display devices, and thus a light emitting material including an organic compound in the emission layer emits light to accomplish display (e.g., of an image).

For application of organic electroluminescence elements to display devices, it is desirable that organic electroluminescence elements have relatively low driving voltage, high light emitting efficiency, and long life (e.g., long lifespan), and thus the development of materials, for organic electroluminescence elements, capable of stably attaining such characteristics is being continuously required and/or pursued.

In recent years, in order to obtain a highly efficient organic electroluminescence element, technologies pertaining to phosphorescence emission utilizing triplet state energy or fluorescence emission utilizing triplet-triplet annihilation (TTA) in which singlet excitons are generated through collision of triplet excitons are being particularly developed, and thus thermally activated delayed fluorescence (TADF) materials utilizing a delayed fluorescence phenomenon are under development.Compounds used for OLEDs are disclosed in JP 2022 115606 A.

### SUMMARY

One or more aspects of embodiments of the present disclosure are directed toward a light emitting element having increased light emitting efficiency and longer element service life (lifespan).

One or more aspects of embodiments of the present disclosure are directed toward a fused polycyclic compound capable of improving light emitting efficiency and element service life.

Additional aspects will be set forth in part in the description which follows and, in part, will be apparent from the description, or may be learned by practice of the presented embodiments.

According to one or more embodiment of the present disclosure, a light emitting element includes a first electrode, a second electrode on the first electrode, and at least one functional layer between the first electrode and the second electrode and including a fused polycyclic compound represented by Formula 1.

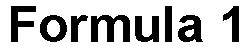

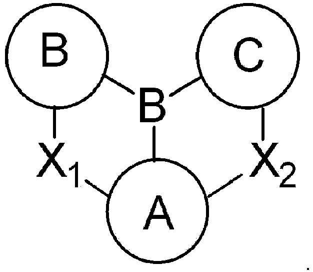

In Formula 1, X₁ and X₂ are each independently O, S, or NR₁, a case (e.g., embodiments) in which X₁ and X₂ are both (e.g., each or simultaneously) O is excluded, R₁ is a substituted or unsubstituted aryl group having 6 to 30 ring-forming carbon atoms or a substituted or unsubstituted heteroaryl group having 2 to 30 ring-forming carbon atoms, and/or bonded to an adjacent group to form a ring, when X₁ and X₂ are both (e.g., each or simultaneously) NR₁, a case (e.g., embodiments) in which R₁ is represented by Formula a is excluded, A to C rings are each independently a substituted or unsubstituted monocyclic aromatic hydrocarbon ring having 6 to 30 ring-forming carbon atoms or a substituted or unsubstituted monocyclic aromatic heterocycle having 2 to 30 ring-forming carbon atoms, and/or a substituent substituted on each or any one of A to C rings is bonded to an adjacent group to form a ring, a case (e.g., embodiments) in which a 5-membered heterocycle is fused to each or any one of A to C rings is excluded, and Formula 1 includes at least one substituent represented by Formula 2.

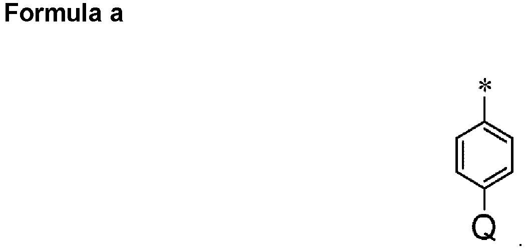

In Formula a, Q is a substituted or unsubstituted alkyl group.

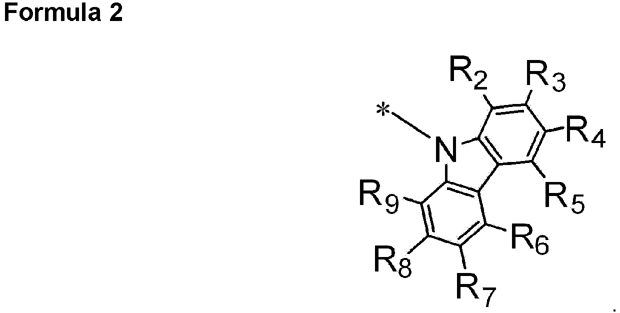

In Formula 2, R₂ to R₉ are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, at least one selected from among R₂ to R₉ is a cyano group, and -* is a site linked to Formula 1.

In one or more embodiments, the at least one functional layer may include an emission layer, a hole transport region between the first electrode and the emission layer, and an electron transport region between the emission layer and the second electrode, and the emission layer may include the fused polycyclic compound.

In one or more embodiments, the emission layer may be to emit delayed fluorescence.

In one or more embodiments, the emission layer may be to emit light having a central emission wavelength of about 430 nm to about 490 nm.

In one or more embodiments, the fused polycyclic compound represented by Formula 1 may be represented by any one selected from among Formulas 1-1-1 to 1-1-3.

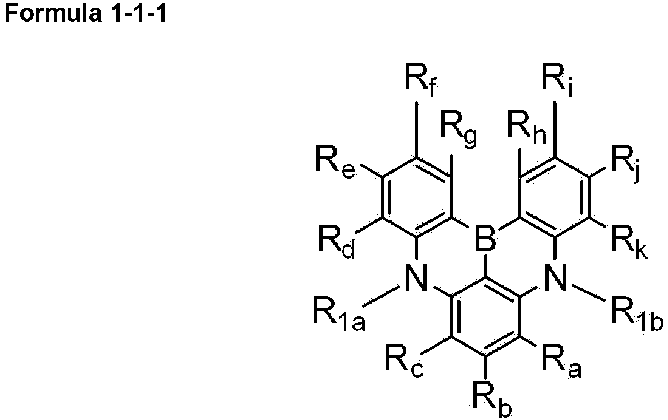

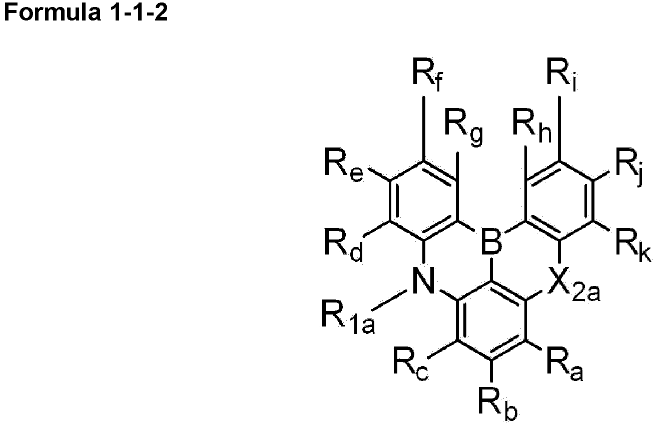

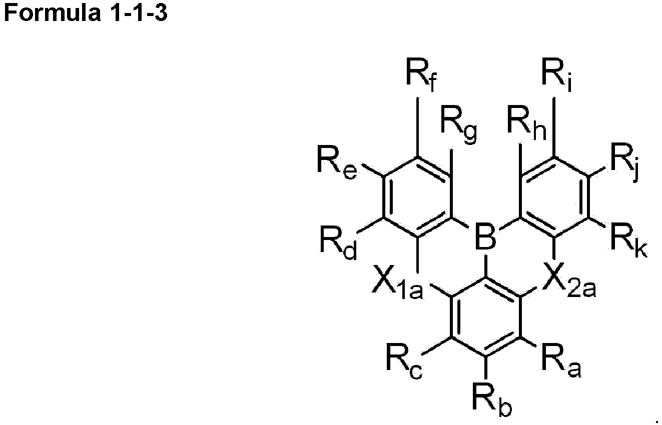

In Formulas 1-1-1 to 1-1-3, X₁ₐ and X₂ₐ are each independently O or S, R₁ₐ and R_{1b} are each independently a substituted or unsubstituted aryl group having 6 to 30 ring-forming carbon atoms or a substituted or unsubstituted heteroaryl group having 2 to 30 ring-forming carbon atoms, and/or bonded to an adjacent group to form an aromatic ring, Rₐ to Rₖ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2, and/or bonded to an adjacent group to form a ring, at least one selected from among Rₐ to Rₖ is a substituent represented by Formula 2, each of Rₐ to Rₖ, R₁ₐ, and R_{1b} is not bonded to an adjacent group to form a 5-membered heterocycle, in Formula 1-1-1, a case (e.g., embodiments) in which R₁ₐ and R_{1b} are each represented by Formula a is excluded, and in Formula 1-1-3, a case (e.g., embodiments) in which X₁ₐ and X₂ₐ are both (e.g., each or simultaneously) O is excluded.

In one or more embodiments, R₁ₐ and R_{1b} may each independently be represented by any one selected from among Formulas A-1 to A-4.

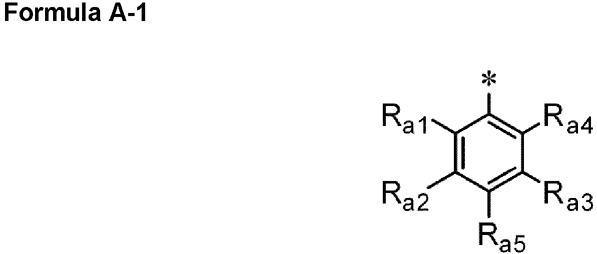

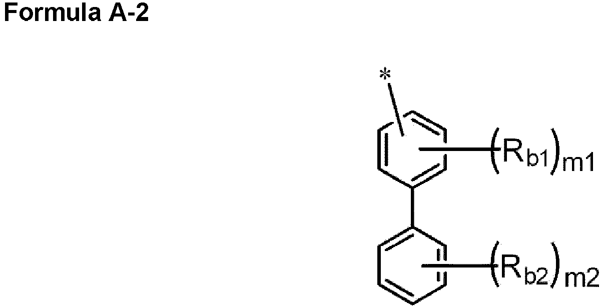

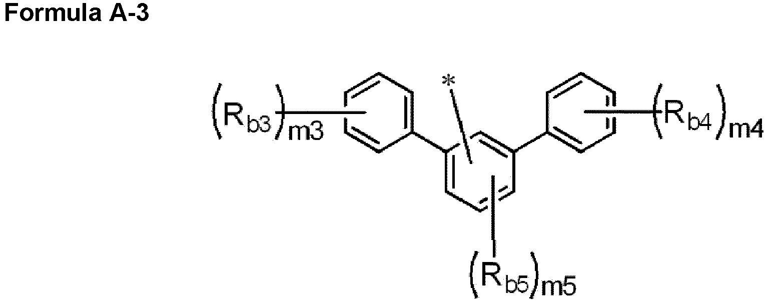

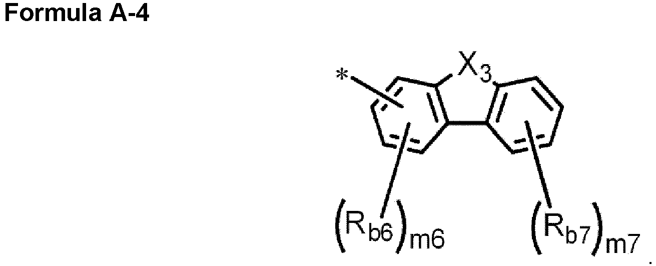

In Formulas A-1 to A-4, X₃ is NR_{b8}, O, or S, Rₐ₁ to Rₐ₄, and R_{b1} to R_{b7} are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or bonded to an adjacent group to form a ring, Rₐ₅ is hydrogen, deuterium, a halogen, a cyano group, a nitro group, a substituted or unsubstituted amine group, a substituted or unsubstituted aryl group having 6 to 30 ring-forming carbon atoms, or a substituted or unsubstituted heteroaryl group having 2 to 30 ring-forming carbon atoms, R_{b8} is a substituted or unsubstituted aryl group having 6 to 30 ring-forming carbon atoms or a substituted or unsubstituted heteroaryl group having 2 to 30 ring-forming carbon atoms, m1 and m7 are each independently an integer of 0 to 4, m2 to m4 are each independently an integer of 0 to 5, m5 and m6 are each independently an integer of 0 to 3, and -* is a site linked to Formula 1.

In one or more embodiments, a substituent represented by Formula 2 may be represented by Formula B-1 or Formula B-2.

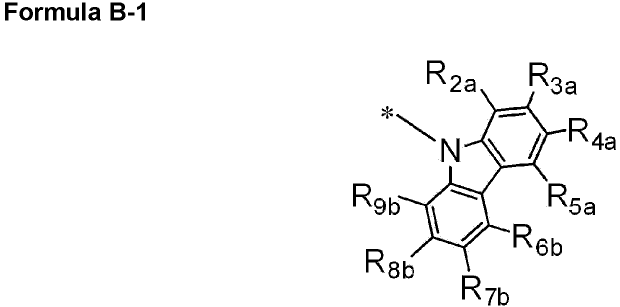

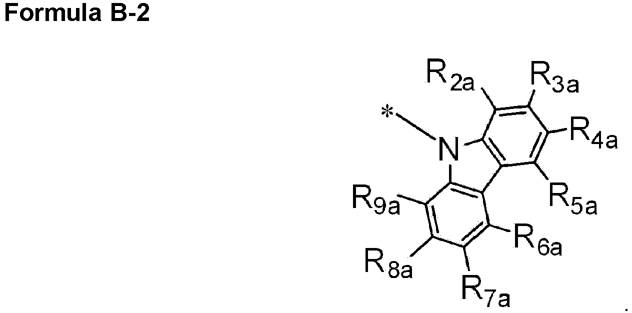

In Formulas B-1 and B-2, R₂ₐ to R₉ₐ are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, R_{6b} to R_{9b} are each independently hydrogen, deuterium, a halogen, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, in Formula B-1, at least one selected from among R₂ₐ to R₅ₐ is a cyano group, in Formula B-2, at least one selected from among R₂ₐ to R₅ₐ and at least one selected from among R₆ₐ to R₉ₐ are each a cyano group, and -* is a site linked to Formula 1.

In one or more embodiments, a substituent represented by Formula 2 may be represented by any one selected from among Formulas C-1 to C-9.

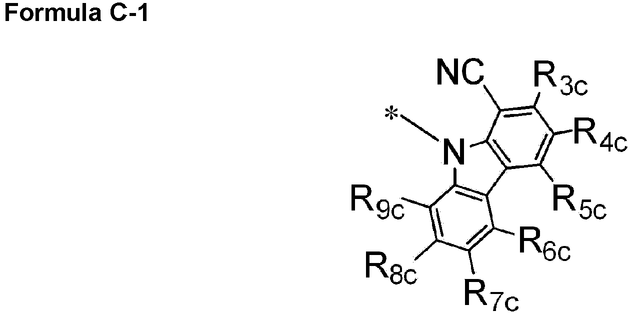

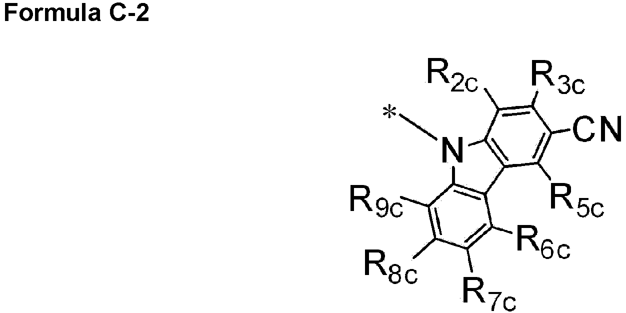

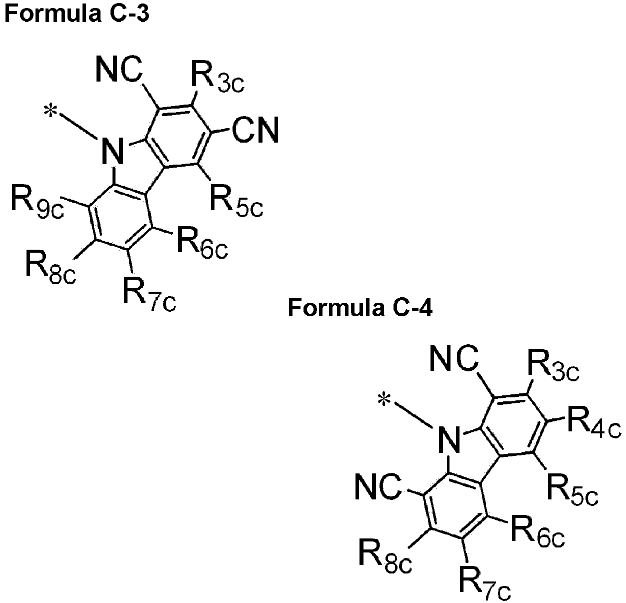

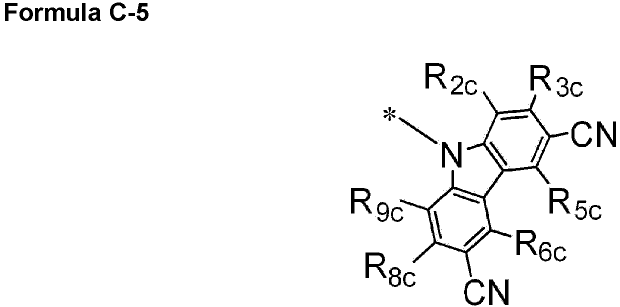

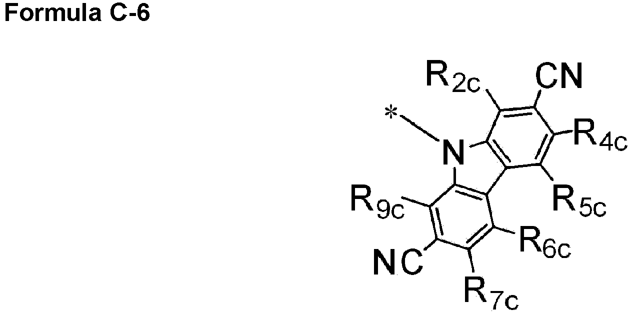

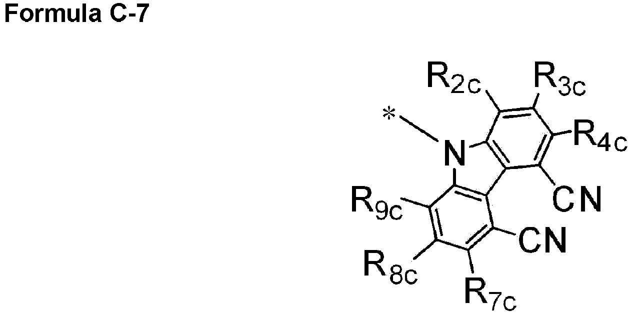

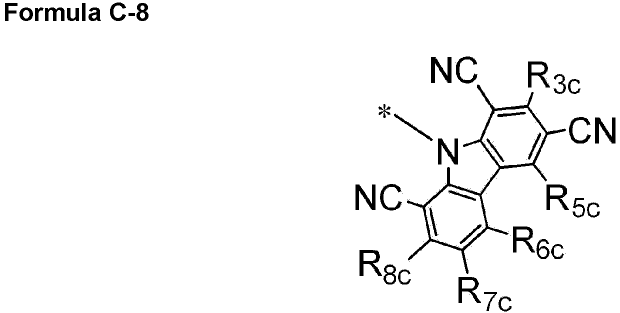

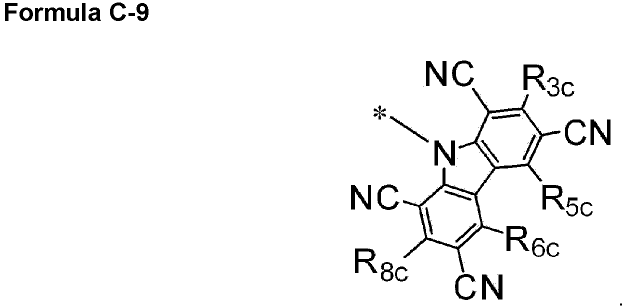

In Formulas C-1 to C-9, R_{2c} to R_{9c} are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and -* is a site linked to Formula 1.

In one or more embodiments, the fused polycyclic compound represented by Formula 1 may be represented by any one selected from among Formulas 1-2-1 to 1-2-8.

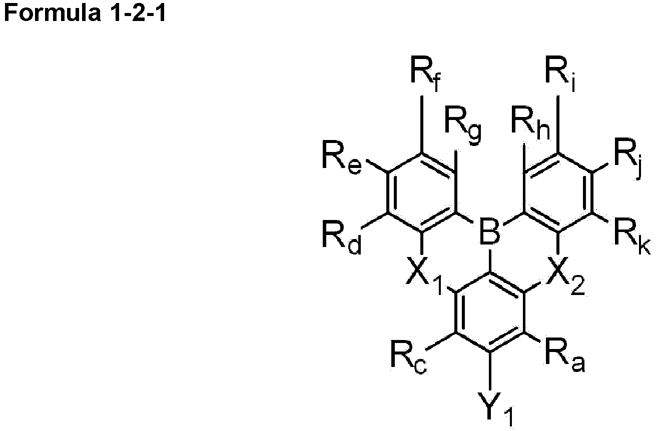

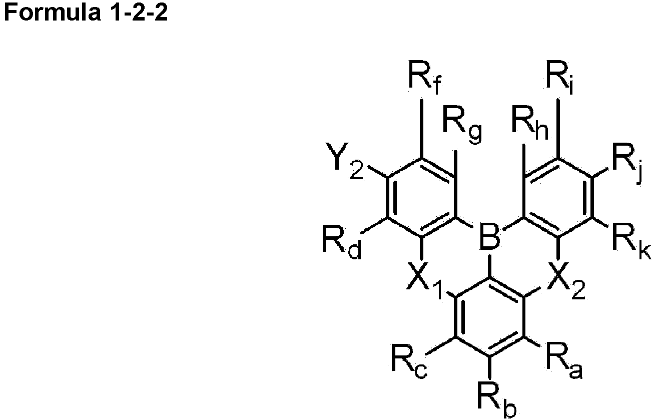

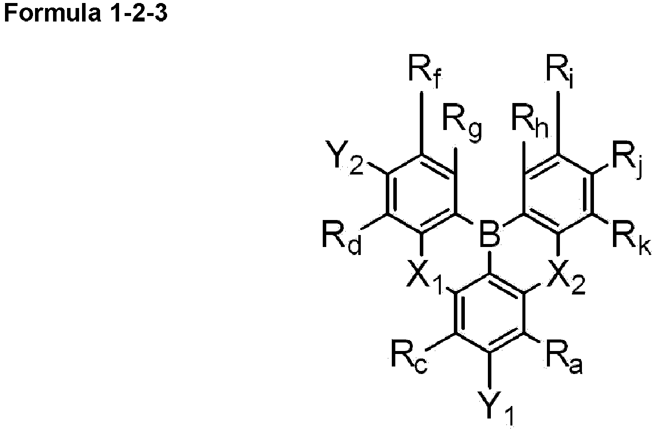

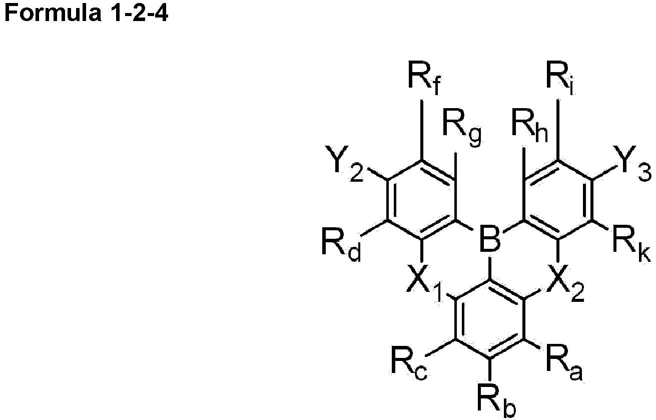

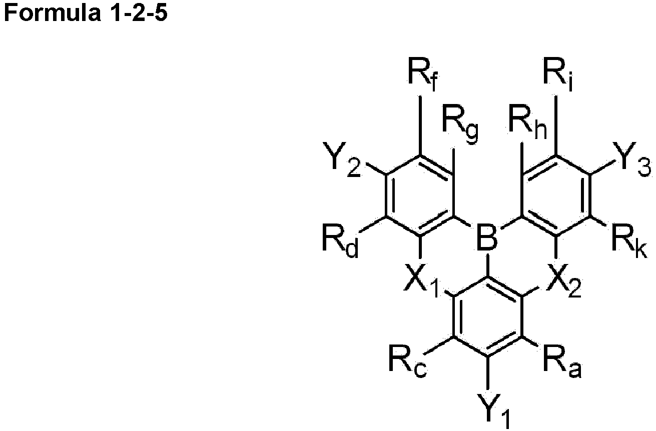

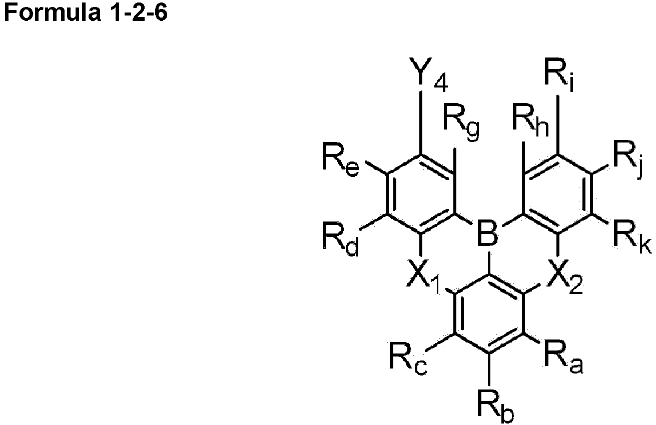

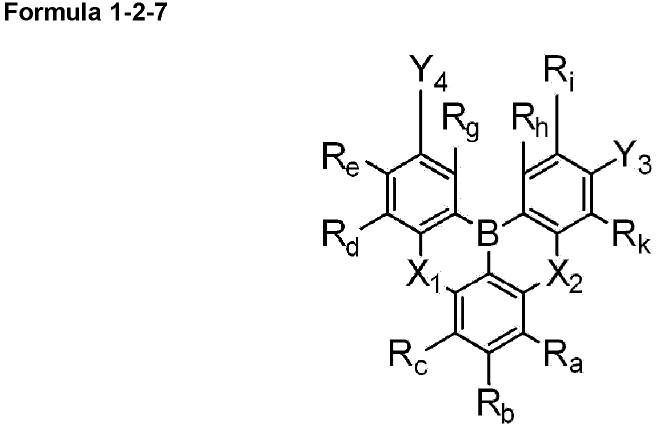

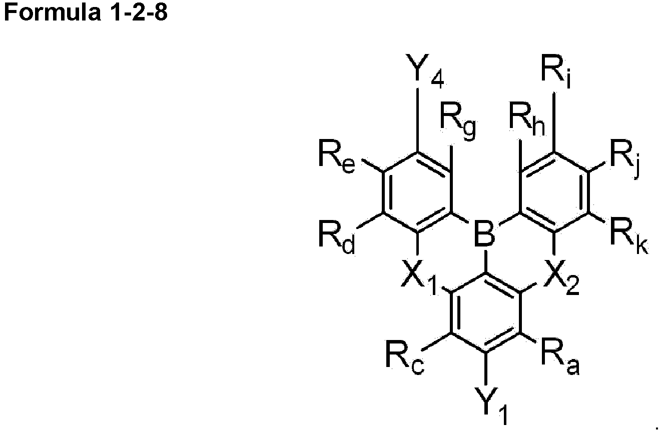

In Formulas 1-2-1 to 1-2-8 above, Rₐ to Rₖ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2, and/or bonded to an adjacent group to form a ring, each of Rₐ to Rₖ is not bonded to an adjacent group to form a 5-membered heterocycle, and Y₁ to Y₄ are represented by Formula 2.

In Formulas 1-2-1 to 1-2-8 above, X₁ and X₂ are each independently the same as defined in Formula 1.

In one or more embodiments, the fused polycyclic compound represented by Formula 1 may be represented by any one selected from among Formulas 1-3-1 to 1-3-3.

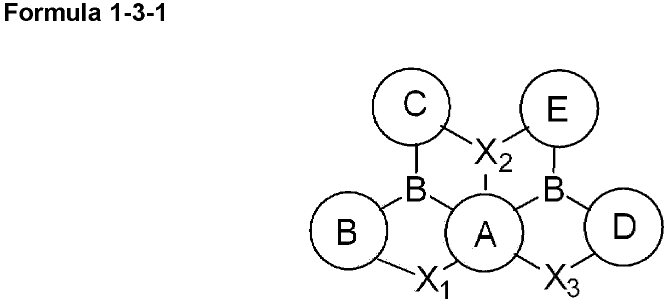

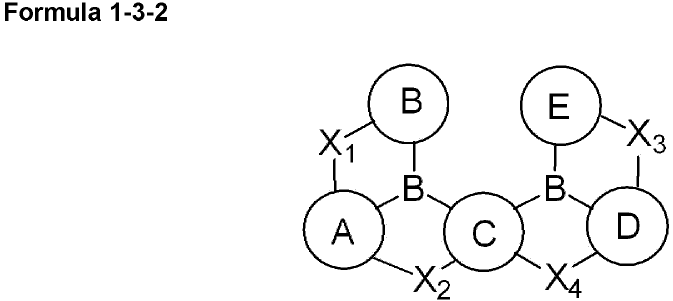

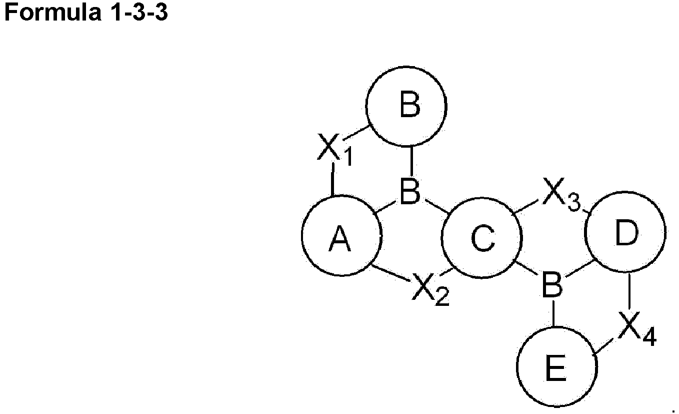

In Formulas 1-3-1 to 1-3-3, X₃ and X₄ are each independently O, S, or NR₁₀, R₁₀ is a substituted or unsubstituted aryl group having 6 to 30 ring-forming carbon atoms or a substituted or unsubstituted heteroaryl group having 2 to 30 ring-forming carbon atoms, and/or bonded to an adjacent group to form a ring, D and E rings are each independently a substituted or unsubstituted monocyclic aromatic hydrocarbon ring having 6 to 30 ring-forming carbon atoms or a substituted or unsubstituted monocyclic aromatic heterocycle having 2 to 30 ring-forming carbon atoms, and/or a substituent substituted on each or any one of D and E rings is bonded to an adjacent group to form a ring, and each of Formulas 1-3-1 to 1-3-3 includes at least one substituent represented by Formula 2.

In Formulas 1-3-1 to 1-3-3, X₁, X₂, and A to C rings are each independently the same as defined in Formula 1.

In one or more embodiments, the fused polycyclic compound represented by Formula 1 may be represented by any one selected from among Formulas 1-4-1 to 1-4-3.

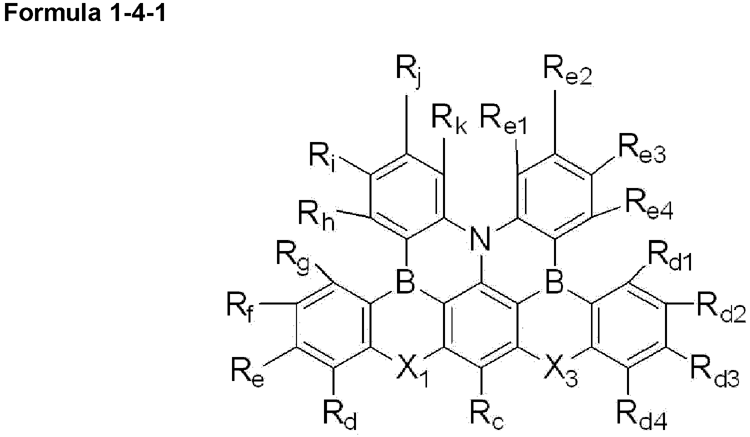

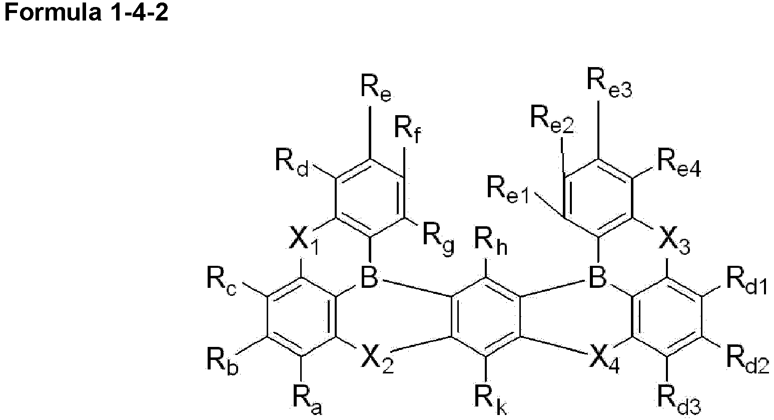

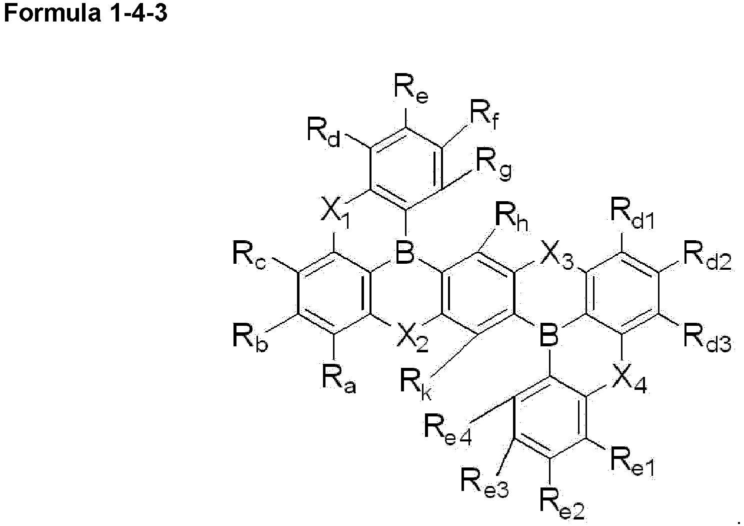

In Formulas 1-4-1 to 1-4-3, X₃ and X₄ are each independently O, S, or NR₁₀, R₁₀ is a substituted or unsubstituted aryl group having 6 to 30 ring-forming carbon atoms or a substituted or unsubstituted heteroaryl group having 2 to 30 ring-forming carbon atoms, and/or bonded to an adjacent group to form a ring, Rₐ to Rₖ, R_{d1} to R_{d4}, and Rₑ₁ to Rₑ₄ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2, and/or bonded to an adjacent group to form a ring, in Formula 1-4-1, at least one selected from among R_{c} to Rₖ, R_{d1} to R_{d4}, and Rₑ₁ to Rₑ₄ is represented by Formula 2, in Formula 1-4-2, at least one selected from among Rₐ to Rₕ, Rₖ, R_{d1} to R_{d3}, and Rₑ₁ to Rₑ₄ is represented by Formula 2, and in Formula 1-4-3, at least one selected from among Rₐ to Rₕ, Rₖ, R_{d1} to R_{d3}, and Rₑ₁ to Rₑ₄ is represented by Formula 2.

In Formulas 1-4-1 to 1-4-3, X₁ and X₂ are each independently the same as defined in Formula 1 above.

In one or more embodiments, the fused polycyclic compound represented by Formula 1 may be represented by any one selected from among Formulas 1-5-1 to 1-5-6.

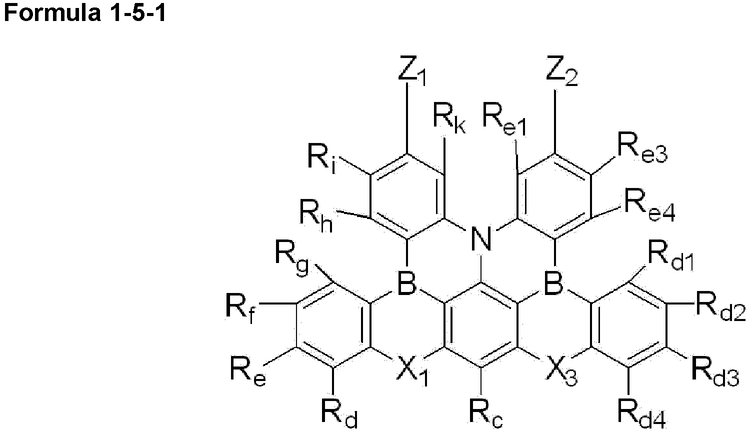

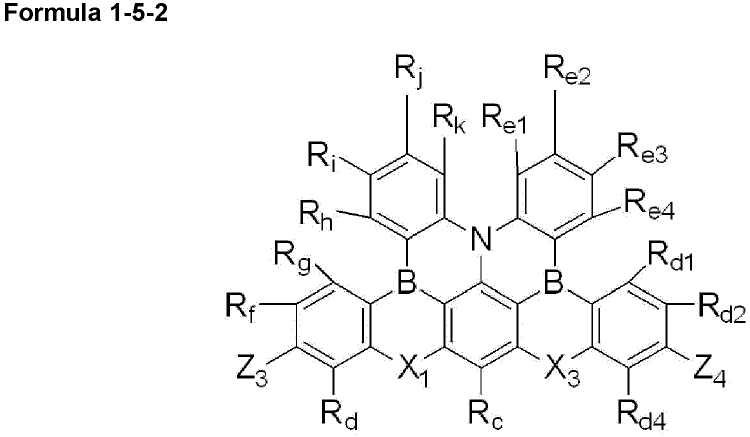

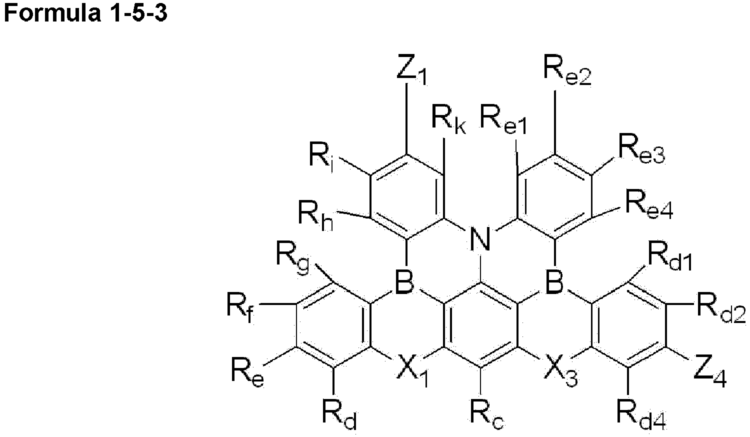

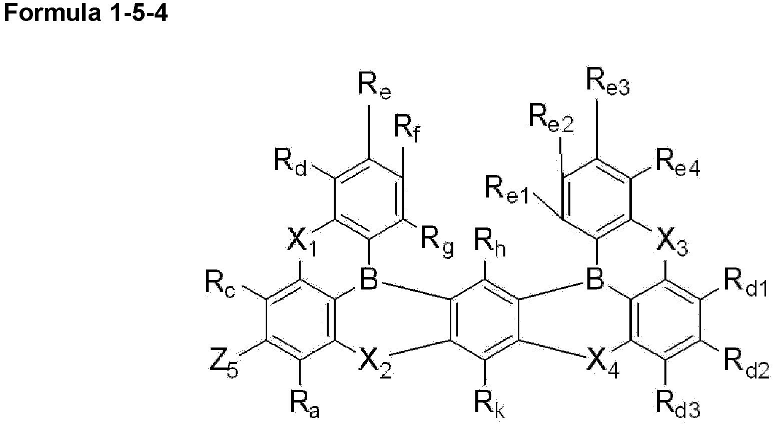

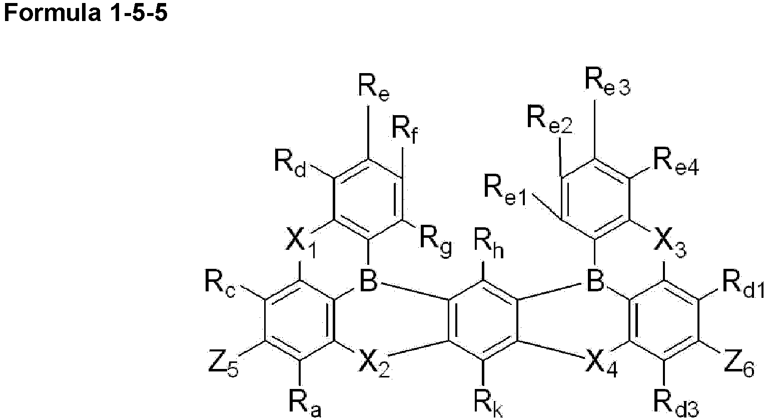

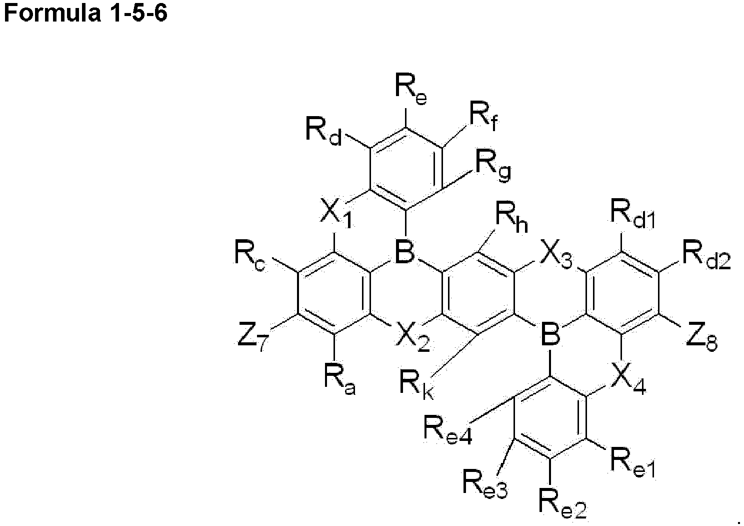

In Formulas 1-5-1 to 1-5-6, X₃ and X₄ are each independently O, S, or NR₁₀, R₁₀ is a substituted or unsubstituted aryl group having 6 to 30 ring-forming carbon atoms or a substituted or unsubstituted heteroaryl group having 2 to 30 ring-forming carbon atoms, and/or bonded to an adjacent group to form a ring, Rₐ, R_{c} to Rₖ, R_{d1} to R_{d4}, and Rₑ₁ to Rₑ₄ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2, and/or bonded to an adjacent group to form a ring, and Z₁ to Z₈ are each represented by Formula 2.

In Formulas 1-5-1 to 1-5-6, X₁ and X₂ are each independently the same as defined in Formula 1.

In one or more embodiment of the present disclosure, a fused polycyclic compound is represented by Formula 1.

At least some of the above and other features of the invention are set out in the claims.

### BRIEF DESCRIPTION OF THE DRAWINGS

The accompanying drawings are included to provide a further understanding of the present disclosure, and are incorporated in and constitute a part of this specification. The drawings illustrate example embodiments of the present disclosure and, together with the description, serve to explain principles of the present disclosure. Above and/or other aspects of the present disclosure should become apparent and appreciated from the following description of embodiments taken in conjunction with the accompanying drawings. In the drawings:
FIG. 1 is a plan view of a display device according to one or more embodiments of the present disclosure;
FIG. 2 is a cross-sectional view of a display device according to one or more embodiments of the present disclosure;
FIG. 3 is a cross-sectional view schematically showing a light emitting element according to one or more embodiments of the present disclosure;
FIG. 4 is a cross-sectional view schematically showing a light emitting element according to one or more embodiments of the present disclosure;
FIG. 5 is a cross-sectional view schematically showing a light emitting element according to one or more embodiments of the present disclosure;
FIG. 6 is a cross-sectional view schematically showing a light emitting element according to one or more embodiments of the present disclosure;
FIG. 7 and FIG. 8 are each a cross-sectional view of a display device according to one or more embodiments of the present disclosure;
FIG. 9 is a cross-sectional view showing a display device according to one or more embodiments of the present disclosure;
FIG. 10 is a cross-sectional view showing a display device according to one or more embodiments of the present disclosure; and
FIG. 11 is a view showing a vehicle in which a display device according to one or more embodiments is disposed.

### DETAILED DESCRIPTION

The present disclosure may be modified in one or more suitable manners and have many forms, and thus specific embodiments will be exemplified in the drawings and described in more detail in the detailed description of the present disclosure. It should be understood, however, that it is not intended to limit the present disclosure to the particular forms disclosed, but rather, is intended to cover all modifications, equivalents, and alternatives falling within the scope of the present disclosure.

When explaining each of the drawings, like reference numbers are utilized for referring to like elements. In the accompanying drawings, the dimensions of each structure may be exaggeratingly illustrated for clarity of the present disclosure. It will be understood that, although the terms "first," "second," etc., may be utilized herein to describe one or more suitable components, these components should not be limited by these terms. These terms are only utilized to distinguish one component from another. For example, a first component could be termed a second component, and, similarly, a second component could be termed a first component, without departing from the scope of example embodiments of the present disclosure. As utilized herein, the singular forms, "a," "an," "one," and "the" are intended to include the plural forms as well, unless the context clearly indicates otherwise. Further, the utilization of "may" when describing embodiments of the present disclosure refers to "one or more embodiments of the present disclosure".

In the present disclosure, it will be understood that the terms "comprise(s)," "include(s)," "have/has" and/or the like specify the presence of features, numbers, steps, operations, component, parts, or combinations thereof disclosed in the disclosure, but do not exclude the possibility of presence or addition of one or more other features, numbers, steps, operations, component, parts, or combinations thereof. As utilized herein, the terms "and", "or", and "and/or" may include any and all combinations of one or more of the associated listed items. Expressions such as "at least one of," "one of," and "selected from," when preceding a list of elements, modify the entire list of elements and do not modify the individual elements of the list. For example, "at least one of a, b, or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof. The "/" utilized herein may be interpreted as "and" or as "or" depending on the situation.

In the present disclosure, when a layer, a film, a region, or a plate is referred to as being "on" or "in an upper portion of" another layer, film, region, or plate, it may be not only "directly on" the layer, film, region, or plate, but intervening layers, films, regions, or plates may also be present. Opposite this, when a layer, a film, a region, or a plate is referred to as being "below", "in a lower portion of" another layer, film, region, or plate, it can be not only directly under the layer, film, region, or plate, but intervening layers, films, regions, or plates may also be present. In some embodiments, it will be understood that when a part is referred to as being "on" another part, it can be disposed above the other part, or disposed under the other part as well. In some embodiments, "directly on" may refer to that there are no additional layers, films, regions, plates, etc., between a layer, a film, a region, a plate, etc. and the other part. For example, "directly on" may refer to two layers or two members are disposed without utilizing an additional member such as an adhesive member therebetween.

In the present disclosure, the term "substituted or unsubstituted" may refer to substituted or unsubstituted with at least one substituent selected from the group consisting of deuterium, a halogen, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. In some embodiments, each of the substituents exemplified above may be substituted or unsubstituted. For example, a biphenyl group may be interpreted as an aryl group or a phenyl group substituted with a phenyl group.

In the present disclosure, the phrase "bonded to an adjacent group to form a ring" may refer to that a group is bonded to an adjacent group to form a substituted or unsubstituted hydrocarbon ring or a substituted or unsubstituted heterocycle. The hydrocarbon ring may include an aliphatic hydrocarbon ring and/or an aromatic hydrocarbon ring. The heterocycle may include an aliphatic heterocycle and/or an aromatic heterocycle. The hydrocarbon ring and the heterocycle may be monocyclic or polycyclic. In some embodiments, the rings formed by two adjacent groups being bonded to each other may be connected to another ring to form a spiro structure.

In the present disclosure, the term "adjacent group" may refer to a substituent substituted for an atom which is directly linked to an atom substituted with a corresponding substituent, another substituent substituted for an atom which is substituted with a corresponding substituent, or a substituent sterically positioned at the nearest position to a corresponding substituent. For example, two methyl groups in 1,2-dimethylbenzene may be interpreted as "adjacent groups" to each other, and two ethyl groups in 1,1-diethylcyclopentane may be interpreted as "adjacent groups" to each other. In some embodiments, two methyl groups in 4,5-dimethylphenanthrene may be interpreted as "adjacent groups" to each other.

In the present disclosure, non-limiting examples of the halogen may include fluorine, chlorine, bromine, or iodine.

In the present disclosure, an alkyl group may be linear or branched. The number of carbons in the alkyl group is 1 to 50, 1 to 30, 1 to 20, 1 to 10, or 1 to 6. Examples of the alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-heneicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, etc., but embodiments of the present disclosure are not limited thereto.

In the present disclosure, a cycloalkyl group may refer to a cyclic alkyl group. The number of carbons in the cycloalkyl group may be 3 to 50, 3 to 30, 3 to 20, or 3 to 10. Examples of the cycloalkyl group may include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, etc., but embodiments of the present disclosure are not limited thereto.

In the present disclosure, an alkenyl group may refer to a hydrocarbon group including at least one carbon-carbon double bond in the middle or terminal of an alkyl group having 2 or more carbon atoms. The alkenyl group may be linear or branched. The number of carbon atoms in the alkenyl group is not specifically limited, for example, may be 2 to 30, 2 to 20, or 2 to 10. Examples of the alkenyl group may include a vinyl group, a 1-butenyl group, a 1-pentenyl group, a 1,3-butadienyl aryl group, a styrenyl group, a styryl vinyl group, etc., but embodiments of the present disclosure are not limited thereto.

In the present disclosure, an alkynyl group may refer to a hydrocarbon group including at least one carbon-carbon triple bond in the middle or terminal of an alkyl group having 2 or more carbon atoms. The alkynyl group may be linear or branched. Although the number of carbon atoms is not specifically limited, it may be 2 to 30, 2 to 20, or 2 to 10. Examples of the alkynyl group may include an ethynyl group, a propynyl group, etc., but embodiments of the present disclosure are not limited thereto.

In the present disclosure, a hydrocarbon ring group may refer to any functional group or substituent derived from an aliphatic hydrocarbon ring. The hydrocarbon ring group may be a saturated hydrocarbon ring group having 5 to 20 ring-forming carbon atoms.

In the present disclosure, an aryl group may refer to any functional group or substituent derived from an aromatic hydrocarbon ring. The aryl group may be a monocyclic aryl group or a polycyclic aryl group. The number of ring-forming carbon atoms in the aryl group may be 6 to 36, 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, etc., but embodiments of the present disclosure are not limited thereto.

In the present disclosure, a fluorenyl group may be substituted, and two substituents may be bonded to each other to form a spiro structure. Examples of the substituted fluorenyl group are as follows. However, embodiments of the present disclosure are not limited thereto.

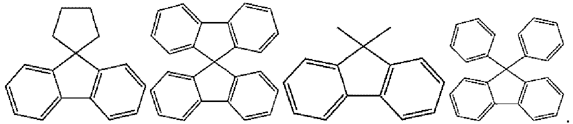

A heterocyclic group utilized herein may refer to any functional group or substituent derived from a ring containing at least one of B, O, **N,** P, Si, or Se as a heteroatom. The heterocyclic group may include an aliphatic heterocyclic group and/or an aromatic heterocyclic group. The aromatic heterocyclic group may be a heteroaryl group. The aliphatic heterocycle and the aromatic heterocycle may be monocyclic or polycyclic.

In the present disclosure, a heterocyclic group may contain at least one of B, O, **N,** P, Si or S as a heteroatom. When the heterocyclic group contains two or more heteroatoms, the two or more heteroatoms may be the same as or different from each other. The heterocyclic group may be a monocyclic heterocyclic group or a polycyclic heterocyclic group, and may include a heteroaryl group. The number of ring-forming carbon atoms in the heterocyclic group may be 2 to 30, 2 to 20, or 2 to 10.

In the present disclosure, an aliphatic heterocyclic group may include at least one of B, O, **N,** P, Si, or S as a heteroatom. The number of ring-forming carbon atoms in the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, etc., but embodiments of the present disclosure are not limited thereto.

In the present disclosure, a heteroaryl group may contain at least one of B, O, **N,** P, Si, or S as a heteroatom. When the heteroaryl group contains two or more heteroatoms, the two or more heteroatoms may be the same as or different from each other. The heteroaryl group may be a monocyclic heterocyclic group or a polycyclic heterocyclic group. The number of ring-forming carbon atoms in the heteroaryl group may be 2 to 30, 2 to 20, or 2 to 10. Examples of the heteroaryl group may include a thiophene group, a furan group, a pyrrole group, an imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, etc., but embodiments of the present disclosure are not limited thereto.

In the present disclosure, the above description of the aryl group may be applied to an arylene group except that the arylene group is a divalent group. The above description of the heteroaryl group may be applied to a heteroarylene group except that the heteroarylene group is a divalent group.

In the present disclosure, a silyl group may include an alkylsilyl group and/or an arylsilyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, etc., but embodiments of the present disclosure are not limited thereto.

In the present disclosure, the number of ring-forming carbon atoms in a carbonyl group is not specifically limited, for example, may be 1 to 40, 1 to 30, or 1 to 20. For example, the carbonyl group may have the following structures, but embodiments of the present disclosure are not limited thereto.

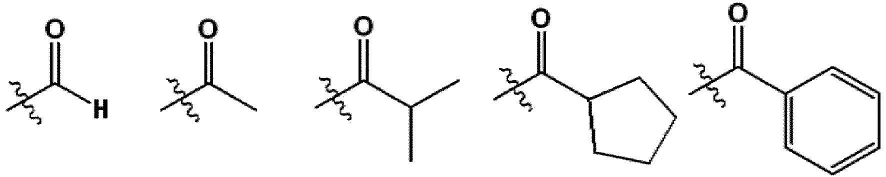

In the present disclosure, the number of carbon atoms in a sulfinyl group or a sulfonyl group is not particularly limited, for example, may be 1 to 30. The sulfinyl group may include an alkyl sulfinyl group and/or an aryl sulfinyl group. The sulfonyl group may include an alkyl sulfonyl group and/or an aryl sulfonyl group.

In the present disclosure, a thio group may include an alkylthio group and/or an arylthio group. The thio group may refer to that a sulfur atom is bonded to the alkyl group or the aryl group as defined above. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, etc., but embodiments of the present disclosure are not limited thereto.

In the present disclosure, an oxy group may refer to that an oxygen atom is bonded to the alkyl group or the aryl group as defined above. The oxy group may include an alkoxy group and/or an aryl oxy group. The alkoxy group may be a linear chain, a branched chain, or a ring. The number of carbon atoms in the alkoxy group is not specifically limited, but may be, for example, 1 to 20 or 1 to 10. Examples of the oxy group may include methoxy, ethoxy, n-propoxy, isopropoxy, butoxy, pentyloxy, hexyloxy, octyloxy, nonyloxy, decyloxy, benzyloxy, etc., but embodiments of the present disclosure are not limited thereto.

A boron group utilized herein may refer to that a boron atom is bonded to the alkyl group or the aryl group as defined above. The boron group may include an alkyl boron group and/or an aryl boron group. Examples of the boron group may include a dimethylboron group, a trimethylboron group, a t-butyldimethylboron group, a diphenylboron group, a phenylboron group, etc., but embodiments of the present disclosure are not limited thereto.

In the present disclosure, the number of carbon atoms in an amine group is not specifically limited, for example, may be 1 to 30. The amine group may include an alkyl amine group and/or an aryl amine group. Examples of the amine group may include a methylamine group, a dimethylamine group, a phenylamine group, a diphenylamine group, a naphthylamine group, a 9-methyl-anthracenylamine group, etc., but embodiments of the present disclosure are not limited thereto.

In the present disclosure, the alkyl group among an alkylthio group, an alkylsulfoxy group, an alkylaryl group, an alkylamino group, an alkyl boron group, an alkyl silyl group, and an alkyl amine group may be the same as the examples of the alkyl group described above.

In the present disclosure, the aryl group among an aryloxy group, an arylthio group, an arylsulfoxy group, an arylamino group, an arylboron group, an arylsilyl group, and an arylamine group may be the same as the examples of the aryl group described above.

In the present disclosure, a direct linkage may refer to a single bond.

In the present disclosure, " 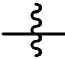 " and " 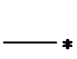 "may refer to a position to be connected.

Hereinafter, embodiments of the present disclosure will be described in more detail with reference to the accompanying drawings. In the present disclosure, term "light emitting device" may be utilized interchangeably with the term "light emitting element."

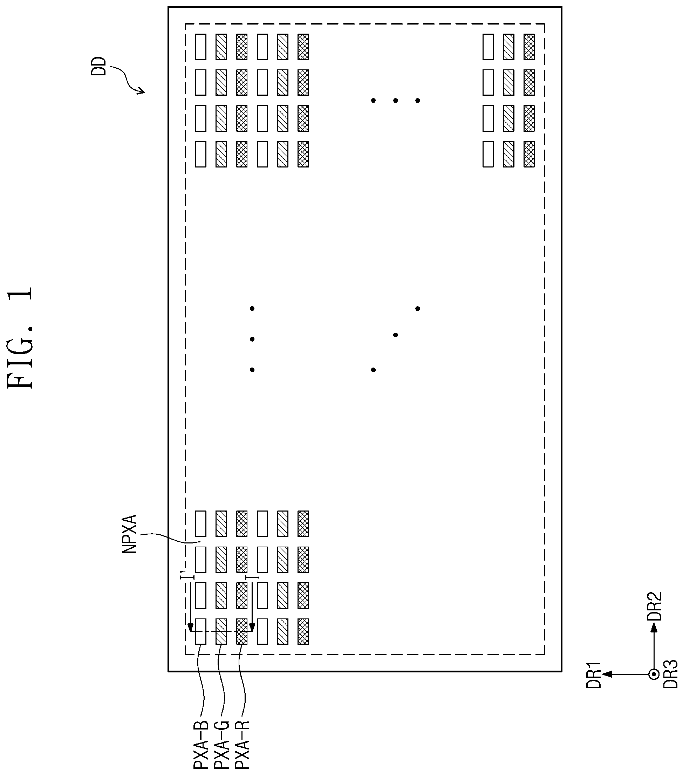

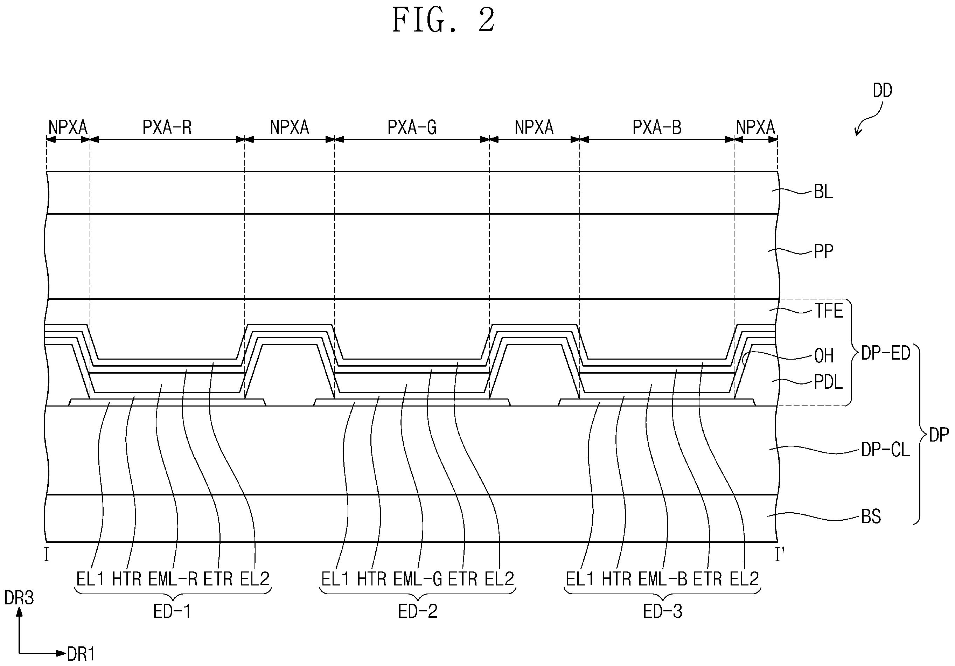

FIG. 1 is a plan view illustrating a display apparatus DD according to one or more embodiments of the present disclosure. FIG. 2 is a cross-sectional view of the display apparatus DD according to one or more embodiments of the present disclosure. FIG. 2 is a cross-sectional view illustrating a part taken along line I-I' of FIG. 1.

The display apparatus DD may include a display panel DP and an optical layer PP disposed on the display panel DP. The display panel DP may include light emitting devices ED-1, ED-2, and ED-3. The display apparatus DD may include a plurality of light emitting devices ED-1, ED-2, and ED-3. The optical layer PP may be disposed on the display panel DP to control reflected light in the display panel DP due to external light. The optical layer PP may include, for example, a polarization layer and/or a color filter layer. In some embodiments, the optical layer PP may not be provided in the display apparatus DD.

A base substrate BL may be disposed or provided on the optical layer PP. The base substrate BL may be a member which provides a base surface on which the optical layer PP disposed. The base substrate BL may be a glass substrate, a metal substrate, a plastic substrate, etc. However, embodiments of the present disclosure are not limited thereto, and the base substrate BL may be an inorganic layer, an organic layer, or a composite material layer. In some embodiments, the base substrate BL may not be provided.

The display apparatus DD according to one or more embodiments may further include a filling layer. The filling layer may be disposed between a display device layer DP-ED and the base substrate BL. The filling layer may be an organic material layer. The filling layer may include at least one of an acrylic-based resin, a silicone-based resin, or an epoxy-based resin.

The display panel DP may include a base layer BS, a circuit layer DP-CL provided on the base layer BS, and a display device layer DP-ED. The display device layer DP-ED may include a pixel defining film PDL, the light emitting devices ED-1, ED-2, and ED-3 disposed between respective portions of the pixel defining film PDL, and an encapsulation layer TFE disposed on the light emitting devices ED-1, ED-2, and ED-3.

The base layer BS may be a member which provides a base surface on which the display device layer DP-ED is disposed. The base layer BS may be a glass substrate, a metal substrate, a plastic substrate, etc. However, embodiments of the present disclosure are not limited thereto, and the base layer BS may be an inorganic layer, an organic layer, or a composite material layer.

In one or more embodiments, the circuit layer DP-CL may be disposed on the base layer BS, and the circuit layer DP-CL may include a plurality of transistors. Each of the transistors may include a control electrode, an input electrode, and an output electrode. For example, in some embodiments, the circuit layer DP-CL may include switching transistor(s) and driving transistor(s) for driving the light emitting devices ED-1, ED-2, and ED-3 of the display device layer DP-ED.

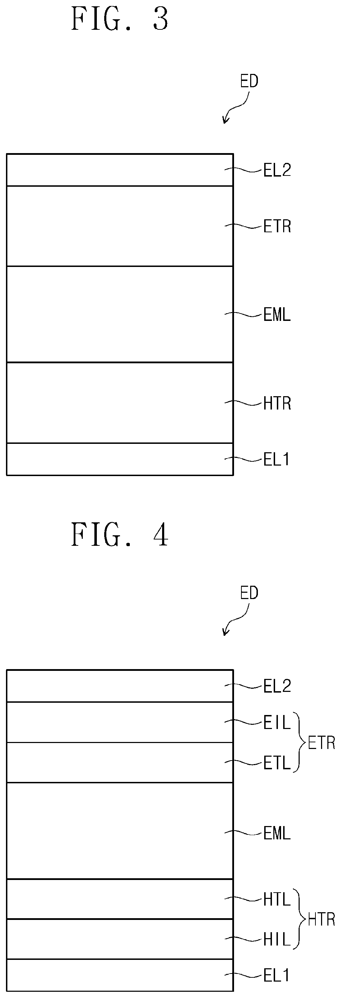

Each of the light emitting devices ED-1, ED-2, and ED-3 may independently have a structure of one of light emitting devices ED of embodiments according to FIGs. 3 to 6, which will be described later. Each of the light emitting devices ED-1, ED-2, and ED-3 may include a first electrode EL1, a hole transport region HTR, respective emission layers EML-R, EML-G, and EML-B, an electron transport region ETR, and a second electrode EL2.

FIG. 2 illustrates an embodiment in which the respective emission layers EML-R, EML-G, and EML-B of the light emitting devices ED-1, ED-2, and ED-3 are disposed in openings OH defined in the pixel defining film PDL, and the hole transport region HTR, the electron transport region ETR, and the second electrode EL2 are provided as a common layer in the entire light emitting devices ED-1, ED-2, and ED-3. However, embodiments of the present disclosure are not limited thereto, for example, in some embodiments, the hole transport region HTR and the electron transport region ETR may be provided by being patterned inside the openings OH defined in the pixel defining film PDL. For example, in some embodiments, the hole transport region HTR, the respective emission layers EML-R, EML-G, and EML-B, and the electron transport region ETR of the light emitting devices ED-1, ED-2, and ED-3 may be provided by being patterned in an inkjet printing method.

The encapsulation layer TFE may cover the light emitting devices ED-1, ED-2, and ED-3. The encapsulation layer TFE may seal the display device layer DP-ED. The encapsulation layer TFE may be a thin film encapsulation layer. The encapsulation layer TFE may be formed by laminating one layer or a plurality of layers. The encapsulation layer TFE may include at least one insulation layer. In some embodiments, the encapsulation layer TFE may include at least one inorganic film (hereinafter, an encapsulation-inorganic film). In some embodiments, the encapsulation layer TFE may include at least one organic film (hereinafter, an encapsulation-organic film) and at least one encapsulation-inorganic film.

The encapsulation-inorganic film protects the display device layer DP-ED from moisture/oxygen, and the encapsulation-organic film protects the display device layer DP-ED from foreign substances such as dust particles. The encapsulation-inorganic film may include silicon nitride, silicon oxynitride, silicon oxide, titanium oxide, aluminium oxide, and/or the like, but embodiments of the present disclosure are not particularly limited thereto. The encapsulation-organic film may include an acrylic-based compound, an epoxy-based compound, and/or the like. In some embodiments, The encapsulation-organic film may include a photopolymerizable organic material, but embodiments of the present disclosure are not particularly limited thereto.

The encapsulation layer TFE may be disposed on the second electrode EL2 and may be disposed filling the opening OH.

Referring to FIG. 1 and FIG. 2, the display apparatus DD may include a non-light emitting region NPXA and light emitting regions PXA-R, PXA-G, and PXA-B. The light emitting regions PXA-R, PXA-G, and PXA-B may be regions in which light generated by the respective light emitting devices ED-1, ED-2, and ED-3 is emitted. The light emitting regions PXA-R, PXA-G, and PXA-B may be spaced apart from each other on a plane.

Each of the light emitting regions PXA-R, PXA-G, and PXA-B may be a region divided by the pixel defining film PDL. The non-light emitting areas NPXA may be areas between adjacent light emitting areas PXA-R, PXA-G, and PXA-B, which correspond to the pixel defining film PDL. In some embodiments, the light emitting regions PXA-R, PXA-G, and PXA-B may respectively correspond to pixels. The pixel defining film PDL may divide the light emitting devices ED-1, ED-2, and ED-3. The respective emission layers EML-R, EML-G, and EML-B of the light emitting devices ED-1, ED-2, and ED-3 may be disposed in openings OH defined in the pixel defining film PDL and separated from each other.

The light emitting regions PXA-R, PXA-G, and PXA-B may be divided into a plurality of groups according to the color of light generated from the light emitting devices ED-1, ED-2, and ED-3. In the display apparatus DD of one or more embodiments illustrated in FIG. 1 and FIG. 2, three light emitting regions PXA-R, PXA-G, and PXA-B, which emit red light, green light, and blue light, respectively, are illustrated as an example. For example, in one or more embodiments, the display device DD may include a red light emitting region PXA-R, a green light emitting region PXA-G, and a blue light emitting region PXA-B that are separated from each other.

In the display apparatus DD according to one or more embodiments, the plurality of light emitting devices ED-1, ED-2 and ED-3 may be to emit light beams having wavelengths different from each other. For example, in one or more embodiments, the display apparatus DD may include a first light emitting device ED-1 that emits red light, a second light emitting device ED-2 that emits green light, and a third light emitting device ED-3 that emits blue light. For example, in some embodiments, the red light emitting region PXA-R, the green light emitting region PXA-G, and the blue light emitting region PXA-B of the display apparatus DD may correspond to the first light emitting device ED-1, the second light emitting device ED-2, and the third light emitting device ED-3, respectively.

However, embodiments of the present disclosure are not limited thereto, and the first to third light emitting devices ED-1, ED-2, and ED-3 may be to emit light beams in substantially the same wavelength range, or at least one light emitting device may be to emit a light beam in a wavelength range different from the others. For example, in some embodiments, the first to third light emitting devices ED-1, ED-2, and ED-3 may all emit blue light.

The light emitting regions PXA-R, PXA-G, and PXA-B in the display apparatus DD according to one or more embodiments may be arranged in a stripe form. Referring to FIG. 1, a plurality of red light emitting regions PXA-R may be arranged with each other along a second direction axis DR2, a plurality of green light emitting regions PXA-G may be arranged with each other along the second direction axis DR2, and a plurality of blue light emitting regions PXA-B may be arranged with each other along the second directional axis DR2. In some embodiments, the red light emitting region PXA-R, the green light emitting region PXA-G, and the blue light emitting region PXA-B may be alternately arranged in the stated order along a first direction axis DR1.

FIG. 1 and FIG. 2 illustrate that all the light emitting regions PXA-R, PXA-G, and PXA-B have similar area, but embodiments of the present disclosure are not limited thereto. Thus, the light emitting regions PXA-R, PXA-G, and PXA-B may have different areas from each other according to the wavelength range of the emitted light. The areas of the light emitting regions PXA-R, PXA-G, and PXA-B may refer to areas when viewed on a plane defined by the first direction axis DR1 and the second direction axis DR2 (e.g., the areas in a plan view).

In some embodiments, an arrangement form of the light emitting regions PXA-R, PXA-G, and PXA-B is not limited to the configuration illustrated in FIG. 1, and the order in which the red light emitting region PXA-R, the green light emitting region PXA-G, and the blue light emitting region PXA-B are arranged may be provided in one or more suitable combinations according to the characteristics of display quality required in the display apparatus DD. For example, in some embodiments, the arrangement form of the light emitting regions PXA-R, PXA-G, and PXA-B may be a pentile (PENTILE^{®}) arrangement form (for example, an RGBG matrix, an RGBG structure, or RGBG matrix structure) or a diamond (Diamond Pixel^{™}) arrangement form (e.g., a display (e.g., an OLED display) containing red, blue, and green (RGB) light-emitting regions arranged in the shape of diamonds). PENTILE^{®} is a duly registered trademark of Samsung Display Co., Ltd. Diamond Pixel^{™} is a trademark of Samsung Display Co., Ltd.

In some embodiments, the areas of the light emitting regions PXA-R, PXA-G, and PXA-B may be different from each other. For example, in some embodiments, the area of the green light emitting region PXA-G may be smaller than that of the blue light emitting region PXA-B, but embodiments of the present disclosure are not limited thereto.

Hereinafter, FIG. 3 to FIG. 6 are cross-sectional views schematically showing light emitting elements according to one or more embodiments of the present disclosure. The light emitting element ED according to one or more embodiments includes a first electrode EL1, a second electrode EL2 oppositely disposed to the first electrode EL1, and at least one functional layer between the first electrode EL1 and the second electrode EL2. The light emitting element ED of one or more embodiments includes a fused polycyclic compound of one or more embodiments of the present disclosure, which will be explained later, in the at least one functional layer.

The light emitting element ED may include a hole transport region HTR, an emission layer EML, an electron transport region ETR, and/or the like, stacked in order (e.g., in the stated order), as the at least one functional layer. Referring to FIG. 3, the light emitting element ED of an embodiment may include a first electrode EL1, a hole transport region HTR, an emission layer EML, an electron transport region ETR, and a second electrode EL2, stacked in order.

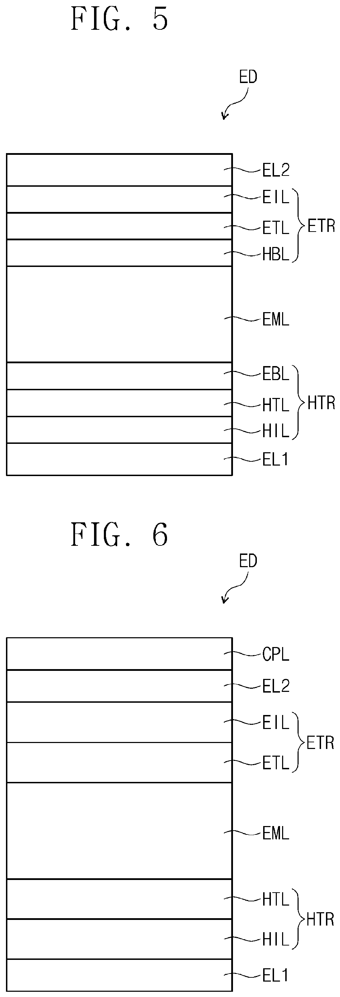

Compared with FIG. 3, FIG. 4 illustrates a cross-sectional view of a light emitting element ED of one or more embodiments, in which a hole transport region HTR may include a hole injection layer HIL and a hole transport layer HTL, and an electron transport region ETR may include an electron injection layer EIL and an electron transport layer ETL. In some embodiments, compared with FIG. 3, FIG. 5 illustrates a cross-sectional view of a light emitting element ED of one or more embodiments, in which a hole transport region HTR may include a hole injection layer HIL, a hole transport layer HTL, and an electron blocking layer EBL, and an electron transport region ETR may include an electron injection layer EIL, an electron transport layer ETL, and a hole blocking layer HBL. Compared with FIG. 4, FIG. 6 illustrates a cross-sectional view of a light emitting element ED of one or more embodiments including a capping layer CPL disposed on a second electrode EL2.

The first electrode EL1 has conductivity (e.g., is a conductor). The first electrode EL1 may be formed of a metal material, a metal alloy, and/or a conductive compound. The first electrode EL1 may be an anode or a cathode. However, embodiments of the present disclosure are not limited thereto. In some embodiments, the first electrode EL1 may be a pixel electrode. The first electrode EL1 may be a transmissive electrode, a transflective electrode, or a reflective electrode. The first electrode EL1 may include at least one selected from among silver (Ag), magnesium (Mg), copper (Cu), aluminium (Al), platinum (Pt), palladium (Pd), gold (Au), nickel (Ni), neodymium (Nd), iridium (Ir), chromium (Cr), lithium (Li), calcium (Ca), lithium fluoride (LiF), molybdenum (Mo), titanium (Ti), tungsten (W), indium (In), tin (Sn), and zinc (Zn), one or more compounds each being of two or more selected therefrom, one or more mixtures each being of two or more selected therefrom, and/or one or more oxides thereof.

When the first electrode EL1 is a transmissive electrode, the first electrode EL1 may include a transparent metal oxide such as indium tin oxide (ITO), indium zinc oxide (IZO), zinc oxide (ZnO), and/or indium tin zinc oxide (ITZO). When the first electrode EL1 is a transflective electrode or the reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, a compound thereof, or a mixture thereof (e.g., a mixture of Ag and Mg). In some embodiments, the first electrode EL1 may have a multilayer structure including a reflective film or a transflective film formed of the above-described materials, and a transparent conductive film formed of ITO, IZO, ZnO, ITZO, etc. For example, in some embodiments, the first electrode EL1 may have a three-layer structure of ITO/Ag/ITO, but embodiments of the present disclosure are not limited thereto. The first electrode EL1 may include one of the above-described metal materials, combinations of at least two metal materials of the above-described metal materials, oxides of the above-described metal materials, and/or the like. A thickness of the first electrode EL1 may be from about 700 Å to about 10,000 Å. For example, in one or more embodiments, the thickness of the first electrode EL1 may be from about 1,000 Å to about 3,000 Å.

The hole transport region HTR may be provided on the first electrode EL1. The hole transport region HTR may include at least one of a hole injection layer HIL, a hole transport layer HTL, a buffer layer or an emission-auxiliary layer, or an electron blocking layer EBL. A thickness of the hole transport region HTR may be, for example, from about 50 Å to about 15,000 Å.

The hole transport region HTR may have a single layer formed of a single material, a single layer formed of a plurality of different materials, or a multilayer structure including a plurality of layers formed of a plurality of different materials.

For example, in one or more embodiments, the hole transport region HTR may have a single layer structure of a hole injection layer HIL or a hole transport layer HTL, or may have a single layer structure formed of a hole injection material and a hole transport material. In some embodiments, the hole transport region HTR may have a single layer structure formed of a plurality of different materials, or a structure in which a hole injection layer HIL/hole transport layer HTL, a hole injection layer HIL/hole transport layer HTL/buffer layer, a hole injection layer HIL/buffer layer, a hole transport layer HTL/buffer layer, or a hole injection layer HIL/hole transport layer HTL/electron blocking layer EBL are stacked in order (e.g., in the stated order) from the first electrode EL1, but embodiments of the present disclosure are not limited thereto.

The hole transport region HTR may be formed utilizing one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the hole transport region HTR may include a compound represented by Formula H-1:

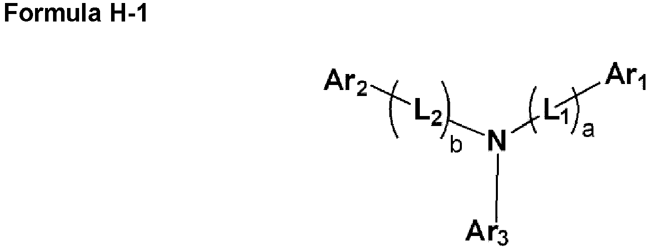

In Formula H-1, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms. a and b may each independently be an integer of 0 to 10. In some embodiments, when a or b is an integer of 2 or greater, a plurality of L₁'s and L₂'s may each independently be a substituted or unsubstituted arylene group having 6 to 30 ring-forming carbon atoms, or a substituted or unsubstituted heteroarylene group having 2 to 30 ring-forming carbon atoms.

In Formula H-1, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. In some embodiments, in Formula H-1, Ar₃ may be a substituted or unsubstituted aryl group having 6 to 30 ring-forming carbon atoms, or a substituted or unsubstituted heteroaryl group having 2 to 30 ring-forming carbon atoms.

The compound represented by Formula H-1 may be a monoamine compound. In some embodiments, the compound represented by Formula H-1 may be a diamine compound in which at least one selected from among Ar₁ to Ar₃ may include an amine group as a substituent. In some embodiments, the compound represented by Formula H-1 may be a carbazole-based compound including a substituted or unsubstituted carbazole group in at least one of Ar₁ or Ar₂, or a fluorene-based compound including a substituted or unsubstituted fluorene group in at least one of Ar₁ or Ar₂.

The compound represented by Formula H-1 may be represented by any one selected from among compounds in Compound Group H. However, the compounds listed in Compound Group H are mere examples, and the compounds represented by Formula H-1 are not limited to those represented in Compound Group H:

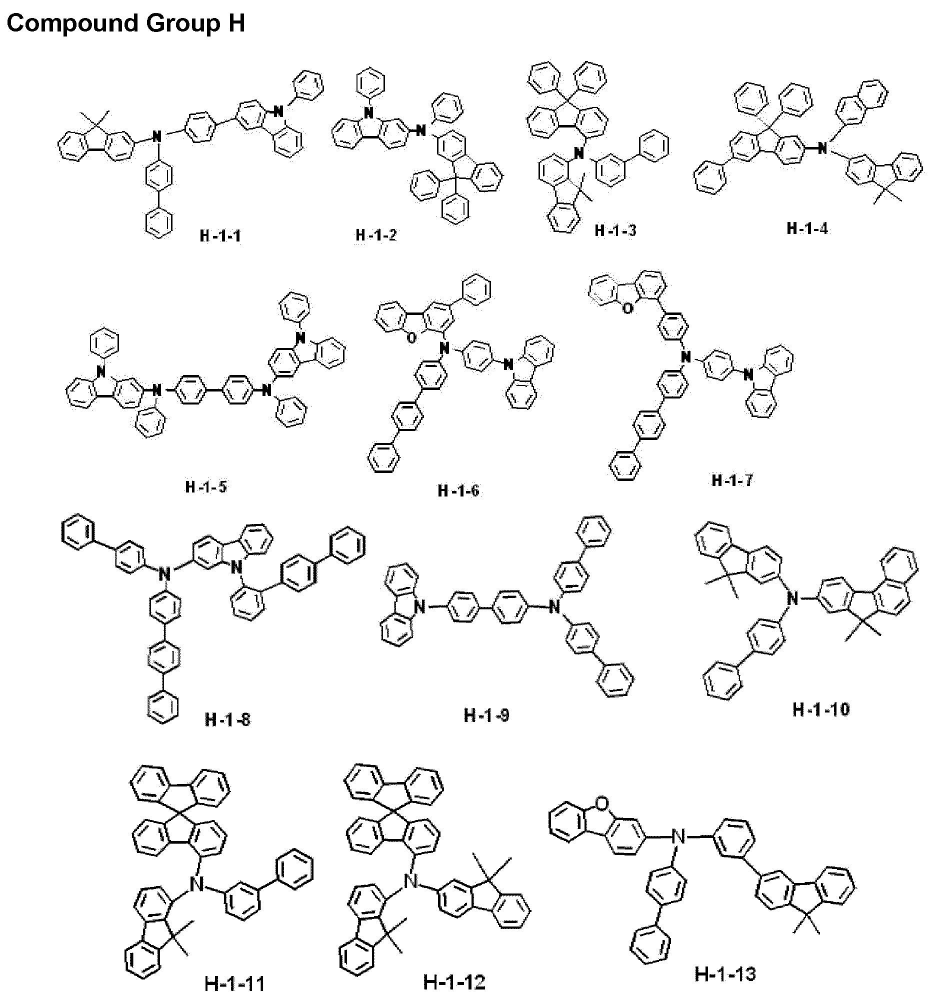

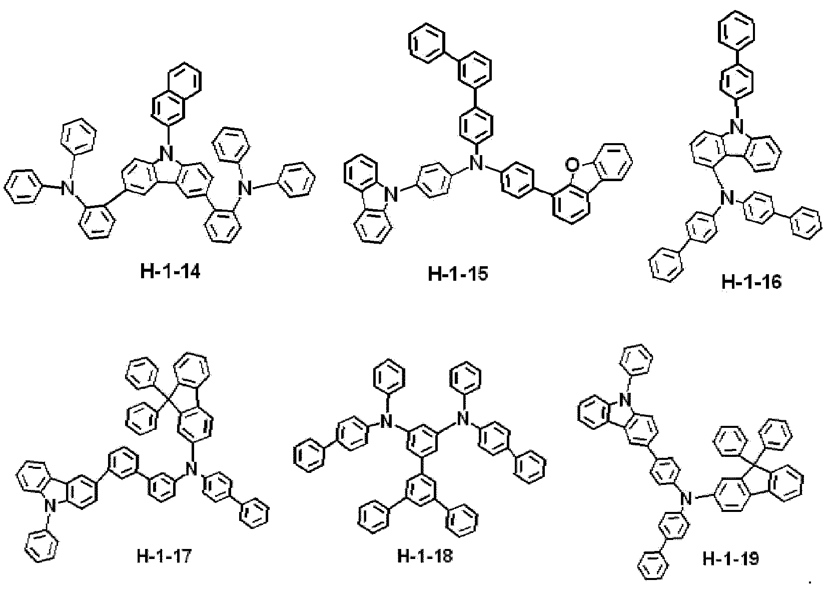

In one or more embodiments, the hole transport region HTR may include at least one selected from a phthalocyanine compound such as copper phthalocyanine, N¹,N^{1'}-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalen-1-yl)-N,N'-diphenyl-benzidine (NPB), triphenylamine-containing polyetherketone (TPAPEK), 4-isopropyl-4'-methyldiphenyliodonium [tetrakis(pentafluorophenyl)borate], dipyrazino[2,3-f: 2',3'-h]quinoxaline-2,3,6,7,10,11-hexacarbonitrile (HATCN), etc.

In one or more embodiments, the hole transport region HTR may include at least one selected from a carbazole-based derivative such as N-phenyl carbazole or polyvinyl carbazole, a fluorene-based derivative, a triphenylamine-based derivative such as N,N'-bis(3-methylphenyl)-N,N'-diphenyl-[1,1-biphenyl]-4,4'-diamine (TPD) or 4,4',4"-tris(N-carbazolyl)triphenylamine (TCTA), N,N'-di(naphthalen-1-yl)-N,N'-diphenyl-benzidine (NPB), 4,4'-cyclohexylidene bis[N,N-bis(4-methylphenyl]benzenamine] (TAPC), 4,4'-bis[N,N'-(3-tolyl)amino]-3,3'-dimethylbiphenyl (HMTPD), 1,3-bis(N-carbazolyl)benzene (mCP), etc.

In some embodiments, the hole transport region HTR may include *9-(4-tert-*butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), etc.

The hole transport region HTR may include at least one of the above-described compounds of the hole transport region in at least one of a hole injection layer HIL, a hole transport layer HTL, or an electron blocking layer EBL.

A thickness of the hole transport region HTR may be from about 100 Å to about 10,000 Å, for example, from about 100 Å to about 5,000 Å. When the hole transport region HTR includes a hole injection layer HIL, the hole injection layer HIL may have, for example, a thickness of about 30 Å to about 1,000 Å. When the hole transport region HTR includes a hole transport layer HTL, the hole transport layer HTL may have a thickness of about 250 Å to about 1,000 Å. For example, when the hole transport region HTR includes an electron blocking layer EBL, the electron blocking layer EBL may have a thickness of about 10 Å to about 1,000 Å. When the thicknesses of the hole transport region HTR, the hole injection layer HIL, the hole transport layer HTL, and the electron blocking layer EBL satisfy the above-described ranges, satisfactory hole transport properties may be achieved without a substantial increase in driving voltage.

In one or more embodiments, the hole transport region HTR may further include a charge generating material to increase conductivity in addition to the above-described materials. The charge generating material may be dispersed substantially uniformly or non-uniformly in the hole transport region HTR. The charge generating material may be, for example, a p-dopant. The p-dopant may include at least one of a halogenated metal compound, a quinone derivative, a metal oxide, or a cyano group-containing compound, but embodiments of the present disclosure are not limited thereto. For example, in some embodiments, the p-dopant may include a metal halide compound such as Cul and/or Rbl, a quinone derivative such as tetracyanoquinodimethane (TCNQ) and/or 2,3,5,6-tetrafluoro-7,7,8,8-tetracyanoquinodimethane (F4-TCNQ), a metal oxide such as tungsten oxide and/or molybdenum oxide, a cyano group-containing compound such as dipyrazino[2,3-f: 2',3'-h] quinoxaline-2,3,6,7,10,11-hexacarbonitrile (HATCN) and/or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), etc., but embodiments of the present disclosure are not limited thereto.

As described above, the hole transport region HTR may further include at least one of the buffer layer or the electron blocking layer EBL in addition to the hole injection layer HIL and the hole transport layer HTL. The buffer layer may compensate for a resonance distance according to the wavelength of light emitted from the emission layer EML and may thus increase light emission efficiency. A material that may be included in the hole transport region HTR may be utilized as a material to be included in the buffer layer. The electron blocking layer EBL is a layer that serves to prevent or reduce the electron injection from the electron transport region ETR to the hole transport region HTR.

The emission layer EML may be provided on the hole transport region HTR. The emission layer EML may have, for example, a thickness of about 100 Å to about 1000 Å or about 100 A to about 300 Å. The emission layer EML may have a single layer formed of a single material, a single layer formed of a plurality of different materials, or a multilayer structure having a plurality of layers formed of a plurality of different materials.

The light emitting element ED of one or more embodiments includes a fused polycyclic compound represented by Formula 1 in the at least one functional layer disposed between the first electrode EL1 and the second electrode EL2. In the light emitting element ED according to one or more embodiments, the emission layer EML may include the fused polycyclic compound of one or more embodiments. In one or more embodiments, the emission layer EML may include the fused polycyclic compound of one or more embodiments as a dopant. The fused polycyclic compound of one or more embodiments may be a dopant material of the emission layer EML. In the present disclosure, the fused polycyclic compound of one or more embodiments, which will be described later, may be referred to as a first compound.

The fused polycyclic compound of one or more embodiments may include a structure in which a plurality of aromatic rings are fused through at least one boron atom and at least two hetero atoms. For example, the fused polycyclic compound of one or more embodiments may include a fused ring formed as a plurality of aromatic rings are fused through at least one boron atom and at least two hetero atoms.

In one or more embodiments, the fused polycyclic compound may include a structure in which a plurality of aromatic rings are fused through one boron atom and two hetero atoms. For example, the fused polycyclic compound of one or more embodiments may include a structure in which first to third aromatic rings are fused through a first boron atom, a first hetero atom, and a second hetero atom. The first to third aromatic rings may each be linked to the first boron atom, the first aromatic ring and the second aromatic ring may be linked through the first hetero atom, and the first aromatic ring and the third aromatic ring may be linked through the second hetero atom.

In one or more embodiments, the fused polycyclic compound may include a structure in which a plurality of aromatic rings are fused through two boron atoms and at least three hetero atoms. For example, the fused polycyclic compound of one or more embodiments may include a structure in which first to fifth aromatic rings are fused through first and second boron atoms and first to third hetero atoms. In some embodiments, the fused polycyclic compound of one or more embodiments may include a structure in which first to fifth aromatic rings are fused through first and second boron atoms and first to fourth hetero atoms.

In one or more embodiments, the first to fifth aromatic rings may each independently be a substituted or unsubstituted monocyclic aromatic hydrocarbon ring having 6 to 30 ring-forming carbon atoms, or a substituted or unsubstituted monocyclic aromatic heterocycle having 2 to 30 ring-forming carbon atoms. For example, in one or more embodiments, the first to fifth aromatic rings may each independently be a 6-membered aromatic hydrocarbon ring. In one or more embodiments, the first to fourth hetero atoms may each independently be an oxygen atom (O), a sulfur atom (S), or a nitrogen atom (N).

The fused polycyclic compound of one or more embodiments may include a first substituent linked to a fused ring core. The first substituent may be linked to at least any one selected from the first to third aromatic rings. The fused polycyclic compound of one or more embodiments may include at least one first substituent. The first substituent may include a structure in which a carbazole moiety and at least one cyano group linked to the carbazole moiety are connected. The first substituent may be directly linked to the fused ring core without a separate linker. In the present disclosure, the first substituent may indicate a substituent represented by Formula 2, which will be described later.

The fused polycyclic compound of one or more embodiments is represented by Formula 1.

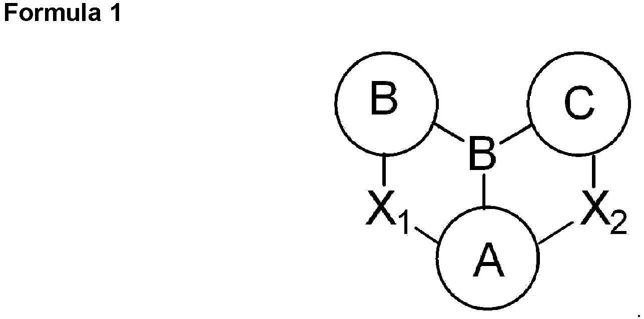

The fused polycyclic compound represented by Formula 1 may include a structure in which three aromatic rings are fused through one boron atom and two nitrogen atoms. In one or more embodiments, the fused polycyclic compound may have a structure in which an additional aromatic ring is fused through an additional boron atom and an additional hetero atom, on the basis of a structure in which three aromatic rings are fused around one boron atom. In one or more embodiments of the present disclosure, in Formula 1, A ring may correspond to the first aromatic ring, B ring may correspond to the second aromatic ring described above, and C ring may correspond to the third aromatic ring described above.

In Formula 1, X₁ and X₂ are each independently O, S, or NR₁. However, a case (e.g., embodiments) in which X₁ and X₂ are both (e.g., each or simultaneously) O is excluded. For example, in some embodiments, X₁ and X₂ may all be NR₁. In some embodiments, any one selected from X₁ and X₂ may be NR₁ and the other may be O or S. In some embodiments, any one selected from X₁ and X₂ may be O, and the other may be S.

In Formula 1, R₁ is a substituted or unsubstituted aryl group having 6 to 30 ring-forming carbon atoms or a substituted or unsubstituted heteroaryl group having 2 to 30 ring-forming carbon atoms. In some embodiments, R₁ may be bonded to an adjacent group to form a ring. In one or more embodiments, R₁ may be a substituted or unsubstituted aryl group having 6 to 30 ring-forming carbon atoms. For example, in some embodiments, R₁ may be a substituted or unsubstituted phenyl group, a substituted or unsubstituted biphenyl group, or a substituted or unsubstituted terphenyl group.

In the fused polycyclic compound represented by Formula 1, when X₁ and X₂ are both (e.g., each or simultaneously) NR₁, an embodiment in which R₁ is represented by Formula a is excluded.

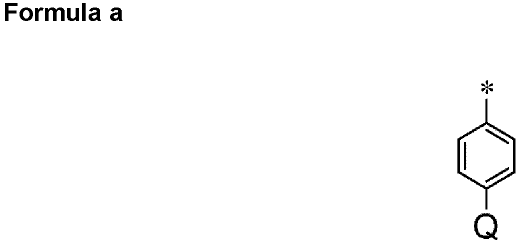

In Formula a, Q is a substituted or unsubstituted alkyl group. For example, Q may be a substituted or unsubstituted alkyl group having 1 to 20 carbon atoms.

In Formula 1, A to C rings are each independently a substituted or unsubstituted monocyclic aromatic hydrocarbon ring having 6 to 30 ring-forming carbon atoms or a substituted or unsubstituted monocyclic aromatic heterocycle having 2 to 30 ring-forming carbon atoms. In one or more embodiments, A to C rings may each independently be a substituted or unsubstituted 6-membered aromatic hydrocarbon ring or a substituted or unsubstituted 6-membered aromatic heterocycle. For example, in some embodiments, A to C rings may each independently be a benzene ring. In some embodiments, a substituent substituted on each or any one of A to C rings may be bonded to an adjacent group to form a ring. For example, in some embodiments, a substituent substituted on each or any one of A to C rings may be bonded to an adjacent ring or an adjacent substituent to form a fused ring. In some embodiments, A to C rings may be independently bonded to an adjacent ring or an adjacent substituent to form a fused ring.

In the fused polycyclic compound represented by Formula 1, an embodiment in which a 5-membered heterocycle is fused to each or any one of A to C rings is excluded. For example, in some embodiments, an embodiment in which substituents substituted on each or any one of A to C rings are bonded to adjacent groups to form a fused ring including a 5-membered heterocycle is excluded. For example, the fused polycyclic compound represented by Formula 1 may not include (e.g., may exclude) a (e.g., any) structure in which a 5-membered heterocycle is additionally fused to a "fused ring core" including A to C rings. For example, as shown in Formula S1, when A to C rings are each a benzene ring which is a 6-membered aromatic hydrocarbon ring, X₁ and X₂ are each NR₁, and R₁ is a phenyl group, an embodiment in which the A ring and the B ring are each bonded to adjacent R₁ to form a 5-membered fused ring may be excluded. When a 5-membered heterocycle is additionally fused to A to C rings, increased ring torsion may degrade chemical stability, and thus may cause a decrease in element service life (e.g., lifespan of element). According to one or more embodiments of the present disclosure, the embodiment where a 5-membered heterocycle is additionally fused to a "fused ring core" including A to C rings is excluded, and accordingly, chemical stability may be improved to exhibit increased element service life. In the present disclosure, the "5-membered heterocycle" may indicate a 5-membered aliphatic heterocycle containing N, O, or S as a ring-forming atom, or a 5-membered aromatic heterocycle containing N, O, or S as a ring-forming atom.

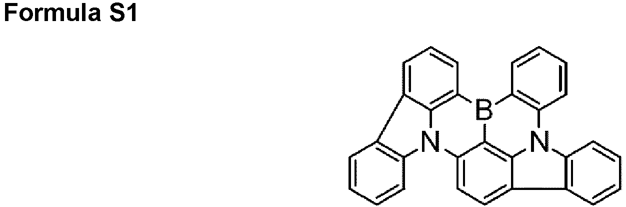

The fused polycyclic compound represented by Formula 1 includes at least one substituent represented by Formula 2. In one or more embodiments, the fused polycyclic compound represented by Formula 1 may include at least one substituent represented by Formula 2 as a substituent. For example, in some embodiments, the substituent represented by Formula 2 may be linked to at least one of A to C rings of Formula 1.

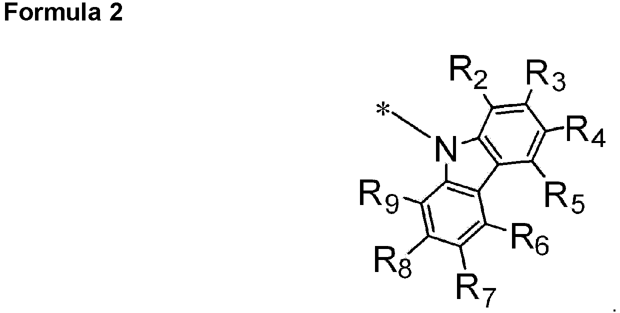

In Formula 2, R₂ to R₉ are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, in some embodiments, R₂ to R₉ may each independently be hydrogen, deuterium, a cyano group, a substituted or unsubstituted methyl group, a substituted or unsubstituted t-butyl group, or a substituted or unsubstituted phenyl group.

In Formula 2, at least one selected from among R₂ to R₉ is a cyano group. For example, in one or more embodiments, at least one selected from among R₂ to R₉ may be a cyano group, and the others may each independently be hydrogen, deuterium, a halogen, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. In some embodiments, R₂ to R₉ may all be a cyano group.

In Formula 2, -* is a site linked to Formula 1.

In one or more embodiments, the fused polycyclic compound represented by Formula 1 may be represented by Formula 1-1.

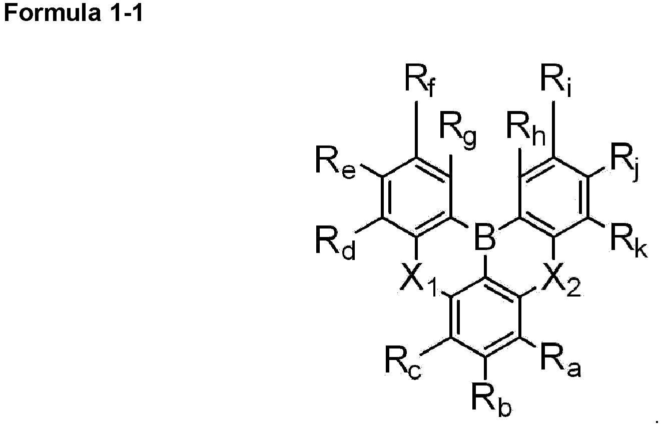

In Formula 1-1, Rₐ to Rₖ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2. In some embodiments, one or more selected from Rₐ to Rₖ may each independently be bonded to an adjacent group to form a ring. For example, in one or more embodiments, Rₐ to Rₖ may each independently be hydrogen, deuterium, a substituted or unsubstituted t-butyl group, a substituted or unsubstituted phenyl group, a substituted or unsubstituted carbazole group, a substituted or unsubstituted arylboron group, a substituted or unsubstituted arylamine group, a substituted or unsubstituted aryloxy group, a substituted or unsubstituted arylthio group, or a substituent represented by Formula 2. In some embodiments, at least one adjacent pair selected from Rₐ to Rₖ may be bonded to form a fused ring. For example, in some embodiments, in Formula 1-1, Rᵢ and Rⱼ may be bonded to form a fused ring. In some embodiments, in Formula 1-1, X₁ is NR₁, and R_{c} may be bonded to each of R₁ and R_{b} to form a fused ring. However, embodiments of the present disclosure are not limited thereto.

In Formula 1-1, each of Rₐ to Rₖ are not bonded to an adjacent group to form a 5-membered heterocycle.

In Formula 1-1, at least one selected from among Rₐ to Rₖ is a substituent represented by Formula 2.

In Formula 1-1, the same descriptions as in Formula 1 are also applied to X₁ and X₂.

In one or more embodiments, R₁ may each independently be represented by any one selected from among Formulas A-1 to A-4.

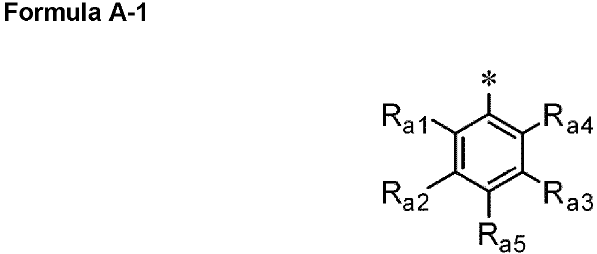

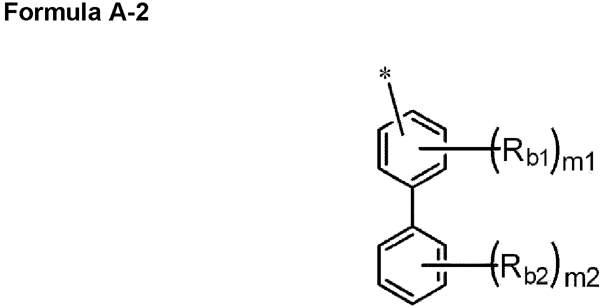

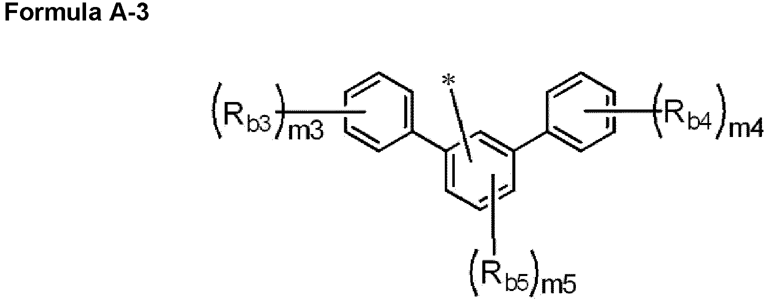

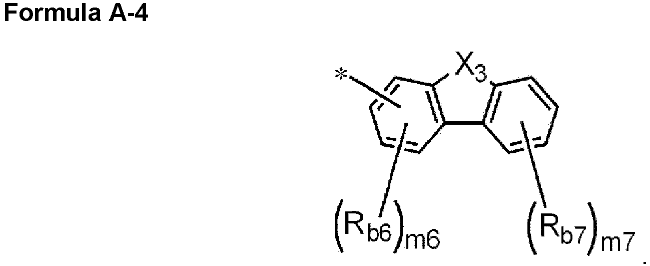

In Formula A-4, X₃ is NR_{b8}, O, or S.

In Formulas A-1 to A-4, Rₐ₁ to Rₐ₄, and R_{b1} to R_{b7} are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. In some embodiments, one or more selected from Rₐ₁ to Rₐ₄, and R_{b1} to R_{b7} may be bonded to an adjacent group to form a ring. For example, in some embodiments, Rₐ₁ to Rₐ₄, and R_{b1} to R_{b7} may each independently be hydrogen, deuterium, a substituted or unsubstituted t-butyl group, or a substituted or unsubstituted phenyl group.

In Formula A-1, Rₐ₅ is hydrogen, deuterium, a halogen, a cyano group, a nitro group, a substituted or unsubstituted amine group, a substituted or unsubstituted aryl group having 6 to 30 ring-forming carbon atoms, or a substituted or unsubstituted heteroaryl group having 2 to 30 ring-forming carbon atoms. For example, in some embodiments, Rₐ₅ may be hydrogen, deuterium, or a substituted or unsubstituted t-butyl group.

In Formula A-4, R_{b8} is a substituted or unsubstituted aryl group having 6 to 30 ring-forming carbon atoms or a substituted or unsubstituted heteroaryl group having 2 to 30 ring-forming carbon atoms. For example, in some embodiments, R_{b8} may be a substituted or unsubstituted phenyl group.

In Formulas A-2 to A-4, m1 and m7 are each independently an integer of 0 to 4. In Formulas A-2 and A-4, when m1 and m7 are each 0, the fused polycyclic compound of an embodiment may not be substituted with each of R_{b1} and R_{b7}. In Formulas A-2 and A-4, an embodiment in which m1 and m7 are each 4, and R_{b1} and R_{b7} are each a hydrogen atom may be the same as an embodiment in which m1 and m7 are each 0 in Formulas A-2 and A-4. When m1 and m7 are each an integer of 2 or greater, R_{b1} and R_{b7} provided in plurality may each be the same, or at least one of R_{b1} or R_{b7} provided in plurality may be different.

In Formulas A-2 and A-3, m2 to m4 are each independently an integer of 0 to 5. In Formulas A-2 and A-3, when m2 to m4 are each 0, the fused polycyclic compound of one or more embodiments may not be substituted with each of R_{b2} to R_{b4}. In Formulas A-2 and A-3, an embodiment in which m2 to m4 are each 5 and R_{b2} to R_{b4} are each hydrogen may be the same as an embodiment in which m2 to m4 are each 0 in Formulas A-2 and A-3. When m2 to m4 are each an integer of 2 or greater, R_{b2} to R_{b4} provided in plurality may each be the same, or at least one selected from among R_{b2} to R_{b4} provided in plurality may be different.

In Formulas A-3 to A-4, m5 and m6 are each independently an integer of 0 to 3. In Formulas A-3 and A-4, when m5 and m6 are each 0, the fused polycyclic compound of one or more embodiments may not be substituted with each of R_{b5} and R_{b6}. In Formulas A-3 and A-4, an embodiment in which m5 and m6 are each 3, and R_{b5} and R_{b6} are each a hydrogen atom may be the same as an embodiment in which m5 and m6 are each 0 in Formulas A-3 and A-4. When m5 and m6 are each an integer of 2 or greater, R_{b5} and R_{b6} provided in plurality may each be the same, or at least one of R_{b5} or R_{b6} provided in plurality may be different.

In Formulas A-1 to A-4, -* is a site linked to Formula 1.

In one or more embodiments, R₁ may each independently be represented by any one selected from among Formulas A-1-1 to A-1-11.

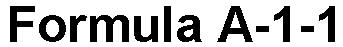

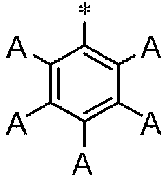

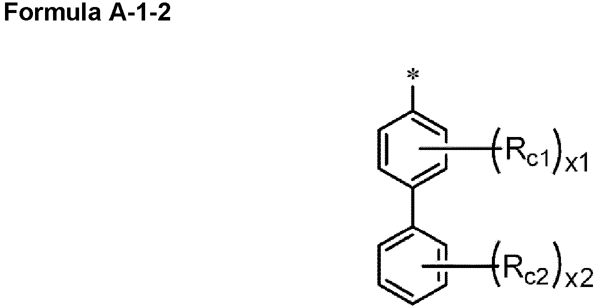

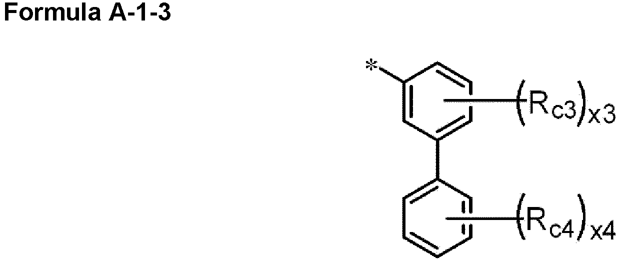

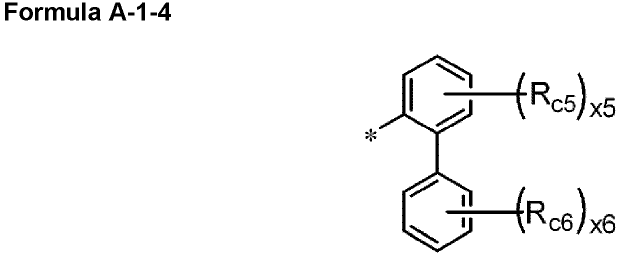

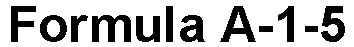

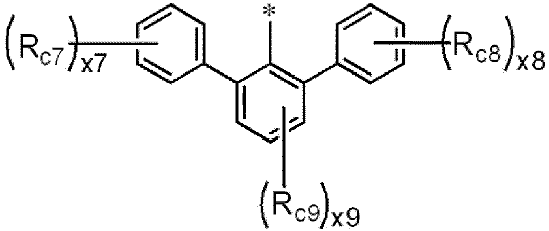

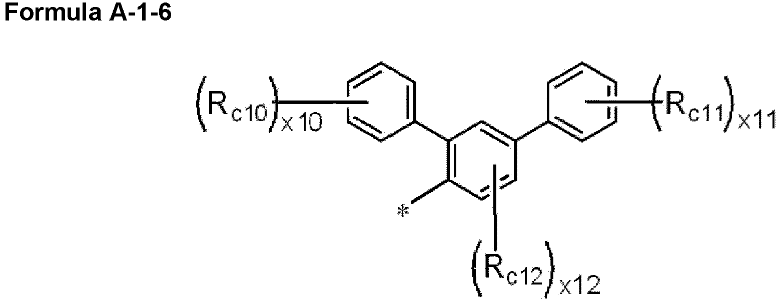

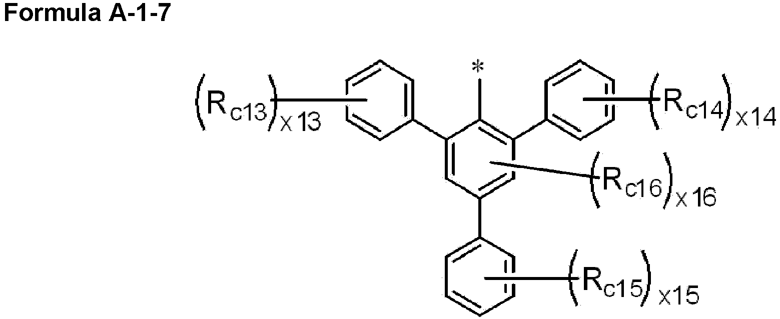

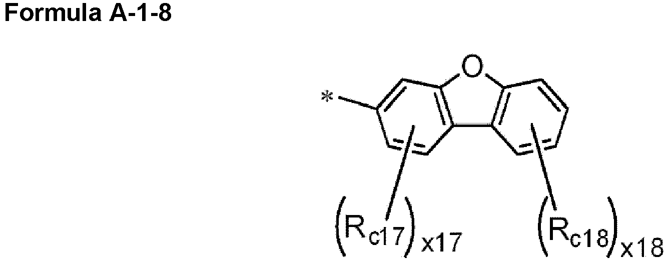

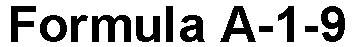

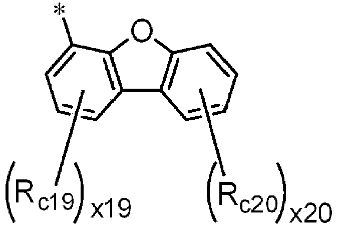

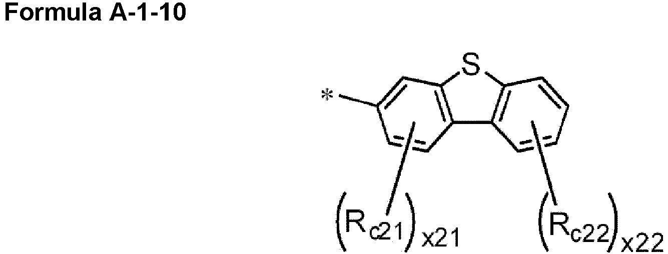

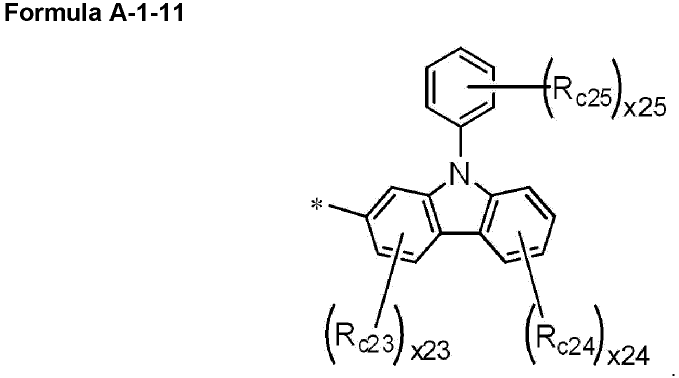

In Formula A-1-1, A is hydrogen or deuterium.

In Formulas A-1-2 to A-1-11, R_{c1} to R_{c25} are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, in some embodiments, R_{c1} to R_{c25} may each independently be hydrogen, deuterium, a substituted or unsubstituted t-butyl group, or a substituted or unsubstituted phenyl group.

In Formulas A-1-2 to A-1-4, x1, x3, and x5 are each independently an integer of 0 to 4. In Formulas A-1-2 to A-1-4, when x1, x3, and x5 are each 0, the fused polycyclic compound of one or more embodiments may not be substituted with each of R_{c1}, R_{c3}, and R_{c5}. In Formulas A-1-2 to A-1-4, an embodiment in which x1, x3, and x5 are each 4, and R_{c1}, R_{c3}, and R_{c5} are each hydrogen may be the same as an embodiment in which x1, x3, and x5 are each 0 in Formulas A-1-2 to A-1-4. When x1, x3, and x5 are each an integer of 2 or greater, R_{c1}, R_{c3}, and R_{c5} provided in plurality may each be the same, or at least one of R_{c1}, R_{c3}, or R_{c5} provided in plurality may be different.

In Formulas A-1-2 to A-1-4, x2, x4, and x6 are each independently an integer of 0 to 5. In Formulas A-1-2 to A-1-4, when x2, x4, and x6 are each 0, the fused polycyclic compound of one or more embodiments may not be substituted with each of R_{c2}, R_{c4}, and R_{c6}. In Formulas A-1-2 to A-1-4, an embodiments in which x2, x4, and x6 are each 5, and R_{c2}, R_{c4}, and R_{c6} are each hydrogen may be the same as an embodiment in which x2, x4, and x6 are each 0 in Formulas A-1-2 to A-1-4. When x2, x4, and x6 are each an integer of 2 or greater, R_{c2}, R_{c4}, and R_{c6} provided in plurality may each be the same, or at least one of R_{c2}, R_{c4}, or R_{c6} provided in plurality may be different.

In Formulas A-1-5 to A-1-7, x7, x8, x10, x11, and x13 to x15 are each independently an integer of 0 to 5. In Formulas A-1-5 to A-1-7, when x7, x8, x10, x11, and x13 to x15 are each 0, the fused polycyclic compound of one or more embodiments may not be substituted with each of R_{c7}, R_{c8}, R_{c10}, R_{c11}, and R_{c13} to R_{c15}. In Formulas A-1-5 to A-1-7, an embodiment in which x7, x8, x10, x11, and x13 to x15 are each 5, and R_{c7}, R_{c8}, R_{c10}, R_{c11}, and R_{c13} to R_{c15} are each hydrogen may be the same as an embodiment in which x7, x8, x10, x11, and x13 to x15 are each 0 in Formulas A-1-5 to A-1-7. When x7, x8, x10, x11, and x13 to x15 are each an integer of 2 or greater, R_{c7}, R_{c8}, R_{c10}, R_{c11}, and R_{c13} to R_{c15} provided in plurality may each be the same, or at least one selected from R_{c7}, R_{c8}, R_{c10}, R_{c11}, and R_{c13} to R_{c15} provided in plurality may be different.

In Formulas A-1-5 and A-1-6, x9 and x12 are each independently an integer of 0 to 3. In Formulas A-1-5 and A-1-6, when x9 and x12 are each 0, the fused polycyclic compound of one or more embodiments may not be substituted with each of R_{c9} and R_{c12}. In Formulas A-1-5 and A-1-6, an embodiment in which x9 and x12 are each 3, and R_{c9} and R_{c12} are each hydrogen may be the same as an embodiment in which x9 and x12 are each 0 in Formulas A-1-5 and A-1-6. When x9 and x12 are each an integer of 2 or greater, R_{c9} and R_{c12} provided in plurality may each be the same, or at least one of R_{c9} or R_{c12} provided in plurality may be different.

In Formula A-1-7, x16 is an integer of 0 to 2. In Formula A-1-7, when x16 is 0, the fused polycyclic compound of one or more embodiments may not be substituted **with** R_{c16}. In Formula A-1-7, an embodiment in which x16 is 2 and R_{c16} is all hydrogen may be the same as an embodiment in which x16 is 0 in Formula A-1-7. When x16 is 2, R_{c16} provided in plurality may all be the same, or at least one of the plurality of R_{c16}'s may be different.

In Formulas A-1-8 to A-1-11, x17, x19, x21, and x23 are each independently an integer of 0 to 3. In Formulas A-1-8 to A-1-11, when x17, x19, x21, and x23 are each 0, the fused polycyclic compound of one or more embodiments may not be substituted with each of R_{c17}, R_{c19}, R_{c21}, and R_{c23}. In Formulas A-1-8 to A-1-11, an embodiment in which x17, x19, x21, and x23 are each 3, and R_{c17}, R_{c19}, R_{c21}, and R_{c23} are each hydrogen may be the same as an embodiment in which x17, x19, x21, and x23 are each 0 in Formulas A-1-8 to A-1-11. When x17, x19, x21, and x23 are each an integer of 2 or greater, R_{c17}, R_{c19}, R_{c21}, and R_{c23} provided in plurality may each be the same, or at least one of R_{c17}, R_{c19}, R_{c21}, or R_{c23} provided in plurality may be different.

In Formulas A-1-8 to A-1-11, x18, x20, x22, and x24 are each independently an integer of 0 to 4. In Formulas A-1-8 to A-1-11, when x18, x20, x22, and x24 are each 0, the fused polycyclic compound of one or more embodiments may not be substituted with each of R_{c18}, R_{c20}, R_{c22}, and R_{c24}. In Formulas A-1-8 to A-1-11, an embodiment in which x18, x20, x22, and x24 are each 4, and R_{c18}, R_{c20}, R_{c22}, and R_{c24} are each hydrogen may be the same as an embodiment in which x18, x20, x22, and x24 are each 0 in Formulas A-1-8 to A-1-11. When x18, x20, x22, and x24 are each an integer of 2 or greater, R_{c18}, R_{c20}, R_{c22}, and R_{c24} provided in plurality may each be the same, or at least one of R_{c18}, R_{c20}, R_{c22}, or R_{c24} provided in plurality may be different.

In Formula A-1-11, x25 is an integer of 0 to 5. In Formula A-1-11, when x25 is 0, the fused polycyclic compound of one or more embodiments may not be substituted with R_{c25}. In Formula A-1-11, an embodiment in which x25 is 5 and R_{c25} is all hydrogen may be the same as an embodiment in which x25 is 0 in Formula A-1-11. When x25 is an integer of 2 or greater, R_{c25} provided in plurality may all be the same, or at least one of the plurality of R_{c25}'s may be different.

In one or more embodiments, the fused polycyclic compound represented by Formula 1 may be represented by any one selected from among Formulas 1-1-1 to 1-1-3.

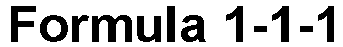

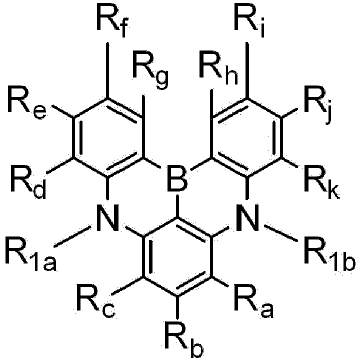

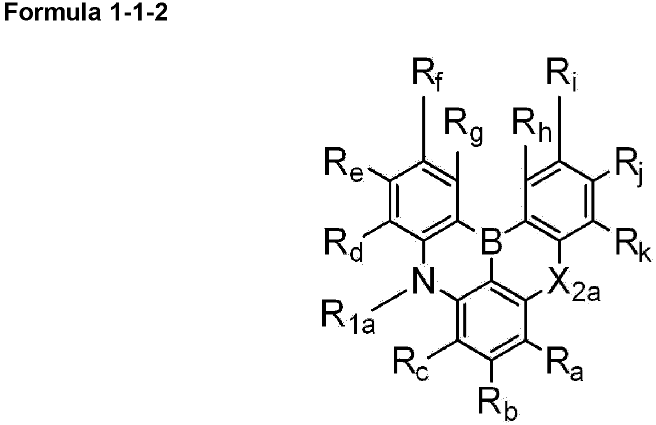

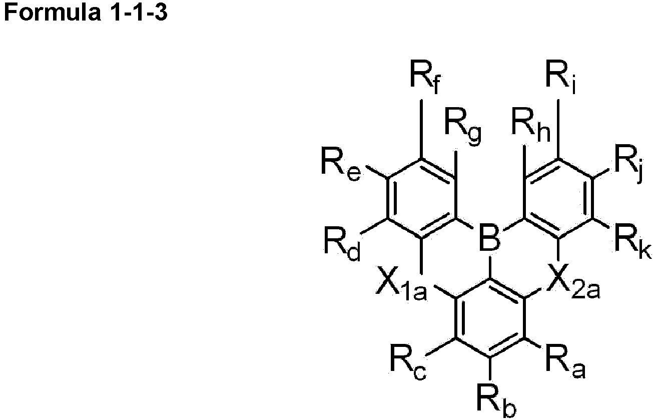

Formulas 1-1-1 to 1-1-3 indicate that A to C rings in Formula 1 are specified as substituted or unsubstituted benzene rings, and types (kinds) of X₁ and X₂ are specified. Formula 1-1-1 indicates an embodiment in which X₁ and X₂ are each represented by NR₁. Formula 1-1-2 indicates an embodiment in which X₁ is represented by NR₁ and X₂ is represented by O or S. Formula 1-1-3 indicates an embodiment in which X₁ and X₂ are each represented by O or S.

In Formulas 1-1-2 and 1-1-3, X₁ₐ and X₂ₐ are each independently O or S.

In Formula 1-1-3, a case (e.g., embodiments) in which both (e.g., each of or simultaneously) X₁ₐ and X₂ₐ are O is excluded. In some embodiments, in Formula 1-1-3, both (e.g., each of or simultaneously) X₁ₐ and X₂ₐ may be S. In some embodiments, any one of X₁ₐ and X₂ₐ may be O and the other may be S.

In Formulas 1-1-1 and 1-1-2, R₁ₐ and R_{1b} are each independently a substituted or unsubstituted aryl group having 6 to 30 ring-forming carbon atoms or a substituted or unsubstituted heteroaryl group having 2 to 30 ring-forming carbon atoms. In some embodiments, R₁ₐ and/or R_{1b} may independently be bonded to an adjacent group to form a ring. For example, in some embodiments, R₁ₐ and R_{1b} may each independently be a substituted or unsubstituted phenyl group, a substituted or unsubstituted biphenyl group, or a substituted or unsubstituted terphenyl group. In one or more embodiments, R₁ₐ and R_{1b} may be represented by any one selected from among Formulas A-1 to A-4. In one or more embodiments, R₁ₐ and R_{1b} may be represented by any one selected from among Formulas A-1-1 to A-1-11.

In Formulas 1-1-1 to 1-1-3, Rₐ to Rₖ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2. In some embodiments, one or more selected from Rₐ to Rₖ may each independently be bonded to an adjacent group to form a ring. For example, in some embodiments, Rₐ to Rₖ may each independently be hydrogen, deuterium, a substituted or unsubstituted t-butyl group, a substituted or unsubstituted phenyl group, a substituted or unsubstituted carbazole group, a substituted or unsubstituted arylboron group, a substituted or unsubstituted arylamine group, a substituted or unsubstituted aryloxy group, a substituted or unsubstituted arylthio group, or a substituent represented by Formula 2. In some embodiments, at least one adjacent pair selected from Rₐ to Rₖ may be bonded to form a fused ring. For example, in some embodiments, in Formulas 1-1-1 to 1-1-3, Rᵢ and Rⱼ may be bonded to form a fused ring. However, embodiments of the present disclosure are not limited thereto.

In Formulas 1-1-1 to 1-1-3, each of Rₐ to Rₖ, R₁ₐ, and R_{1b} is not bonded to an adjacent group to form a 5-membered heterocycle. In Formula 1-1-1, each of Rₐ to Rₖ, R₁ₐ, and R_{1b} is not bonded to an adjacent group to form a 5-membered heterocycle. In Formula 1-1-2, each of Rₐ to Rₖ, and R₁ₐ is not bonded to an adjacent group to form a 5-membered heterocycle. In Formula 1-1-3, each of Rₐ to Rₖ is not bonded to an adjacent group to form a 5-membered heterocycle.

In Formulas 1-1-1 to 1-1-3, at least one selected from among Rₐ to Rₖ is a substituent represented by Formula 2.

In Formula 1-1-1, an embodiment in which R₁ₐ and R_{1b} are each represented by Formula a is excluded.

In one or more embodiments, a substituent represented by Formula 2 may be represented by Formula B-1 or Formula B-2.

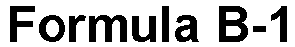

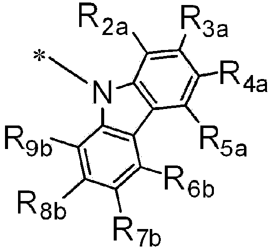

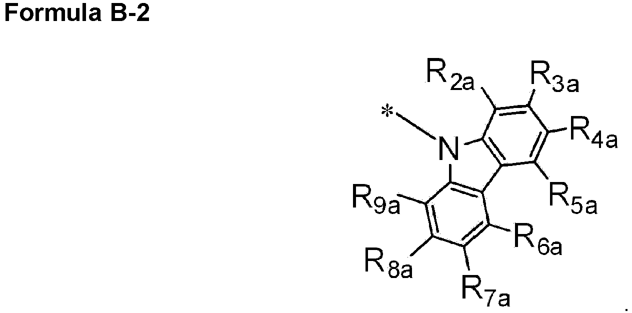

In Formulas B-1 and B-2, R₂ₐ to R₉ₐ are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, in some embodiments, R₂ₐ to R₉ₐ may each independently be hydrogen, deuterium, a nitro group, a substituted or unsubstituted methyl group, a substituted or unsubstituted t-butyl group, or a substituted or unsubstituted phenyl group.

In Formula B-1, R_{6b} to R_{9b} are each independently hydrogen, deuterium, a halogen, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, in some embodiments, R_{6b} to R_{9b} may each independently be hydrogen, deuterium, a substituted or unsubstituted methyl group, a substituted or unsubstituted t-butyl group, or a substituted or unsubstituted phenyl group. In Formula B-1, each of R_{6b} to R_{9b} may not be a cyano group.

In Formula B-1, at least one selected from among R₂ₐ to R₅ₐ is a cyano group.

In Formula B-2, at least one selected from among R₂ₐ to R₅ₐ and at least one selected from among R₆ₐ to R₉ₐ are each a cyano group.

In Formulas B-1 to B-2, -* is a site linked to Formula 1.

In one or more embodiments, a substituent represented by Formula 2 may be represented by any one selected from among Formulas C-1 to C-9.

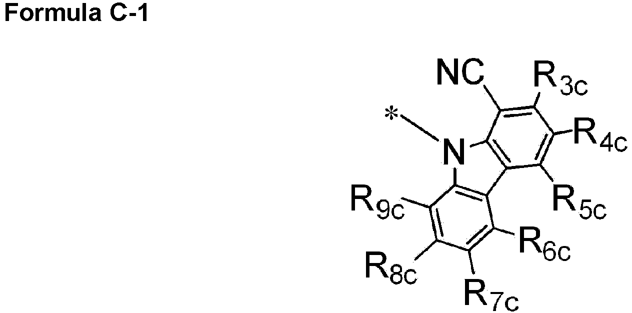

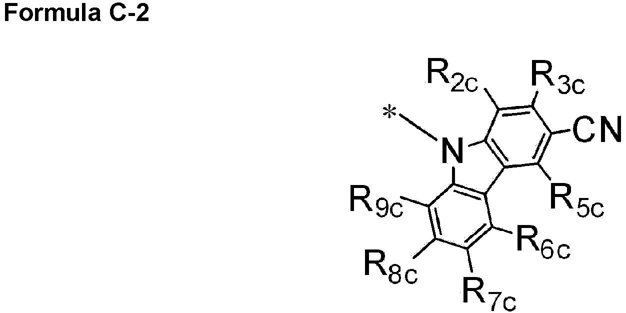

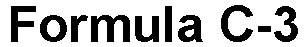

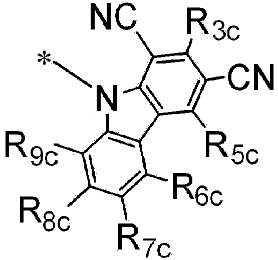

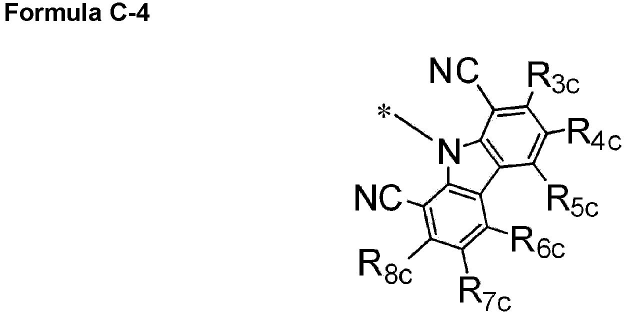

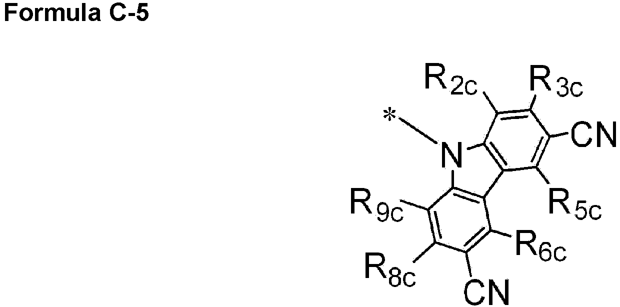

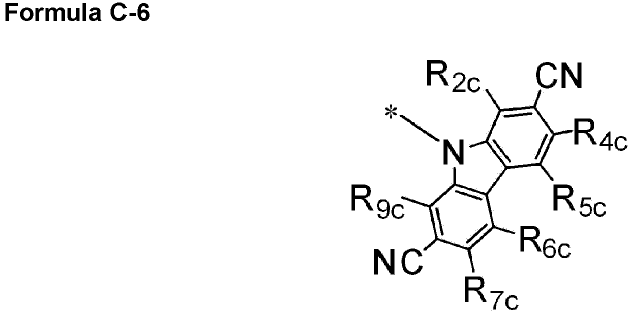

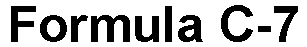

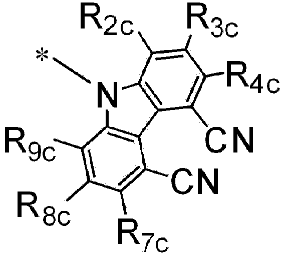

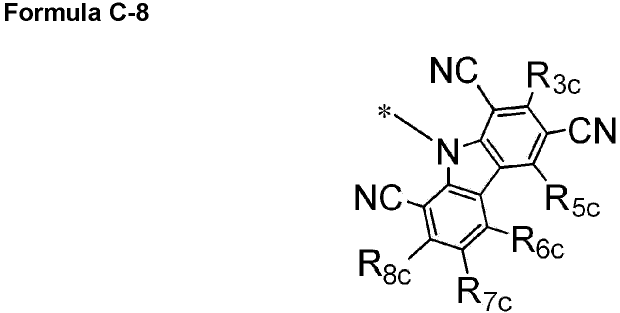

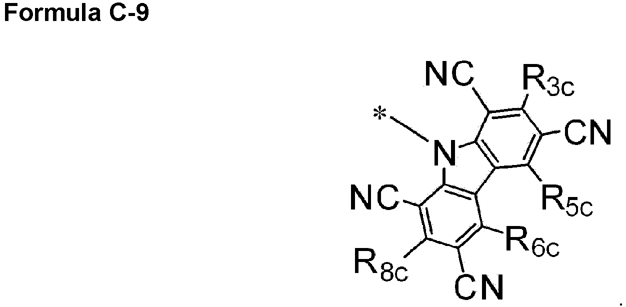

In Formulas C-1 to C-9, R_{2c} to R_{9c} are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, in some embodiments, R_{2c} to R_{9c} may each independently be hydrogen, deuterium, a substituted or unsubstituted methyl group, a substituted or unsubstituted t-butyl group, or a substituted or unsubstituted phenyl group.

In Formulas C-1 to C-9, -* is a site linked to Formula 1.

In one or more embodiments, the fused polycyclic compound represented by Formula 1 may be represented by any one selected from among Formulas 1-2-1 to 1-2-8.

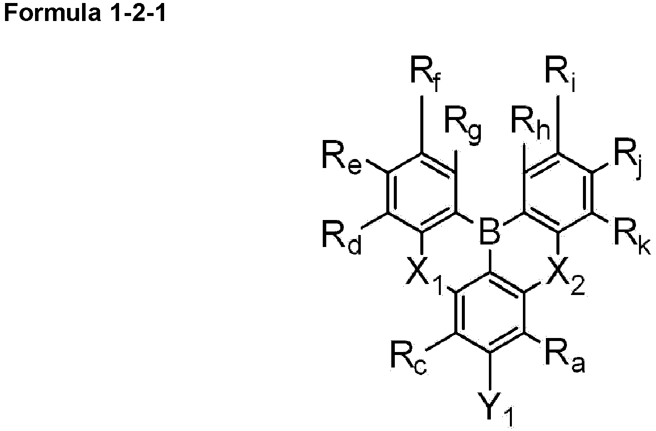

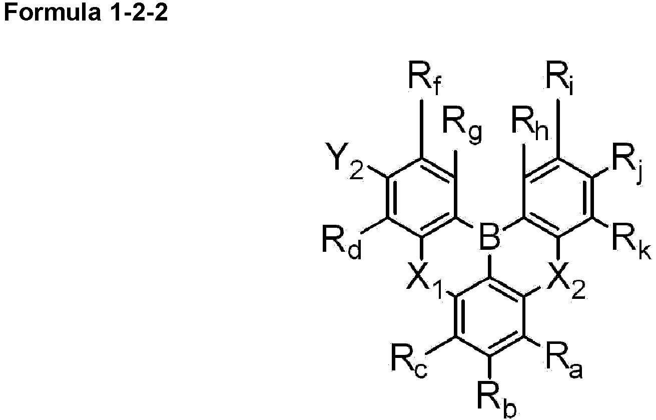

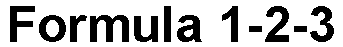

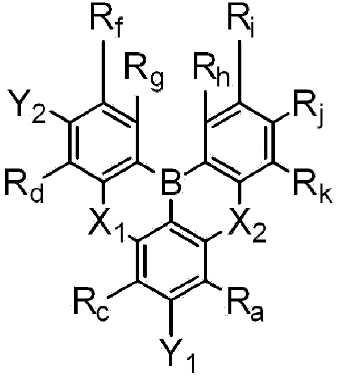

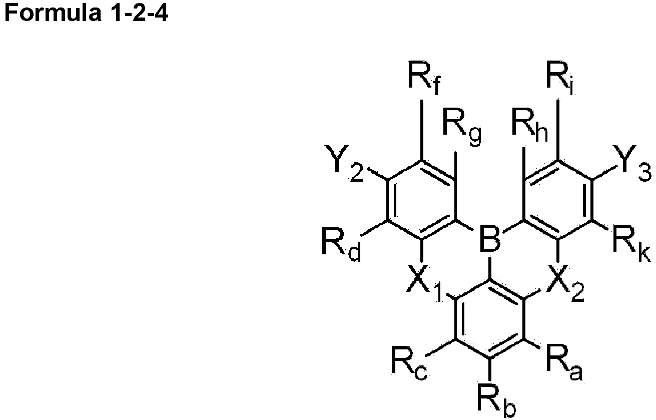

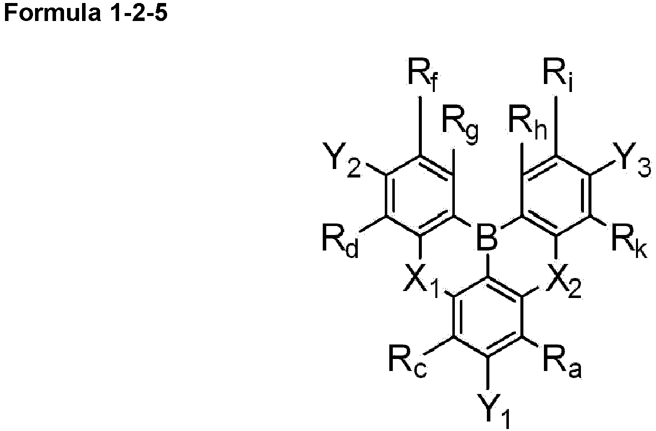

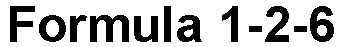

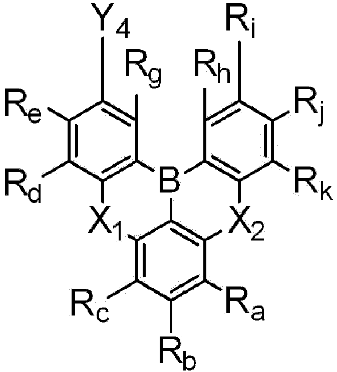

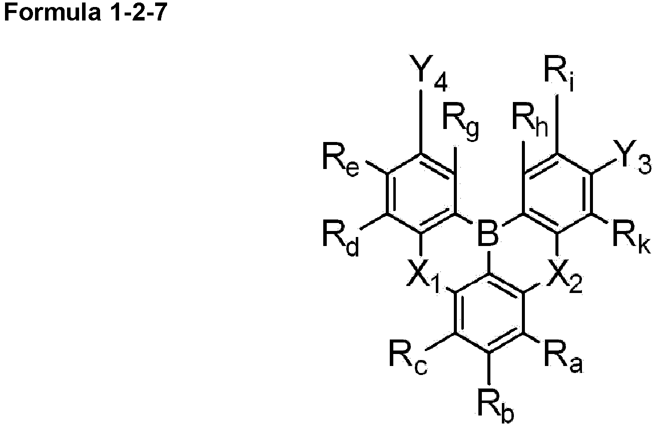

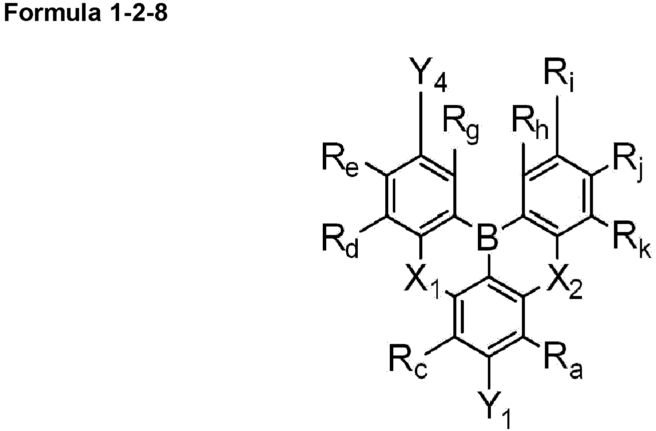

In Formulas 1-2-1 to 1-2-8, Rₐ to Rₖ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2. In some embodiments, one or more selected from Rₐ to Rₖ may each independently be bonded to an adjacent group to form a ring. For example, in some embodiments, Rₐ to Rₖ may each independently be hydrogen, deuterium, a substituted or unsubstituted t-butyl group, a substituted or unsubstituted phenyl group, a substituted or unsubstituted carbazole group, a substituted or unsubstituted arylboron group, a substituted or unsubstituted arylamine group, a substituted or unsubstituted aryloxy group, a substituted or unsubstituted arylthio group, or a substituent represented by Formula 2. In some embodiments, at least one adjacent pair selected from Rₐ to Rₖ may be bonded to form a fused ring.

In Formula 1-2-1 to Formula 1-2-8, Y₁ to Y₄ are represented by Formula 2.

In Formulas 1-2-1 to 1-2-8, the same descriptions as in Formula 1 are also applied to X₁ and X₂.

In one or more embodiments, the fused compound represented by Formula 1 may be represented by any one selected from among Formulas 1-1a to 1-1c.

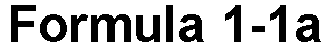

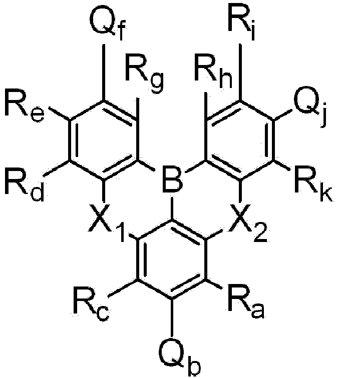

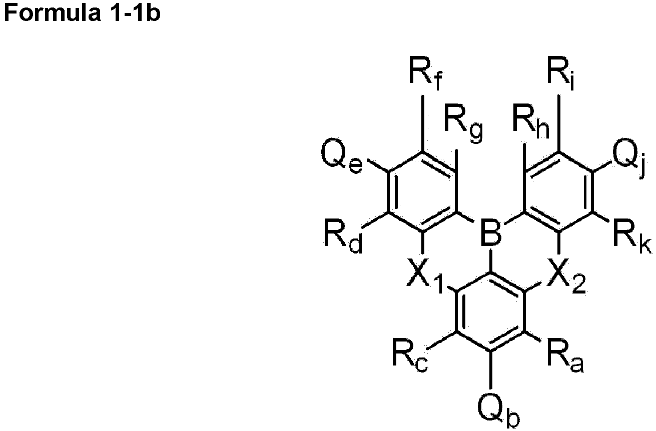

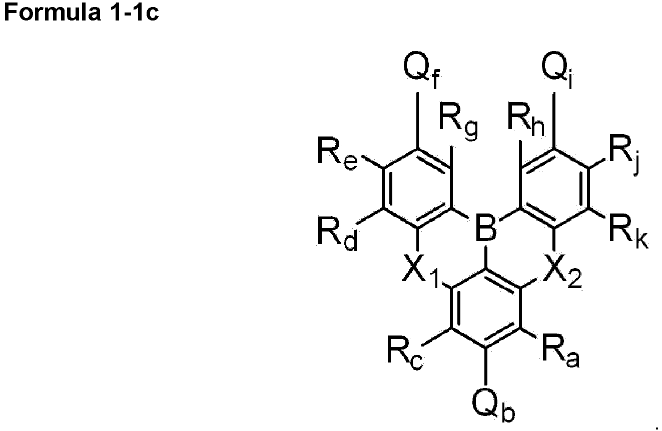

In Formulas 1-1a to 1-1c, Rₐ, R_{c} to Rₖ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2.

In Formulas 1-1a to 1-1c, Q_{b}, Qₑ, Q_{f}, Qᵢ, and Qⱼ are each independently hydrogen, deuterium, or a substituent represented by Formula 2, or are represented by any one selected from among Formulas D-1 to D-3.

In Formulas 1-1a to 1-1c, at least one of Q_{b}, Qₑ, Q_{f}, Qᵢ, and Qⱼ may be a substituent represented by Formula 2, and at least one selected from the others may be represented by any one selected from among Formulas D-1 to D-3.

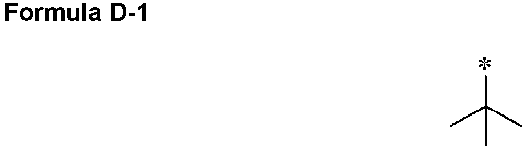

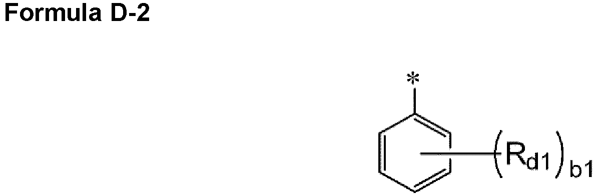

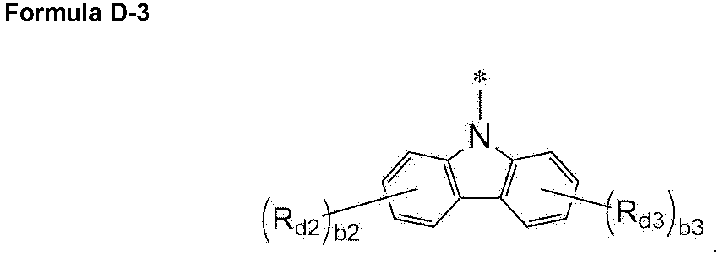

In Formulas D-2 and D-3, R_{d1} to R_{d3} are each independently hydrogen, deuterium, a halogen, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, in some embodiments, R_{d1} to R_{d3} may each independently be hydrogen, deuterium, a substituted or unsubstituted t-butyl group, or a substituted or unsubstituted phenyl group.

In Formula D-2, b1 is an integer of 0 to 5. In Formula D-2, when b1 is 0, the fused polycyclic compound of one or more embodiments may not be substituted with R_{d1}. In Formula D-1, an embodiment in which b1 is 5 and R_{d1} is all hydrogen may be the same as an embodiment in which b1 is 0 in Formula D-2. When b1 is an integer of 2 or greater, R_{d1} provided in plurality may all be the same, or at least one of the plurality of R_{q1}'s may be different.

In Formula D-3, b2 and b3 are each independently an integer of 0 to 4. In Formula D-3, when b2 and b3 are each 0, the fused polycyclic compound of one or more embodiments may not be substituted with each of R_{d2} and R_{d3}. In Formula D-3, an embodiment in which b2 and b3 are each 4, and R_{d2} and R_{d3} are each hydrogen may be the same as an embodiment in which b2 and b3 are each 0 in Formula D-3. When b2 and b3 are each an integer of 2 or greater, R_{d2} and R_{d3} provided in plurality may each be the same, or at least one of R_{d2} or R_{d3} provided in plurality may be different.

In Formulas D-1 to D-3, -* is a site linked to Formulas 1-1a to 1-1c above.

In Formulas 1-1a to 1-1c, the same descriptions as in Formula 1 are also applied to X₁ and X₂.

In one or more embodiments, the fused polycyclic compound represented by Formula 1 may be represented by any one selected from among Formulas 1-3-1 to 1-3-3.

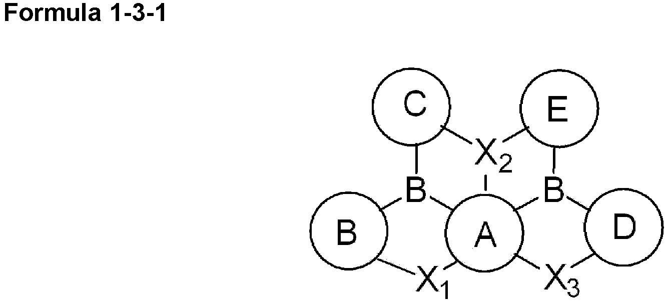

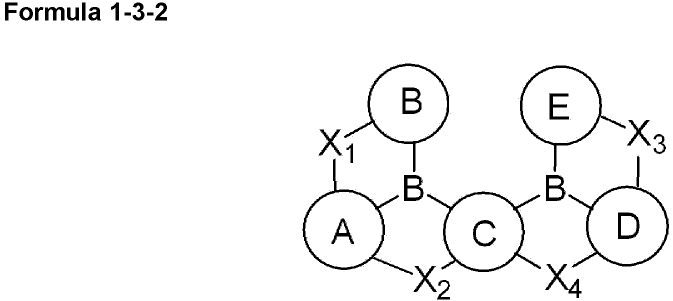

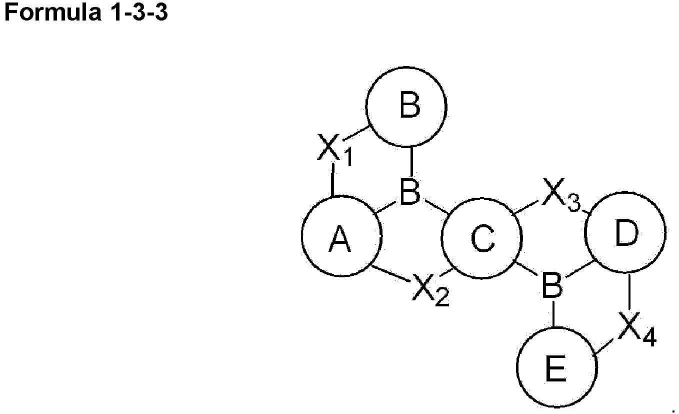

Formulas 1-3-1 to 1-3-3 each show an embodiment in which D ring and E ring are additionally fused through an additional boron atom and an additional hetero atom in the fused ring structure of Formula 1. In present disclosure, in Formulas 1-3-1 to 1-3-3, D ring may correspond to the fourth aromatic ring described above, and E ring may correspond to the fifth aromatic ring described above.

In Formulas 1-3-1 to 1-3-3, X₃ and X₄ are each independently O, S, or NR₁₀.

In Formulas 1-3-1 to 1-3-3, R₁₀ is a substituted or unsubstituted aryl group having 6 to 30 ring-forming carbon atoms or a substituted or unsubstituted heteroaryl group having 2 to 30 ring-forming carbon atoms. For example, in some embodiments, R₁₀ may be a substituted or unsubstituted phenyl group, a substituted or unsubstituted biphenyl group, or a substituted or unsubstituted terphenyl group. In some embodiments, R₁₀ may be bonded to an adjacent group to form a ring.

In Formulas 1-3-1 to 1-3-3, D ring and E ring are each independently a substituted or unsubstituted monocyclic aromatic hydrocarbon ring having 6 to 30 ring-forming carbon atoms or a substituted or unsubstituted monocyclic aromatic heterocycle having 2 to 30 ring-forming carbon atoms. In one or more embodiments, D ring and E ring may each independently be a substituted or unsubstituted 6-membered aromatic hydrocarbon ring or a substituted or unsubstituted 6-membered aromatic heterocycle. For example, in some embodiments, D ring and E ring may each independently be a substituted or unsubstituted benzene ring. In some embodiments, a substituent substituted on each or any one of D ring and E ring may be bonded to an adjacent group to form a ring. For example, in some embodiments, a substituent substituted on each or any one of D ring and E ring may be bonded to an adjacent ring or an adjacent substituent to form a fused ring.

Formulas 1-3-1 to 1-3-3 each include at least one substituent represented by Formula 2. Formulas 1-3-1 to 1-3-3 may each be linked to at least one substituent represented by Formula 2. For example, in one or more embodiments, at least one selected from A to E rings may be substituted with a substituent represented by Formula 2.

In Formulas 1-3-1 to 1-3-3, the same descriptions as in Formula 1 are also applied to X₁, X₂, and A to C rings.

In one or more embodiments, the fused compound represented by Formula 1 may be represented by any one selected from among Formulas 1-2a to 1-2g.

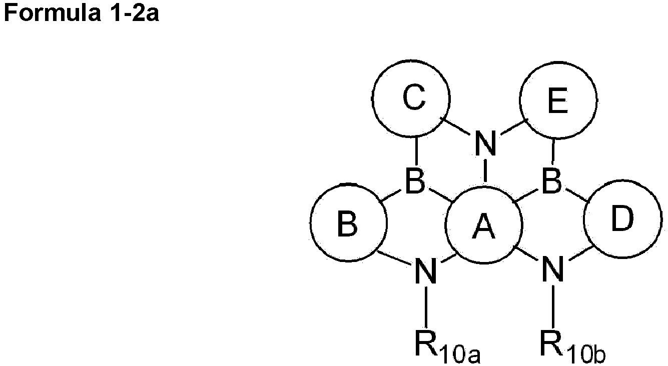

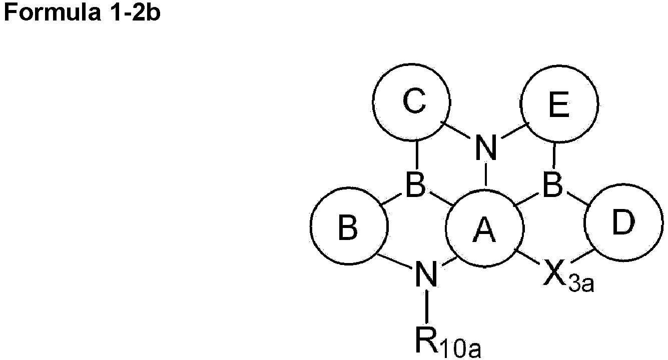

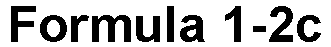

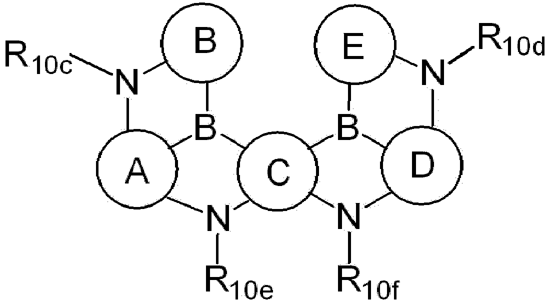

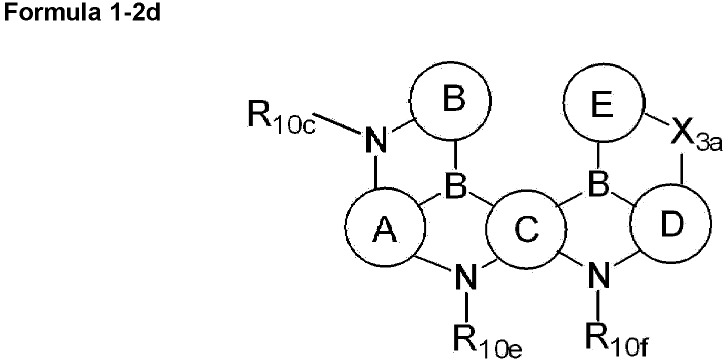

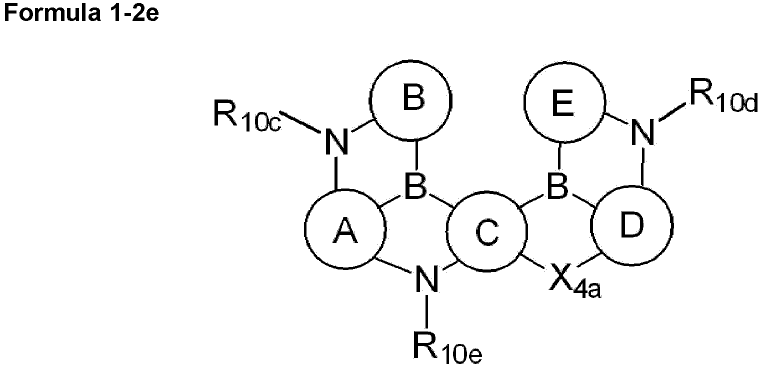

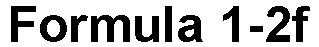

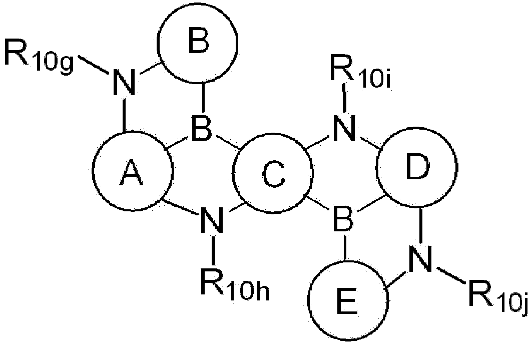

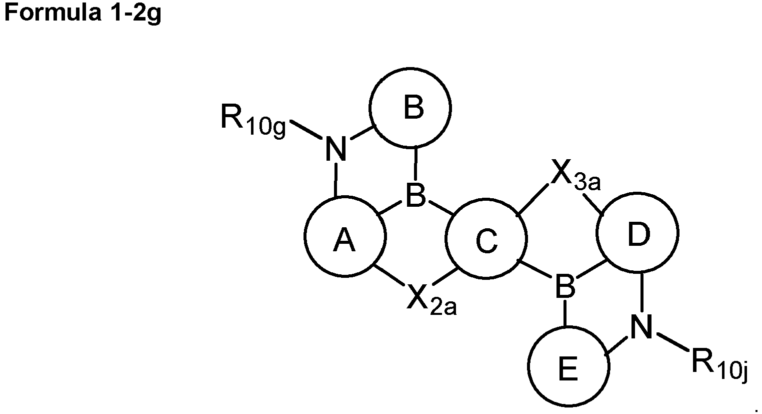

In Formulas 1-2a to 1-2g, R₁₀ₐ to R₁₀ⱼ are each independently a substituted or unsubstituted aryl group having 6 to 30 ring-forming carbon atoms or a substituted or unsubstituted heteroaryl group having 2 to 30 ring-forming carbon atoms. For example, in some embodiments, R₁₀ₐ to R₁₀ⱼ may each independently be a substituted or unsubstituted phenyl group, a substituted or unsubstituted biphenyl group, or a substituted or unsubstituted terphenyl group.

In Formulas 1-2b, 1-2d, 1-2e, and 1-2g, X₂ₐ to X₄ₐ are each independently O or S.

In Formulas 1-2a to 1-2g, the same descriptions as in Formula 1 are also applied to A to C rings.

In Formulas 1-2a to 1-2g, the same descriptions as in Formulas 1-3-1 to 1-3-3 above are also applied to D and E rings.

In one or more embodiments, the fused polycyclic compound represented by Formula 1 may be represented by any one selected from among Formulas 1-4-1 to 1-4-3.

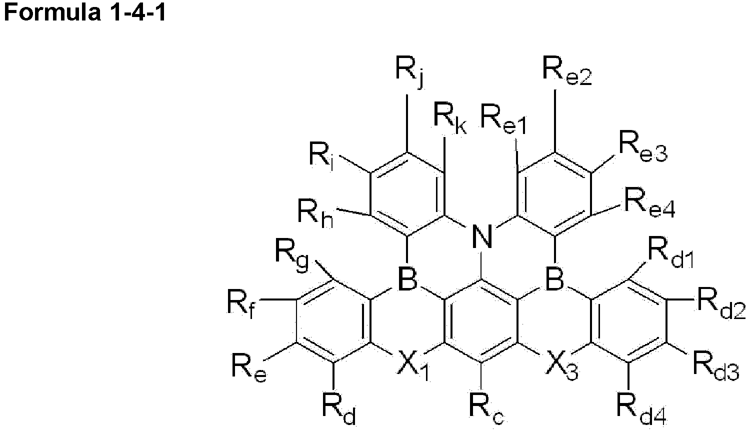

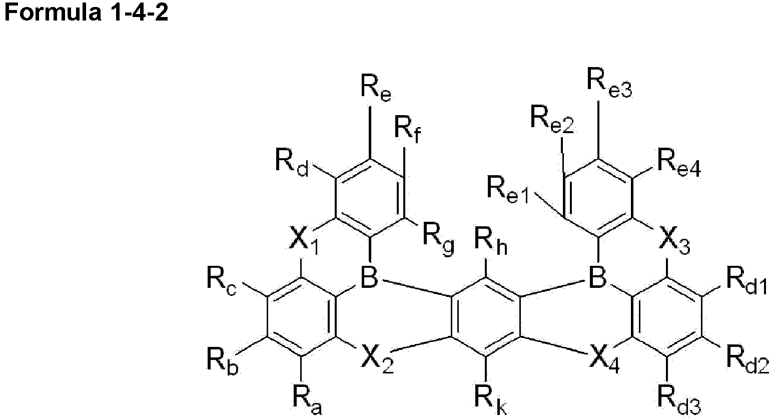

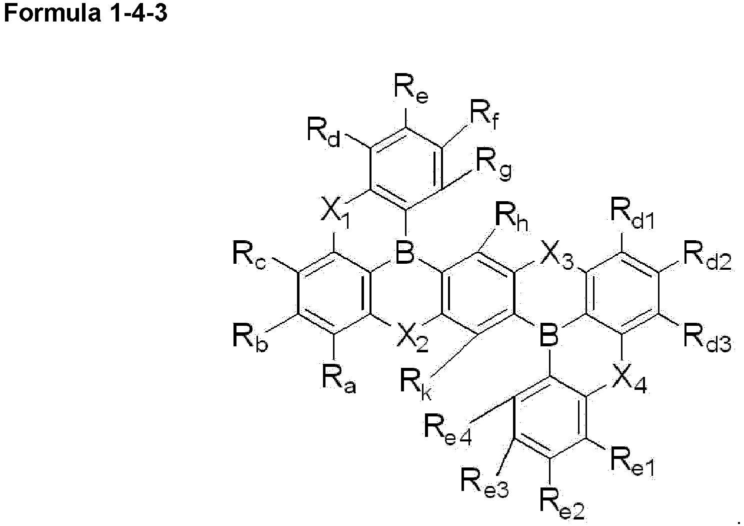

In Formulas 1-4-1 to 1-4-3, X₃ and X₄ are each independently O, S, or NR₁₀.

In Formulas 1-4-1 to 1-4-3, R₁₀ is a substituted or unsubstituted aryl group having 6 to 30 ring-forming carbon atoms or a substituted or unsubstituted heteroaryl group having 2 to 30 ring-forming carbon atoms. For example, in some embodiments, R₁₀ may be a substituted or unsubstituted phenyl group, a substituted or unsubstituted biphenyl group, or a substituted or unsubstituted terphenyl group. In some embodiments, R₁₀ may be bonded to an adjacent group to form a ring.

In Formulas 1-4-1 to 1-4-3, Rₐ to Rₖ, Rₐ₁ to R_{d4}, and Rₑ₁ to Rₑ₄ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2 above. In one or more embodiments, in Formulas 1-4-1 to 1-4-3, Rₐ to Rₖ, Rₐ₁ to R_{d4}, and Rₑ₁ to Rₑ₄ may each independently be hydrogen, deuterium, a substituted or unsubstituted t-butyl group, a substituted or unsubstituted diphenylamine group, a substituted or unsubstituted phenyl group, or a substituted or unsubstituted carbazole group. In some embodiments, one or more selected from Rₐ to Rₖ, Rₐ₁ to R_{d4}, and Rₑ₁ to Rₑ₄ may each independently be bonded to an adjacent group to form a ring.

In Formula 1-4-1, at least one selected from among R_{c} to Rₖ, R_{d1} to R_{d4}, and Rₑ₁ to Rₑ₄ is represented by Formula 2.

In Formula 1-4-2, at least one selected from among Rₐ to Rₕ, Rₖ, R_{d1} to R_{d3}, and Rₑ₁ to Rₑ₄ is represented by Formula 2.

In Formula 1-4-3, at least one selected from among Rₐ to Rₕ, Rₖ, R_{d1} to R_{d3}, and Rₑ₁ to Rₑ₄ is represented by Formula 2.

In Formulas 1-4-1 to 1-4-3, the same descriptions as in Formula 1 are also applied to X₁ and X₂.

In one or more embodiments, the fused polycyclic compound represented by Formula 1 may be represented by any one selected from among Formulas 1-5-1 to 1-5-6.

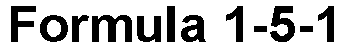

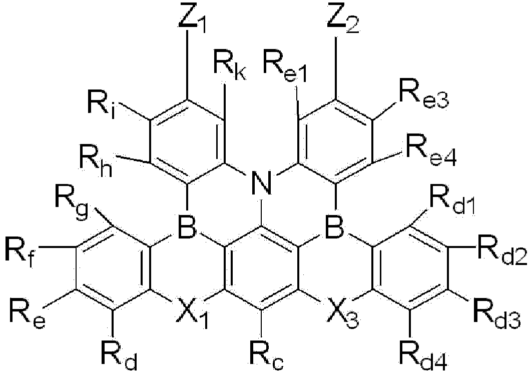

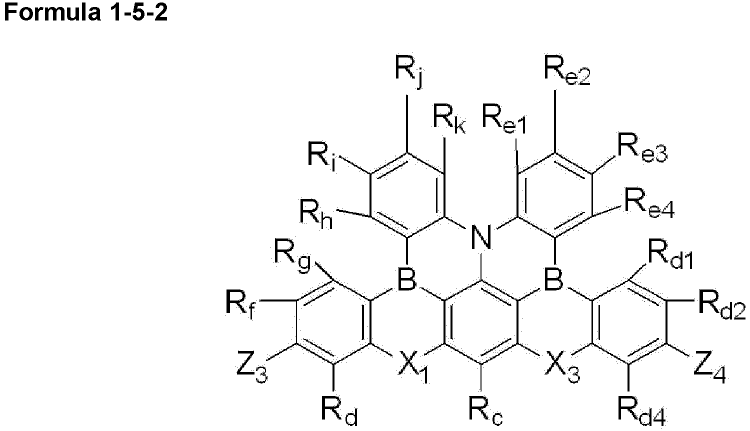

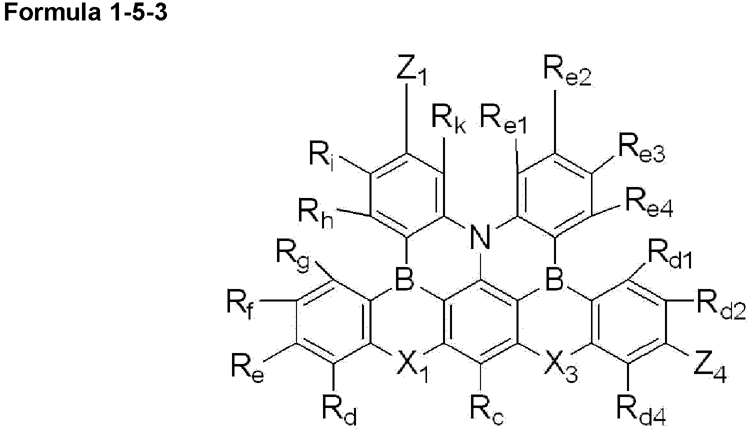

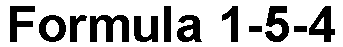

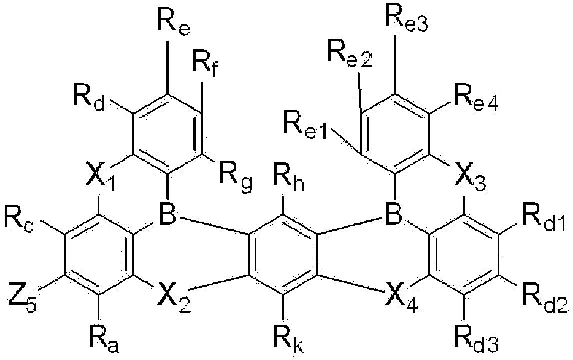

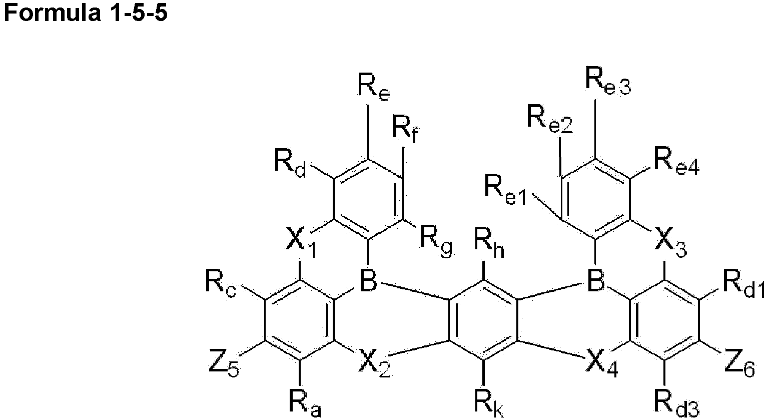

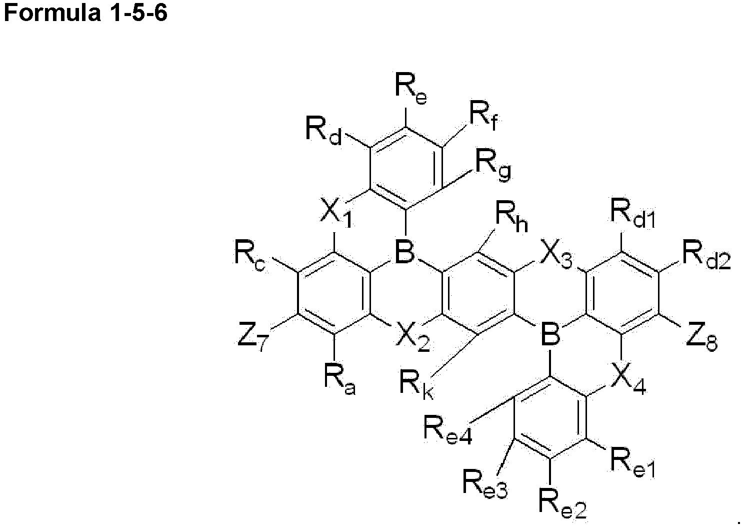

In Formulas 1-5-1 to 1-5-6, X₃ and X₄ are each independently O, S, or NR₁₀.

In Formulas 1-5-1 to 1-5-6, R₁₀ is a substituted or unsubstituted aryl group having 6 to 30 ring-forming carbon atoms or a substituted or unsubstituted heteroaryl group having 2 to 30 ring-forming carbon atoms. For example, in some embodiments, R₁₀ may be a substituted or unsubstituted phenyl group, a substituted or unsubstituted biphenyl group, or a substituted or unsubstituted terphenyl group. In some embodiments, R₁₀ may be bonded to an adjacent group to form a ring.

In Formulas 1-5-1 to 1-5-6, Rₐ, R_{c} to Rₖ, R_{d1} to R_{d4}, and Rₑ₁ to Rₑ₄ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2. For example, in some embodiments, Rₐ, R_{c} to Rₖ, R_{d1} to R_{d4}, and Rₑ₁ to Rₑ₄ may each independently be hydrogen, deuterium, a substituted or unsubstituted t-butyl group, a substituted or unsubstituted diphenylamine group, a substituted or unsubstituted phenyl group, or a substituted or unsubstituted carbazole group. In some embodiments, one or more selected from Rₐ, R_{c} to Rₖ, R_{d1} to R_{d4}, and Rₑ₁ to Rₑ₄ may each independently be bonded to an adjacent group to form a ring.

In Formulas 1-5-1 to 1-5-6, Z₁ to Z₈ are each represented by Formula 2. In Formula 1-5-1, Z₁ and Z₂ are each represented by Formula 2. In Formula 1-5-2, Z₃ and Z₄ are each represented by Formula 2. In Formula 1-5-3, Z₁ and Z₄ are each represented by Formula 2. In Formula 1-5-4, Z₅ is represented by Formula 2. In Formula 1-5-5, Z₅ and Z₆ are each represented by Formula 2. In Formula 1-5-6, Z₇ and Z₈ are each represented by Formula 2.

In Formulas 1-5-1 to 1-5-6, the same descriptions as in Formula 1 are also applied to X₁ and X₂.

In one or more embodiments, the fused polycyclic compound represented by Formula 1 may be represented by any one selected from among Formulas 1-6-1 to 1-6-7.

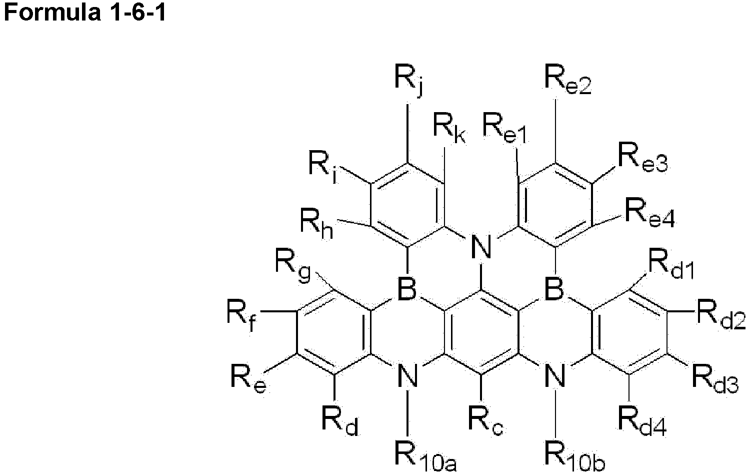

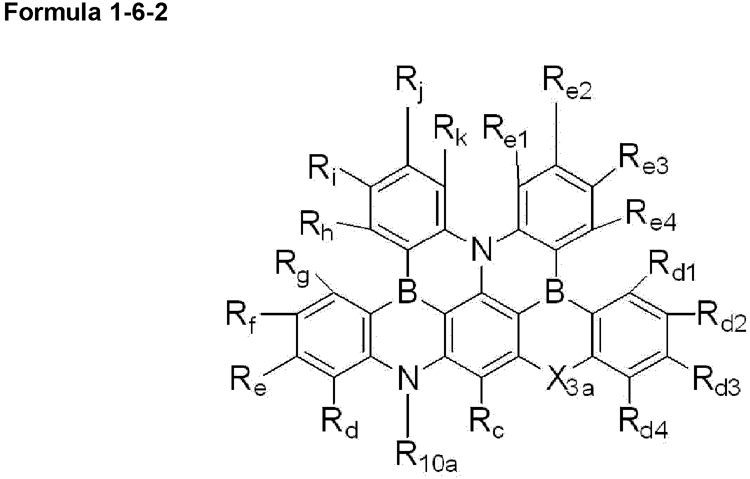

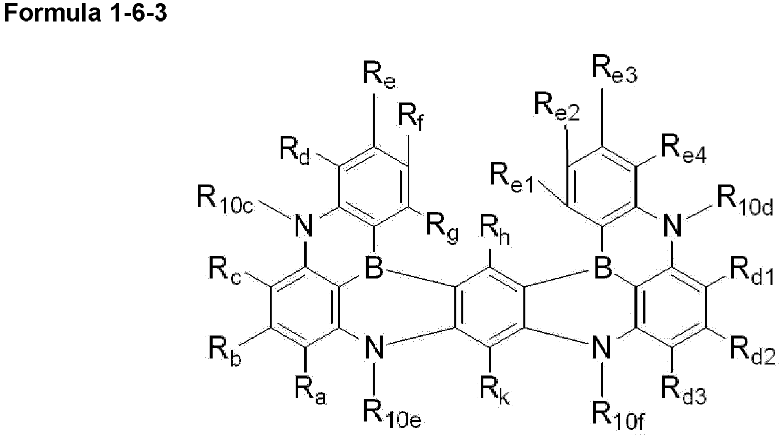

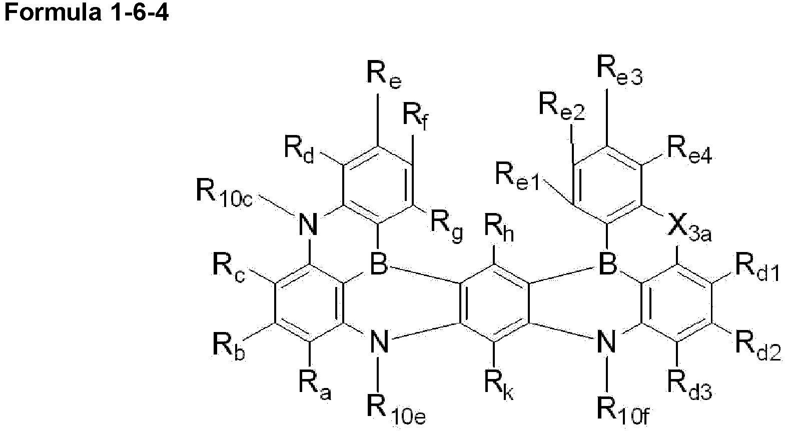

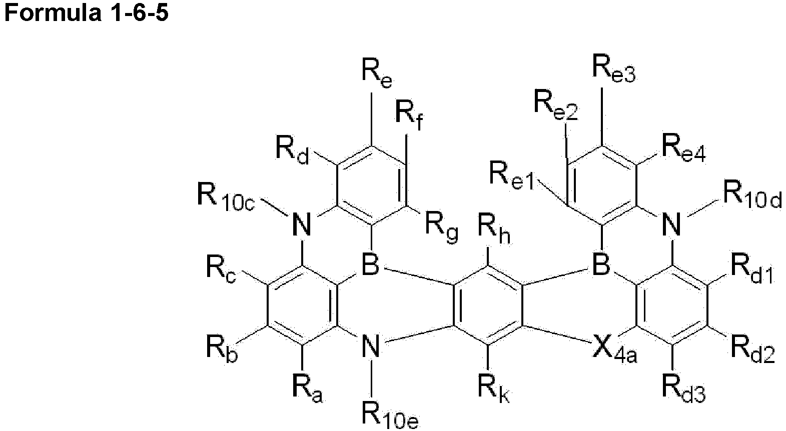

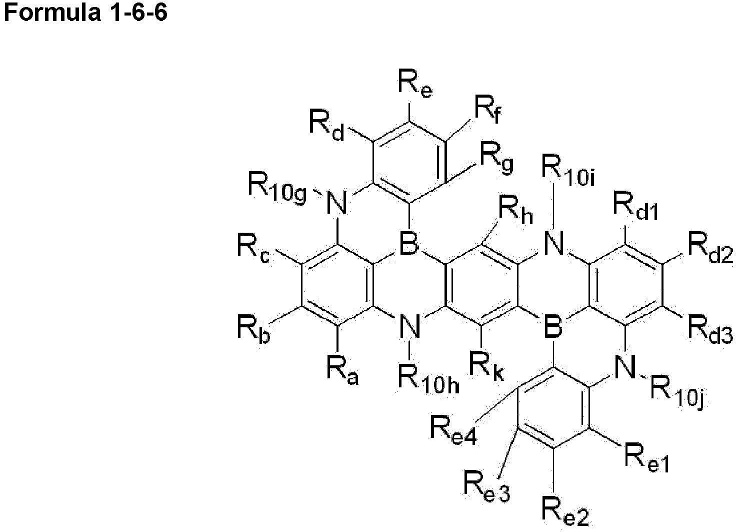

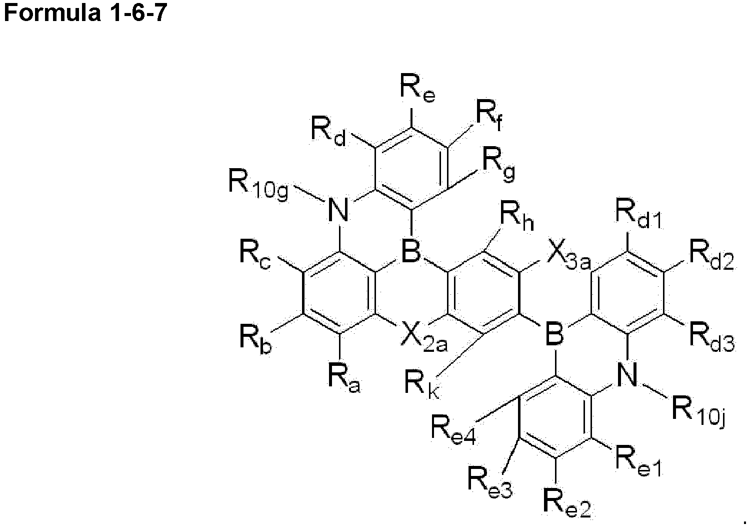

In Formulas 1-6-1 to 1-6-7, R₁₀ₐ to R₁₀ⱼ are each independently a substituted or unsubstituted aryl group having 6 to 30 ring-forming carbon atoms or a substituted or unsubstituted heteroaryl group having 2 to 30 ring-forming carbon atoms. For example, in some embodiments, R₁₀ₐ to R₁₀ⱼ may each independently be a substituted or unsubstituted phenyl group, a substituted or unsubstituted biphenyl group, or a substituted or unsubstituted terphenyl group.

In Formulas 1-6-2, 1-6-4, 1-6-5, and 1-6-7, X₂ₐ to X₄ₐ are each independently O or S.

In Formulas 1-6-1 to 1-6-7, Rₐ to Rₖ, R_{d1} to R_{d4}, and Rₑ₁ to Rₑ₄ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2. In some embodiments, in Formulas 1-6-1 to 1-6-7, Rₐ to Rₖ, R_{d1} to R_{d4}, and Rₑ₁ to Rₑ₄ may each independently be hydrogen, deuterium, a substituted or unsubstituted t-butyl group, a substituted or unsubstituted diphenylamine group, a substituted or unsubstituted phenyl group, or a substituted or unsubstituted carbazole group. In some embodiments, one or more selected from among Rₐ to Rₖ, R_{d1} to R_{d4}, and Rₑ₁ to Rₑ₄ may each independently be bonded to an adjacent group to form a ring.

In Formulas 1-6-1 and 1-6-2, at least one selected from among R_{c} to Rₖ, R_{d1} to R_{d4}, and Rₑ₁ to Rₑ₄ is represented by Formula 2.

In Formulas 1-6-3 to 1-6-5, at least one selected from among Rₐ to Rₕ, Rₖ, R_{d1} to R_{d3}, and Rₑ₁ to Rₑ₄ is represented by Formula 2.

In Formulas 1-6-6 and 1-6-7, at least one selected from among Rₐ to Rₕ, Rₖ, R_{d1} to R_{d3}, and Rₑ₁ to Rₑ₄ is represented by Formula 2.

In one or more embodiments, the fused polycyclic compound of one or more embodiments represented by Formula 1 may include at least one deuterium atom as a substituent.

The fused polycyclic compound of one or more embodiments may be any one of compounds shown in Compound Group 1. The light emitting element ED of one or more embodiments may include at least one fused polycyclic compound selected from among the compounds shown in Compound Group 1 in the emission layer EML.

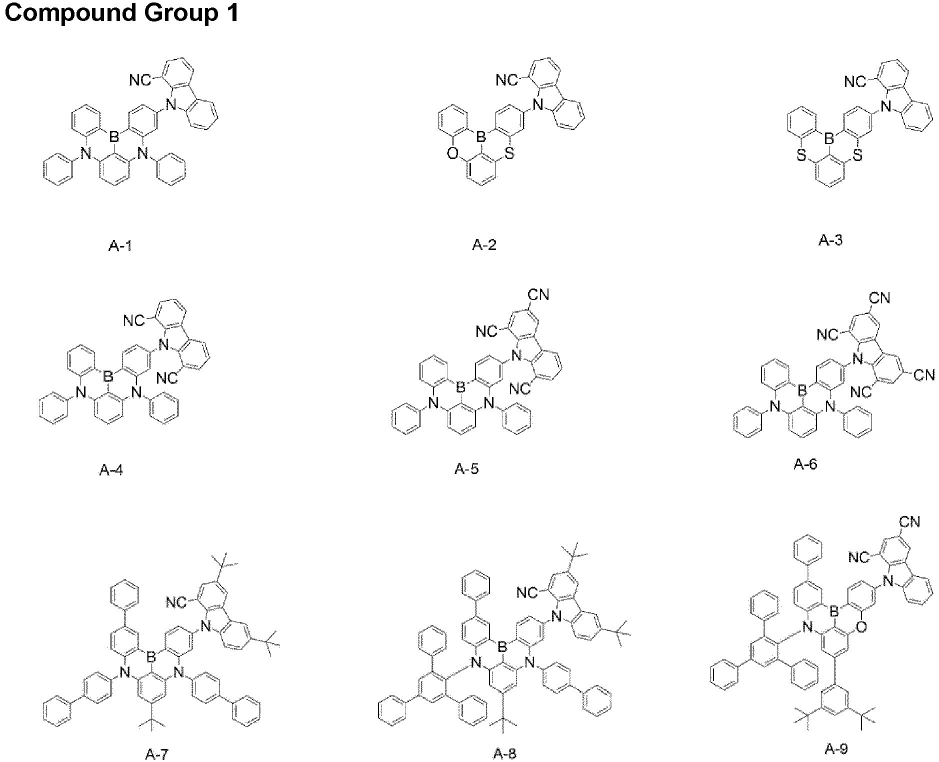

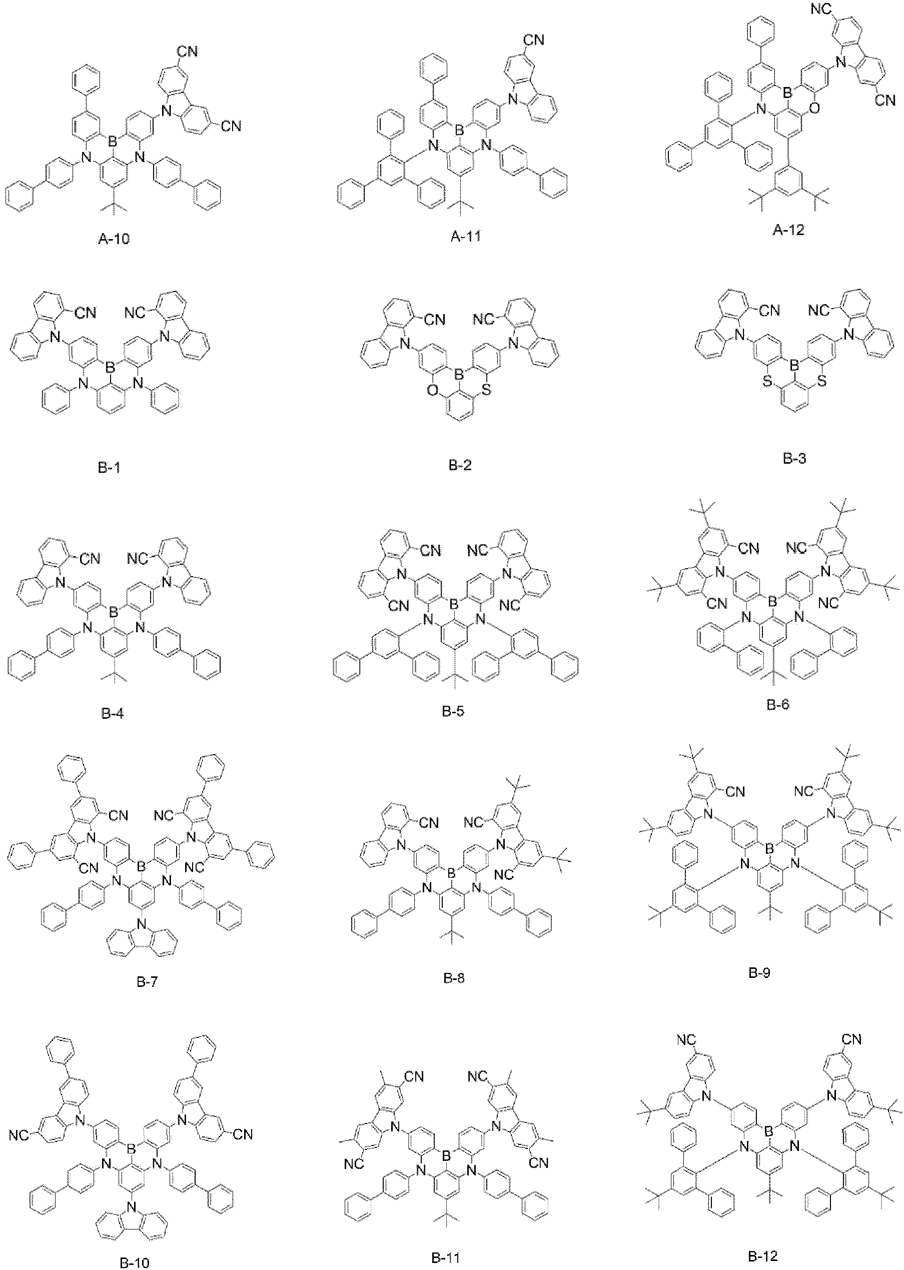

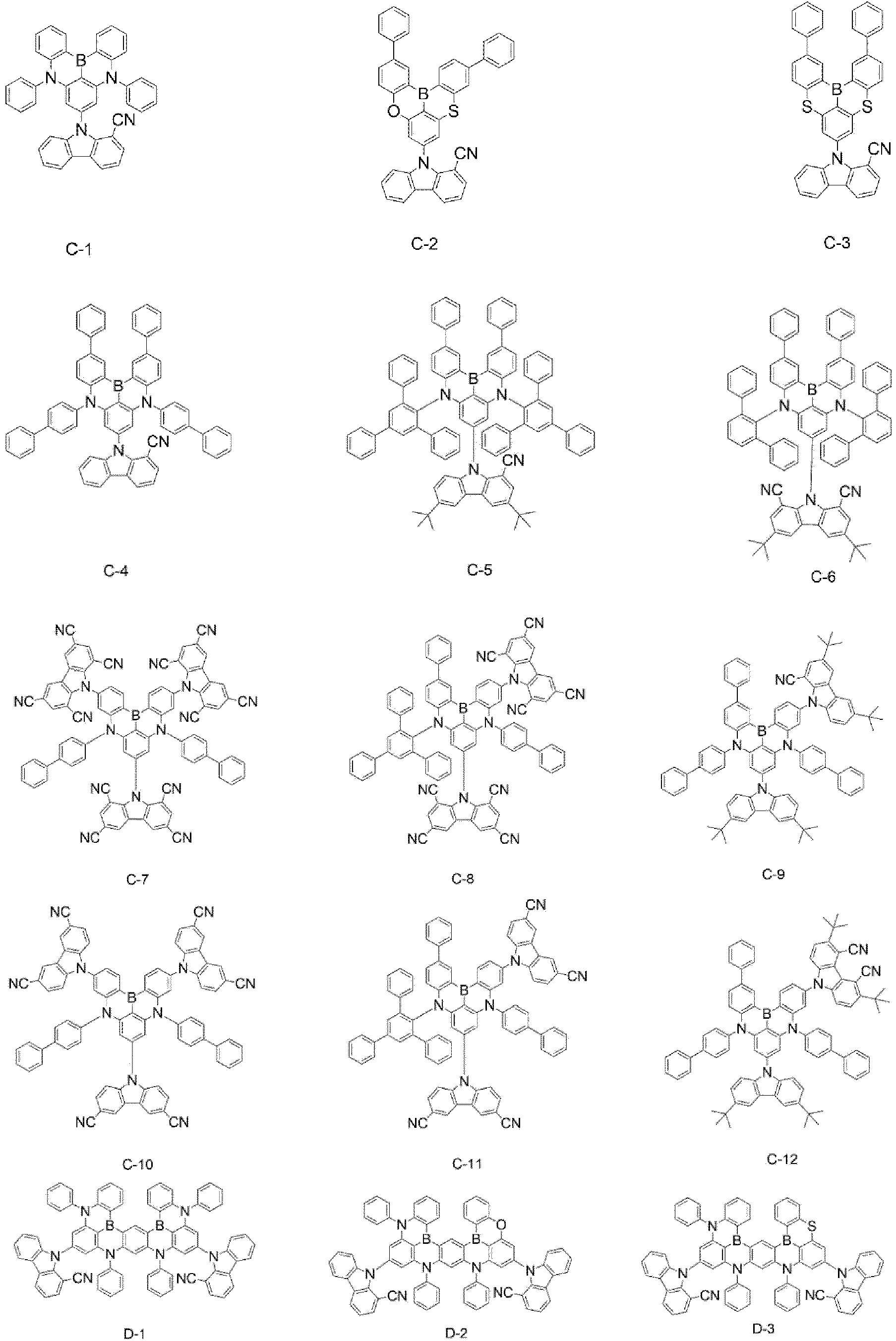

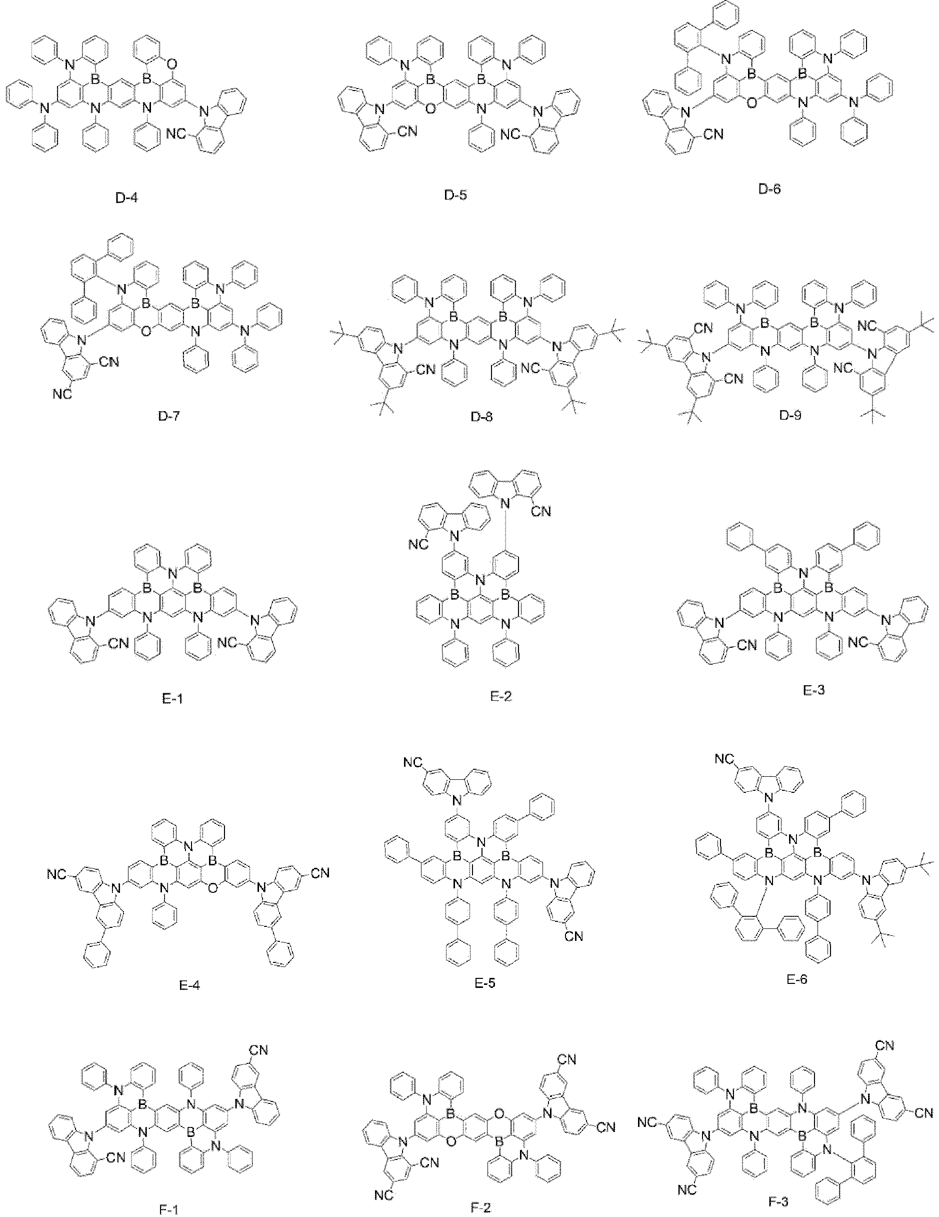

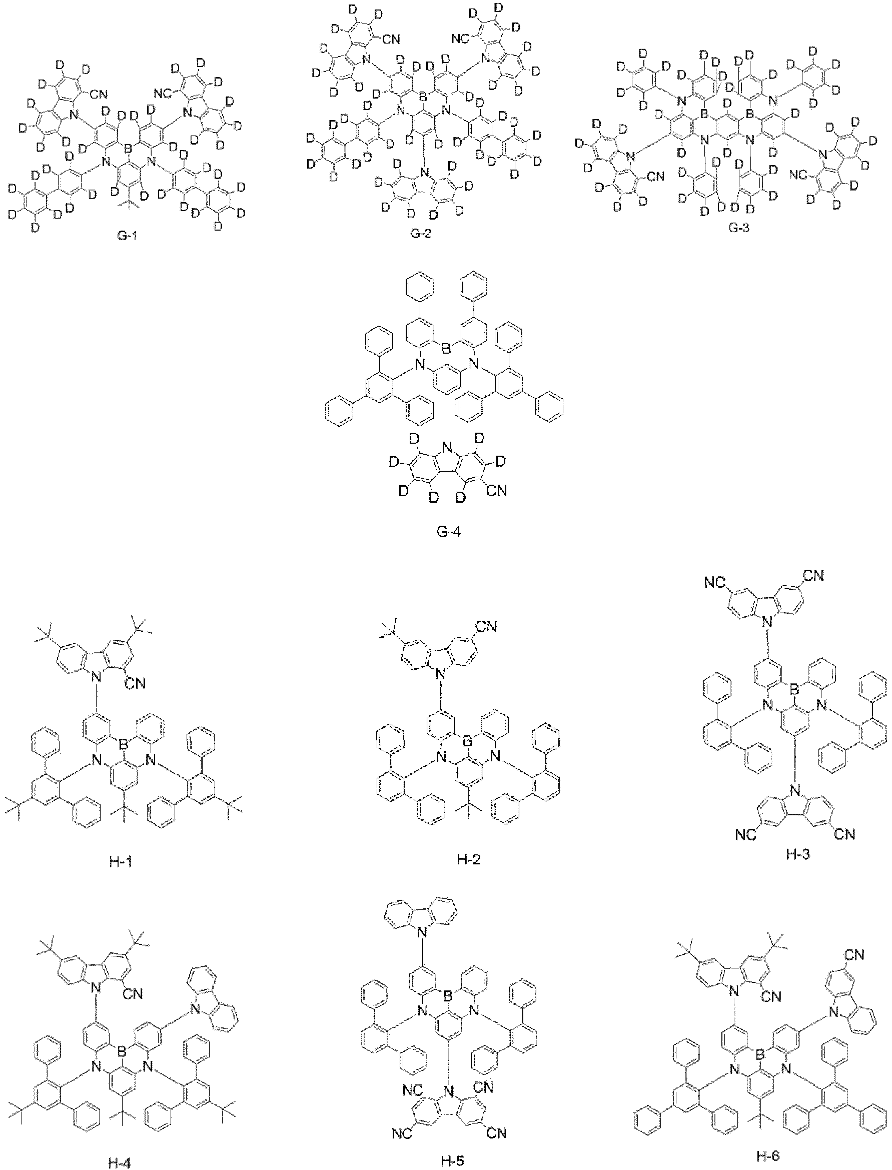

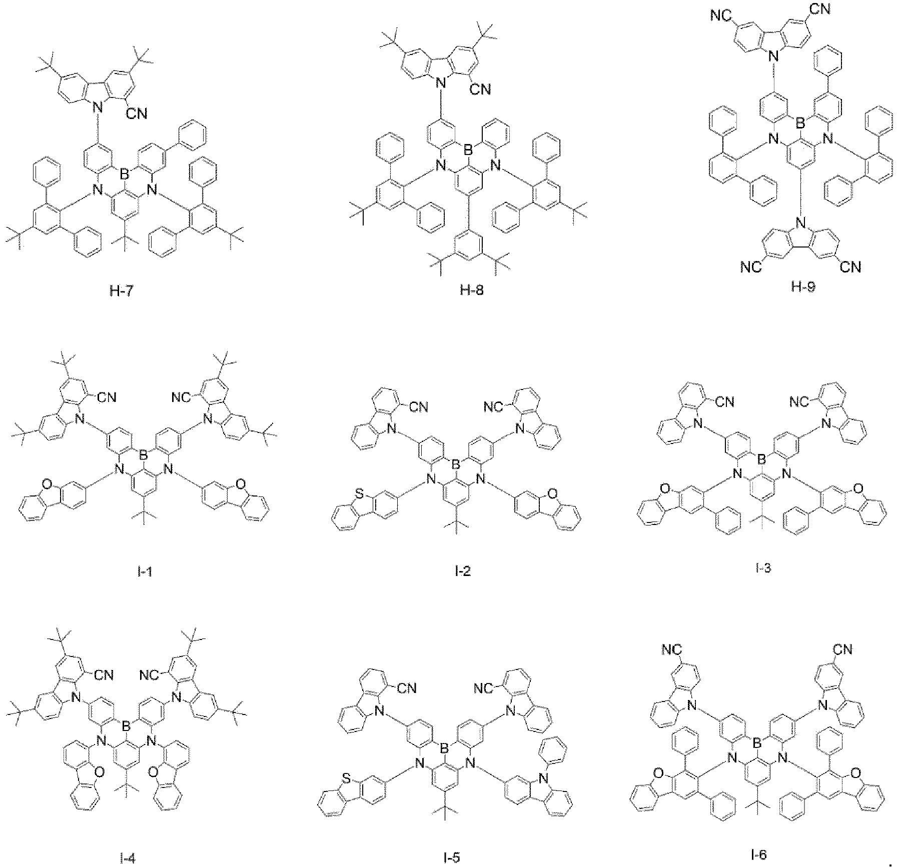

In the example compounds presented in Compound Group 1, "D" indicates deuterium.

The fused polycyclic compound represented by Formula 1 according to one or more embodiments has a structure in which the first substituent is introduced, and may thus achieve high light emitting efficiency and long lifespan.

The fused polycyclic compound of one or more embodiments represented by Formula 1 may include a structure in which a plurality of aromatic rings are fused to at least one boron atom and at least two hetero atoms, and may have a structure in which the first substituent is linked to at least one of the plurality of aromatic rings. The first substituent may include a structure in which a carbazole moiety and at least one cyano group linked to the carbazole moiety are connected. The carbazole moiety may include a structure in which a first benzene ring and a second benzene ring are fused through a nitrogen atom. In one or more embodiments, a cyano group may be linked to at least one selected from the carbon atoms constituting the first and second benzene rings.

The fused polycyclic compound of one or more embodiments has a structure in which the first substituent is introduced into a fused ring core and may thus exhibit improved light emitting efficiency and element service life. A carbazole group may be introduced to regulate physical properties such as an emission wavelength of a fused polycyclic compound around a boron atom, but the introduction causes the highest occupied molecular orbital (HOMO) energy level of a compound to be shallow. When the HOMO energy level of a dopant is shallow, hole trapping in an emission layer may take place to reduce element efficiency, and also to cause formation of excitons in the dopant through a trap-assisted recombination mechanism in which holes and electrons recombine directly in the dopant. Accumulation of high-energy excitons formed through the trap-assisted recombination may contribute to reducing element service life. According to one or more embodiments of the present disclosure, the fused polycyclic compound of one or more embodiments introduces a carbazole group including a cyano group, which is an electron withdrawing group, as a substituent to have a deep HOMO energy level, and may thus prevent or reduce the trap-assisted recombination, leading to a further improvement in element service life of a light emitting element when utilized as a dopant material of an emission layer. In addition, even when an electron-donating substituent such as a carbazole group is substituted on the fused ring core, the introduction of the first substituent may prevent or reduce the HOMO energy level from being shallow, and accordingly, both (e.g., simultaneously) a desired or suitable emission wavelength and HOMO energy level may be satisfied. In addition, the low HOMO energy level promotes energy transfer from a host in a light emitting element, and efficiency may thus be improved. In present disclosure, "shallow" in relation to energy level may indicate that an absolute value of the energy level decreases in a negative direction from a vacuum level. In present disclosure, "deep" in relation to energy level may indicate that an absolute value of the energy level increases in a negative direction from a vacuum level.

An emission spectrum of the fused polycyclic compound represented by Formula 1 has a full width at half maximum of about 10 to about 50 nm, for example, about 20 to about 40 nm. As the emission spectrum of the polycyclic compound of one or more embodiments represented by Formula 1 has a full width at half maximum in the above range, light emitting efficiency may be improved when the fused polycyclic compound of one or more embodiments is applied to a light-emitting element. In some embodiments, element service life of a light-emitting element may be improved when the fused polycyclic compound of one or more embodiments is utilized as a blue light emitting material for the light emitting element.

The fused polycyclic compound of one or more embodiments represented by Formula 1 may be a thermally activated delayed fluorescence emitting material. In one or more embodiments, the fused polycyclic compound represented by Formula 1 may be a thermally activated delayed fluorescence dopant having a difference △E_{ST} between a lowest triplet excitation energy level (T1 level) and a lowest singlet excitation energy level (S1 level) of 0.6 eV or less. In one or more embodiments, the fused polycyclic compound represented by Formula 1 may be a thermally activated delayed fluorescence dopant having a difference △E_{ST} between a lowest triplet excitation energy level (T1 level) and a lowest singlet excitation energy level (S1 level)of 0.2 eV or less.

The fused polycyclic compound of one or more embodiments represented by Formula 1 may be a light emitting material having a central emission wavelength in a wavelength range of about 430 nm to about 490 nm. For example, in one or more embodiments, the fused polycyclic compound represented by Formula 1 may be a blue thermally activated delayed fluorescence (TADF) dopant. However, embodiments of the present disclosure are not limited thereto, and when the fused polycyclic compound of one or more embodiments is utilized as a light emitting material, the fused polycyclic compound may be utilized as a dopant material emitting light in one or more suitable wavelength ranges, such as a red light emitting dopant or a green light emitting dopant.

In the light emitting element ED of one or more embodiments, the emission layer EML may be to emit delayed fluorescence. For example, in one or more embodiments, the emission layer EML may be to emit light of thermally activated delayed fluorescence (TADF).

In some embodiments, the emission layer EML of the light emitting element ED may be to emit blue light. For example, the emission layer EML of an organic electroluminescence element ED of one or more embodiments may be to emit blue light in a wavelength range of about 490 nm or less. However, embodiments of the present disclosure are not limited thereto, in some embodiments, the emission layer EML may be to emit green light or red light.

In some embodiments, the fused polycyclic compound of one or more embodiments may be included in the emission layer EML. In some embodiments, the fused polycyclic compound of one or more embodiments may be included in the emission layer EML as a dopant material. In some embodiments, the fused polycyclic compound of one or more embodiments may be a thermally activated delayed fluorescence material. The fused polycyclic compound of one or more embodiments may be utilized as a thermally activated delayed fluorescence dopant. For example, in the light emitting element ED of one or more embodiments, the emission layer EML may include at least one selected from the fused polycyclic compounds shown in Compound Group 1 as a thermally activated delayed fluorescence dopant. However, the utilization of the fused polycyclic compound of one or more embodiments is not limited thereto.

In one or more embodiments, the emission layer EML may include multiple compounds. The emission layer EML of one or more embodiments may include the fused polycyclic compound represented by Formula 1, i.e., the first compound, and at least one selected from among a second compound represented by Formula HT-1, a third compound represented by Formula ET-1, and a fourth compound represented by Formula D-1.

In one or more embodiments, the emission layer EML may include the first compound represented by Formula 1 and further include at least one selected from among a second compound represented by Formula HT-1 and a third compound represented by Formula ET-1.

In one or more embodiments, the emission layer EML may include a second compound represented by Formula HT-1. In one or more embodiments, the second compound may be utilized as a hole transport host material in the emission layer EML.

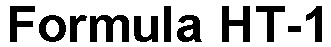

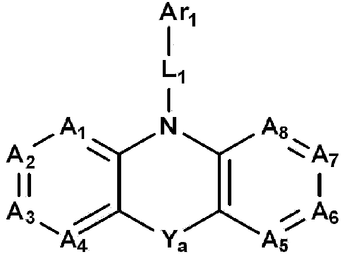

In Formula HT-1, A₁ to A₈ may each independently be N or CR₅₁. For example, in some embodiments, all A₁ to A₈ may be CR₅₁. In some embodiments, any one selected from among A₁ to A₈ may be N, and the remainder may be CR₅₁.

In Formula HT-1, L₁ may be a direct linkage, a substituted or unsubstituted arylene group of 6 to 30 ring-forming carbon atoms, or a substituted or unsubstituted heteroarylene group of 2 to 30 ring-forming carbon atoms. For example, in some embodiments, L₁ may be a direct linkage, a substituted or unsubstituted phenylene group, a substituted or unsubstituted divalent biphenyl group, a substituted or unsubstituted divalent carbazole group, and/or the like, but embodiments of the present disclosure are not limited thereto.

In Formula HT-1, Yₐ may be a direct linkage, CR₅₂R₅₃, or SiR₅₄R₅₅. For example, it may refer to that two benzene rings connected with the nitrogen atom of Formula HT-1 may be connected via a direct linkage, 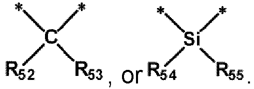 In Formula HT-1, when Yₐ is a direct linkage, the compound represented by Formula HT-1 may include a carbazole moiety.

In Formula HT-1, Ar₁ may be a substituted or unsubstituted aryl group of 6 to 30 ring-forming carbon atoms or a substituted or unsubstituted heteroaryl group of 2 to 30 ring-forming carbon atoms. For example, in some embodiments, Ar₁ may be a substituted or unsubstituted carbazole group, a substituted or unsubstituted dibenzofuran group, a substituted or unsubstituted dibenzothiophene group, a substituted or unsubstituted biphenyl group, and/or the like, but embodiments of the present disclosure are not limited thereto.

In Formula HT-1, R₅₁ to R₅₅ may each independently be hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 60 ring-forming carbon atoms. In some embodiments, one or more selected from among R₅₁ to R₅₅ may be combined with an adjacent group to form a ring. For example, in some embodiments, R₅₁ to R₅₅ may each independently be hydrogen or deuterium. In some embodiments, R₅₁ to R₅₅ may each independently be an unsubstituted methyl group or an unsubstituted phenyl group.

In one or more embodiments, the second compound represented by Formula HT-1 may be represented by any one selected from among compounds represented in Compound Group 2. The emission layer EML may include at least one selected from among the compounds represented in Compound Group 2 as a hole transport host material.

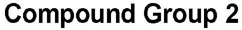

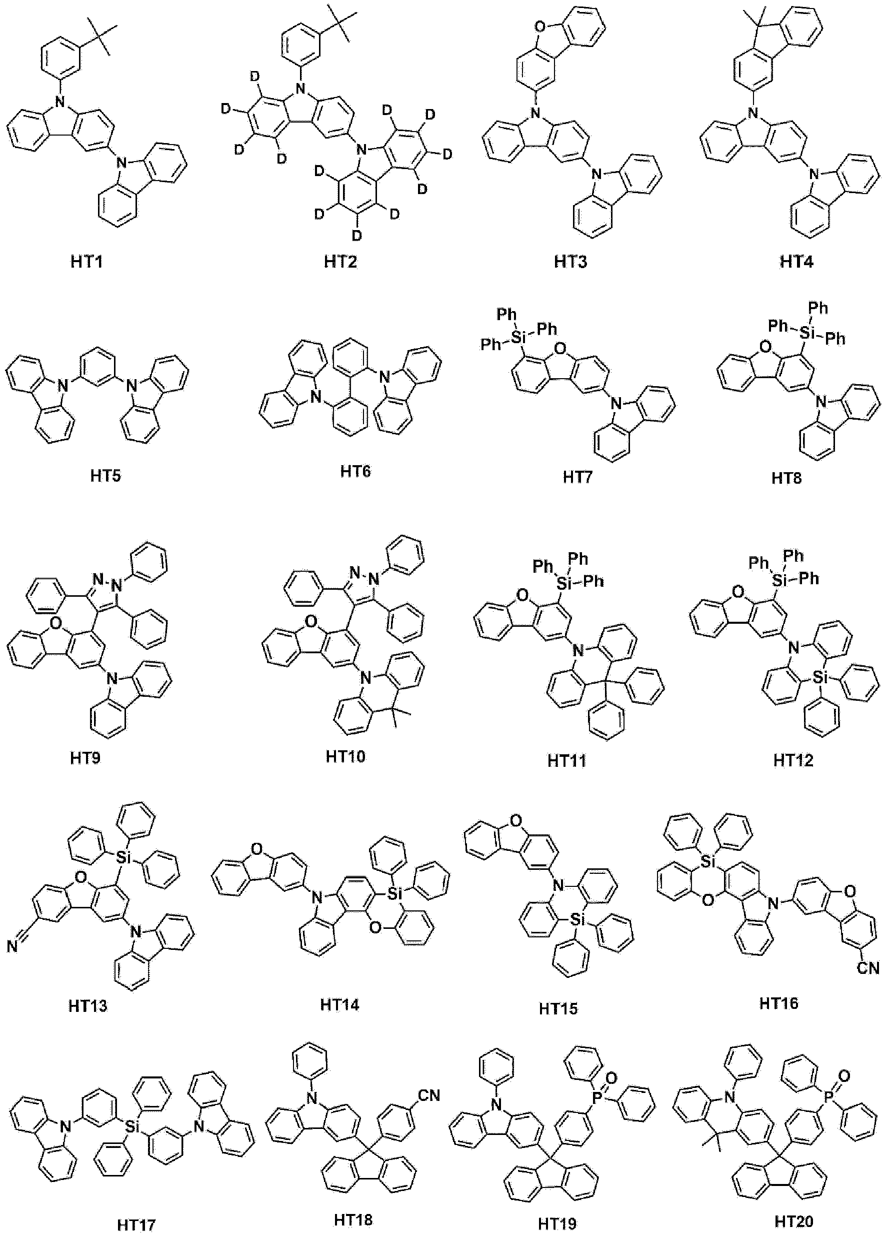

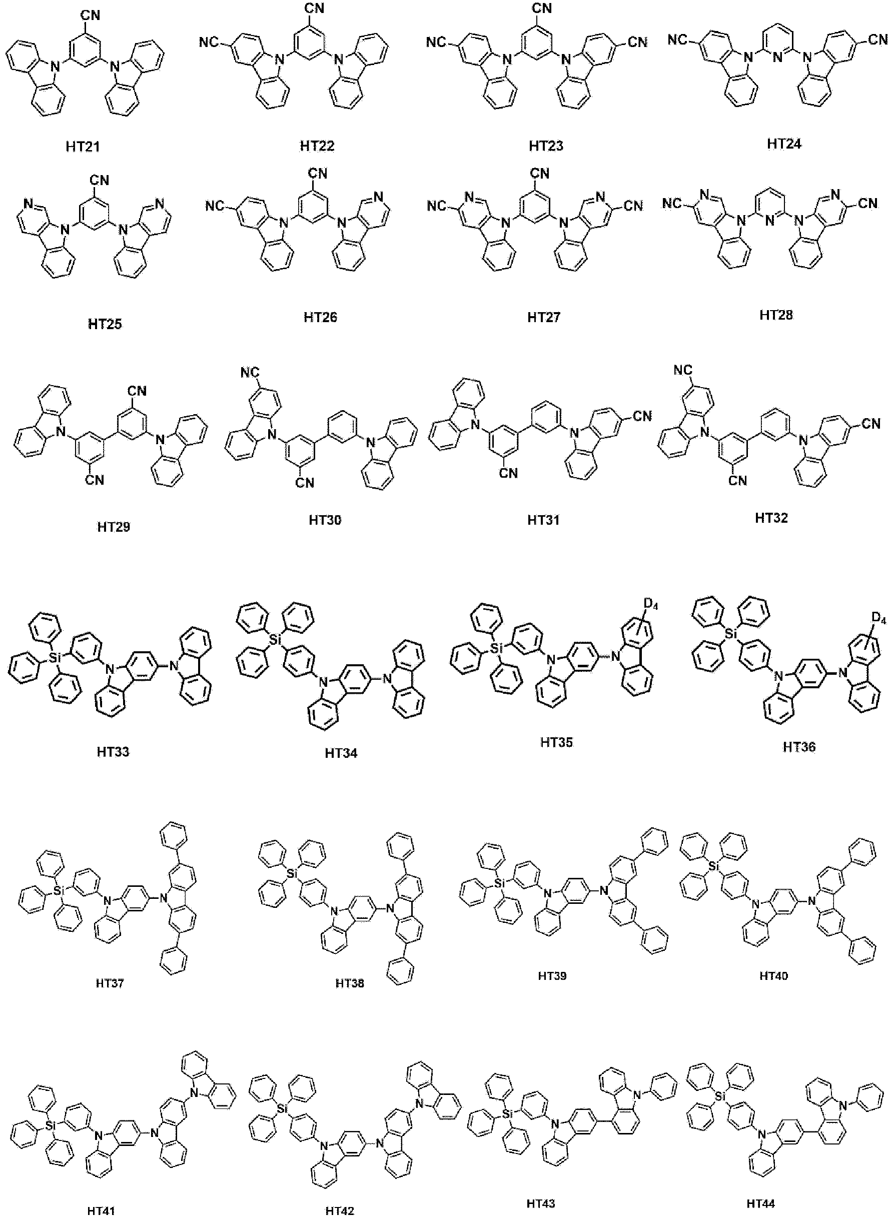

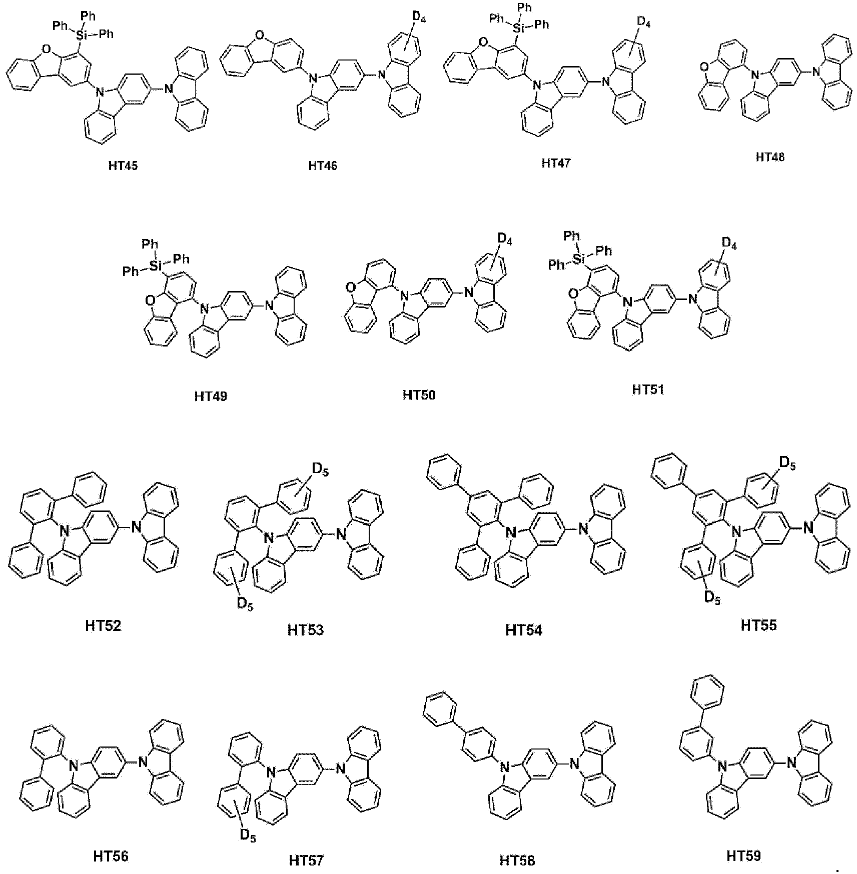

In the example compounds in Compound Group 2, "D" refers to deuterium, and "Ph" may refer to a substituted or unsubstituted phenyl group. For example, in the example compounds in Compound Group 2, "Ph" may be an unsubstituted phenyl group.

In one or more embodiments, the emission layer EML may include a third compound represented by Formula ET-1. For example, in one or more embodiments, the third compound may be utilized as an electron transport host material in the emission layer EML.

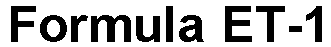

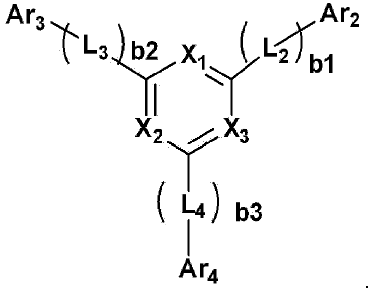

In Formula ET-1, at least one selected from among X₁ to X₃ may be N, and the remainder may be CR₅₆. For example, in some embodiments, one selected from among X₁ to X₃ may be N, and the remainder two may each independently be CR₅₆. In these embodiments, the third compound represented by Formula ET-1 may include a pyridine moiety. In some embodiments, two among X₁ to X₃ may be N, and the remainder may be CR₅₆. In these embodiments, the third compound represented by Formula ET-1 may include a pyrimidine moiety. In some embodiments, X₁ to X₃ may be all N. In these embodiments, the third compound represented by Formula ET-1 may include a triazine moiety.

In Formula ET-1, R₅₆ may be hydrogen, deuterium, a substituted or unsubstituted alkyl group of 1 to 20 carbon atoms, a substituted or unsubstituted aryl group of 6 to 60 ring-forming carbon atoms, or a substituted or unsubstituted heteroaryl group of 2 to 60 ring-forming carbon atoms.

In Formula ET-1, b1 to b3 may each independently be an integer of 0 to 10.

In Formula ET-1, Ar₂ to Ar₄ may each independently be hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. For example, in some embodiments, Ar₂ to Ar₄ may be substituted or unsubstituted phenyl groups or substituted or unsubstituted carbazole groups.

In Formula ET-1, L₂ to L₄ may each independently be a direct linkage, a substituted or unsubstituted arylene group of 6 to 30 ring-forming carbon atoms, or a substituted or unsubstituted heteroarylene group of 2 to 30 ring-forming carbon atoms. In some embodiments, when each of b1 to b3 is an integer of 2 or more, L₂(s) to L₄(s) may each independently be a substituted or unsubstituted arylene group of 6 to 30 ring-forming carbon atoms, or a substituted or unsubstituted heteroarylene group of 2 to 30 ring-forming carbon atoms.

In one or more embodiments, the third compound may be represented by any one selected from among compounds in Compound Group 3. The light emitting element ED of one or more embodiments may include any one selected from among the compounds in Compound Group 3.

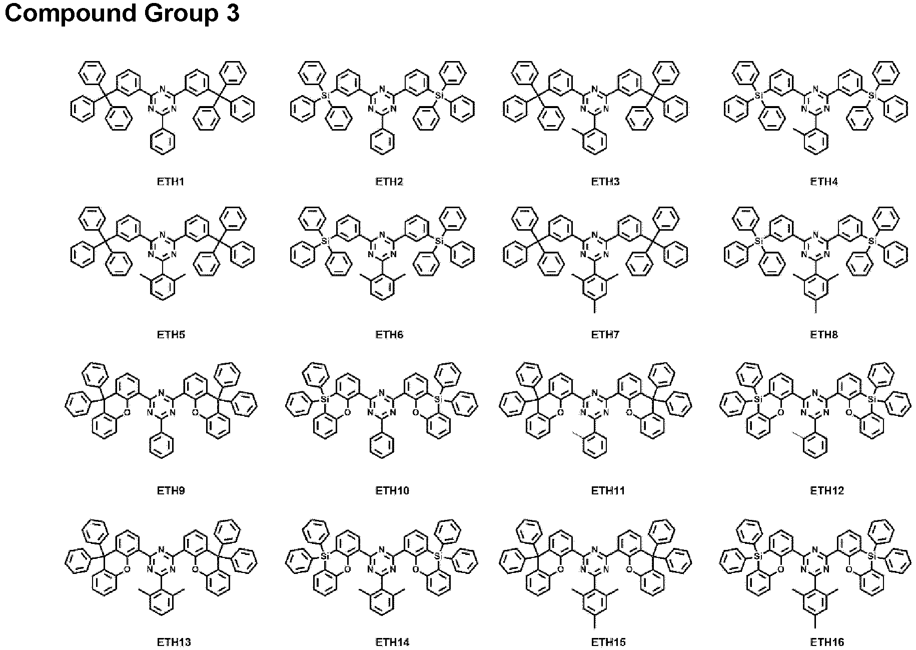

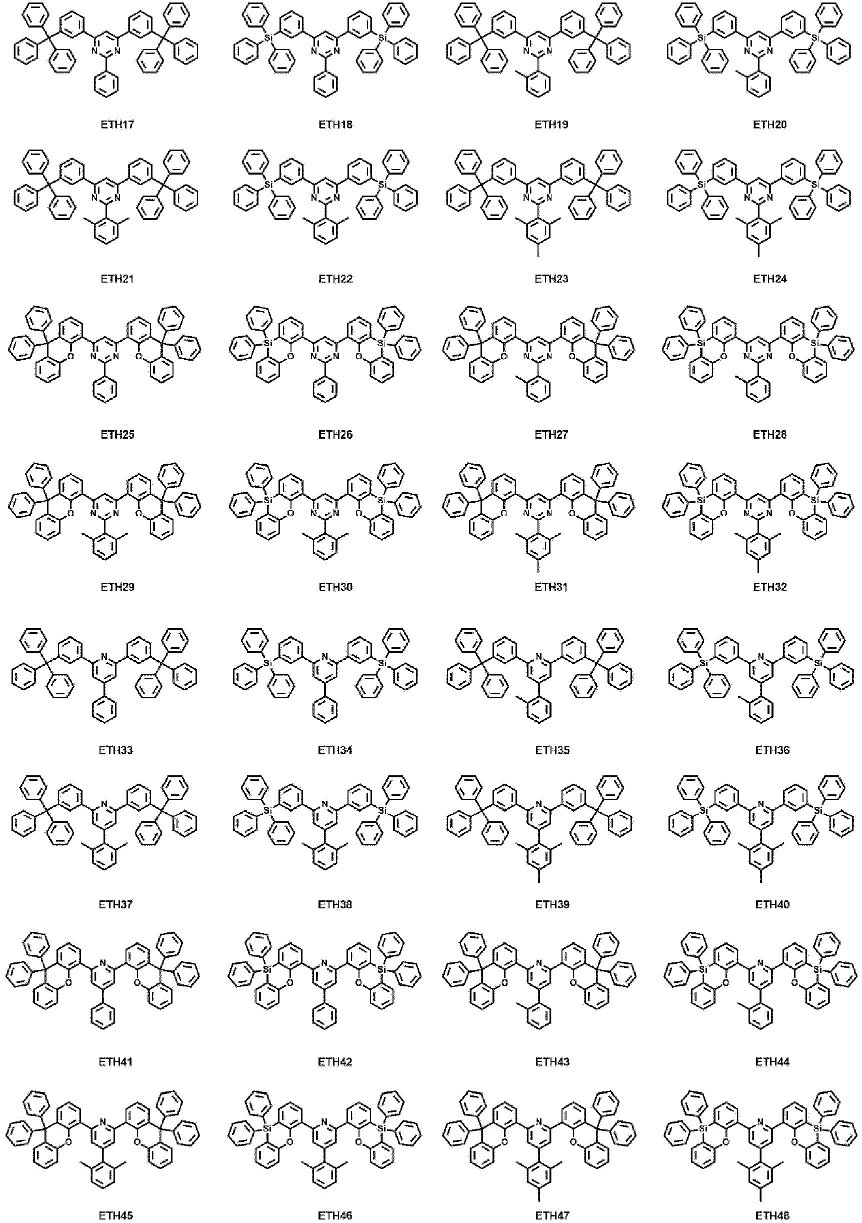

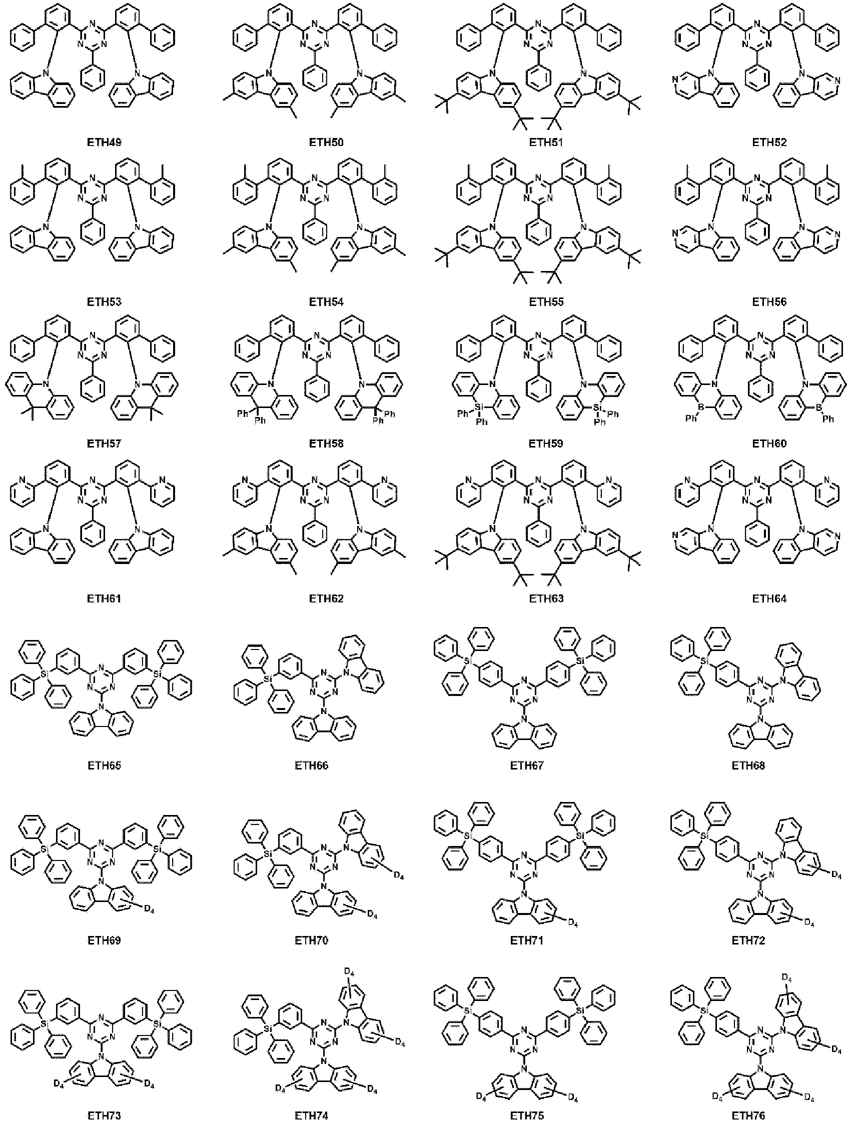

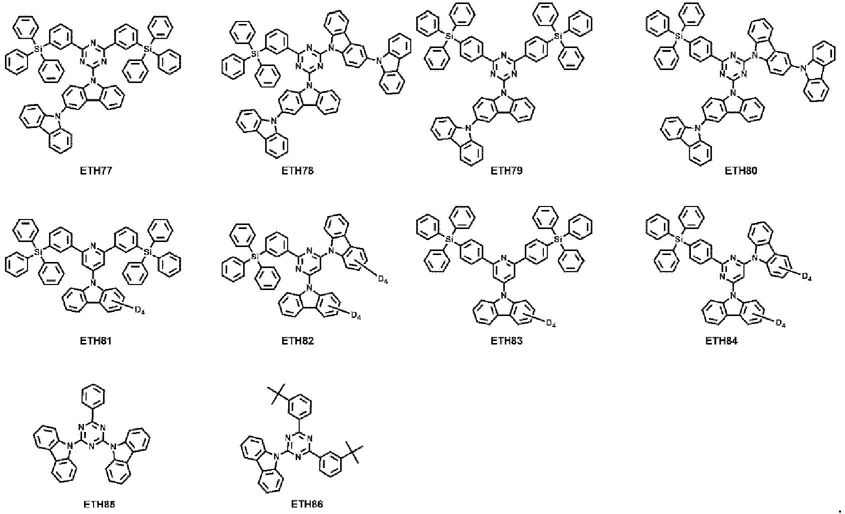

In the example compounds in Compound Group 3, "D" refers to deuterium, and "Ph" refers to an unsubstituted phenyl group.

In one or more embodiments, the emission layer EML may include the second compound and the third compound, and the second compound and the third compound may form exciplex. In the emission layer EML, exciplex may be formed by a hole transport host and an electron transport host. In this case, the triplet energy of the exciplex formed by the hole transport host and the electron transport host may correspond to a difference between the lowest unoccupied molecular orbital (LUMO) energy level of the electron transport host and the highest occupied molecular orbital (HOMO) energy level of the hole transport host.

For example, in one or more embodiments, the absolute value of the triplet energy level (T1) of the exciplex formed by the hole transport host and the electron transport host may be about 2.4 eV to about 3.0 eV. In some embodiments, the triplet energy of the exciplex may be a smaller value than the energy gap of each host material. The exciplex may have a triplet energy of about 3.0 eV or less, that is the energy gap between the hole transport host and the electron transport host.

In one or more embodiments, the emission layer EML may include a fourth compound in addition to the first compound to the third compound. The fourth compound may be utilized as a phosphorescence sensitizer of the emission layer EML. Because energy may transfer from the fourth compound to the first compound, light emission may arise.

For example, in one or more embodiments, the emission layer EML may include an organometallic complex including platinum (Pt) as a central metal atom and ligands bonded to the central metal atom, as the fourth compound. In the light emitting element ED of one or more embodiments, the emission layer EML may include a compound represented by Formula D-1 as the fourth compound.

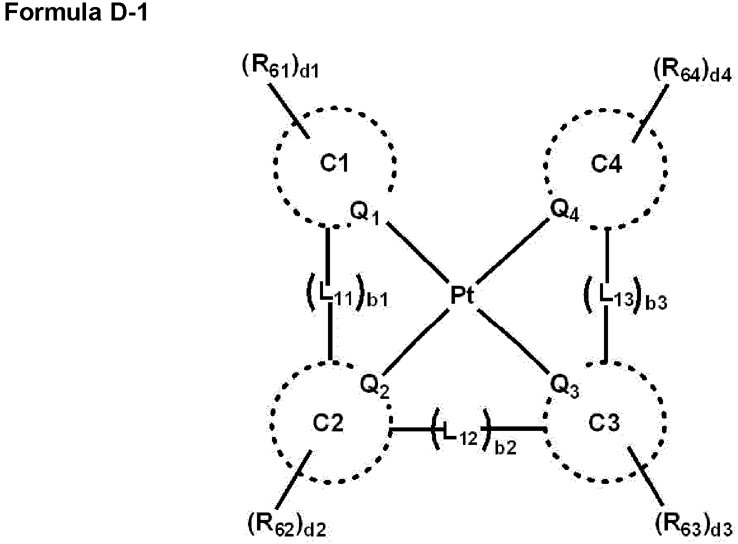

In Formula D-1, Q₁ to Q₄ may each independently be C or N.

In Formula D-1, C1 to C4 may each independently be a substituted or unsubstituted hydrocarbon ring of 5 to 30 ring-forming carbon atoms or a substituted or unsubstituted heterocycle of 2 to 30 ring-forming carbon atoms.

In Formula D-1, L₁₁ to L₁₃ may each independently be a direct linkage, *-O-*, *-S-*, 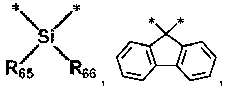 a substituted or unsubstituted alkylene group of 1 to 20 carbon atoms, a substituted or unsubstituted arylene group of 6 to 30 ring-forming carbon atoms, or a substituted or unsubstituted heteroarylene group of 2 to 30 ring-forming carbon atoms. In L₁₁ to L₁₃, "-* "refers to a part connected with C1 to C4.

In Formula D-1, b1 to b3 may each independently be 0 or 1. When b1 is 0, C1 and C2 may be unconnected. When b2 is 0, C2 and C3 may be unconnected. When b3 is 0, C3 and C4 may be unconnected.

In Formula D-1, R₆₁ to R₆₆ may each independently be hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms. In some embodiments, one or more selected from R₆₁ to R₆₆ may independently be combined with an adjacent group to form a ring. In some embodiments, R₆₁ to R₆₆ may each independently be a substituted or unsubstituted methyl group, or a substituted or unsubstituted t-butyl group.

In Formula D-1, d1 to d4 may each independently be an integer of 0 to 4. In Formula D-1, when d1 to d4 each are 0, the fourth compound may be unsubstituted with corresponding R₆₁ to R₆₄. An embodiment in which d1 to d4 each are 4, and R₆₁ to R₆₄ are hydrogen, may be the same as an embodiment where d1 to d4 each are 0. When d1 to d4 each are integers of 2 or more, each of multiple R₆₁(s) to R₆₄(s) may be all the same, or at least one selected from among multiple R₆₁(s) to R₆₄(s) may be different.

In Formula D-1, C1 to C4 may each independently be a substituted or unsubstituted hydrocarbon ring or a substituted or unsubstituted heterocycle, represented by any one selected from among C-1 to C-4.

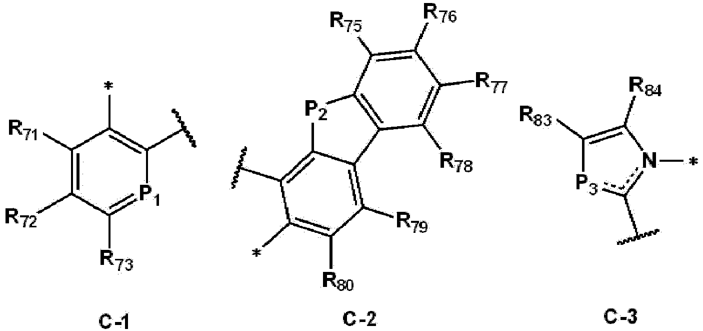

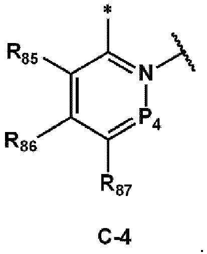

In C-1 to C-4, P₁ may be C-* or CR₇₄, P₂ may be N-* or NR₈₁, P₃ may be N-* or NR₈₂, and P₄ may be C-* or CR₈₈. R₇₁ to R₈₈ may each independently be a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring.

In C-1 to C-4, " 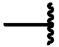 " is a part connected with a central metal atom of Pt, and "-*" corresponds to a part connected with an adjacent ring group (C1 to C4) or linker (L₁₁ to L₁₃).

The emission layer EML of one or more embodiments may include the first compound that is a fused polycyclic compound of the present disclosure, and at least one selected from among the second to fourth compounds. For example, in some embodiments, the emission layer EML may include the first compound, the second compound and the third compound. In the emission layer EML, the second compound and the third compound may form exciplex, and via the exciplex, energy transfer to the first compound may arise, and light emission may arise.

In one or more embodiments, the emission layer EML may include the first compound, the second compound, the third compound, and the fourth compound. In the emission layer EML, the second compound and the third compound may form exciplex, and via the exciplex, energy transfer to the fourth compound and the first compound may arise, and light emission may arise. In one or more embodiments, the fourth compound may be a sensitizer. In the light emitting element ED of one or more embodiments, the fourth compound included in the emission layer EML may act as a sensitizer and may play the role of transferring energy from a host to the first compound that is a light-emitting dopant. For example, the fourth compound that plays the role of an auxiliary dopant may accelerate energy transfer to the first compound that is a light emitting dopant and increase the light emitting ratio of the first compound. Accordingly, the emission efficiency of the emission layer EML of one or more embodiments may be improved. In some embodiments, when the energy transfer to the first compound increases, excitons formed in the emission layer EML may not be accumulated but rapidly emit light, and the deterioration of a device may be reduced. As a result, the lifetime of the light emitting element ED of one or more embodiments may increase.

The light emitting element ED of one or more embodiments may include all of the first compound, the second compound, the third compound, and the fourth compound, and the emission layer EML may include the combination of two host materials and two dopant materials. In the light emitting element ED of one or more embodiments, the emission layer EML may include the second compound and the third compound, which are two different hosts, the first compound which emits delayed fluorescence, and the fourth compound including an organometallic complex, concurrently (e.g., simultaneously), and may show excellent or suitable emission efficiency properties.

In one or more embodiments, the fourth compound represented by Formula D-1 may be represented by at least one selected from among compounds represented in Compound Group 4. In some embodiments, the emission layer EML may include at least one selected from among the compounds represented in Compound Group 4 as a sensitizer material.

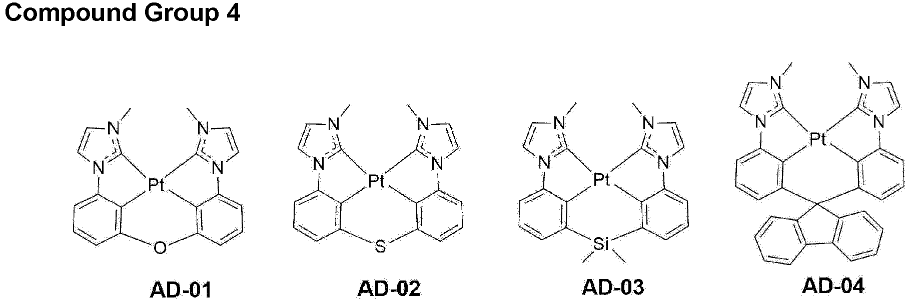

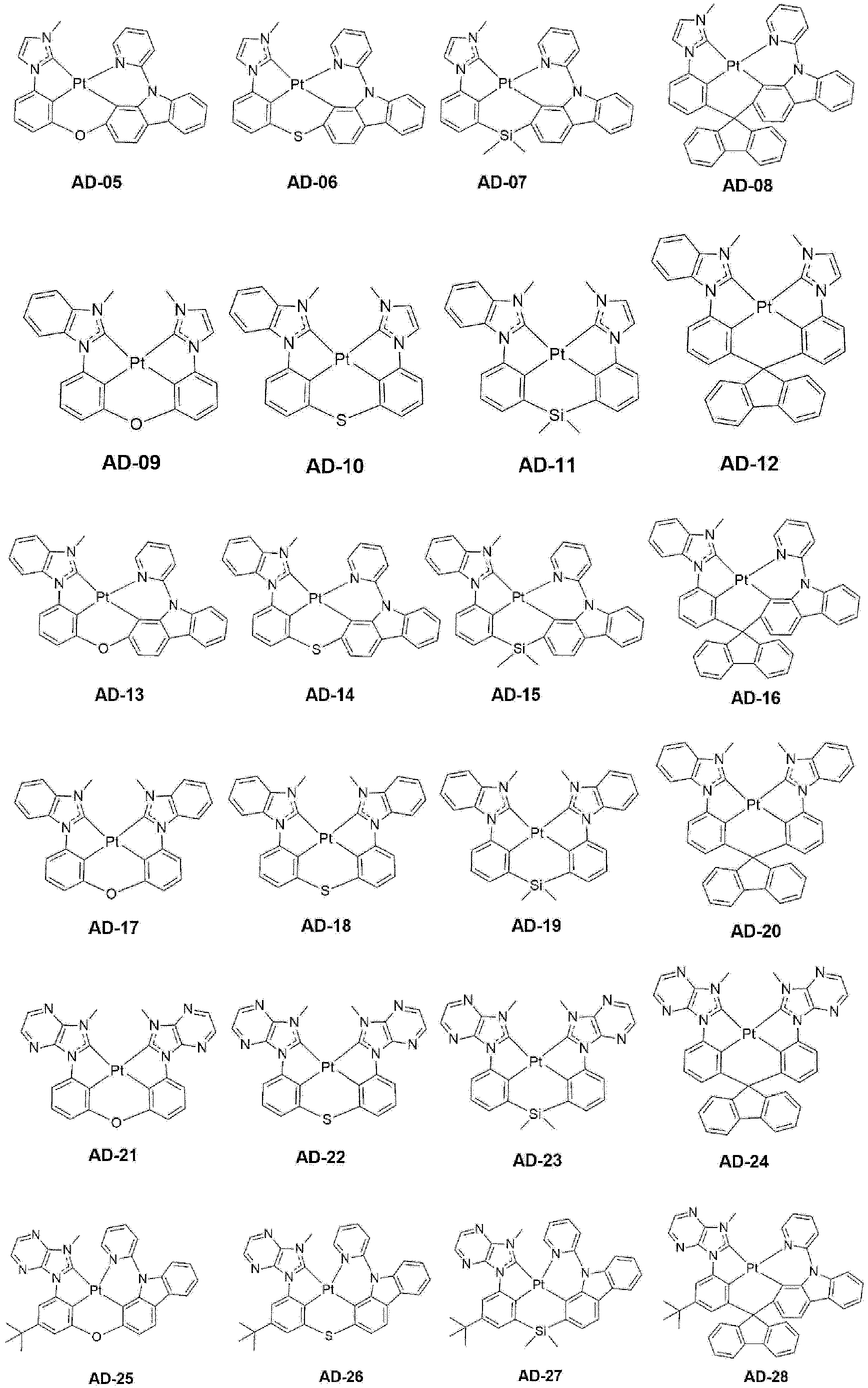

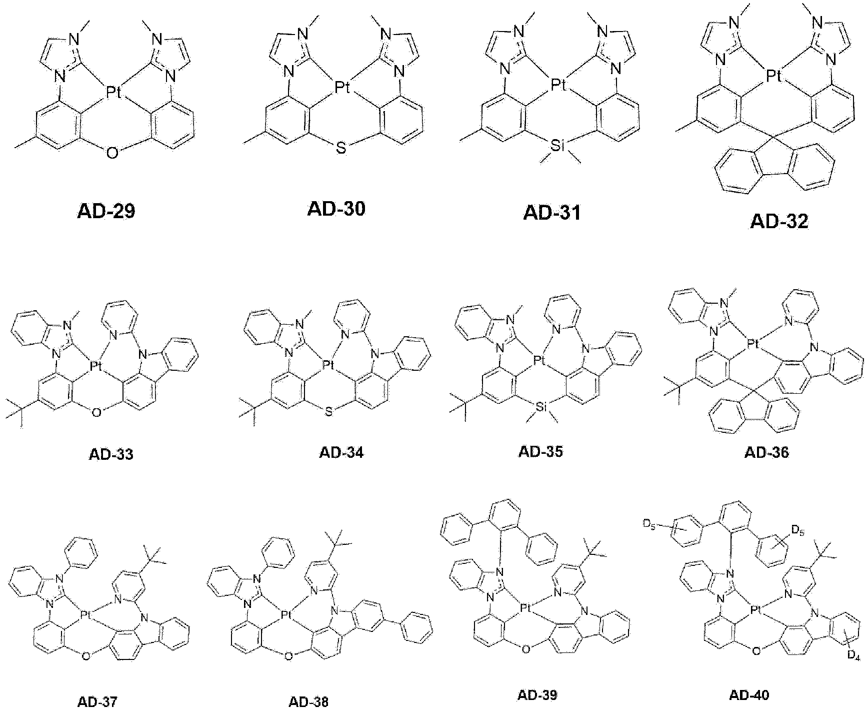

In the example compounds in Compound Group 4, "D" refers to deuterium.

In one or more embodiments, the light emitting element ED of one or more embodiments may include multiple emission layers. Multiple emission layers may be stacked in order and provided, and for example, a light emitting element ED including multiple emission layers may be to emit white light (e.g., combined white light). The light emitting element including multiple emission layers may be a light emitting element of a tandem structure. When the light emitting element ED includes multiple emission layers, at least one emission layer EML may include the first compound represented by Formula 1 of one or more embodiments. In some embodiments, when the light emitting element ED includes multiple emission layers, at least one emission layer EML may include all of the first compound, the second compound, the third compound, and the fourth compound as described above.

In the light emitting element ED of one or more embodiments, when the emission layer EML includes all of the first compound, the second compound, and the third compound, the amount of the first compound may be about 0.1 wt% to about 5 wt% based on the total weight of the first compound, the second compound, and the third compound. However, embodiments of the present disclosure are not limited thereto. When the amount of the first compound satisfies the above-described ratio, energy transfer from the second compound and the third compound to the first compound may increase, and accordingly, the emission efficiency and device lifetime may increase.

In the emission layer EML, the total amount of the second compound and the third compound may be the remaining amount excluding the amount of the first compound. For example, the total amount of the second compound and the third compound may be about 65 wt% to about 95 wt% based on the total weight of the first compound, the second compound, and the third compound.

In the total amount of the second compound and the third compound, the weight ratio of the second compound and the third compound may be about 3: 7 to about 7: 3.

When the total amount of the second compound and the third compound satisfies the above-described ratio, charge balance properties in the emission layer EML may be improved, and emission efficiency and device lifetime may be improved and/or increased. When the total amount of the second compound and the third compound deviates from the above-described ratio range, charge balance in the emission layer EML may be broken, emission efficiency may be degraded and/or decreased, and the device may be easily deteriorated.

In one or more embodiments, when the emission layer EML includes the fourth compound, the amount of the fourth compound may be about 10 wt% to 30 wt% based on the total weight of the first compound, the second compound, the third compound, and the fourth compound in the emission layer EML. However, embodiments of the present disclosure are not limited thereto. When the amount of the fourth compound satisfies the above-described amount, energy transfer from a host to the first compound that is a light emitting dopant may increase, and emission ratio may be improved. Accordingly, the emission efficiency of the emission layer EML may be improved. When the amount ratio of the first compound, the second compound, the third compound, and the fourth compound, included in the emission layer EML satisfies the above-described amount ratio, excellent or suitable emission efficiency and long lifetime of the light emitting element may be achieved.

In the light emitting element ED of one or more embodiments, the emission layer EML may further include at least one of anthracene derivatives, pyrene derivatives, fluoranthene derivatives, chrysene derivatives, dihydrobenzanthracene derivatives, or triphenylene derivatives. For example, in some embodiments, the emission layer EML may include one or more anthracene derivatives and/or one or more pyrene derivatives.

In the light emitting elements ED of one or more embodiments, shown in FIG. 3 to FIG. 6, the emission layer EML may further include suitable hosts and dopants in addition to the above-described host and dopant. For example, in some embodiments, the emission layer EML may include a compound represented by Formula E-1. The compound represented by Formula E-1 may be utilized as a fluorescence host material.

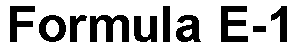

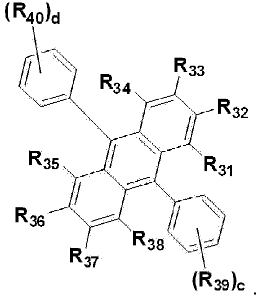

In Formula E-1, R₃₁ to R₄₀ may each independently be hydrogen, deuterium, a halogen, a substituted or unsubstituted silyl group, a substituted or unsubstituted thiol group, a substituted or unsubstituted oxy group, a substituted or unsubstituted alkyl group of 1 to 10 carbon atoms, a substituted or unsubstituted alkenyl group of 2 to 10 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring. In some embodiments, one or more selected from R₃₁ to R₄₀ may be combined with an adjacent group to form a saturated hydrocarbon ring, an unsaturated hydrocarbon ring, a saturated heterocycle, or an unsaturated heterocycle.

In Formula E-1, "c" and "d" may each independently be an integer of 0 to 5.

The compound represented by Formula E-1 may be any one selected from among Compound E1 to Compound E19.

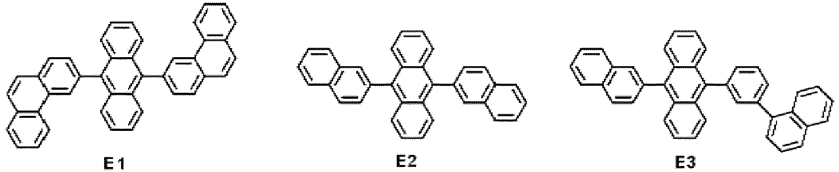

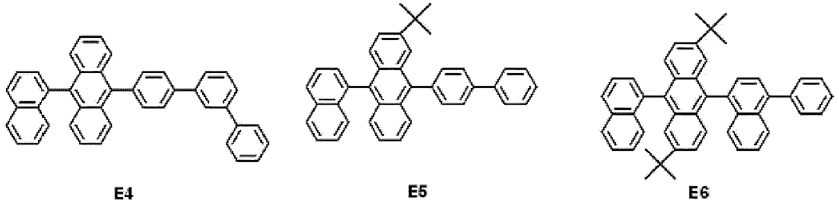

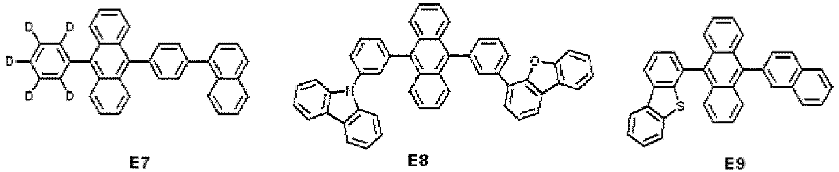

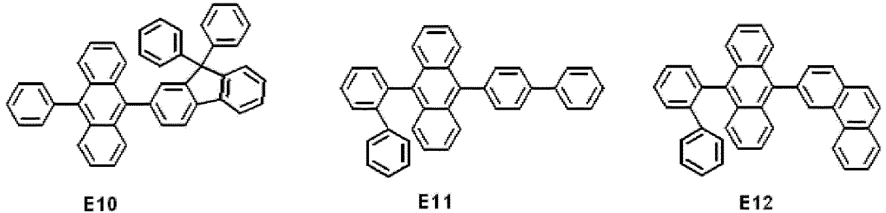

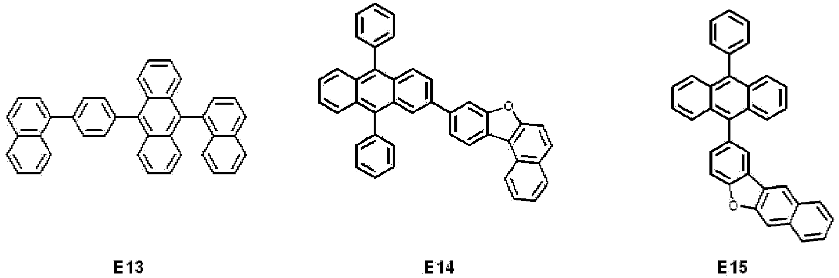

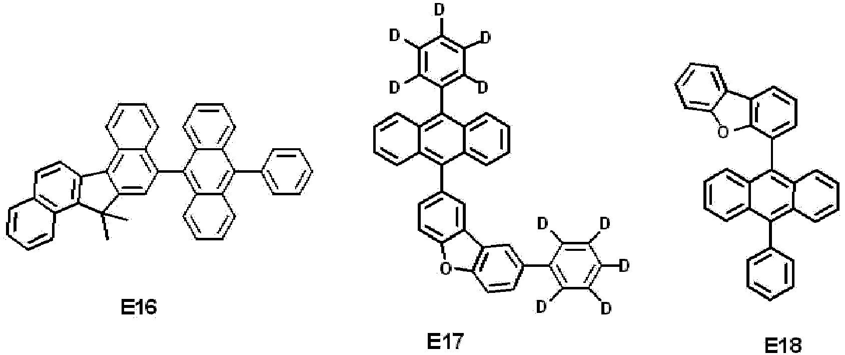

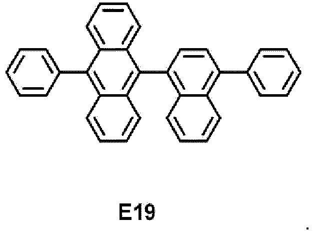

In one or more embodiments, the emission layer EML may include a compound represented by Formula E-2a or Formula E-2b. The compound represented by Formula E-2a or Formula E-2b may be utilized as a phosphorescence host material.

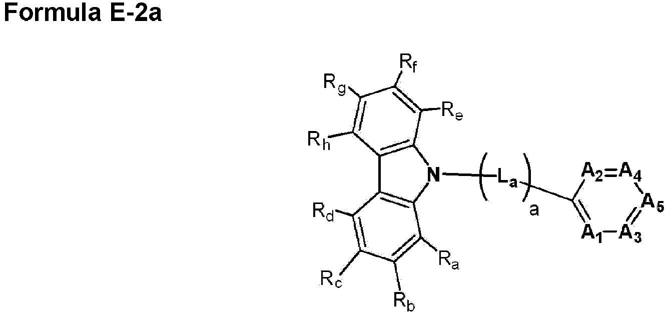

In Formula E-2a, "a" may be an integer of 0 to 10, Lₐ may be a direct linkage, a substituted or unsubstituted arylene group of 6 to 30 ring-forming carbon atoms, or a substituted or unsubstituted heteroarylene group of 2 to 30 ring-forming carbon atoms. In some embodiments, when "a" is an integer of 2 or more, multiple Lₐ(s) may each independently be a substituted or unsubstituted arylene group of 6 to 30 ring-forming carbon atoms or a substituted or unsubstituted heteroarylene group of 2 to 30 ring-forming carbon atoms.

In some embodiments, in Formula E-2a, A₁ to A₅ may each independently be N or CRᵢ. Rₐ to Rᵢ may each independently be hydrogen, deuterium, a substituted or unsubstituted amine group, a substituted or unsubstituted thiol group, a substituted or unsubstituted oxy group, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, and/or may be combined with an adjacent group to form a ring. In some embodiments, one or more selected from among Rₐ to Rᵢ may be combined with an adjacent group to form a hydrocarbon ring or a heterocycle including N, O, S, etc. as a ring-forming atom.

In some embodiments, in Formula E-2a, two or three selected from A₁ to A₅ may be N, and the remainder may be CRᵢ.

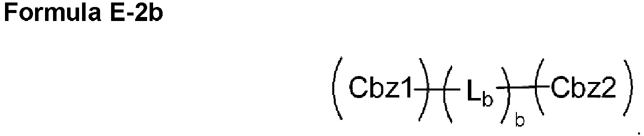

In Formula E-2b, Cbz1 and Cbz2 may each independently be an unsubstituted carbazole group or a carbazole group substituted with an aryl group of 6 to 30 ring-forming carbon atoms. L_{b} may be a direct linkage, a substituted or unsubstituted arylene group of 6 to 30 ring-forming carbon atoms, or a substituted or unsubstituted heteroarylene group of 2 to 30 ring-forming carbon atoms. "b" may be an integer of 0 to 10, and when "b" is an integer of 2 or more, multiple L_{b}(s) may each independently be a substituted or unsubstituted arylene group of 6 to 30 ring-forming carbon atoms or a substituted or unsubstituted heteroarylene group of 2 to 30 ring-forming carbon atoms.

The compound represented by Formula E-2a or Formula E-2b may be any one selected from among compounds in Compound Group E-2. However, the compounds shown in Compound Group E-2 are only examples, and the compound represented by Formula E-2a or Formula E-2b is not limited to the compounds represented in Compound Group E-2.

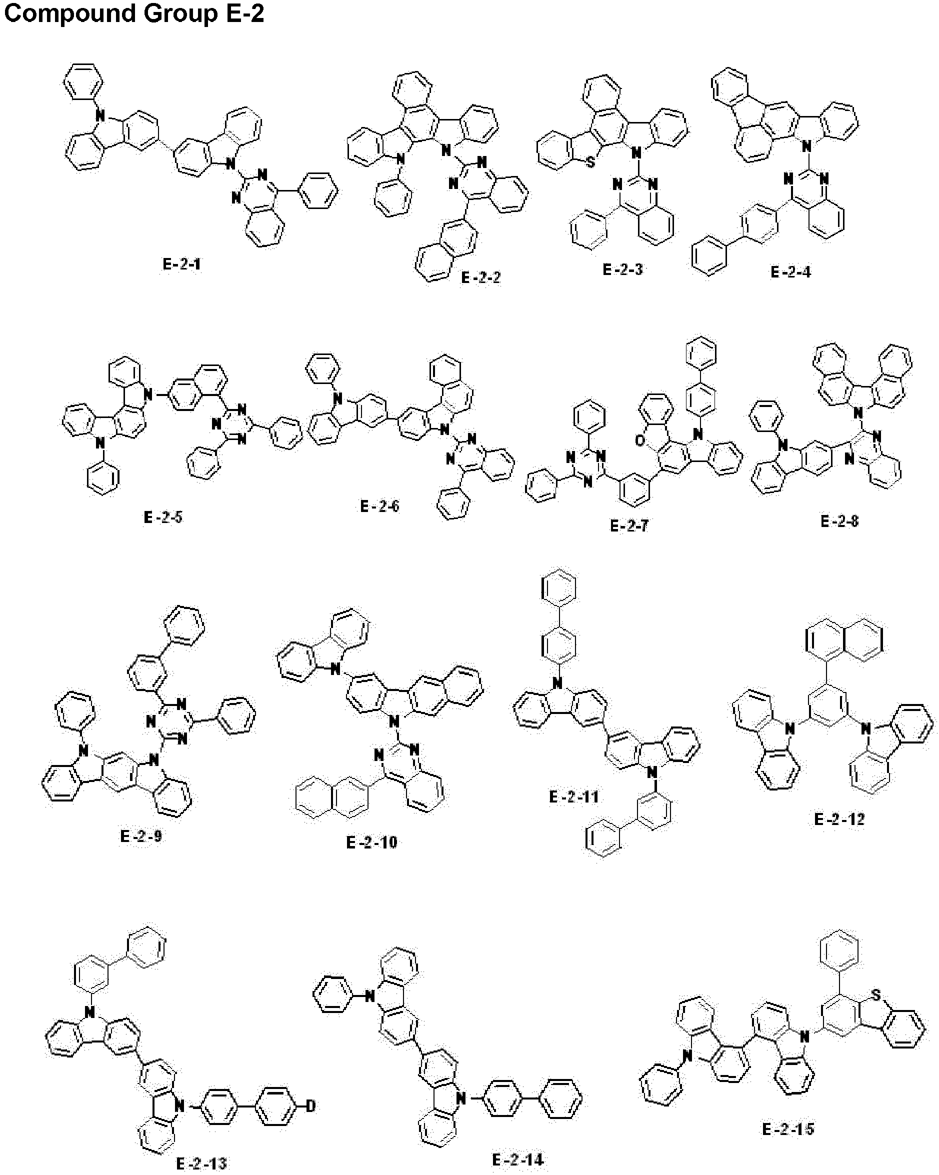

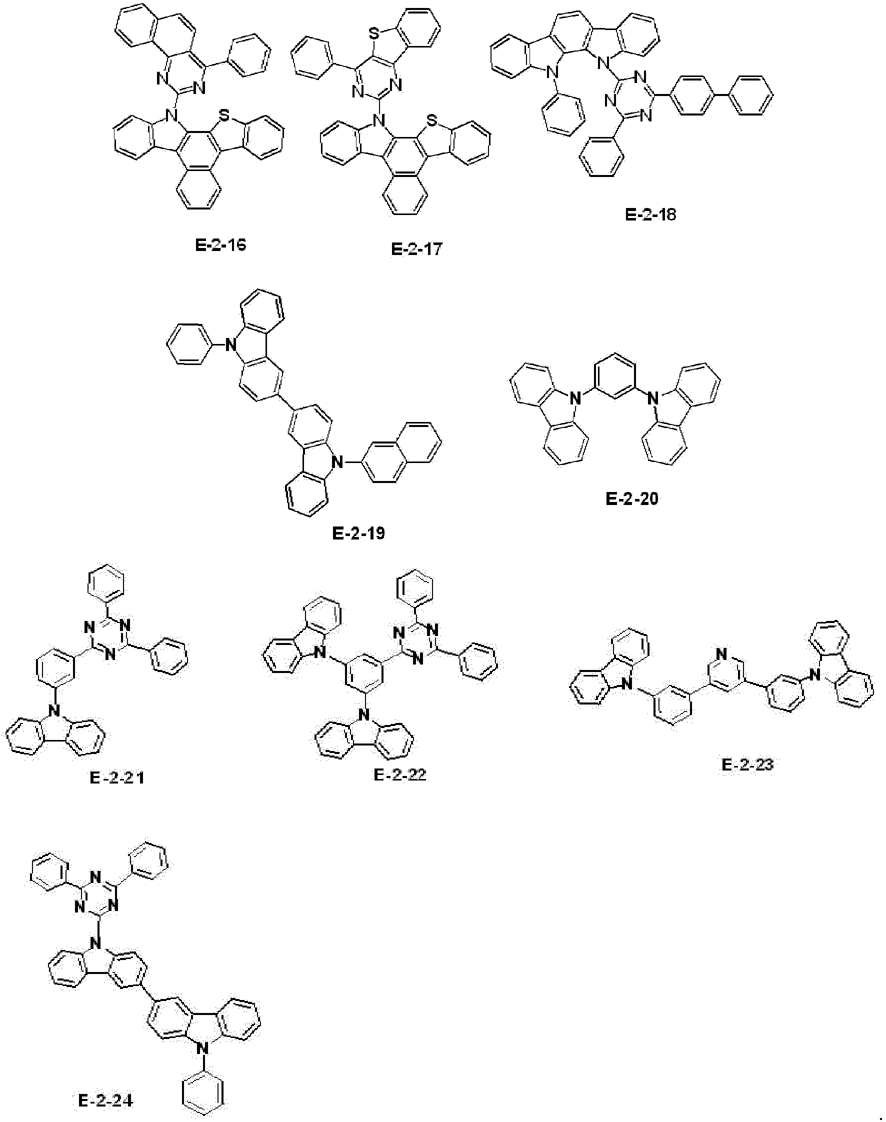

In one or more embodiments, the emission layer EML may further include a material well-suitable in the art as a host material. For example, the emission layer EML may include as a host material, at least one of bis (4-(9H-carbazol-9-yl) phenyl) diphenylsilane (BCPDS), (4-(1-(4-(diphenylamino) phenyl) cyclohexyl) phenyl) diphenyl-phosphine oxide (POPCPA), bis[2-(diphenylphosphino)phenyl] ether oxide (DPEPO), 4,4'-bis(N-carbazolyl)-1,1'-biphenyl (CBP), 1,3-bis(carbazol-9-yl)benzene (mCP), 2,8-bis(diphenylphosphoryl)dibenzo[b,d]furan (PPF), 4,4',4"-tris(carbazol-9-yl)-triphenylamine (TCTA), or 1,3,5-tris(1-phenyl-1H-benzo[d]imidazole-2-yl)benzene (TPBi). However, embodiments of the present disclosure are not limited thereto. For example, tris(8-hydroxyquinolinato)aluminium (Alq₃), 9,10-di(naphthalen-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiO₃), octaphenylcyclotetra siloxane (DPSiO₄), etc., may be utilized as the host material.

In one or more embodiments, the emission layer EML may include a compound represented by Formula M-a. The compound represented by Formula M-a may be utilized as a phosphorescence dopant material.

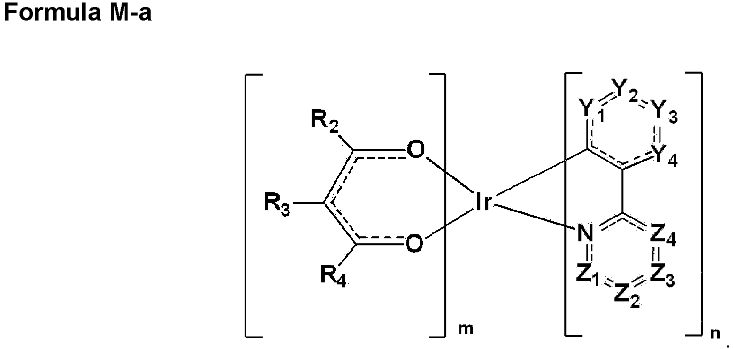

In Formula M-a, Y₁ to Y₄, and Z₁ to Z₄ may each independently be CR₁ or N, and R₁ to R₄ may each independently be hydrogen, deuterium, a substituted or unsubstituted amine group, a substituted or unsubstituted thiol group, a substituted or unsubstituted oxy group, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, and/or may be combined with an adjacent group to form a ring. In Formula M-a, "m" is 0 or 1, and "n" is 2 or 3. In Formula M-a, when "m" is 0, "n" is 3, and when "m" is 1, "n" is 2.

The compound represented by Formula M-a may be utilized as a phosphorescence dopant.

The compound represented by Formula M-a may be any one selected from among Compounds M-a1 to M-a25. However, Compounds M-a1 to M-a25 are mere examples, and the compound represented by Formula M-a is not limited to the compounds represented by Compounds M-a1 to M-a25.

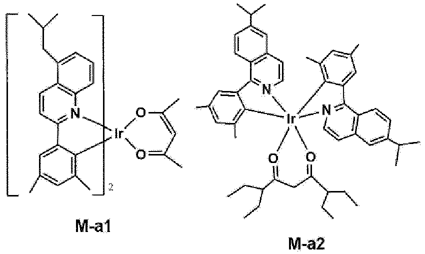

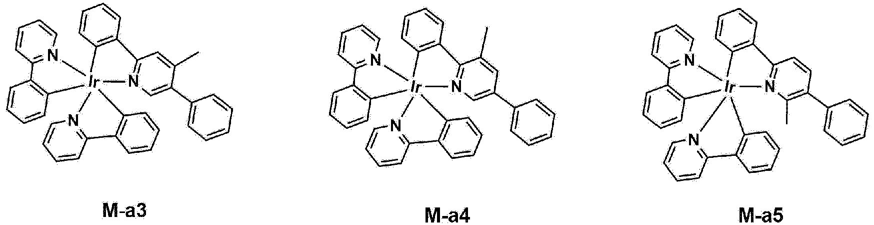

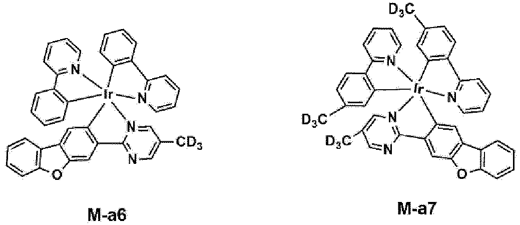

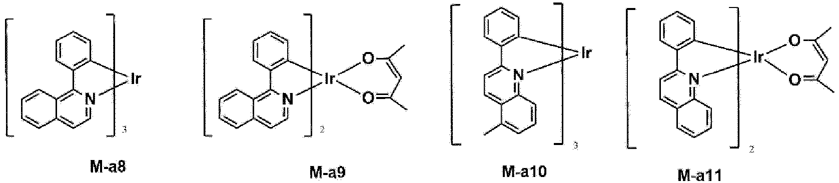

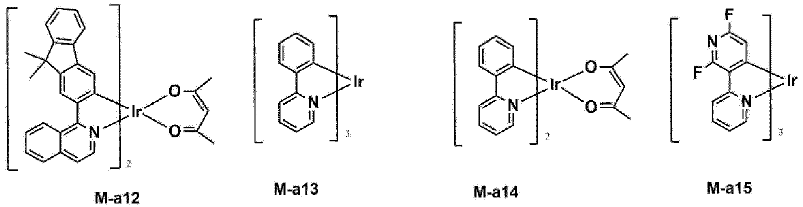

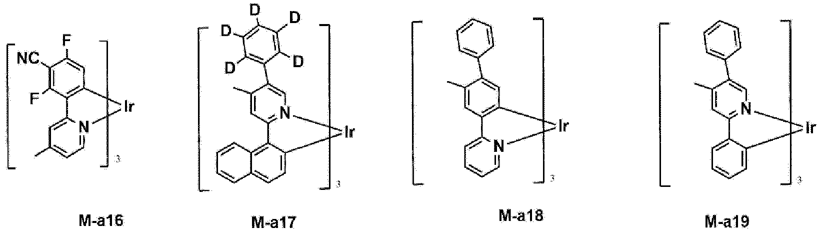

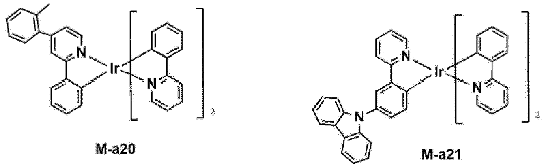

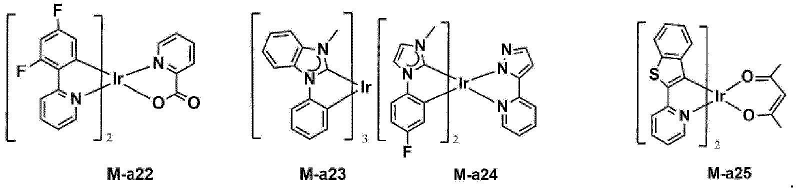

In one or more embodiments, the emission layer EML may further include a compound represented by any one selected from among Formula F-a to Formula F-c. The compounds represented by Formula F-a to Formula F-c may be utilized as fluorescence dopant materials.

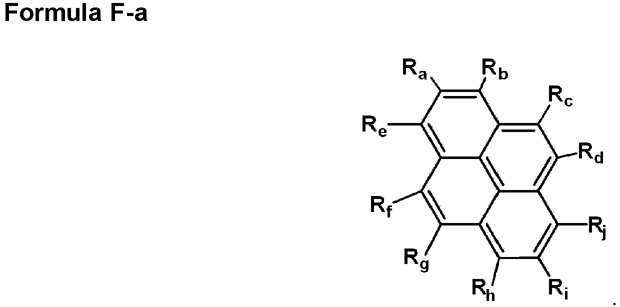

In Formula F-a, two selected from Rₐ to Rⱼ may each independently be substituted with _{*}-NAr₁Ar₂. The remainder not substituted with *-NAr₁Ar₂ among Rₐ to Rⱼ may each independently be hydrogen, deuterium, a halogen, a cyano group, a substituted or unsubstituted amine group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. In _{*}-NAr₁Ar₂, Ar₁ and Ar₂ may each independently be a substituted or unsubstituted aryl group of 6 to 30 ring-forming carbon atoms or a substituted or unsubstituted heteroaryl group of 2 to 30 ring-forming carbon atoms. For example, in some embodiments, at least one selected from among Ar₁ and Ar₂ may be a heteroaryl group including O or S as a ring-forming atom.

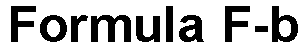

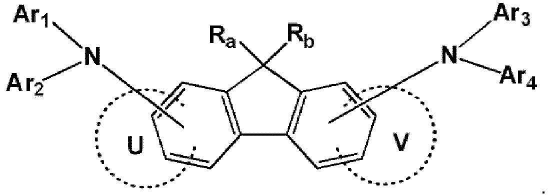

In Formula F-b, Rₐ and R_{b} may each independently be hydrogen, deuterium, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, and/or may be combined with an adjacent group to form a ring. Ar₁ to Ar₄ may each independently be a substituted or unsubstituted aryl group of 6 to 30 ring-forming carbon atoms or a substituted or unsubstituted heteroaryl group of 2 to 30 ring-forming carbon atoms.

In Formula F-b, U and V may each independently be a substituted or unsubstituted hydrocarbon ring of 5 to 30 ring-forming carbon atoms or a substituted or unsubstituted heterocycle of 2 to 30 ring-forming carbon atoms. In some embodiments, at least one selected from among Ar₁ to Ar₄ may be a heteroaryl group including O or S as a ring-forming atom.

In Formula F-b, the number of rings represented by U and V may each independently be 0 or 1. For example, in Formula F-b, when the number of U or V is 1, one ring forms a fused ring at the designated part by U or V, and when the number of U or V is 0, a ring is not present at the designated part by U or V. For example, when the number of U is 0, and the number of V is 1, or when the number of U is 1, and the number of V is 0, a fused ring having the fluorene core of Formula F-b may be a ring compound with four rings. In some embodiments, when the number of both (e.g., simultaneously) U and V is 0, the fused ring of Formula F-b may be a ring compound with three rings. In some embodiments, when the number of both (e.g., simultaneously) U and V is 1, a fused ring having the fluorene core of Formula F-b may be a ring compound with five rings.

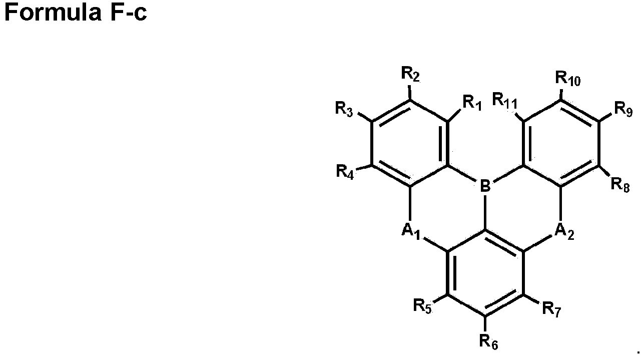

In Formula F-c, A₁ and A₂ may each independently be O, S, Se, or NRₘ, and Rₘ may be hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. R₁ to R₁₁ may each independently be hydrogen, deuterium, a halogen, a cyano group, a substituted or unsubstituted amine group, a substituted or unsubstituted boryl group, a substituted or unsubstituted oxy group, a substituted or unsubstituted thiol group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring.

In Formula F-c, A₁ and A₂ may each independently be combined with the substituents of an adjacent ring to form a fused ring. For example, when A₁ and A₂ may each independently be NRₘ, A₁ may be combined with R₄ or R₅ to form a ring. In some embodiments, A₂ may be combined with R₇ or R₈ to form a ring.

In one or more embodiments, the emission layer EML may include as a suitable dopant material, one or more selected from styryl derivatives (for example, 1,4-bis[2-(3-N-ethylcarbazoryl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (N-BDAVBi), and 4,4'-bis[2-(4-(N,N-diphenylamino)phenyl)vinyl]biphenyl (DPAVBi)), perylene and the derivatives thereof (for example, 2,5,8,11-tetra-t-butylperylene (TBP)), pyrene and the derivatives thereof (for example, 1,1-dipyrene, 1,4-dipyrenylbenzene, and 1,4-bis(N,N-diphenylamino)pyrene), etc.

In one or more embodiments, the emission layer EML may include a suitable phosphorescence dopant material. For example, the phosphorescence dopant may utilize a metal complex including iridium (Ir), platinum (Pt), osmium (Os), gold (Au), titanium (Ti), zirconium (Zr), hafnium (Hf), europium (Eu), terbium (Tb), or thulium (Tm). For example, iridium(III) bis(4,6-difluorophenylpyridinato-N,C2')picolinate (FIrpic), bis(2,4-difluorophenylpyridinato)-tetrakis(1-pyrazolyl)borate iridium(III) (Fir6), or platinum octaethyl porphyrin (PtOEP) may be utilized as the phosphorescence dopant. However, embodiments of the present disclosure are not limited thereto.

In one or more embodiments, the emission layer may include one or more quantum dots.

In the present disclosure, the quantum dot refers to a crystal of a semiconductor compound. The quantum dot may be to emit light having one or more suitable emission wavelengths depending on the size of crystal. The quantum dot may be to emit light having one or more suitable emission wavelengths as the elemental ratio in the quantum dot compound is adjusted.

The quantum dot may have a diameter of, for example, about 1 nm to about 10 nm.

The quantum dot may be synthesized by a wet chemical process, a metal organic chemical vapor deposition process, a molecular beam epitaxy process, a similar process thereto, and/or the like.

The wet chemical process is a method in which a precursor material of a quantum dot is mixed with an organic solvent to grow quantum dot particle crystals. When the crystals grow, the organic solvent naturally may act as a dispersant coordinated on the surface of the quantum dot crystals and control the growth of the crystals. Thus, the wet chemical process may control the growth of quantum dot particles through a process which is more easily performed than vapor deposition methods, such as metal organic chemical vapor deposition (MOCVD) or molecular beam epitaxy (MBE), and which is performed at low costs.

In one or more embodiments, the emission layer EML may include a quantum dot material. In one or more embodiments, the quantum dot material may have a core/shell structure. The core of the quantum dot may be selected from a II-VI group compound, a III-VI group compound, a I-III-VI group compound, a III-V group compound, a III-II-V group compound, a IV-VI group compound, a IV group element, a IV group compound, and combinations thereof.

The Group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and a mixture thereof; a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, and a mixture thereof. In some embodiments, the Group II-VI compound may further include a Group I metal and/or a Group IV element. The Group I-II-VI compound may be selected from CuSnS and/or CuZnS, and the Group II-IV-VI compound may be selected from ZnSnS and/or the like. The Group I-II-IV-VI compound may be selected from quaternary compounds selected from the group consisting of Cu₂ZnSnS₂, Cu₂ZnSnS₄, Cu₂ZnSnSe₄, Ag₂ZnSnS₂, and a mixture thereof.

The III-VI group compound may include a binary compound such as In₂S₃ and/or In₂Se₃, a ternary compound such as InGaS₃ and/or InGaSe₃, or one or more combinations thereof.

The I-III-VI group compound may be selected from a ternary compound selected from the group consisting of AgInS, AgInS₂, CuInS, CuInS₂, AgGaS₂, CuGaS₂, CuGaO₂, AgGaO₂, AgAlO₂ and mixtures thereof, and/or a quaternary compound such as AgInGaS₂ and/or CuInGaS₂.

The III-V group compound may be selected from the group consisting of a binary compound selected from the group consisting of GaN, GaP, GaAs, GaSb, AIN, AlP, AlAs, AlSb, InN, InP, InAs, InSb, and mixtures thereof; a ternary compound selected from the group consisting of GaNP, GaNAs, GaNSb, GaPAs, GaPSb, AINP, AlNAs, AlNSb, AlPAs, AlPSb, InGaP, InAlP, InNP, InNAs, InNSb, InPAs, InPSb, and mixtures thereof; and a quaternary compound selected from the group consisting of GaAlNP, GaAINAs, GaAINSb, GaAlPAs, GaAlPSb, GalnNP, GalnNAs, GalnNSb, GaInPAs, GaInPSb, InAlNP, InAINAs, InAlNSb, InAlPAs, InAlPSb, and mixtures thereof. In some embodiments, the III-V group compound may further include a II group metal. For example, InZnP, etc. may be selected as a III-II-V group compound.

The Group IV-VI compound may be selected from the group consisting of a binary compound selected from the group consisting of SnS, SnSe, SnTe, PbS, PbSe, PbTe, and a mixture thereof; a ternary compound selected from the group consisting of SnSeS, SnSeTe, SnSTe, PbSeS, PbSeTe, PbSTe, SnPbS, SnPbSe, SnPbTe, and a mixture thereof; and a quaternary compound selected from the group consisting of SnPbSSe, SnPbSeTe, SnPbSTe, and a mixture thereof.

The Group II-IV-V compound may be selected from a ternary compound selected from the group consisting of ZnSnP, ZnSnP₂, ZnSnAs₂, ZnGeP₂, ZnGeAs₂, CdSnP₂, and CdGeP₂ and a mixture thereof.

The Group IV element may be selected from the group consisting of Si, Ge, and a mixture thereof. The Group IV compound may be a binary compound selected from the group consisting of SiC, SiGe, and a mixture thereof.

Each element included in the multi-element compound such as the binary compound, ternary compound, and quaternary compound may be present in particles at a substantially uniform concentration or a non-substantially uniform concentration. For example, Formula above indicates the types (kinds) of elements included in a compound, and element ratios in the compound may be different. For example, AgInGaS₂ may indicate AgInₓGa₁₋ₓS₂ (x is a real number between 0 and 1).

In one or more embodiments, constituting elements of the binary compound, the ternary compound, or the quaternary compound may be present at substantially uniform concentration in a particle or may be present at a partially different concentration distribution within the same particle. In some embodiments, a core/shell structure in which one quantum dot wraps another quantum dot may be desirable. The interface of the core and the shell may have a concentration gradient in which the concentration of an element present in the shell is decreased toward the center.

In some embodiments, the quantum dot may have the above-described core-shell structure including a core including a nanocrystal and a shell wrapping the core. The shell of the quantum dot may play the role of a protection layer for preventing or reducing the chemical deformation of the core to maintain semiconductor properties and/or a charging layer for imparting the quantum dot with electrophoretic properties. The shell may have a single layer or a multilayer. Examples of the shell of the quantum dot may include a metal or non-metal oxide, a semiconductor compound, or combinations thereof.

For example, the metal or non-metal oxide for the shell may include a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄ and/or NiO, and/or a ternary compound such as MgAl₂O₄, CoFe₂O₄, NiFe₂O₄, and/or CoMn₂O₄, but embodiments of the present disclosure are not limited thereto.

Also, the semiconductor compound suitable as a shell may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, etc., but embodiments of the present disclosure are not limited thereto.

The quantum dot may have a full width of half maximum (FWHM) of emission spectrum of about 45 nm or less, about 40 nm or less, or, about 30 nm or less. Within this range, the color purity or color reproducibility of the light emitting element may be improved. In some embodiments, light emitted via such quantum dots is emitted in all directions, and light view angle properties may be improved.

In some embodiments, the shape of the quantum dot may be generally utilized shapes in the art, without specific limitation. In one or more embodiments, the shape of spherical nanoparticle, pyramidal nanoparticle, multi-arm nanoparticle, or cubic nanoparticle, nanotube, nanowire, nanofiber, nanoplate particle, etc. may be utilized.

As the size of the quantum dot or the ratio of elements in the quantum dot compound is regulated, the energy band gap may be accordingly controlled or selected to obtain light of one or more suitable wavelengths from a quantum dot emission layer. Therefore, by utilizing the quantum dots as described above (utilizing quantum dots of different sizes or having different element ratios in the quantum dot compound), a light emitting device emitting light of one or more suitable wavelengths may be obtained. For example, the size of the quantum dots or the ratio of elements in the quantum dot compound may be regulated to emit red, green, and/or blue light. In some embodiments, the quantum dots may be configured to emit white light by combining light of one or more suitable colors.

In the light emitting elements ED of one or more embodiments, as shown in FIG. 3 to FIG. 6, the electron transport region ETR may be provided on the emission layer EML. The electron transport region ETR may include at least one of a hole blocking layer HBL, an electron transport layer ETL, or an electron injection layer EIL. However, embodiments of the present disclosure are not limited thereto.

The electron transport region ETR may have a single layer formed utilizing a single material, a single layer formed utilizing multiple different materials, or a multilayer structure having multiple layers formed utilizing multiple different materials.

For example, in some embodiments, the electron transport region ETR may have a single layer structure of an electron injection layer EIL or an electron transport layer ETL, or a single layer structure formed utilizing an electron injection material and an electron transport material. Further, in some embodiments, the electron transport region ETR may have a single layer structure formed utilizing multiple different materials, or a structure stacked from the emission layer EML of electron transport layer ETL/electron injection layer EIL, or hole blocking layer HBL/electron transport layer ETL/electron injection layer EIL, without limitation. A thickness of the electron transport region ETR may be, for example, from about 1,000 Å to about 1,500 Å.

The electron transport region ETR may be formed utilizing one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the electron transport region ETR may include a compound represented by Formula ET-2.

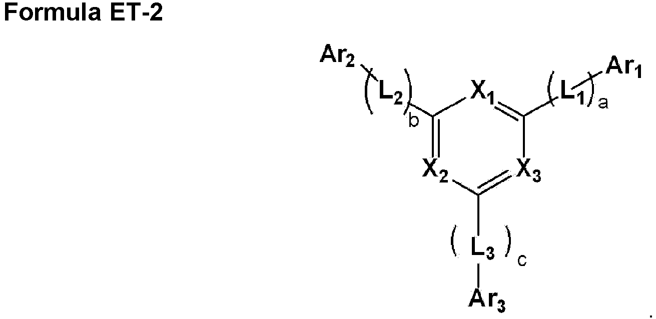

In Formula ET-2, at least one selected from among X₁ to X₃ may be N, and the remainder are CRₐ. Rₐ may be hydrogen, deuterium, a substituted or unsubstituted alkyl of 1 to 20 carbon atoms, a substituted or unsubstituted aryl group of 6 to 30 ring-forming carbon atoms, or a substituted or unsubstituted heteroaryl group of 2 to 30 ring-forming carbon atoms. Ar₁ to Ar₃ may each independently be hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms.

In Formula ET-2, "a" to "c" may each independently be an integer of 0 to 10. In Formula ET-2, L₁ to L₃ may each independently be a direct linkage, a substituted or unsubstituted arylene group of 6 to 30 ring-forming carbon atoms, or a substituted or unsubstituted heteroarylene group of 2 to 30 ring-forming carbon atoms. In some embodiments, when "a" to "c" each are integers of 2 or more, L₁(s) to L₃(s) may each independently be a substituted or unsubstituted arylene group of 6 to 30 ring-forming carbon atoms or a substituted or unsubstituted heteroarylene group of 2 to 30 ring-forming carbon atoms.

In one or more embodiments, the electron transport region ETR may include an anthracene-based compound. However, embodiments of the present disclosure are not limited thereto, for example, in some embodiments, the electron transport region ETR may include, for example, at least one selected from among tris(8-hydroxyquinolinato)aluminium (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzimidazolyl-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(biphenyl-4-yl)-4-phenyl-5-tert-butylphenyl-1,2,4-triazole (TAZ), 4-(naphthalen-1-yl)-3,5-diphenyl-4H-1,2,4-triazole (NTAZ), 2-(biphenyl-4-yl)-5-(4-tert-butylphenyl)-1,3,4-oxadiazole (tBu-PBD), bis(2-methyl-8-quinolinolato-N1,O8)-(1,1'-biphenyl-4-olato)aluminium (BAlq), berylliumbis(benzoquinolin-10-olate (Bebq₂), 9,10-di(naphthalen-2-yl)anthracene (ADN), 1,3-bis[3,5-di(pyridin-3-yl)phenyl]benzene (BmPyPhB), and mixtures thereof, without limitation.

In one or more embodiments, the electron transport region ETR may include at least one selected from among Compounds ET1 to ET36.

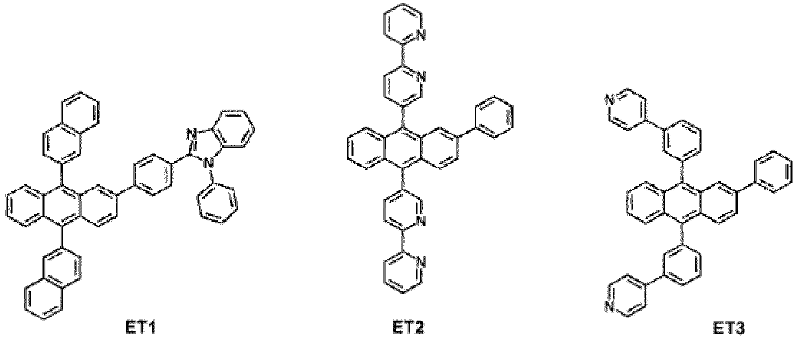

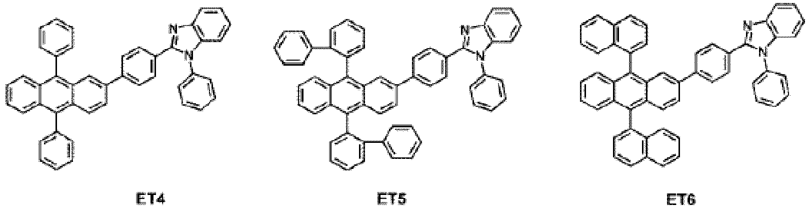

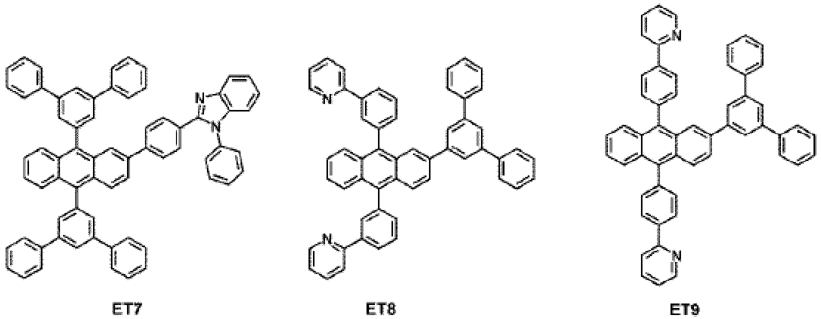

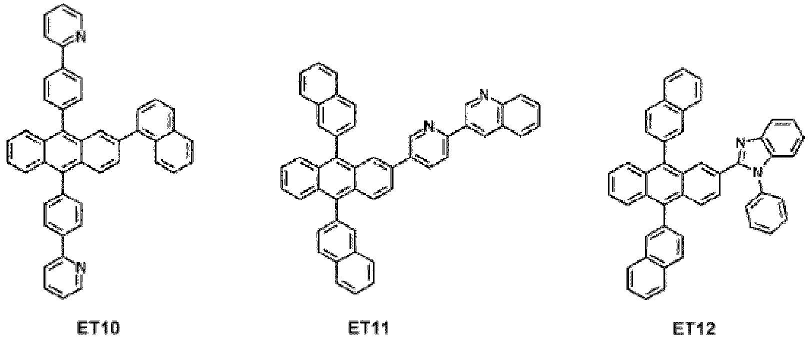

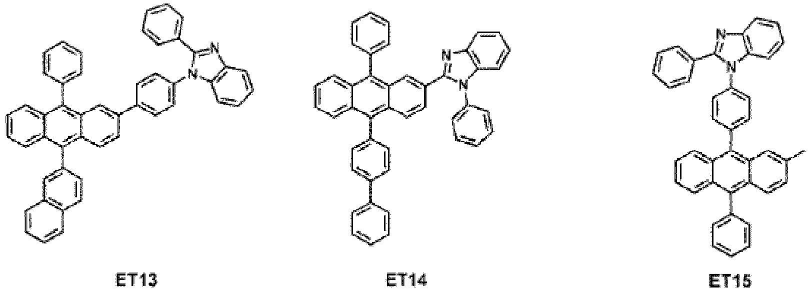

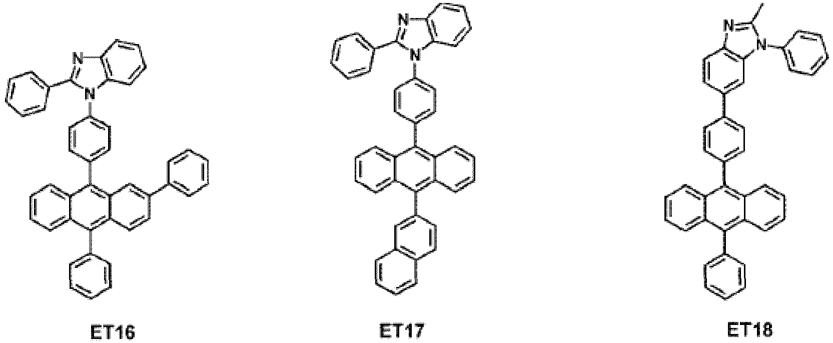

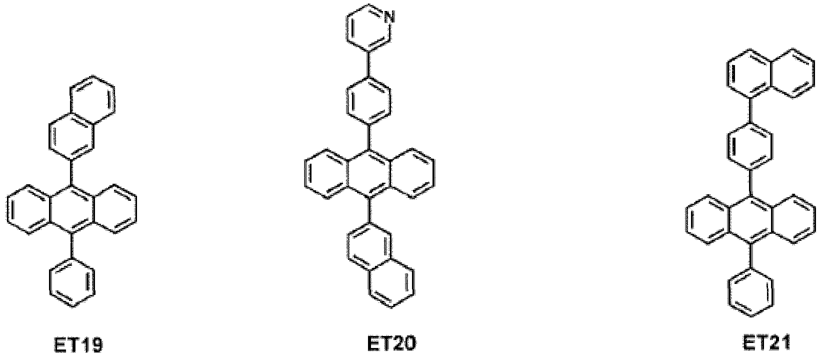

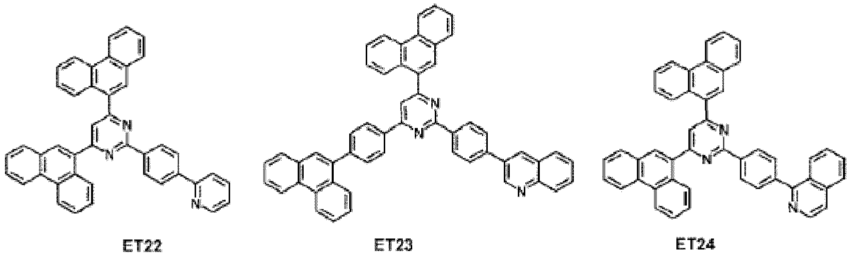

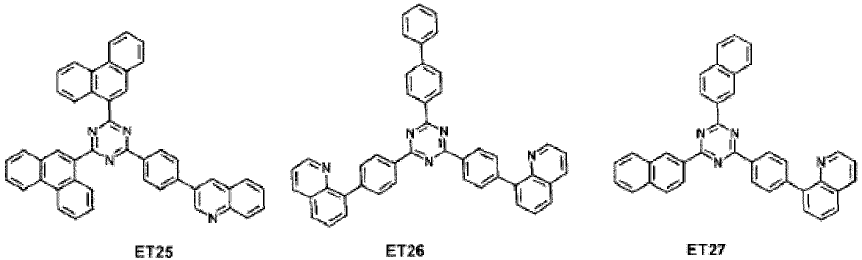

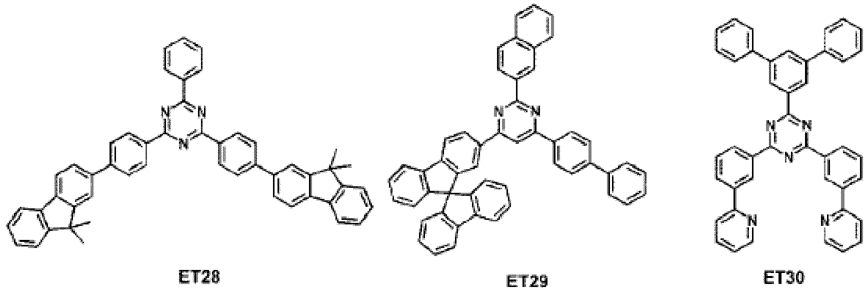

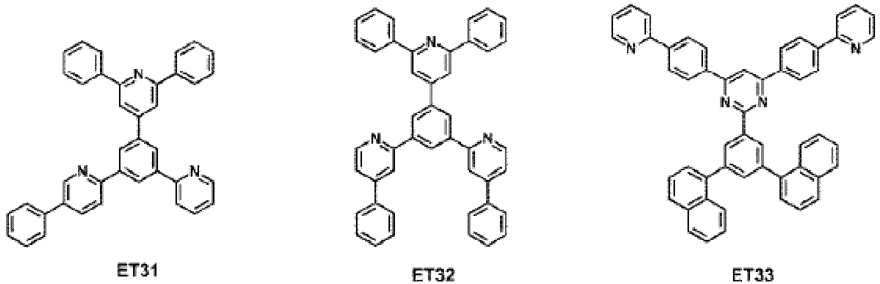

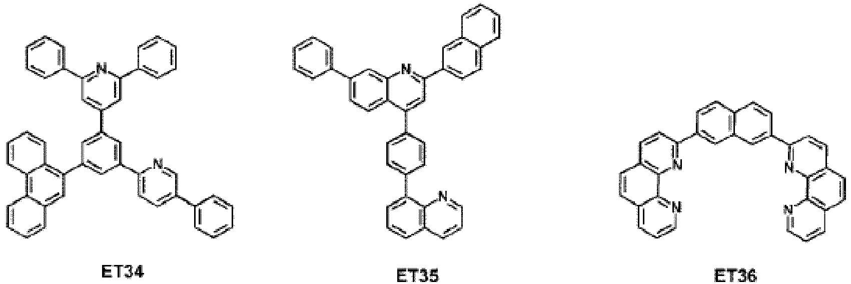

In some embodiments, the electron transport region ETR may include a metal halide such as LiF, NaCl, CsF, RbCl, Rbl, CuI, and/or KI, a lanthanide metal such as Yb, or a co-depositing material of the metal halide and the lanthanide metal. For example, in some embodiments, the electron transport region ETR may include KI:Yb, RbI:Yb, LiF:Yb, etc., as the co-depositing material. In some embodiments, the electron transport region ETR may utilize a metal oxide such as Li₂O and/or BaO, or 8-hydroxy-lithium quinolate (Liq). However, embodiments of the present disclosure are not limited thereto. In some embodiments, the electron transport region ETR also may be formed utilizing a mixture material of an electron transport material and an insulating organo metal salt. The organo metal salt may be a material having an energy band gap of about 4 eV or more. For example, the organo metal salt may include, for example, metal acetates, metal benzoates, metal acetoacetates, metal acetylacetonates, and/or metal stearates.

In one or more embodiments, the electron transport region ETR may include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen) in addition to the aforementioned materials. However, embodiments of the present disclosure are not limited thereto.

The electron transport region ETR may include the compounds of the electron transport region in at least one selected from among an electron injection layer EIL, an electron transport layer ETL, and a hole blocking layer HBL.

When the electron transport region ETR includes an electron transport layer ETL, a thickness of the electron transport layer ETL may be from about 100 Å to about 1,000 Å, for example, from about 150 Å to about 500 Å. When the thickness of the electron transport layer ETL satisfies the above-described range, satisfactory electron transport properties may be obtained without a substantial increase in driving voltage. When the electron transport region ETR includes an electron injection layer EIL, a thickness of the electron injection layer EIL may be from about 1 Å to about 100 Å, or from about 3 Å to about 90 Å. When the thickness of the electron injection layer EIL satisfies the above described range, satisfactory electron injection properties may be obtained without inducing a substantial increase in driving voltage.

The second electrode EL2 may be provided on the electron transport region ETR. The second electrode EL2 may be a common electrode. The second electrode EL2 may be a cathode or an anode, but embodiments of the present disclosure are not limited thereto. For example, when the first electrode EL1 is an anode, the second electrode EL2 may be a cathode, and when the first electrode EL1 is a cathode, the second electrode EL2 may be an anode.

The second electrode EL2 may be a transmissive electrode, a transflective electrode, or a reflective electrode. When the second electrode EL2 is the transmissive electrode, the second electrode EL2 may include a transparent metal oxide, for example, ITO, IZO, ZnO, ITZO, etc.

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, compounds thereof, or mixtures thereof (for example, AgMg, AgYb, or MgYb). In some embodiments, the second electrode EL2 may have a multilayered structure including a reflective layer or a transflective layer formed utilizing one or more selected from the above-described materials and a transparent conductive layer formed utilizing ITO, IZO, ZnO, ITZO, etc. For example, the second electrode EL2 may include one selected from the aforementioned metal materials, combinations of two or more metal materials selected from the aforementioned metal materials, or oxides of the aforementioned metal materials.

In some embodiments, the second electrode EL2 may be connected with an auxiliary electrode. When the second electrode EL2 is connected with the auxiliary electrode, the resistance of the second electrode EL2 may decrease.

In one or more embodiments, on the second electrode EL2 in the light emitting element ED, a capping layer CPL may be further disposed. In one or more embodiments, the capping layer CPL may be an organic layer or an inorganic layer. For example, in some embodiments, when the capping layer CPL includes an inorganic material, the inorganic material may include an alkali metal compound such as LiF, an alkaline earth metal compound such as MgF₂, SiON, SiNₓ, SiO_{y}, etc.

For example, in some embodiments, when the capping layer CPL includes an organic material, the organic material may include 2,2'-dimethyl-N,N'-di-[(1-naphthyl)-N,N'-diphenyl]-1,1'-biphenyl-4,4'-diamine(α-NPD), NPB, TPD, m-MTDATA, Alq₃, CuPc, N4,N4,N4',N4'-tetra(biphenyl-4-yl) biphenyl-4,4'-diamine (TPD15), 4,4',4"-tris(carbazol-9-yl) triphenylamine (TCTA), etc., and/or may include an epoxy resin and/or acrylate such as methacrylate. In some embodiments, the capping layer CPL may include at least one selected from among Compounds P1 to P5, but embodiments of the present disclosure are not limited thereto.

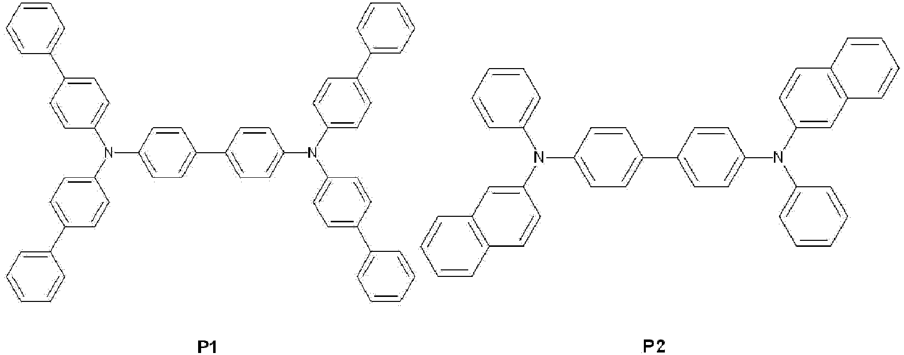

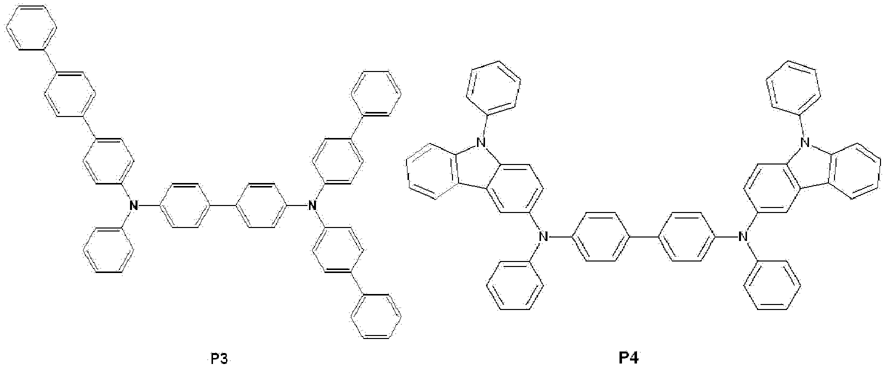

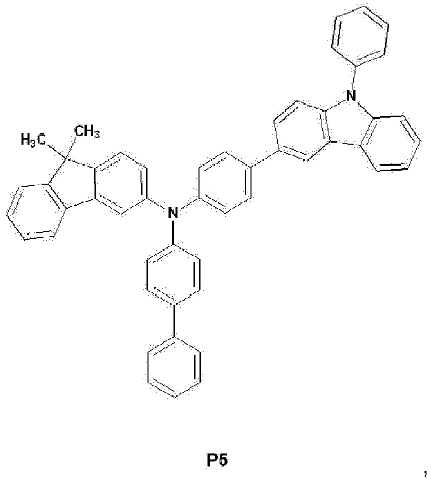

In some embodiments, the refractive index of the capping layer CPL may be about 1.6 or more. For example, in some embodiments, the refractive index of the capping layer CPL with respect to light in a wavelength range of about 550 nm to about 660 nm may be about 1.6 or more.

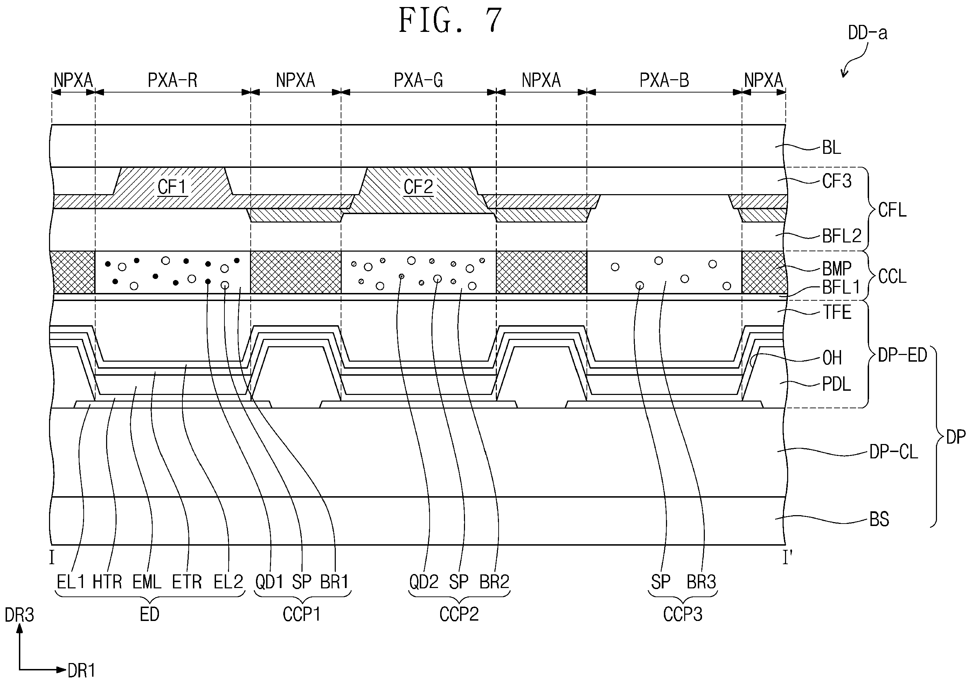

FIG. 7 to FIG. 10 are each a cross-sectional view on a display apparatus according to one or more embodiments of the present disclosure. In the explanation on the display apparatuses of embodiments by referring to FIG. 7 to FIG. 10, the overlapping parts with the explanation on FIG. 1 to FIG. 6 will not be explained/described again for conciseness, and only different features will be explained chiefly and mainly.

Referring to FIG. 7, the display apparatus DD-a according to one or more embodiments may include a display panel DP including a display device layer DP-ED, a light controlling layer CCL disposed on the display panel DP, and a color filter layer CFL. In one or more embodiments shown in FIG. 7, the display panel DP may include a base layer BS, a circuit layer DP-CL provided on the base layer BS, and a display device layer DP-ED, and the display device layer DP-ED may include a light emitting device ED.

The light emitting device ED may include a first electrode EL1, a hole transport region HTR on the first electrode EL1, an emission layer EML on the hole transport region HTR, an electron transport region ETR on the emission layer EML, and a second electrode EL2 on the electron transport region ETR. In one or more embodiments, the same structures as the light emitting devices of FIG. 3 to FIG. 6 may be applied to the structure of the light emitting device ED shown in FIG. 7.

The emission layer EML of the light emitting device ED included in the display device DD-a according to one or more embodiments may include the fused polycyclic compound of one or more embodiments described above.

Referring to FIG. 7, the emission layer EML may be disposed in an opening part OH defined in a pixel definition film PDL. For example, the emission layer EML divided by the pixel definition film PDL and correspondingly provided to each of luminous areas PXA-R, PXA-G, and PXA-B may be to emit light in substantially the same wavelength region. In the display apparatus DD-a of one or more embodiments, the emission layer EML may be to emit blue light. In some embodiments, the emission layer EML may be provided as a common layer for all luminous areas PXA-R, PXA-G, and PXA-B.

The light controlling layer CCL may be disposed on the display panel DP. The light controlling layer CCL may include a light converter. The light converter may be a quantum dot and/or a phosphor. The light converter may transform the wavelength of light provided and then emit. For example, the light controlling layer CCL may be a layer including a quantum dot or a layer including a phosphor.

The light controlling layer CCL may include multiple light controlling parts CCP1, CCP2, and CCP3. The light controlling parts CCP1, CCP2, and CCP3 may be separated and apart from one another.

Referring to FIG. 7, a partition pattern BMP may be disposed between the separated light controlling parts CCP1, CCP2, and CCP3, but embodiments of the present disclosure are not limited thereto. In FIG. 7, the partition pattern BMP is shown not to be overlapped with the light controlling parts CCP1, CCP2, and CCP3, but, in some embodiments, at least a portion of the edges of the light controlling parts CCP1, CCP2, and CCP3 may be overlapped with the partition pattern BMP.

The light controlling layer CCL may include a first light controlling part CCP1 including a first quantum dot QD1 converting first color light provided from the light emitting device ED into second color light, a second light controlling part CCP2 including a second quantum dot QD2 converting first color light into third color light, and a third light controlling part CCP3 transmitting first color light. In one or more embodiments, the first light controlling part CCP1 may provide red light which is the second color light, and the second light controlling part CCP2 may provide green light which is the third color light. The third color controlling part CCP3 may be to transmit and provide blue light which is the first color light provided from the light emitting device ED. For example, in some embodiments, the first quantum dot QD1 may be a red quantum dot to emit red light, and the second quantum dot QD2 may be a green quantum dot to emit green light. On the quantum dots QD1 and QD2, the same content as those described above may be applied.

In some embodiments, the light controlling layer CCL may further include a scatterer SP. The first light controlling part CCP1 may include the first quantum dot QD1 and the scatterer SP, the second light controlling part CCP2 may include the second quantum dot QD2 and the scatterer SP, and the third light controlling part CCP3 may not include a (e.g., may exclude any) quantum dot but include the scatterer SP.

The scatterer SP may be an inorganic particle. For example, the scatterer SP may include at least one selected from among TiO₂, ZnO, Al₂O₃, SiO₂, and hollow silica. In one or more embodiments, the scatterer SP may include at least one selected from among TiO₂, ZnO, Al₂O₃, SiO₂, and hollow silica, or may be a mixture of two or more materials selected from among TiO₂, ZnO, Al₂O₃, SiO₂, and hollow silica.

The first light controlling part CCP1, the second light controlling part CCP2, and the third light controlling part CCP3 may respectively include base resins BR1, BR2, and BR3 dispersing the quantum dots QD1 and QD2 and the scatterer SP. In one or more embodiments, the first light controlling part CCP1 may include the first quantum dot QD1 and the scatterer SP dispersed in a first base resin BR1, the second light controlling part CCP2 may include the second quantum dot QD2 and the scatterer SP dispersed in a second base resin BR2, and the third light controlling part CCP3 may include the scatterer particle SP dispersed in a third base resin BR3.

The base resins BR1, BR2 and BR3 are mediums in which the quantum dots QD1 and QD2 and the scatterer SP are dispersed, and may be composed of one or more suitable resin compositions which may be generally referred to as a binder. For example, the base resins BR1, BR2, and BR3 may each independently be acrylic resins, urethane-based resins, silicone-based resins, epoxy-based resins, etc. The base resins BR1, BR2 and BR3 may be transparent resins. In one or more embodiments, the first base resin BR1, the second base resin BR2, and the third base resin BR3 may be the same or different from each other.

In one or more embodiments, the light controlling layer CCL may include a barrier layer BFL1. The barrier layer BFL1 may play the role of blocking the penetration of moisture and/or oxygen (hereinafter, will be referred to as "humidity/oxygen"). The barrier layer BFL1 may block or reduce the exposure of the light controlling parts CCP1, CCP2 and CCP3 to humidity/oxygen. In some embodiments, the barrier layer BFL1 may cover the light controlling parts CCP1, CCP2, and CCP3. In some embodiments, a color filter layer CFL, which will be explained later, may include a barrier layer BFL2 disposed on the light controlling parts CCP1, CCP2, and CCP3.

The barrier layers BFL1 and BFL2 may include at least one inorganic layer. For example, in some embodiments, the barrier layers BFL1 and BFL2 may be formed by including an inorganic material. For example, the barrier layers BFL1 and BFL2 may be formed by including one or more selected from silicon nitride, aluminium nitride, zirconium nitride, titanium nitride, hafnium nitride, tantalum nitride, silicon oxide, aluminium oxide, titanium oxide, tin oxide, cerium oxide, silicon oxynitride, and a metal thin film securing light transmittance. In some embodiments, the barrier layers BFL1 and BFL2 may further include an organic layer. The barrier layers BFL1 and BFL2 may be composed of a single layer or multiple layers.

In one or more embodiments, in the display apparatus DD-a, the color filter layer CFL may be disposed on the light controlling layer CCL. For example, the color filter layer CFL may be disposed directly on the light controlling layer CCL. In these embodiments, the barrier layer BFL2 may not be provided.

The color filter layer CFL may include filters CF1, CF2, and CF3. Each of the first to third filters CF1, CF2, and CF3 may be disposed corresponding to a red luminous area PXA-R, a green luminous area PXA-G, and a blue luminous area PXA-B, respectively.

The color filter layer CFL may include a first filter CF1 transmitting the second color light, a second filter CF2 transmitting the third color light, and a third filter CF3 transmitting the first color light. For example, in some embodiments, the first filter CF1 may be a red filter, the second filter CF2 may be a green filter, and the third filter CF3 may be a blue filter. Each of the filters CF1, CF2, and CF3 may include a polymer photosensitive resin and a pigment and/or dye. The first filter CF1 may include a red pigment and/or dye, the second filter CF2 may include a green pigment and/or dye, and the third filter CF3 may include a blue pigment and/or dye.

However, embodiments of the present disclosure are not limited thereto, and the third filter CF3 may not include (e.g., may exclude) the pigment and/or dye (e.g., not include any pigment and/or dye). The third filter CF3 may include a polymer photosensitive resin and not include a pigment and/or dye. The third filter CF3 may be transparent. The third filter CF3 may be formed utilizing a transparent photosensitive resin.

In some embodiments, the first filter CF1 and the second filter CF2 may each be yellow filters. The first filter CF1 and the second filter CF2 may be provided in one body without distinction.

In one or more embodiments, the color filter layer CFL may further include a light blocking part. The light blocking part may be a black matrix. The light blocking part may be formed by including an organic light blocking material and/or an inorganic light blocking material including a black pigment and/or black dye. The light blocking part may prevent or reduce light leakage phenomenon and divide the boundaries among adjacent filters CF1, CF2, and CF3.

On the color filter layer CFL, a base substrate BL may be disposed/provided. The base substrate BL may be a member providing a base surface on which the color filter layer CFL, the light controlling layer CCL, etc. are disposed. The base substrate BL may be a glass substrate, a metal substrate, a plastic substrate, etc. However, embodiments of the present disclosure are not limited thereto, and the base substrate BL may be an inorganic layer, an organic layer, or a composite material layer. In some embodiments, the base substrate BL may not be provided.

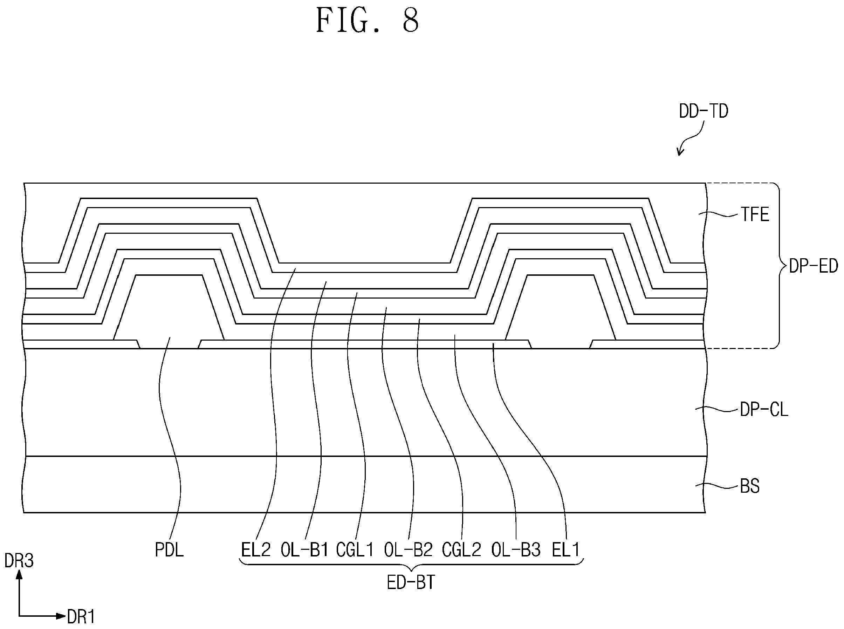

FIG. 8 is a cross-sectional view showing a portion of a display apparatus according to one or more embodiments. In a display apparatus DD-TD, a light emitting device ED-BT may include multiple light emitting structures OL-B1, OL-B2, and OL-B3. The light emitting device ED-BT may include oppositely disposed first electrode EL1 and second electrode EL2, and the multiple light emitting structures OL-B1, OL-B2, and OL-B3 stacked in order in a thickness direction and provided between the first electrode EL1 and the second electrode EL2. Each of the light emitting structures OL-B1, OL-B2, and OL-B3 may include an emission layer EML (FIG. 7), and a hole transport region HTR and an electron transport region ETR disposed with the emission layer EML (FIG. 7) therebetween.

For example, in some embodiments, the light emitting device ED-BT included in the display apparatus DD-TD may be a light emitting device of a tandem structure including multiple emission layers.

In one or more embodiments shown in FIG. 8, light emitted from the light emitting structures OL-B1, OL-B2, and OL-B3 may be all blue light. However, embodiments of the present disclosure are not limited thereto, and the wavelength regions of light emitted from the light emitting structures OL-B1, OL-B2, and OL-B3 may be different from each other. For example, in one or more embodiments, the light emitting device ED-BT including the multiple light emitting structures OL-B1, OL-B2, and OL-B3 emitting light in different wavelength regions may be to emit white light (e.g., combined white light).

Between neighboring light emitting structures OL-B1, OL-B2, and OL-B3, charge generating layers CGL1 and CGL2 may be disposed. The charge generating layers CGL1 and CGL2 may include a p-type or kind charge (e.g., P-charge) generating layer and/or an n-type or kind charge (e.g., N-charge) generating layer.

At least one selected from the light emitting structures OL-B1, OL-B2, and OL-B3 included in the display device DD-TD of one or more embodiments may include the fused polycyclic compound of one or more embodiments described above. For example, in one or more embodiments, at least one of the plurality of emission layers included in the light emitting device ED-BT may include the fused polycyclic compound of one or more embodiments.

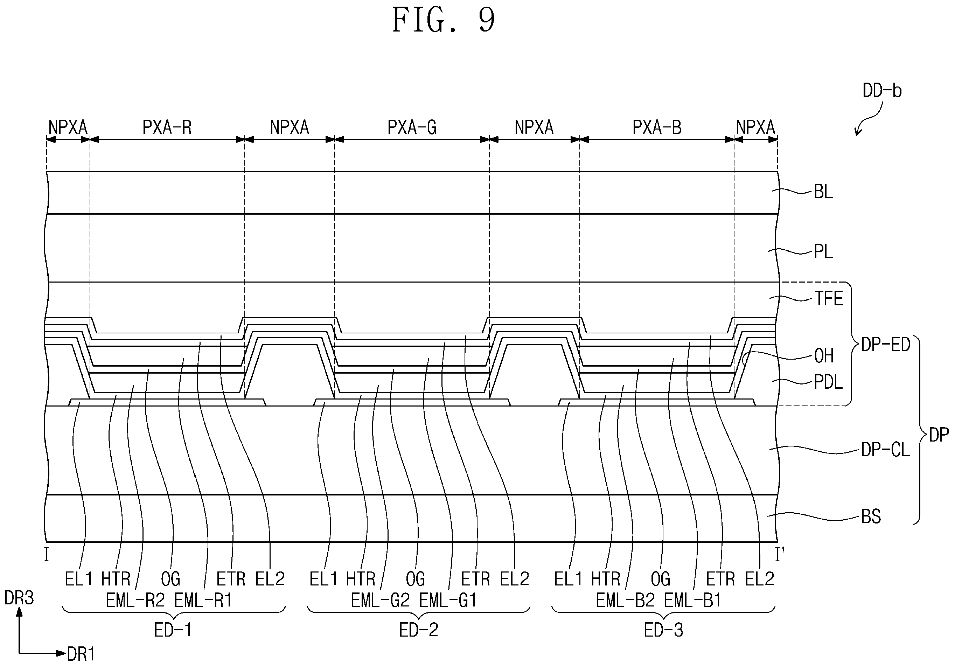

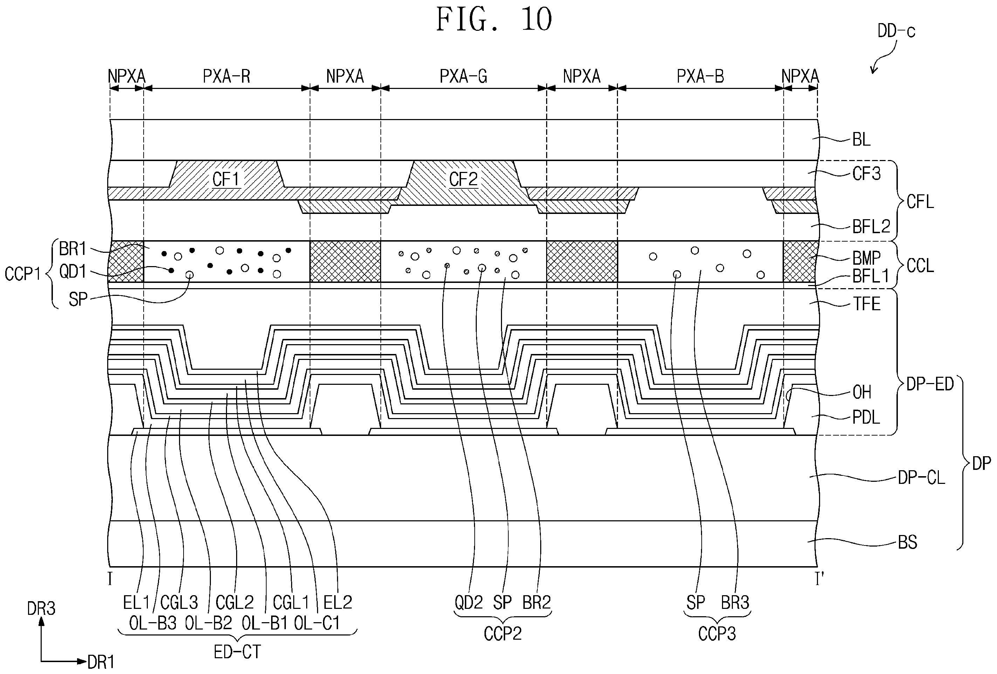

FIG. 9 is a cross-sectional view showing a display apparatus according to one or more embodiments of the present disclosure. FIG. 10 is a cross-sectional view showing a display apparatus according to one or more embodiments of the present disclosure.

Referring to FIG. 9, a display apparatus DD-b according to one or more embodiments may include light emitting devices ED-1, ED-2, and ED-3, formed by stacking two emission layers. Compared to the display apparatus DD shown in FIG. 2, the display apparatus DD-b shown in FIG. 9 is different in that first to third light emitting devices ED-1, ED-2, and ED-3 each include two emission layers stacked in a thickness direction. In the first to third light emitting devices ED-1, ED-2, and ED-3, the two emission layers may be to emit light in substantially the same wavelength region.

In one or more embodiments, the first light emitting device ED-1 may include a first red emission layer EML-R1 and a second red emission layer EML-R2. The second light emitting device ED-2 may include a first green emission layer EML-G1 and a second green emission layer EML-G2. In addition, the third light emitting device ED-3 may include a first blue emission layer EML-B1 and a second blue emission layer EML-B2. Between the first red emission layer EML-R1 and the second red emission layer EML-R2, between the first green emission layer EML-G1 and the second green emission layer EML-G2, and between the first blue emission layer EML-B1 and the second blue emission layer EML-B2, an emission auxiliary part OG may be disposed.

The emission auxiliary part OG may include a single layer or a multilayer. The emission auxiliary part OG may include a charge generating layer. In one or more embodiments, the emission auxiliary part OG may include an electron transport region, a charge generating layer, and a hole transport region stacked in order (e.g., in the stated order). The emission auxiliary part OG may be provided as a common layer in all of the first to third light emitting devices ED-1, ED-2, and ED-3. However, embodiments of the present disclosure are not limited thereto, and the emission auxiliary part OG may be patterned and provided in an opening part OH defined in a pixel definition film PDL.

The first red emission layer EML-R1, the first green emission layer EML-G1 and the first blue emission layer EML-B1 may each be disposed between the electron transport region ETR and the emission auxiliary part OG. The second red emission layer EML-R2, the second green emission layer EML-G2 and the second blue emission layer EML-B2 may each be disposed between the emission auxiliary part OG and the hole transport region HTR.

For example, in one or more embodiments, the first light emitting device ED-1 may include a first electrode EL1, a hole transport region HTR, a second red emission layer EML-R2, an emission auxiliary part OG, a first red emission layer EML-R1, an electron transport region ETR, and a second electrode EL2, stacked in order (e.g., in the stated order). The second light emitting device ED-2 may include a first electrode EL1, a hole transport region HTR, a second green emission layer EML-G2, an emission auxiliary part OG, a first green emission layer EML-G1, an electron transport region ETR, and a second electrode EL2, stacked in order (e.g., in the stated order). The third light emitting device ED-3 may include a first electrode EL1, a hole transport region HTR, a second blue emission layer EML-B2, an emission auxiliary part OG, a first blue emission layer EML-B1, an electron transport region ETR, and a second electrode EL2, stacked in order (e.g., in the stated order).

In some embodiments, an optical auxiliary layer PL may be disposed on a display device layer DP-ED. The optical auxiliary layer PL may include a polarization layer. The optical auxiliary layer PL may be disposed on a display panel DP and may control reflected light at the display panel DP by external light. In some embodiments, the optical auxiliary layer PL may not be provided in the display apparatus.

In one or more embodiments, at least one emission layer included in the display device DD-b shown in FIG. 9 may include the fused polycyclic compound of one or more embodiments described above. For example, in some embodiments, at least one of the first blue emission layer EML-B1 or the second blue emission layer EML-B2 may include the fused polycyclic compound of one or more embodiments.

Different from FIG. 8 and FIG. 9, a display apparatus DD-c in FIG. 10 is shown to include four light emitting structures OL-B1, OL-B2, OL-B3, and OL-C1. A light emitting device ED-CT may include oppositely disposed first electrode EL1 and second electrode EL2, and first to fourth light emitting structures OL-B1, OL-B2, OL-B3, and OL-C1 stacked in a thickness direction between the first electrode EL1 and the second electrode EL2. Between the first to fourth light emitting structures OL-B1, OL-B2, OL-B3, and OL-C1, charge generating layers CGL1, CGL2 and CGL3 may be disposed. Among the four light emitting structures, the first to third light emitting structures OL-B1, OL-B2, and OL-B3 may be to emit blue light, and the fourth light emitting structure OL-C1 may be to emit green light. However, embodiments of the present disclosure are not limited thereto, and the first to fourth light emitting structures OL-B1, OL-B2, OL-B3, and OL-C1 may be to emit different wavelengths of light.

Charge generating layers CGL1, CGL2, and CGL3 disposed among neighboring light emitting structures OL-B1, OL-B2, OL-B3, and OL-C1 may include a p-type or kind charge (e.g., P-charge) generating layer and/or an n-type or kind charge (e.g., N-charge) generating layer.

At least one selected from the light emitting structures OL-B1, OL-B2, OL-B3, and OL-C1 included in the display device DD-c according to one or more embodiments may include the fused polycyclic compound of one or more embodiments described above. For example, in one or more embodiments, at least one selected from the first to third light emitting structures OL-B1, OL-B2, and OL-B3 may include the fused polycyclic compound of one or more embodiments described above.

The light emitting device/element ED described above according to one or more embodiments of the present disclosure includes the fused polycyclic compound of one or more embodiments in at least one functional layer disposed between the first electrode EL1 and the second electrode EL2, and may thus exhibit excellent or suitable light emitting efficiency and improved lifespan. For example, the fused polycyclic compound according to one or more embodiments may be included in the emission layer EML of the light emitting element ED of one or more embodiments, and the light emitting element of one or more embodiments may exhibit long lifespan.

In one or more embodiments, an electronic apparatus may include a display apparatus including multiple light emitting devices and a control part controlling the display apparatus. The electronic apparatus of one or more embodiments may be an apparatus activated according to electrical signals. The electronic apparatus may include display apparatuses of one or more suitable embodiments. For example, the electronic apparatus may include at least one selected from televisions, monitors, large-size display apparatuses such as outside billboards, personal computers, laptop computers, personal digital terminals, display apparatuses for automobiles, game consoles, portable electronic devices, and medium- and small-size display apparatuses such as cameras.

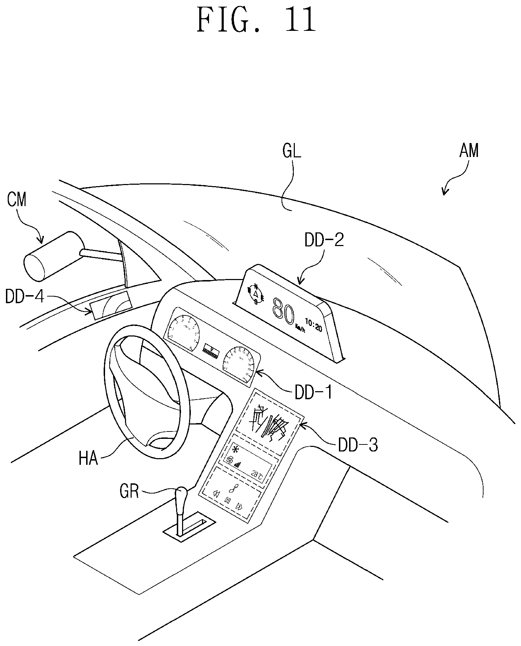

FIG. 11 is a diagram showing an automobile AM in which first to fourth display apparatuses DD-1, DD-2, DD-3, and DD-4 are disposed. At least one selected from among the first to fourth display apparatuses DD-1, DD-2, DD-3, and DD-4 may include substantially the same configurations of the display apparatuses DD, DD-TD, DD-a, DD-b, and/or DD-c, explained referring to FIGs. 1, 2, and 7 to 10.

In FIG. 11, a vehicle is shown as an automobile AM, but this is a mere example. The first to fourth display apparatuses DD-1, DD-2, DD-3, and DD-4 may be disposed on other transport apparatus such as bicycles, motorcycles, trains, ships, and/or airplanes. In some embodiments, at least one selected from among the first to fourth display apparatuses DD-1, DD-2, DD-3, and DD-4 including substantially the same configurations of the display apparatuses DD, DD-TD, DD-a, DD-b, and/or DD-c may be introduced in personal computers, laptop computers, personal digital terminals, game consoles, portable electronic devices, televisions, monitors, external billboards, and/or the like. These are mere examples, and the display apparatus may be introduced in other electronic devices as long as not deviated from the present disclosure.

In one or more embodiments, at least one selected from among the first to fourth display devices DD-1, DD-2, DD-3, and DD-4 may include the light emitting element ED of one or more embodiments described with reference to FIGs. 3 to 6. The light emitting element ED according to one or more embodiments may include the fused polycyclic compound of one or more embodiments. In one or more embodiments, at least one selected from the first to fourth display devices DD-1, DD-2, DD-3, and DD-4 may include a light emitting element ED containing the fused polycyclic compound of one or more embodiments, thereby increasing lifespan of the display devices.

Referring to FIG. 11, an automobile AM may include a steering wheel HA for the operation of the automobile AM and a gear GR. In addition, the automobile AM may include a front window GL disposed to face a driver.

A first display apparatus DD-1 may be disposed in a first region overlapping with the steering wheel HA. For example, the first display apparatus DD-1 may be a digital cluster displaying first information of the automobile AM. The first information may include a first graduation showing the travel speed of the automobile AM, a second graduation showing the number of revolution of an engine (i.e., revolutions per minute (RPM)), and images showing a fuel state. The first graduation and second graduation may be represented by digital images.

A second display apparatus DD-2 may be disposed in a second region facing a driver seat and overlapping with the front window GL. The driver seat may be a seat where the steering wheel HA faces. For example, the second display apparatus DD-2 may be a head up display (HUD) showing second information of the automobile AM. The second display apparatus DD-2 may be optically clear. The second information may include digital numbers showing the travel speed of the automobile AM and may further include information including the current time. In some embodiments, the second information of the second display apparatus DD-2 may be projected and displayed on the front window GL.

A third display apparatus DD-3 may be disposed in a third region adjacent to the gear GR. For example, the third display apparatus DD-3 may be a center information display (CID) for the automobile, disposed between a driver seat and a passenger seat and showing third information. The passenger seat may be a seat separated from the driver seat with the gear GR therebetween. The third information may include information on road conditions (for example, navigation information), on playing music or radio, on playing a dynamic image (or image), on the temperature in the automobile AM, and/or the like.

A fourth display apparatus DD-4 may be disposed in a fourth region separated from the steering wheel HA and the gear GR and adjacent to a side of the automobile AM. For example, the fourth display apparatus DD-4 may be a digital wing mirror displaying fourth information. The fourth display apparatus DD-4 may display external images of the automobile AM, taken by a camera module CM disposed at the outside of the automobile AM. The fourth information may include external images of the automobile AM.

The above-described first to fourth information are mere examples, and the first to fourth display apparatuses DD-1, DD-2, DD-3, and DD-4 may further display information on the inside and outside of the automobile. The first to fourth information may include different information from each other. However, embodiments of the present disclosure are not limited thereto, for example, in some embodiments, a portion of the first to fourth information may include the same information.

Hereinafter, with reference to Examples and Comparative Examples, a fused polycyclic compound and a light emitting element of one or more embodiments of the present disclosure will be specifically described. In addition, Examples described herein are shown only for the understanding of the present disclosure, and the scope of the present disclosure is not limited thereto.

### Examples

### 1. Synthesis of Fused Polycyclic Compounds

First, a process of synthesizing fused polycyclic compounds according to one or more embodiments of the present disclosure will be described in more detail by presenting a process of synthesizing Compounds B-9, C-5, D-9, and G-4 as an example. In addition, the process of synthesizing fused polycyclic compounds, which will be described hereinafter, is provided as a mere example, and thus a process of synthesizing fused polycyclic compounds according to one or more embodiments of the present disclosure is not limited to Examples.

### (1) Synthesis of Intermediate a

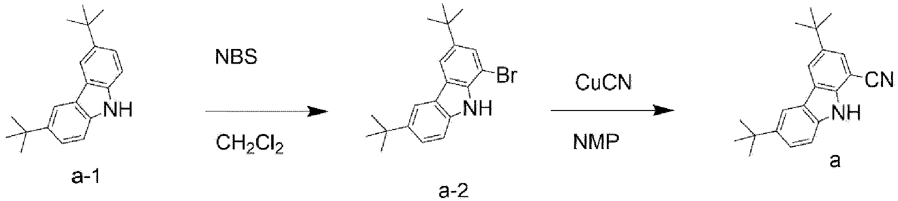

In a three-neck flask, Intermediate a-1 (200 mmol) and N-bromosuccinimide (NBS, 100 mmol) were added to perform argon (Ar) substitution, and then dichloromethane (DCM, CH₂Cl₂, 200 mL) was added thereto and stirred at room temperature for 24 hours. Water was then added to a reaction system to extract an organic layer utilizing DCM, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (160 mmol, yield: 80%). The obtained purified product was determined to have a molecular weight of 358 through fast atom bombardment-mass spectrometry (FAB-MS) measurement, indicating that Intermediate a-2 was obtained.

In a three-neck flask, Intermediate a-2 (160 mmol) and CuCN (480 mmol) were added to perform Ar substitution, and then N-methyl-2-Pyrrolidinone (NMP, 100 mL) was added thereto and stirred at 150 °C for 50 hours. Water was then added to a reaction system to extract an organic layer utilizing DCM, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (134 mmol, yield: 84%). The obtained purified product was determined to have a molecular weight of 304 through FAB-MS measurement, indicating that Intermediate a was obtained.

### (2) Synthesis of Intermediate b

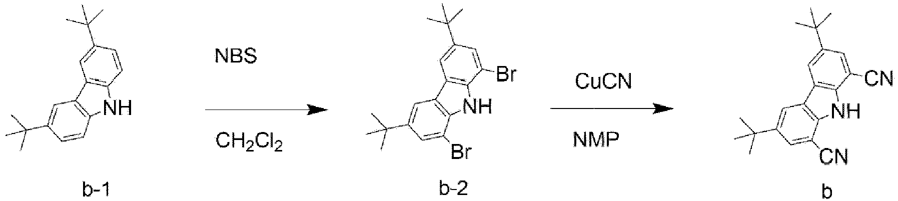

In a three-neck flask, Intermediate b-1 (200 mmol) and NBS (220 mmol) were added to perform Ar substitution, and then DCM (200 mL) was added thereto and stirred at room temperature for 24 hours. Water was then added to a reaction system to extract an organic layer utilizing DCM, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (188 mmol, yield: 94%). The obtained purified product was determined to have a molecular weight of 437 through FAB-MS measurement, indicating that Intermediate b-2 was obtained.

In a three-neck flask, Intermediate b-2 (188 mmol) and CuCN (754 mmol) were added to perform Ar substitution, and then NMP (150 mL) was added thereto and stirred at 150 °C for 60 hours. Water was then added to a reaction system to extract an organic layer utilizing DCM, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (161 mmol, yield: 86%). The obtained purified product was determined to have a molecular weight of 329 through FAB-MS measurement, indicating that Intermediate b was obtained.

### (3) Synthesis of Intermediate c

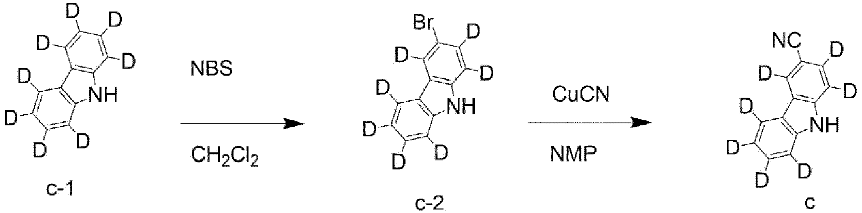

In a three-neck flask, Intermediate c-1 (2000 mmol) and NBS (1000 mmol) were added to perform Ar substitution, and then DCM (1000 mL) was added thereto and stirred at room temperature for 24 hours. Water was then added to a reaction system to extract an organic layer utilizing DCM, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (200 mmol, yield: 10%). The obtained purified product was determined to have a molecular weight of 253 through FAB-MS measurement, indicating that Intermediate c-2 was obtained.

In a three-neck flask, Intermediate c-2 (200 mmol) and CuCN (400 mmol) were added to perform Ar substitution, and then NMP (200 mL) was added thereto and stirred at 150 °C for 60 hours. Water was then added to a reaction system to extract an organic layer utilizing DCM, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (87 mmol, yield: 43%). The obtained purified product was determined to have a molecular weight of 199 through FAB-MS measurement, indicating that Intermediate c was obtained.

### (4) Synthesis of Compound B-9

### (Synthesis of Intermediate B-9a)

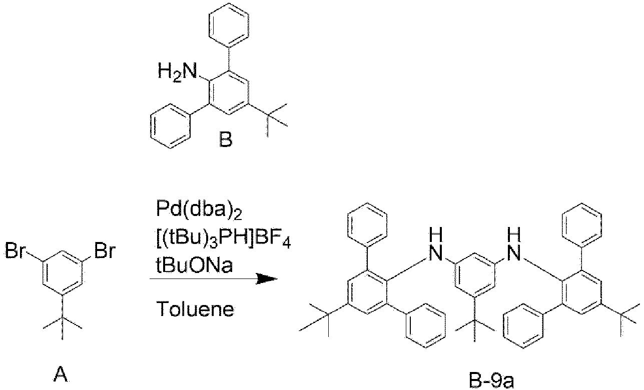

In a three-neck flask, Intermediate A (150 mmol), Intermediate B (300 mmol), tBuONa (450 mmol), palladium(0) bis(dibenzylideneacetone) (Pd(dba)₂) (15 mmol), and [(tBu)₃PH]BF₄ (30 mmol) were added to perform Ar substitution, and then toluene (1000 mL) was added thereto and stirred at 100 °C for 5 hours. Water was then added to a reaction system to extract an organic layer utilizing toluene, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (129 mmol, yield: 86%). The obtained purified product was determined to have a molecular weight of 733 through FAB-MS measurement, indicating that Intermediate B-9a was obtained.

### (Synthesis of Intermediate B-9b)

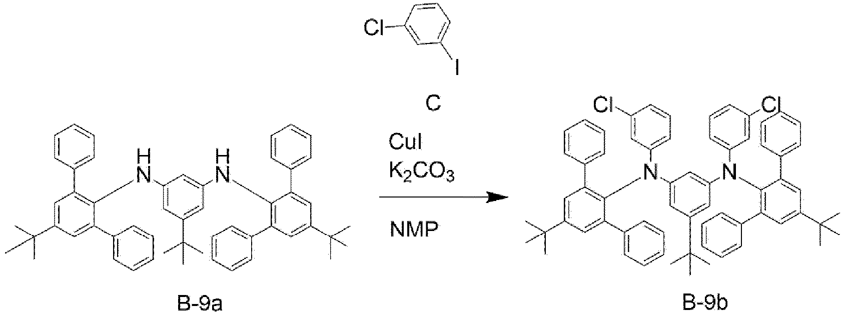

In a three-neck flask, Intermediate B-9a (129 mmol), Intermediate C (1290 mmol), K₂CO₃ (645 mmol), and CuI (141 mmol) were added to perform Ar substitution, and then NMP (50 mL) was added thereto and stirred at 200 °C for 50 hours. Water was then added to a reaction system to extract an organic layer utilizing toluene, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (101 mmol, yield: 78%). The obtained purified product was determined to have a molecular weight of 954 through FAB-MS measurement, indicating that Intermediate B-9b was obtained.

### (Synthesis of Intermediate B-9c)

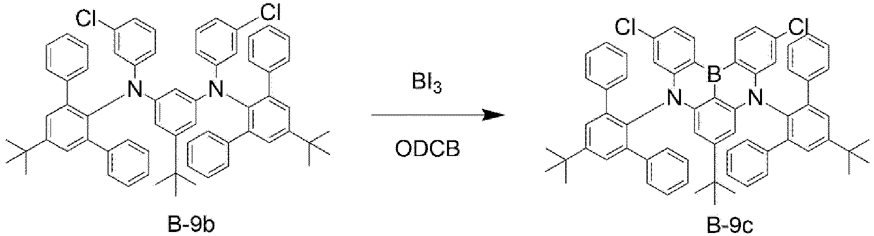

In a three-neck flask, Intermediate B-9b (101 mmol) was added to perform Ar substitution, and then o-dichlorobenzene (ODCB, 100 mL) was added and dissolved, and then BI₃ (202 mmol) was added thereto and stirred at 160 °C for 17 hours. The reaction solution was dispersed and washed utilizing a large amount of acetonitrile, and the solid was collected through filtration. The obtained crude product was purified through silica gel column chromatography (a mixed solvent of hexane/dichloromethane as an eluent) and recrystallization (a mixed solvent of ethanol/toluene) to obtain a yellow solid (45 mmol, yield: 45%). The obtained purified product was determined to have a molecular weight of 962 through FAB-MS measurement, indicating that Intermediate B-9c was obtained.

### (Synthesis of Compound B-9)

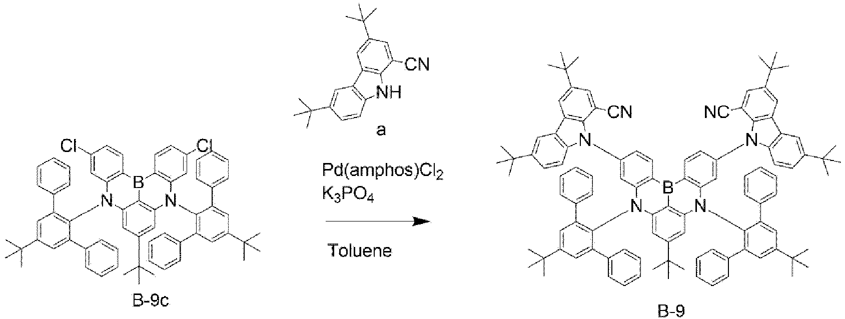

In a three-neck flask, Intermediate B-9c (45 mmol), Intermediate a (100 mmol), K₃PO₄ (160 mmol), and bis(di-tert-butyl(4-dimethylaminophenyl) phosphine) dichloropalladium(II) (Pd(amphos)Cl₂) (4 mmol) were added to perform Ar substitution, and then toluene (60 mL) was added thereto and stirred at 110 °C for 24 hours. Water was then added to a reaction system to extract an organic layer utilizing toluene, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a yellow solid (19 mmol, yield: 42%). The obtained purified product was determined to have a molecular weight of 1498 through FAB-MS measurement, indicating that Compound B-9 was obtained.

### (5) Synthesis of Compound C-5

### (Synthesis of Intermediate C-5a)

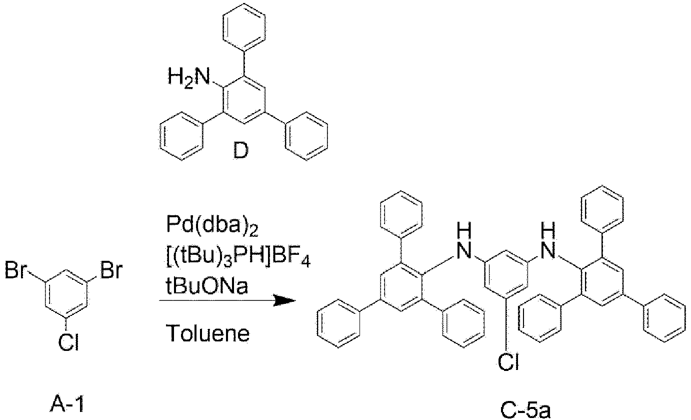

In a three-neck flask, Intermediate A-1 (150 mmol), Intermediate D (300 mmol), tBuONa (450 mmol), Pd(dba)₂ (15 mmol), and [(tBu)₃PH]BF₄ (30 mmol) were added to perform Ar substitution, and then toluene (1000 mL) was added thereto and stirred at 80 °C for 12 hours. Water was then added to a reaction system to extract an organic layer utilizing toluene, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (140 mmol, yield: 93%). The obtained purified product was determined to have a molecular weight of 751 through FAB-MS measurement, indicating that Intermediate C-5a was obtained.

### (Synthesis of Intermediate C-5b)

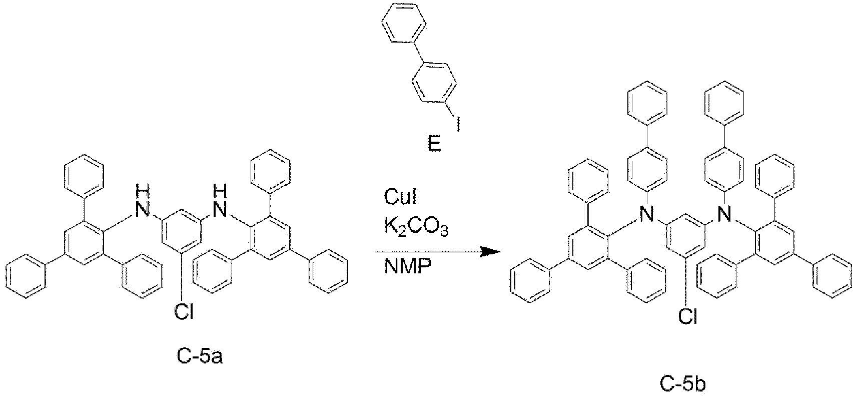

In a three-neck flask, Intermediate C-5a (140 mmol), Intermediate E (1400 mmol), K₂CO₃ (700 mmol), and CuI (140 mmol) were added to perform Ar substitution, and then NMP (50 mL) was added thereto and stirred at 210 °C for 48 hours. Water was then added to a reaction system to extract an organic layer utilizing toluene, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (128 mmol, yield: 91%). The obtained purified product was determined to have a molecular weight of 1056 through FAB-MS measurement, indicating that Intermediate C-5b was obtained.

### (Synthesis of Intermediate C-5c)

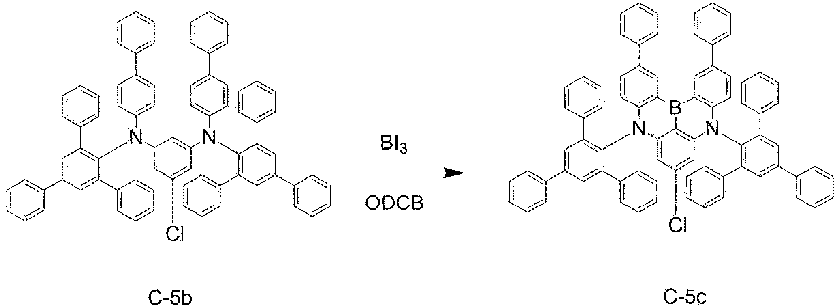

In a three-neck flask, Intermediate C-5b (128 mmol) was added to perform Ar substitution, and then ODCB (100 mL) was added and dissolved, and then BI₃ (256 mmol) was added thereto and stirred at 160 °C for 3 hours. The reaction solution was dispersed and washed utilizing a large amount of acetonitrile, and the solid was collected through filtration. The obtained crude product was purified through silica gel column chromatography (a mixed solvent of hexane/dichloromethane as an eluent) and recrystallization (a mixed solvent of ethanol/toluene) to obtain a yellow solid (25 mmol, yield: 20%). The obtained purified product was determined to have a molecular weight of 1064 through FAB-MS measurement, indicating that Intermediate C-5c was obtained.

### (Synthesis of Compound C-5)

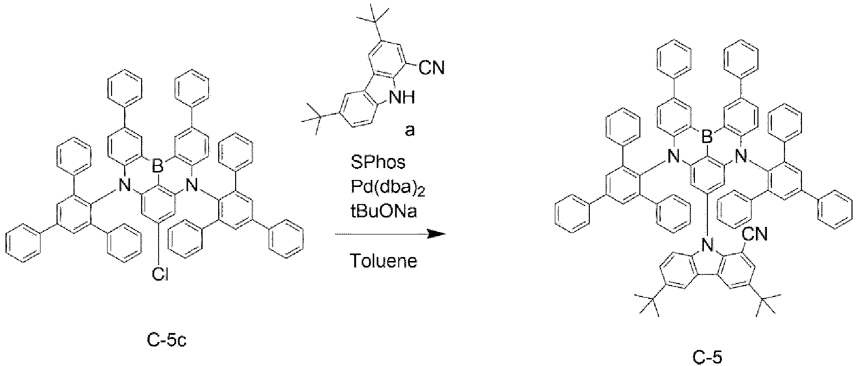

In a three-neck flask, Intermediate C-5c (25 mmol), Intermediate a (50 mmol), tBuONa (50mmol), Pd(dba)₂ (5 mmol), and 2-dicyclohexylphosphino-2',6'-dimethoxybiphenyl (SPhos) (10 mmol) were added to perform Ar substitution, and then toluene (30 mL) was added thereto and stirred at 110 °C for 6 hours. Water was then added to a reaction system to extract an organic layer, utilizing toluene, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a yellow solid (20 mmol, yield: 80%). The obtained purified product was determined to have a molecular weight of 1332 through FAB-MS measurement, indicating that Intermediate C-5 was obtained.

### (6) Synthesis of Compound D-9

### (Synthesis of Intermediate I)

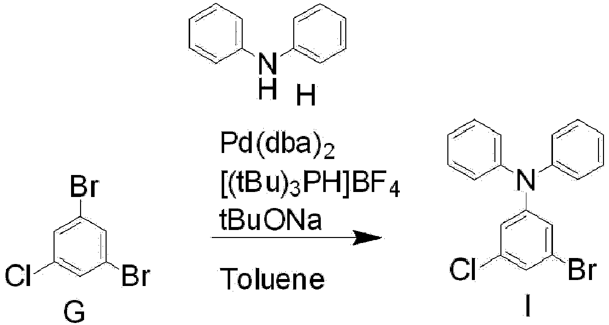

In a three-neck flask, Intermediate G (150 mmol), Intermediate H (150 mmol), tBuONa (300 mmol), Pd(dba)₂ (15 mmol), and [(tBu)₃PH]BF₄ (30 mmol) were added to perform Ar substitution, and then toluene (500 mL) was added thereto and stirred at 80 °C for 5 hours. Water was then added to a reaction system to extract an organic layer utilizing toluene, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (56 mmol, yield: 37%).

### (Synthesis of Intermediate D-9a)

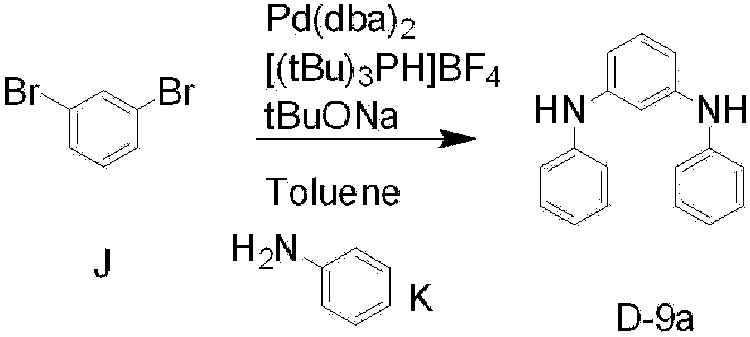

In a three-neck flask, Intermediate J (150 mmol), Intermediate K (350 mmol), tBuONa (450 mmol), Pd(dba)₂ (15 mmol), and [(tBu)₃PH]BF₄ (30 mmol) were added to perform Ar substitution, and then toluene (1000 mL) was added thereto and stirred at 80 °C for 12 hours. Water was then added to a reaction system to extract an organic layer utilizing toluene, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (123 mmol, yield: 82%). The obtained purified product was determined to have a molecular weight of 260 through FAB-MS measurement, indicating that Intermediate D-9a was obtained.

### (Synthesis of Intermediate D-9b)

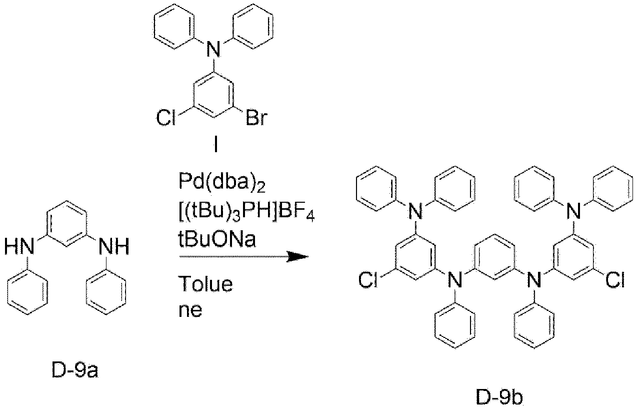

In a three-neck flask, Intermediate D-9a (123 mmol), Intermediate I (246 mmol), tBuONa (369 mmol), Pd(dba)₂ (12 mmol), and [(tBu)₃PH]BF₄ (24 mmol) were added to perform Ar substitution, and then toluene (1000 mL) was added thereto and stirred at 80 °C for 15 hours. Water was then added to a reaction system to extract an organic layer utilizing toluene, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a white solid (105 mmol, yield: 85%). The obtained purified product was determined to have a molecular weight of 816 through FAB-MS measurement, indicating that Intermediate D-9b was obtained.

### (Synthesis of Intermediate D-9c)

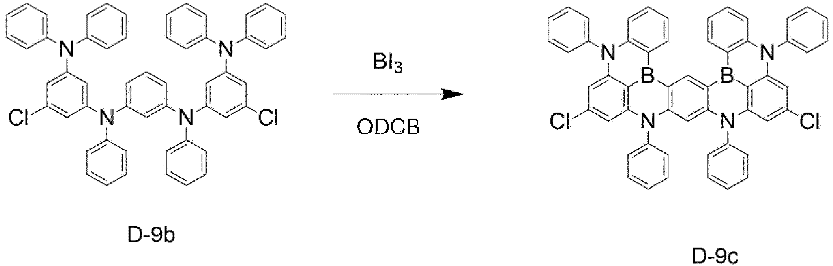

In a three-neck flask, Intermediate D-9b (105 mmol) was added to perform Ar substitution, and then ODCB (50 mL) was added and dissolved, and then BI₃ (210 mmol) was added thereto and stirred at 160 °C for 13 hours. The reaction solution was dispersed and washed utilizing a large amount of acetonitrile, and the solid was collected through filtration. The obtained crude product was purified through silica gel column chromatography (a mixed solvent of hexane/dichloromethane as an eluent) and recrystallization (a mixed solvent of ethanol/toluene) to obtain a yellow solid (34 mmol, yield: 32%). The obtained purified product was determined to have a molecular weight of 831 through FAB-MS measurement, indicating that Intermediate D-9c was obtained.

### (Synthesis of Compound D-9)

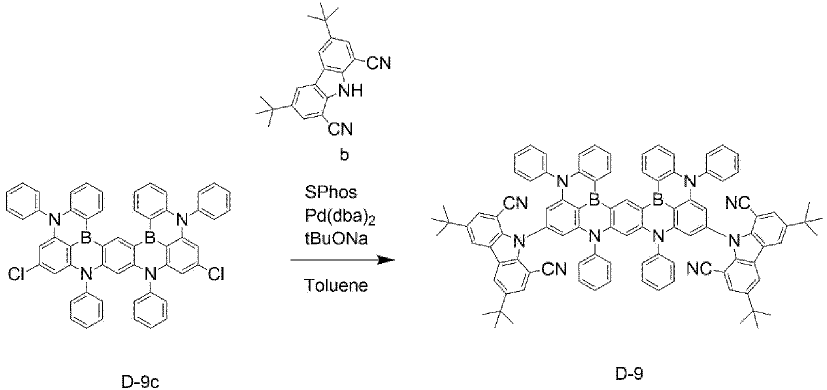

In a three-neck flask, Intermediate D-9c (34 mmol), Intermediate b (68 mmol), tBuONa (68mmol), Pd(dba)₂ (4 mmol), and SPhos (8 mmol) were added to perform Ar substitution, and then toluene (50 mL) was added thereto and stirred at 110 °C for 8 hours. Water was then added to a reaction system to extract an organic layer, utilizing toluene, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene) to obtain a yellow solid (21 mmol, yield: 62%). The obtained purified product was determined to have a molecular weight of 1417 through FAB-MS measurement, indicating that Compound D-9 was obtained.

### (7) Synthesis of Compound G-4

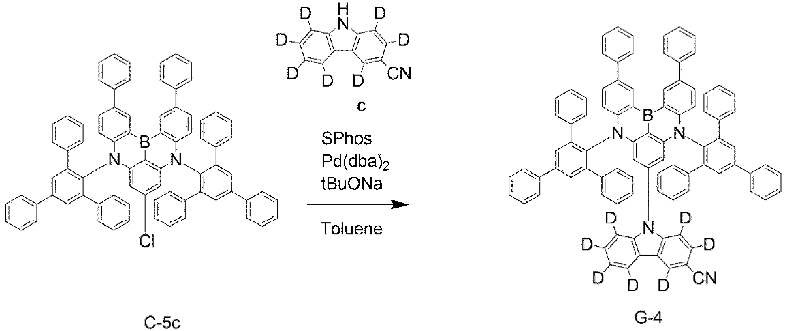

In a three-neck flask, Intermediate C-5c (25 mmol), Intermediate c (50 mmol), tBuONa (50mmol), Pd(dba)₂ (5 mmol), and SPhos (10 mmol) were added to perform Ar substitution, and then toluene (30 mL) was added thereto and stirred at 110 °C for 12 hours. Water was then added to a reaction system to extract an organic layer utilizing toluene, and the resulting product was dried with magnesium sulfate to distill off a solvent. The obtained crude product was purified through silica gel column chromatography (a mixed solvent of hexane/toluene as an eluent) and recrystallization (a mixed solvent of ethanol/toluene as an eluent) to obtain a yellow solid (15 mmol, yield: 60%). The obtained purified product was determined to have a molecular weight of 1226 through FAB-MS measurement, indicating that Compound G-4 was obtained.

### 2. Preparation and Evaluation of Light Emitting Elements

Light emitting elements of one or more embodiments including a fused polycyclic compound of one or more embodiments in an emission layer were each prepared utilizing a method described herein. Light emitting elements of Examples 1 to 4 were respectively prepared utilizing fused polycyclic compounds of Compounds B-9, C-5, D-9, and G-4, which are Example Compounds described above, as a dopant material of an emission layer. Comparative Examples 1 to 7 correspond to light emitting elements prepared utilizing Comparative Example Compound X-1 to X-7 as a dopant material of an emission layer, respectively.

### Example Compound

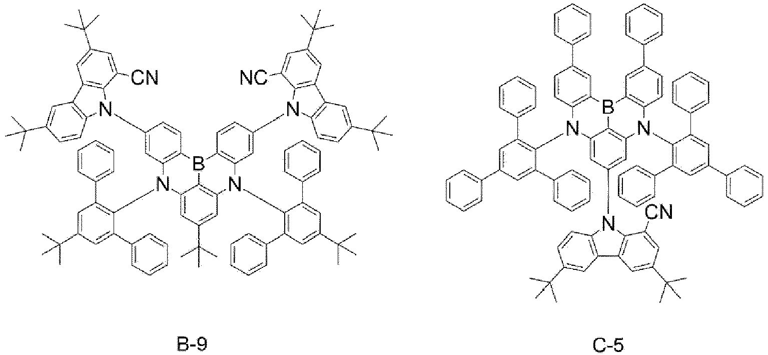

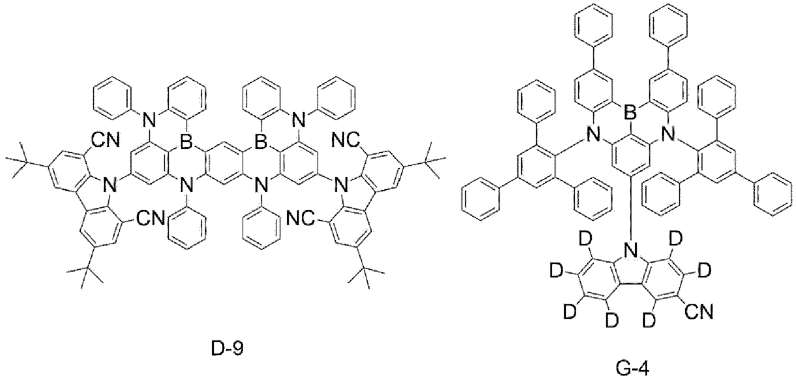

### Comparative Example Compound

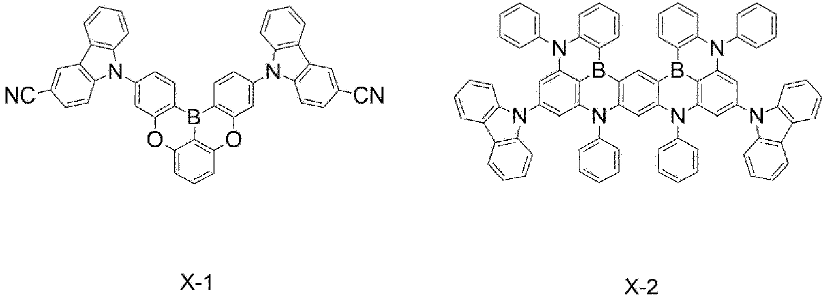

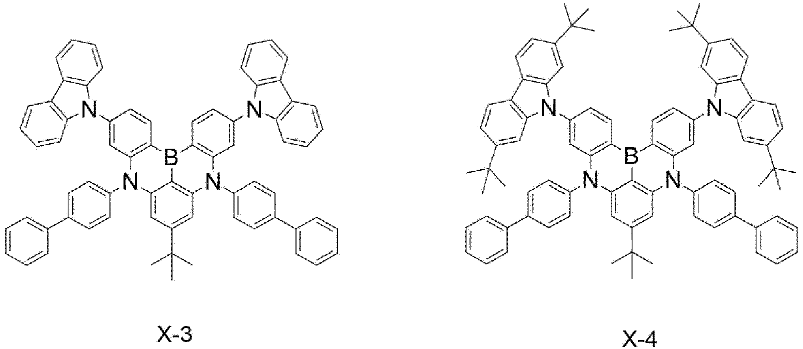

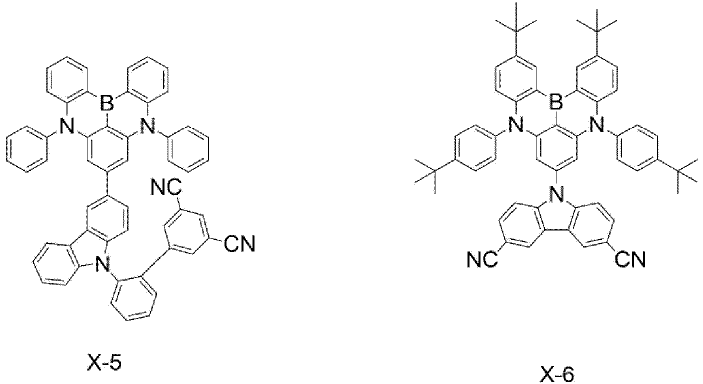

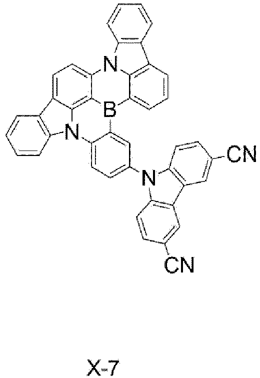

### Preparation of light emitting elements

A 150 nm-thick first electrode was formed utilizing ITO, a hole injection layer having a thickness of 10 nm was formed utilizing dipyrazino[2,3-f: 2',3'-h] quinoxaline-2,3,6,7,10,11-hexacarbonitrile (HATCN), a hole transport layer having a thickness of 40 nm was formed on the hole injection layer, utilizing N,N'-Di(1-naphthyl)-N,N'-diphenyl-(1,1'-biphenyl)-4,4'-diamine (NPD), an auxiliary emission layer having a thickness of 5 nm was formed on the hole transport layer, utilizing mCP(1,3-bis(N-carbazolyl)benzene), a 20 nm-thick emission layer doped with 1% by weight of Example Compounds or Comparative Example Compounds was formed on the auxiliary emission layer, utilizing 3,3'-di(9H-carbazol-9-yl)-1,1'-biphenyl (mCBP), an electron transport layer having a thickness of 30 nm was formed on the emission layer, utilizing 2,2',2"-(1,3,5-benzinetriyl)-tris(1-phenyl-1-H-benzimidazole) (TPBi), an electron injection layer having a thickness of 0.5 nm was formed on the electron transport layer, utilizing LiF, and a second electrode having a thickness of 300 nm was formed on the electron injection layer, utilizing Al. Each layer was formed through vapor deposition in a vacuum atmosphere.

The compounds utilized in the preparation of the light emitting elements of Examples and Comparative Examples are disclosed herein. The following materials, which are suitable materials, were utilized for the preparation of light emitting elements after sublimation-purifying commercially available products.

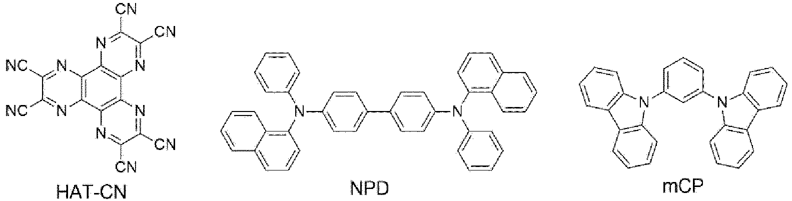

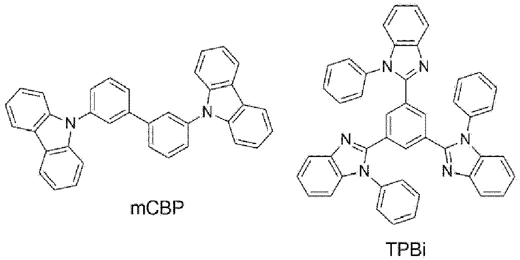

### Evaluation of Physical Properties of Example Compounds and Comparative Example Compounds

Table 1 shows the results of evaluating the physical properties of each of Example Compounds B-9, C-5, D-9, and G-4 and Comparative Example Compounds X-1 to X-7. In Table 1, emission wavelengths (λₘₐₓ) and fluorescence quantum yield in the deposited films of Example Compounds and Comparative Example Compounds were determined.

For evaluation of emission characteristics, a JASCO V-670 spectrometer was utilized to characterize a film prepared on a quartz glass through deposition of a 20 wt% doped film with PPF as a matrix and then determine fluorescence spectra. The fluorescence quantum yield was determined utilizing a JASCOILF-835 integrating sphere system.

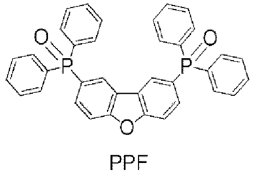

**Table 1**

| Compound | λₘₐₓ (nm) | Fluorescent quantum yield (%) |
|---|---|---|
| Compound B-9 | 467 | 66 |
| Compound C-5 | 459 | 60 |
| Compound D-9 | 465 | 75 |
| Compound G-4 | 460 | 61 |
| Comparative Example Compound X-1 | 451 | 53 |
| Comparative Example Compound X-2 | 464 | 59 |
| Comparative Example Compound X-3 | 469 | 55 |
| Comparative Example Compound X-4 | 466 | 56 |
| Comparative Example Compound X-5 | 457 | 46 |
| Comparative Example Compound X-6 | 455 | 58 |
| Comparative Example Compound X-7 | 478 | 57 |

Referring to Table 1, it is seen that Example compounds included in Examples 1 to 4 each have higher fluorescence quantum yields than Comparative Example Compounds included in Comparative Examples 1 to 7. Accordingly, it is expected that when applied to a light emitting element, Example Compounds included in Examples 1 to 4 may exhibit higher light emitting efficiency in the blue light wavelength range than Comparative Example Compounds included in Comparative Examples 1 to 7.

### Property Evaluation of Light Emitting Elements

Table 2 shows results of evaluation on light emitting elements for Examples 1 to 4 and Comparative Examples 1 to 7. In Table 2, maximum emission wavelength (λₘₐₓ), maximum value of external quantum efficiency (EQEₘₐₓ), and relative lifespan (LT50) of the prepared light emitting elements were compared and shown. Voltage and current density of the light emitting elements were determined utilizing a source meter (Keithley Instrument Co., 2400 series), and luminance and external quantum efficiency were determined utilizing an external quantum efficiency measuring instrument C9920-12 manufactured by Hamamatsu Photonics Co., Ltd. In addition, the relative lifespan is indicated by evaluating the luminance half-life at an initial luminance of 100 cd/m². The relative lifespan was shown to be relative with respect to the results of Comparative Example 1.

**Table 2**

| Item | Dopant | λₘₐₓ | EQEₘₐₓ | LT50 |
|---|---|---|---|---|
| | | (nm) | (%) | (%) |
| Example 1 | Compound B-9 | 468 | 21 | 454 |
| Example 2 | Compound C-5 | 460 | 23 | 433 |
| Example 3 | Compound D-9 | 466 | 29 | 330 |
| Example 4 | Compound G-4 | 461 | 24 | 430 |
| Comparative Example 1 | Comparative Example Compound X-1 | 455 | 15 | 100 |
| Comparative Example 2 | Comparative Example Compound X-2 | 465 | 20 | 293 |
| Comparative Example 3 | Comparative Example Compound X-3 | 470 | 20 | 307 |
| Comparative Example 4 | Comparative Example Compound X-4 | 467 | 18 | 289 |
| Comparative Example 5 | Comparative Example Compound X-5 | 458 | 11 | 99 |
| Comparative Example 6 | Comparative Example Compound X-6 | 456 | 17 | 210 |
| Comparative Example 7 | Comparative Example Compound X-7 | 479 | 18 | 165 |

Referring to the results of Table 2, it is seen that each of the light emitting elements of Examples utilizing the fused polycyclic compound according to one or more embodiments of the present disclosure as light emitting materials had greater light emitting efficiency and longer lifespan than the light emitting elements of Comparative Examples. It is seen that when applied to a light emitting element, each of Example Compounds has a structure in which a first substituent is introduced into a fused ring core and thus exhibit high greater light emitting efficiency and longer lifespan than Comparative Examples. Example Compounds each include a fused ring core in which a plurality of aromatic rings are fused through at least one boron atom and at least two hetero atoms, and have a structure in which at least one first substituent is linked to the fused ring core, and accordingly, a deep HOMO energy level is shown to prevent or reduce trap-assisted recombination, which causes element deterioration, resulting in greater light emitting efficiency and longer lifespan. Accordingly, when one or more Example Compounds are applied to a light emitting element, high light emitting efficiency and long lifespan may be achieved. The light emitting element of one or more embodiments includes a first compound of one or more embodiments (i.e., a fused polycyclic compound of the present disclosure) as a light emitting dopant of a thermally activated delayed fluorescence (TADF) light emitting element, and may thus achieve high element efficiency, particularly in a blue light wavelength range.

When comparing Examples 1, 2, and 4 including Example Compounds containing one boron atom (B) in a fused polycyclic compound with Comparative Examples 1, and 3 to 7, it is seen that Comparative Example 1 and Comparative Examples 3 to 7 have lower light emitting efficiency and shorter lifespan than Example 1, Example 2, and Example 4.

Referring to Comparative Example 1, it is seen that Comparative Example Compound X-1 included in Comparative Example 1, like Example Compounds, has a structure in which a carbazole group substituted with a cyano group is linked to a fused ring core, but Comparative Example 1 in which both (e.g., simultaneously) X₁ and X₂ corresponding to hetero atoms, which are fused ring constituent atoms, are oxygen atoms shows low external quantum efficiency and low half-life. As in Comparative Example Compound X-1, when portions corresponding to X₁ and X₂ are all oxygen atoms, orbital separation may take place between the fused ring core and the carbazole group, and thus, the emission spectrum widens, resulting in less overlapping of the orbital to reduce light emitting efficiency.

Referring to Comparative Examples 3 and 4, it is seen that Comparative Examples Compounds X-3 and X-4 included in Comparative Examples 3 and 4 have a structure in which a carbazole group which does not include a cyano group as a substituent is linked to a fused ring core, and show reduced light emitting efficiency and element lifespan when applied to a light emitting element than Example Compounds.

Referring to Comparative Example 5, Comparative Example Compound X-5 included in Comparative Example 5 is a compound that includes a cyano group in molecules, but has a structure in which the cyano group is substituted with a biphenyl group substituted on a 9th nitrogen atom instead of the two benzene rings constituting a carbazole group, and accordingly, it is determined that Comparative Example Compound X-5 has reduced effect in terms of preventing or reducing the trap-assisted recombination described above and/or the like compared to the fused polycyclic compound of one or more embodiments.

Referring to Comparative Example 6, Comparative Example Compound X-6 included in Comparative Example 6 has a structure in which a phenyl group in which an alkyl group is introduced at a para position with respect to a nitrogen atom is substituted on the nitrogen atom, a fused ring constituent element. Accordingly, Comparative Example Compound X-6 has lower stability of compound than Example compounds, and thus, it is determined that light emitting efficiency and element lifespan are reduced when applied to a light emitting element.

Referring to Comparative Example 7, Comparative Example Compound X-7 included in Comparative Example 7 has a structure in which 5-membered heterocycles are additionally fused to a fused ring core. When 5-membered heterocycles are additionally fused to the fused ring core as in Comparative Example Compound X-7, chemical stability may be reduced due to an increase in ring torsion, and accordingly, when Comparative Example Compound X-7 is applied to a light emitting element, light emitting efficiency and element lifespan may be reduced compared to Example Compounds.

In addition, when comparing Example 3 including Example Compound D-9 containing two boron atoms (B) in the fused polycyclic compound with Comparative Example 2, it is seen that Example 3 having a structure in which a first substituent including a cyano group is linked to a fused ring core shows high external quantum efficiency and improved lifespan. For example, it is believed that Example Compound D-9 utilized in Example 3 has a structure in which the first substituent is introduced into the fused ring core, and thus have greater effect in terms of preventing or reducing trap-assisted recombination, which causes element deterioration, and shows improved light emitting efficiency and lifespan of the light emitting element.

The light emitting element of one or more embodiments of the present disclosure may exhibit improved element characteristics of relatively high efficiency and long service life.

The fused polycyclic compound of one or more embodiments may be included in an emission layer of a light emitting element, and may thus contribute to relatively high efficiency and long service life of the light emitting element.

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

In the present disclosure, when particles are spherical, "size" indicates a particle diameter or an average particle diameter, and when the particles are non-spherical, the "size" indicates a major axis length or an average major axis length. The diameter (or size) of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter (or size) is referred to as D50. D50 refers to the average diameter (or size) of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

The light-emitting element/device, the display device, the display apparatus, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

## Claims

1. A fused polycyclic compound represented by Formula 1: 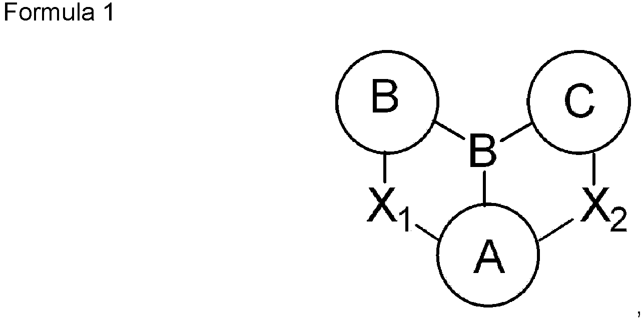 wherein in Formula 1,
X₁ and X₂ are each independently O, S, or NR₁,
a case in which X₁ and X₂ are simultaneously O is excluded,
R₁ is a substituted or unsubstituted aryl group having 6 to 30 ring-forming carbon atoms or a substituted or unsubstituted heteroaryl group having 2 to 30 ring-forming carbon atoms, and/or bonded to an adjacent group to form a ring,
when X₁ and X₂ are simultaneously NR₁, a case in which R₁ is represented by Formula a is excluded,
A to C rings are each independently a substituted or unsubstituted monocyclic aromatic hydrocarbon ring having 6 to 30 ring-forming carbon atoms or a substituted or unsubstituted monocyclic aromatic heterocycle having 2 to 30 ring-forming carbon atoms, and/or a substituent substituted on any one of A to C rings is bonded to an adjacent group to form a ring,
a case in which a 5-membered heterocycle is fused to any one of A to C rings is excluded, and
Formula 1 comprises at least one substituent represented by Formula 2: 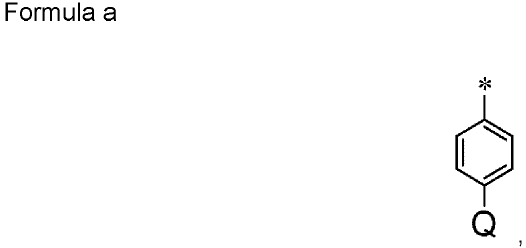 wherein in Formula a,
Q is a substituted or unsubstituted alkyl group, 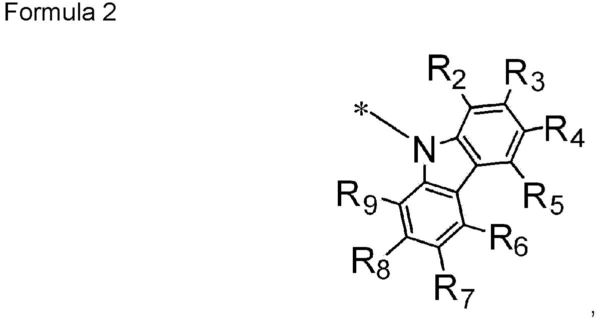 and
wherein in Formula 2,
R₂ to R₉ are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms,
at least one selected from among R₂ to R₉ is a cyano group, and
- * is a site linked to Formula 1.

2. The fused polycyclic compound of claim 1, wherein the fused polycyclic compound represented by Formula 1 is represented by any one selected from among Formulas 1-1-1 to 1-1-3: 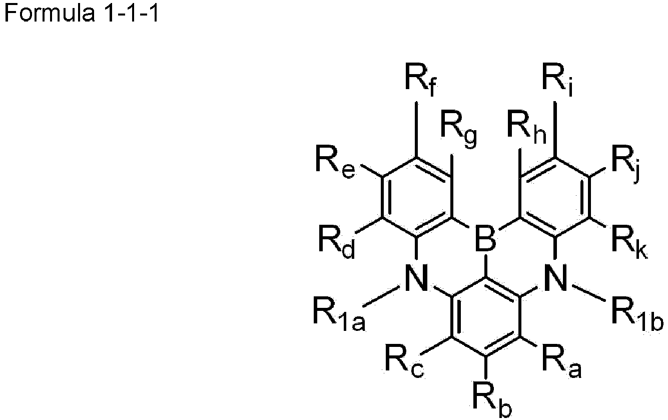 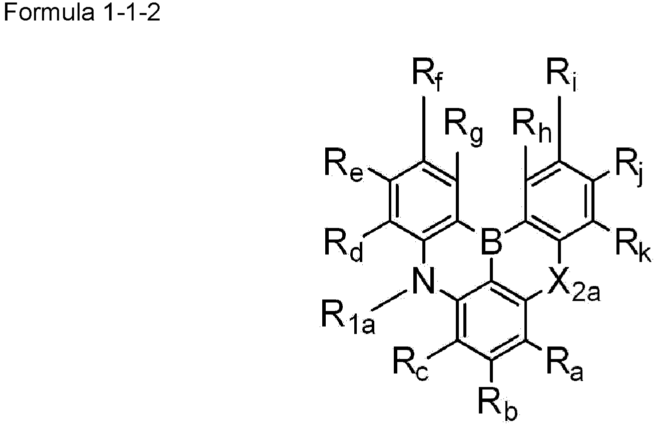 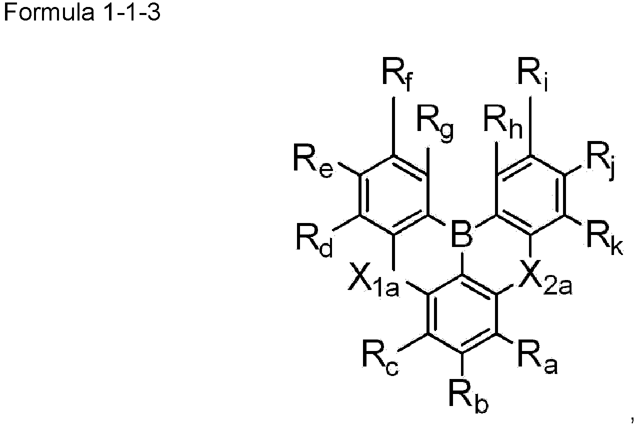 and
wherein in Formulas 1-1-1 to 1-1-3,
X₁ₐ and X₂ₐ are each independently O or S,
R₁ₐ and R_{1b} are each independently a substituted or unsubstituted aryl group having 6 to 30 ring-forming carbon atoms or a substituted or unsubstituted heteroaryl group having 2 to 30 ring-forming carbon atoms, and/or bonded to an adjacent group to form an aromatic ring,
Rₐ to Rₖ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2, and/or bonded to an adjacent group to form a ring,
at least one selected from among Rₐ to Rₖ is a substituent represented by Formula 2,
each of Rₐ to Rₖ, R₁ₐ, and R_{1b} is not bonded to an adjacent group to form a 5-membered heterocycle,
in Formula 1-1-1, a case in which R₁ₐ and R_{1b} are each represented by Formula a is excluded, and
in Formula 1-1-3, a case in which X₁ₐ and X₂ₐ are simultaneously O is excluded.

3. The fused polycyclic compound of claim 2, wherein R₁ₐ and R_{1b} are each independently represented by any one selected from among Formulas A-1 to A-4: 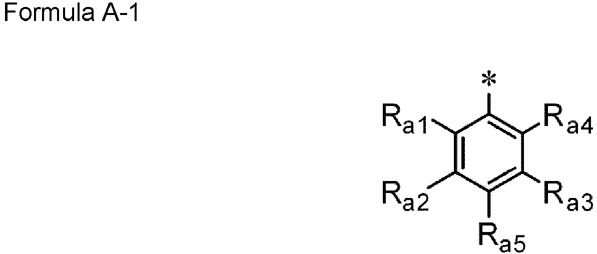 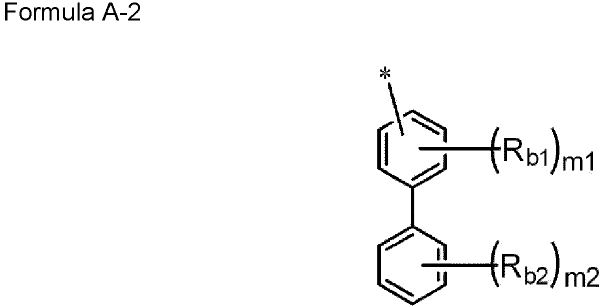 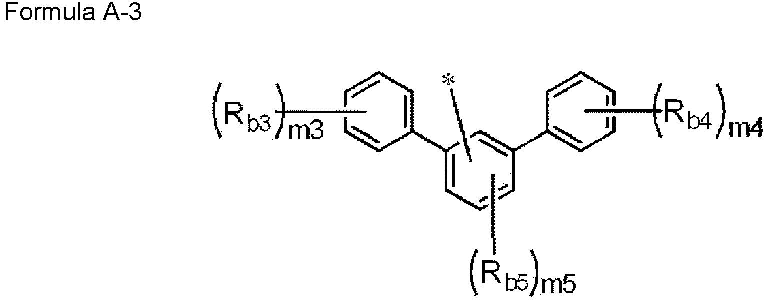 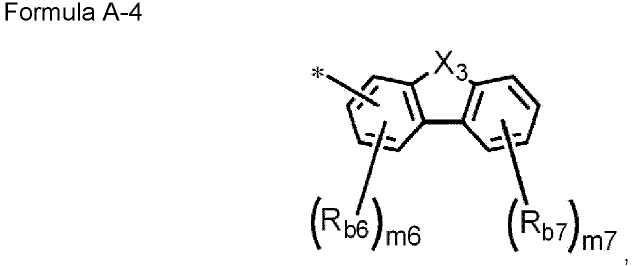 and
wherein in Formulas A-1 to A-4,
X₃ is NR_{b8}, O, or S,
Rₐ₁ to Rₐ₄, and R_{b1} to R_{b7} are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or bonded to an adjacent group to form a ring,
Rₐ₅ is hydrogen, deuterium, a halogen, a cyano group, a nitro group, a substituted or unsubstituted amine group, a substituted or unsubstituted aryl group having 6 to 30 ring-forming carbon atoms, or a substituted or unsubstituted heteroaryl group having 2 to 30 ring-forming carbon atoms,
R_{b8} is a substituted or unsubstituted aryl group having 6 to 30 ring-forming carbon atoms or a substituted or unsubstituted heteroaryl group having 2 to 30 ring-forming carbon atoms,
m1 and m7 are each independently an integer of 0 to 4,
m2 to m4 are each independently an integer of 0 to 5,
m5 and m6 are each independently an integer of 0 to 3, and
- * is a site linked to Formula 1.

4. The fused polycyclic compound of claim 1, wherein a substituent represented by Formula 2 is represented by Formula B-1 or Formula B-2: 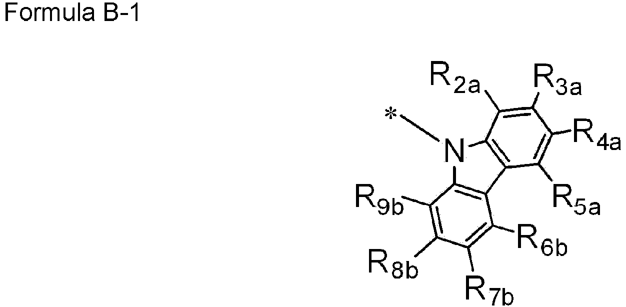 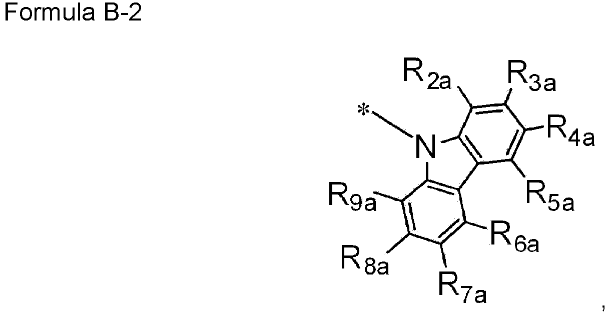 and
wherein in Formulas B-1 and B-2,
R₂ₐ to R₉ₐ are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms,
R_{6b} to R_{9b} are each independently hydrogen, deuterium, a halogen, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms,
in Formula B -1,
at least one selected from among R₂ₐ to R₅ₐ is a cyano group,
in Formula B-2,
at least one selected from among R₂ₐ to R₅ₐ and at least one selected from among R₆ₐ to R₉ₐ are each a cyano group, and
- * is a site linked to Formula 1.

5. The fused polycyclic compound of claim 1, wherein a substituent represented by Formula 2 is represented by any one selected from among Formulas C-1 to C-9: 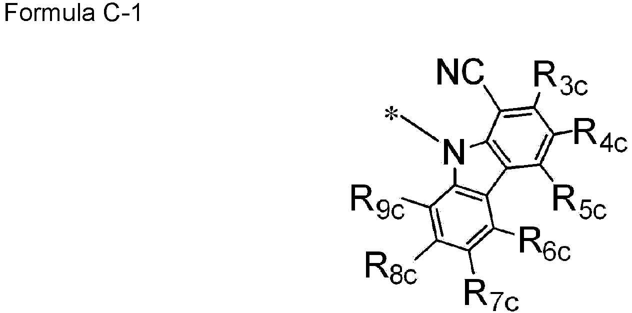 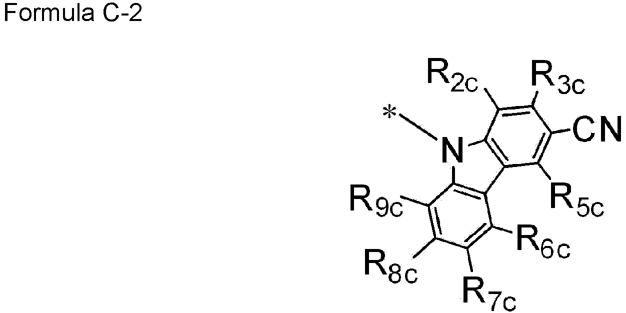 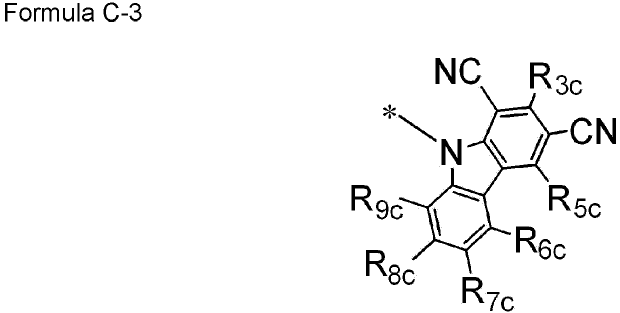 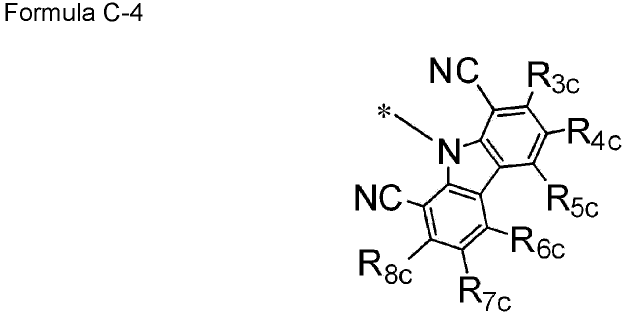 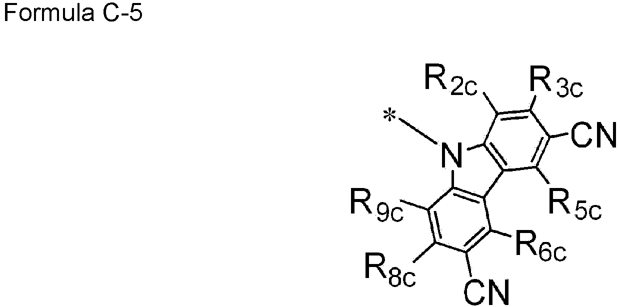 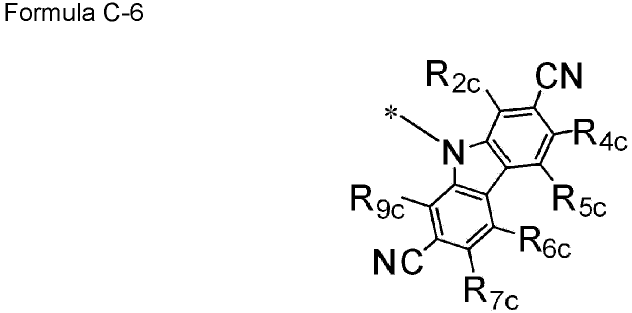 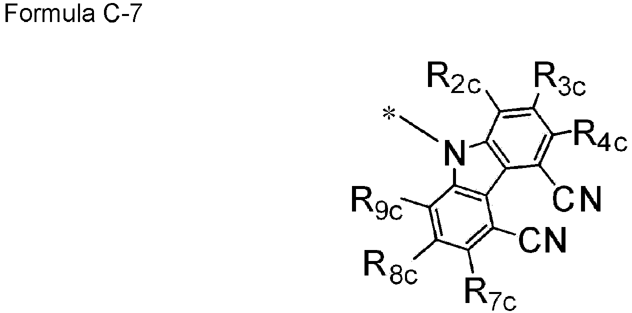 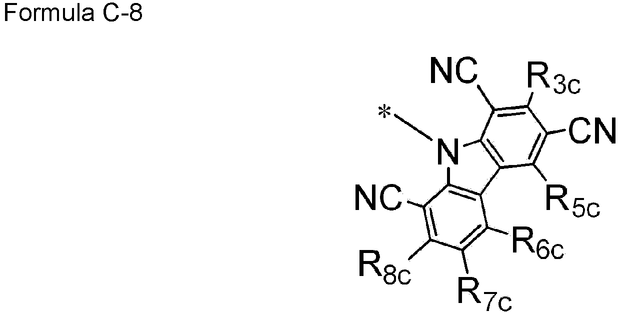 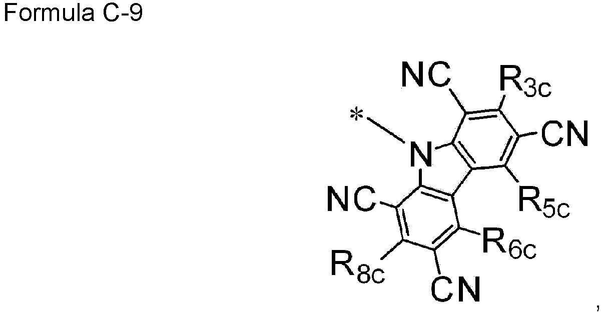 and
wherein in Formulas C-1 to C-9,
R_{2c} to R_{9c} are each independently hydrogen, deuterium, a halogen, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and
- * is a site linked to Formula 1.

6. The fused polycyclic compound of claim 1, wherein the fused polycyclic compound represented by Formula 1 is represented by any one selected from among Formulas 1-2-1 to 1-2-8: 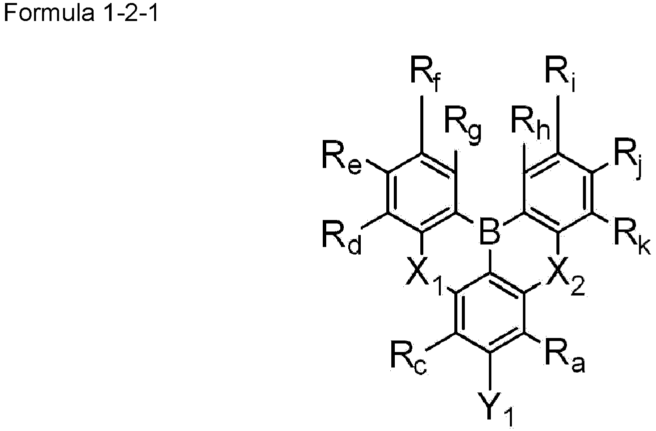 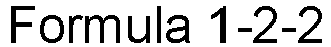 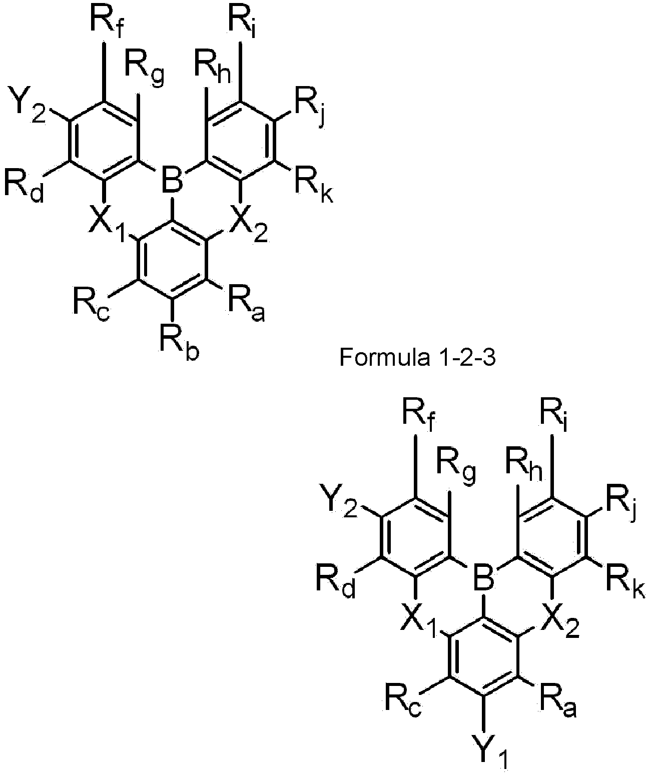 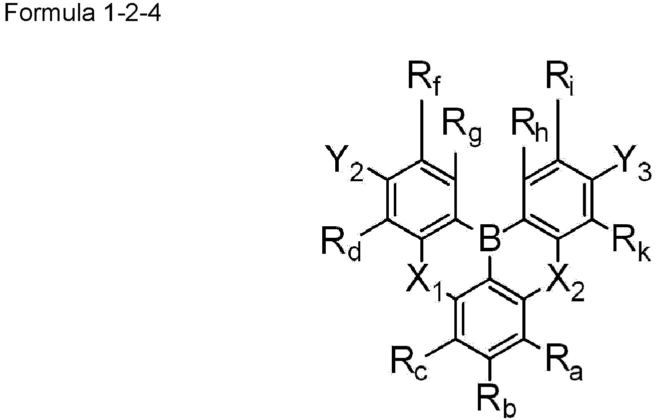 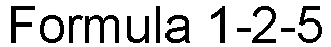 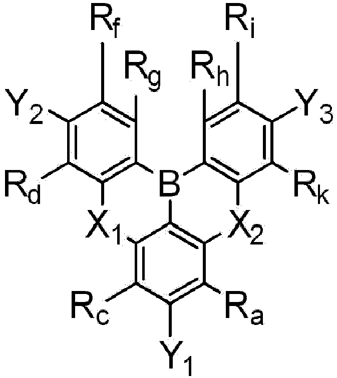 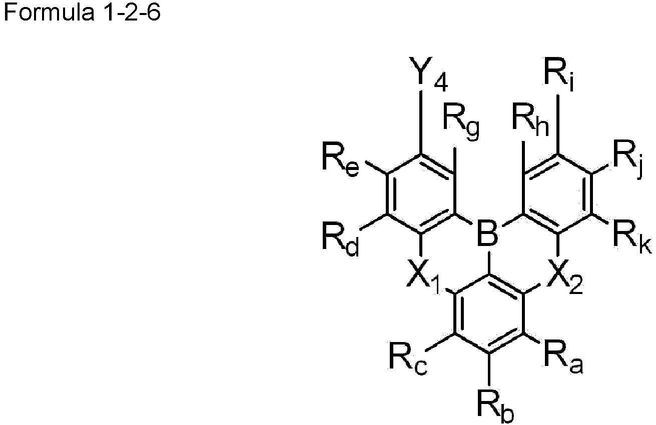 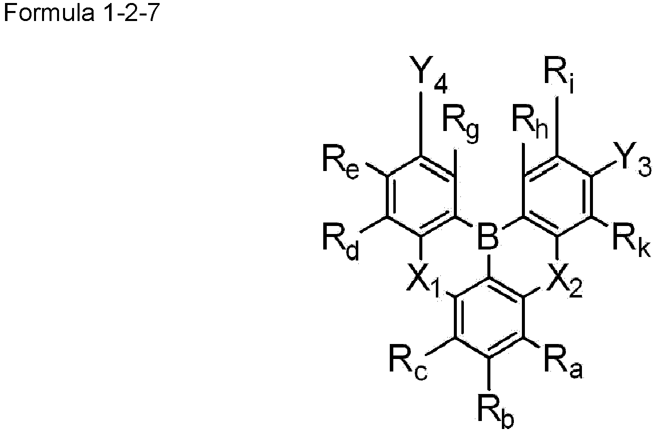 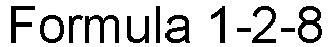 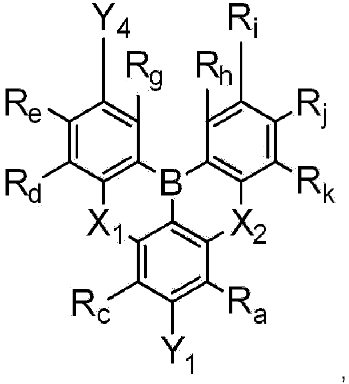 and
wherein in Formulas 1-2-1 to 1-2-8,
Rₐ to Rₖ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2, and/or bonded to an adjacent group to form a ring,
each of Rₐ to Rₖ is not bonded to an adjacent group to form a 5-membered heterocycle,
Y₁ to Y₄ are represented by Formula 2, and
X₁ and X₂ are the same as defined in Formula 1.

7. The fused polycyclic compound of claim 1, wherein the fused polycyclic compound represented by Formula 1 is represented by any one selected from among Formulas 1-3-1 to 1-3-3: 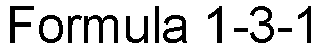 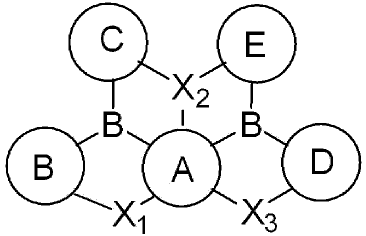 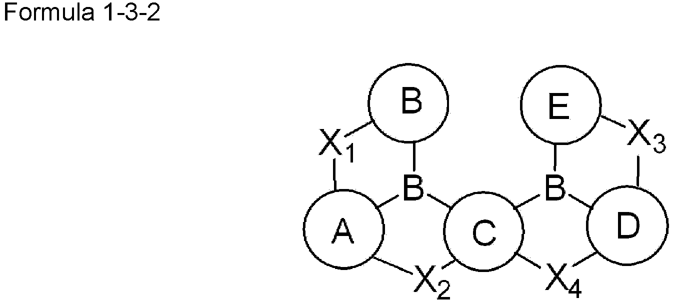 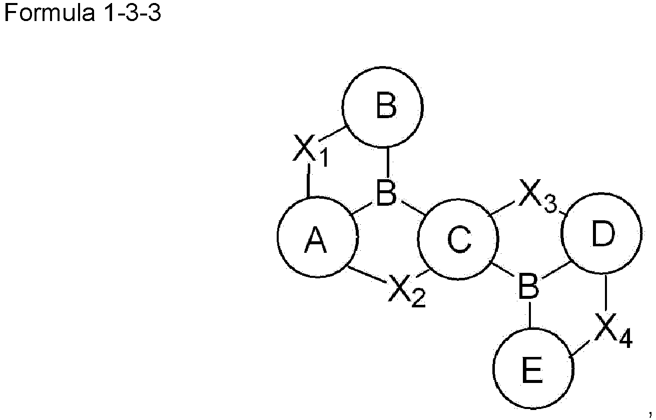 and
wherein in Formulas 1-3-1 to 1-3-3,
X₃ and X₄ are each independently O, S, or NR₁₀,
R₁₀ is a substituted or unsubstituted aryl group having 6 to 30 ring-forming carbon atoms or a substituted or unsubstituted heteroaryl group having 2 to 30 ring-forming carbon atoms, and/or bonded to an adjacent group to form a ring,
D and E rings are each independently a substituted or unsubstituted monocyclic aromatic hydrocarbon ring having 6 to 30 ring-forming carbon atoms or a substituted or unsubstituted monocyclic aromatic heterocycle having 2 to 30 ring-forming carbon atoms, and/or a substituent substituted on any one of D and E rings is bonded to an adjacent group to form a ring,
each of Formulas 1-3-1 to 1-3-3 comprises at least one substituent represented by Formula 2, and
X₁, X₂, and A to C rings are each the same as defined in Formula 1.

8. The fused polycyclic compound of claim 1, wherein the fused polycyclic compound represented by Formula 1 is represented by any one selected from among Formulas 1-4-1 to 1-4-3: 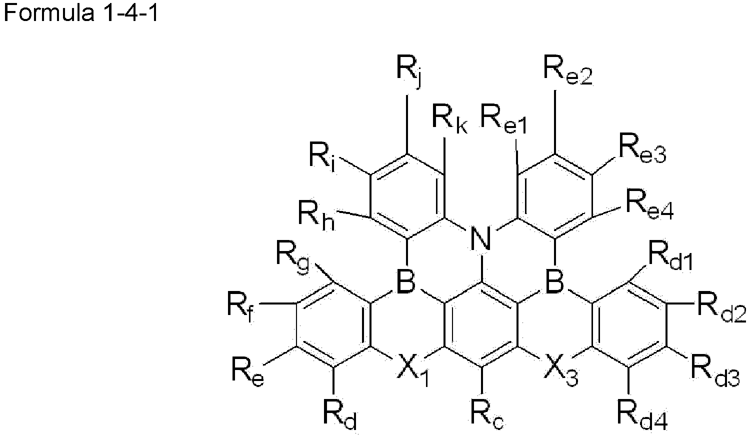 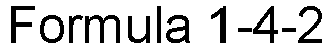 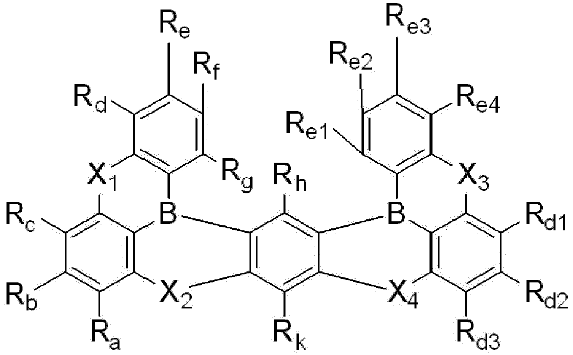 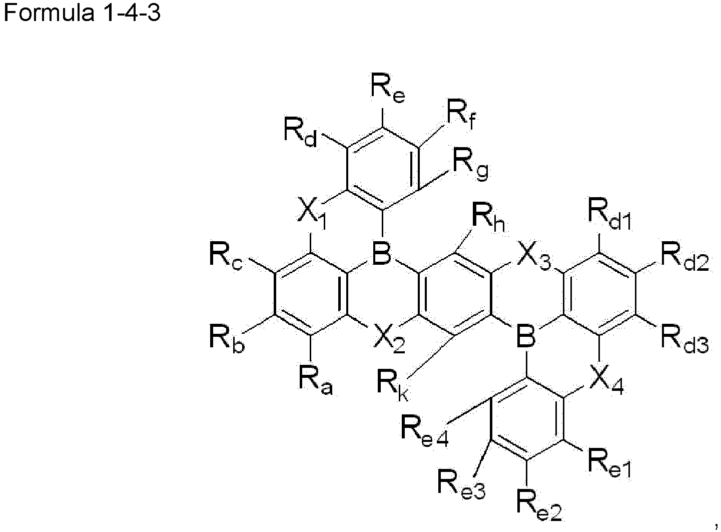 and
wherein in Formulas 1-4-1 to 1-4-3,
X₃ and X₄ are each independently O, S, or NR₁₀,
R₁₀ is a substituted or unsubstituted aryl group having 6 to 30 ring-forming carbon atoms or a substituted or unsubstituted heteroaryl group having 2 to 30 ring-forming carbon atoms, and/or bonded to an adjacent group to form a ring,
Rₐ to Rₖ, R_{d1} to R_{d4}, and Rₑ₁ to Rₑ₄ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2, and/or bonded to an adjacent group to form a ring,
in Formula 1-4-1,
at least one selected from among R_{c} to Rₖ, R_{d1} to R_{d4}, and Rₑ₁ to Rₑ₄ is represented by Formula 2,
in Formula 1-4-2,
at least one selected from among Rₐ to Rₕ, Rₖ, R_{d1} to R_{d3}, and Rₑ₁ to Rₑ₄ is represented by Formula 2,
in Formula 1-4-3,
at least one selected from among Rₐ to Rₕ, Rₖ, R_{d1} to R_{d3}, and Rₑ₁ to Rₑ₄ is represented by Formula 2, and
in Formulas 1-4-1 to 1-4-3,
X₁ and X₂ are the same as defined in Formula 1.

9. The fused polycyclic compound of claim 1, wherein the fused polycyclic compound represented by Formula 1 is represented by any one selected from among Formulas 1-5-1 to 1-5-6: 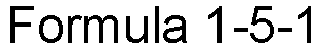 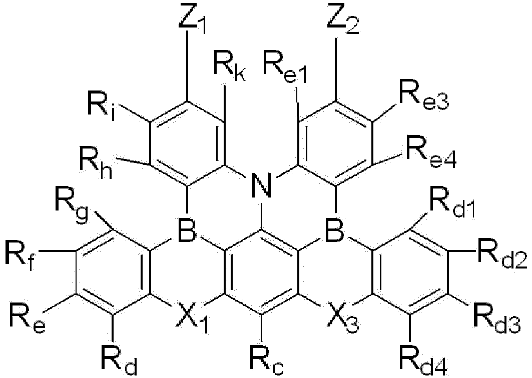 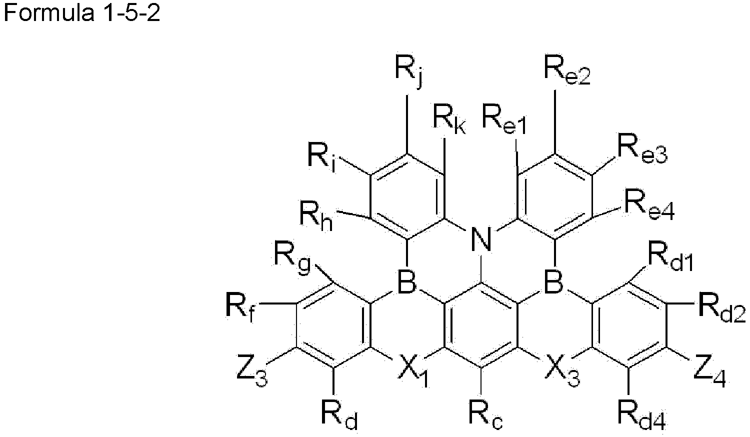 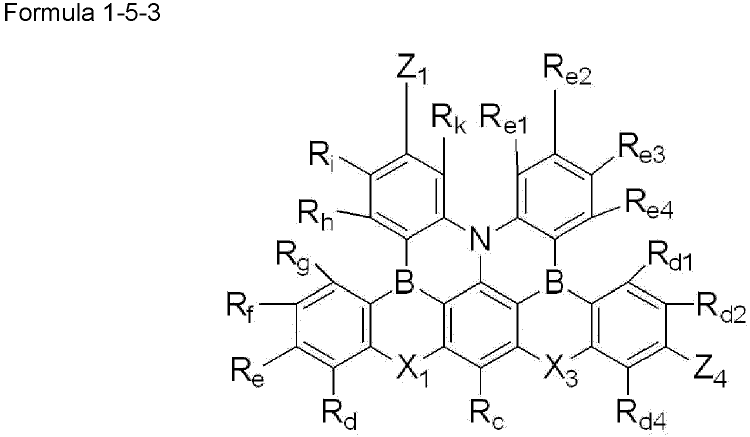 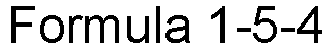 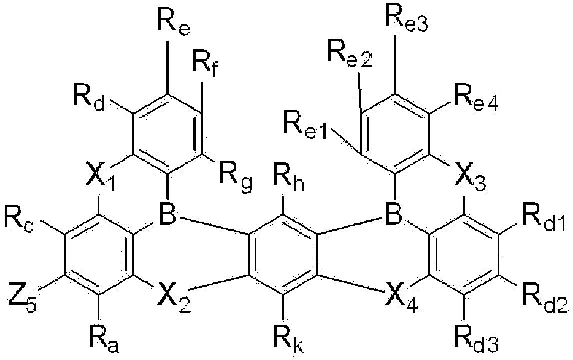 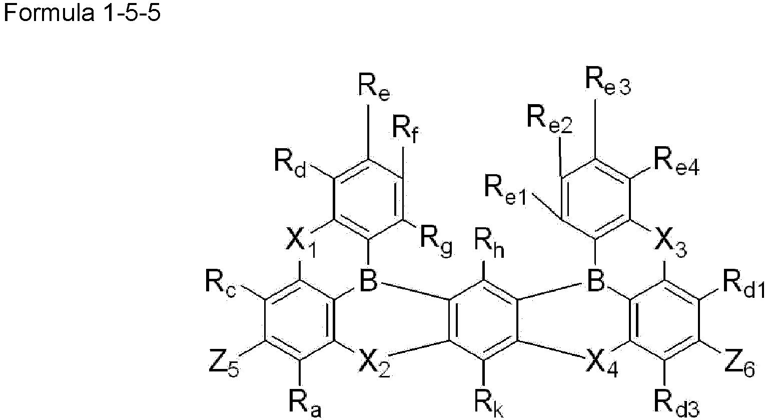 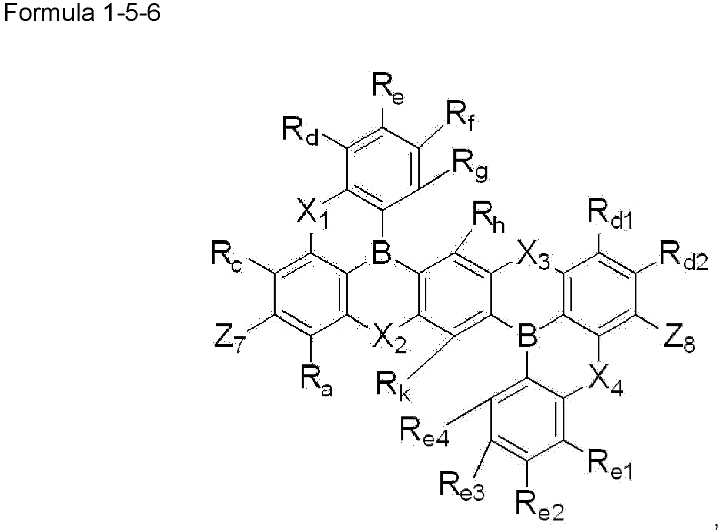 and
wherein in Formulas 1-5-1 to 1-5-6,
X₃ and X₄ are each independently O, S, or NR₁₀,
R₁₀ is a substituted or unsubstituted aryl group having 6 to 30 ring-forming carbon atoms or a substituted or unsubstituted heteroaryl group having 2 to 30 ring-forming carbon atoms, and/or bonded to an adjacent group to form a ring,
Rₐ to Rₖ, R_{d1} to R_{d4}, and Rₑ₁ to Rₑ₄ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or a substituent represented by Formula 2, and/or bonded to an adjacent group to form a ring,
Z₁ to Z₈ are represented by Formula 2, and
X₁ and X₂ are the same as defined in Formula 1.

10. The fused polycyclic compound of claim 1, wherein the fused polycyclic compound comprises at least one selected from among compounds of Compound Group 1:

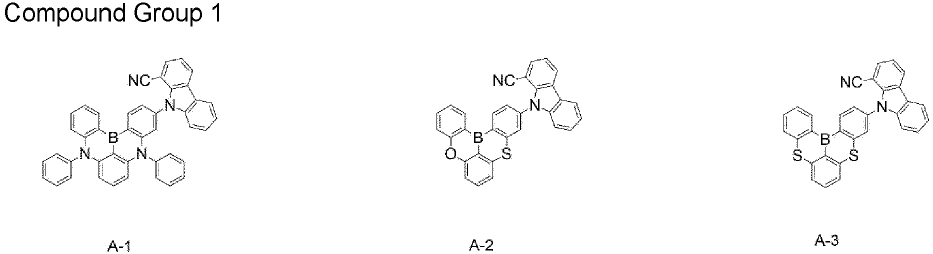

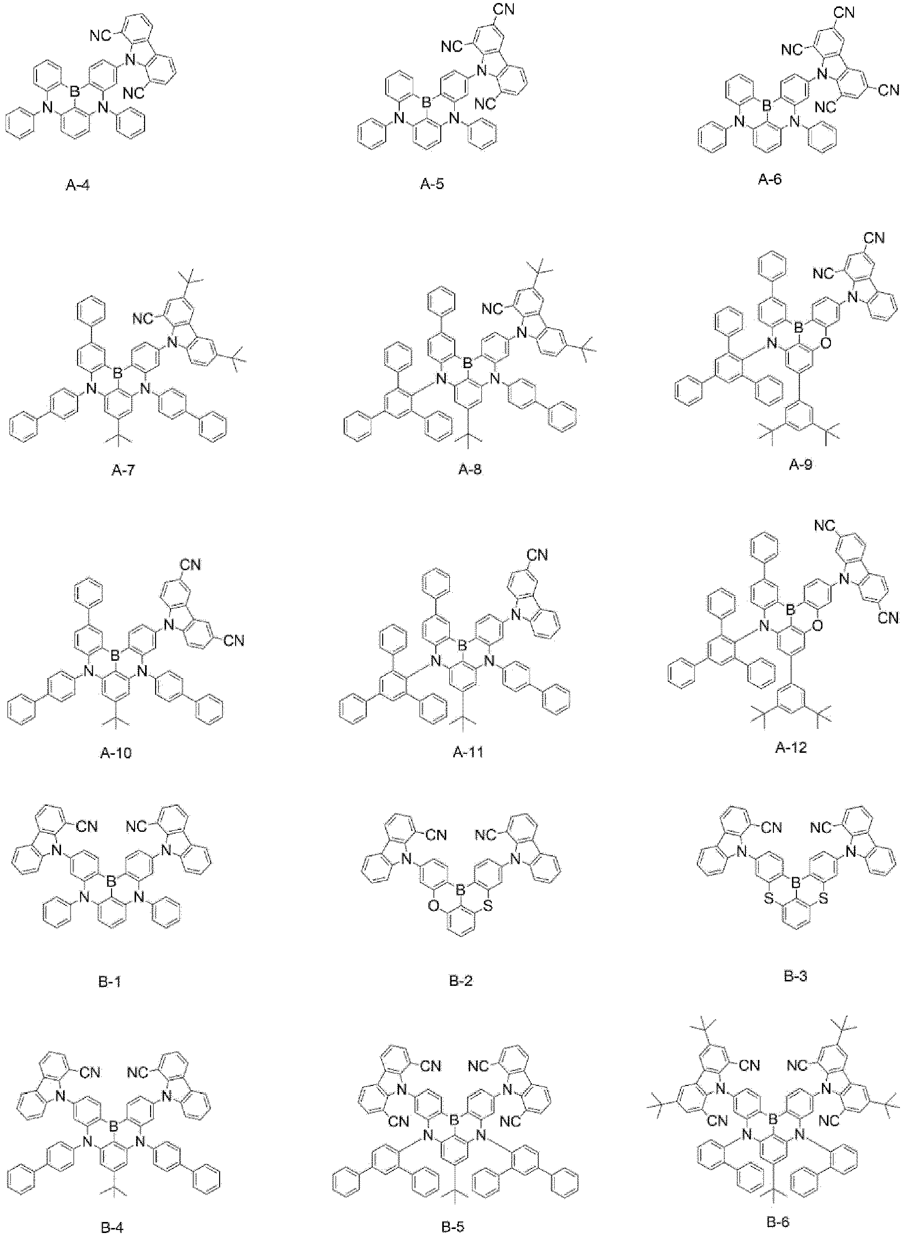

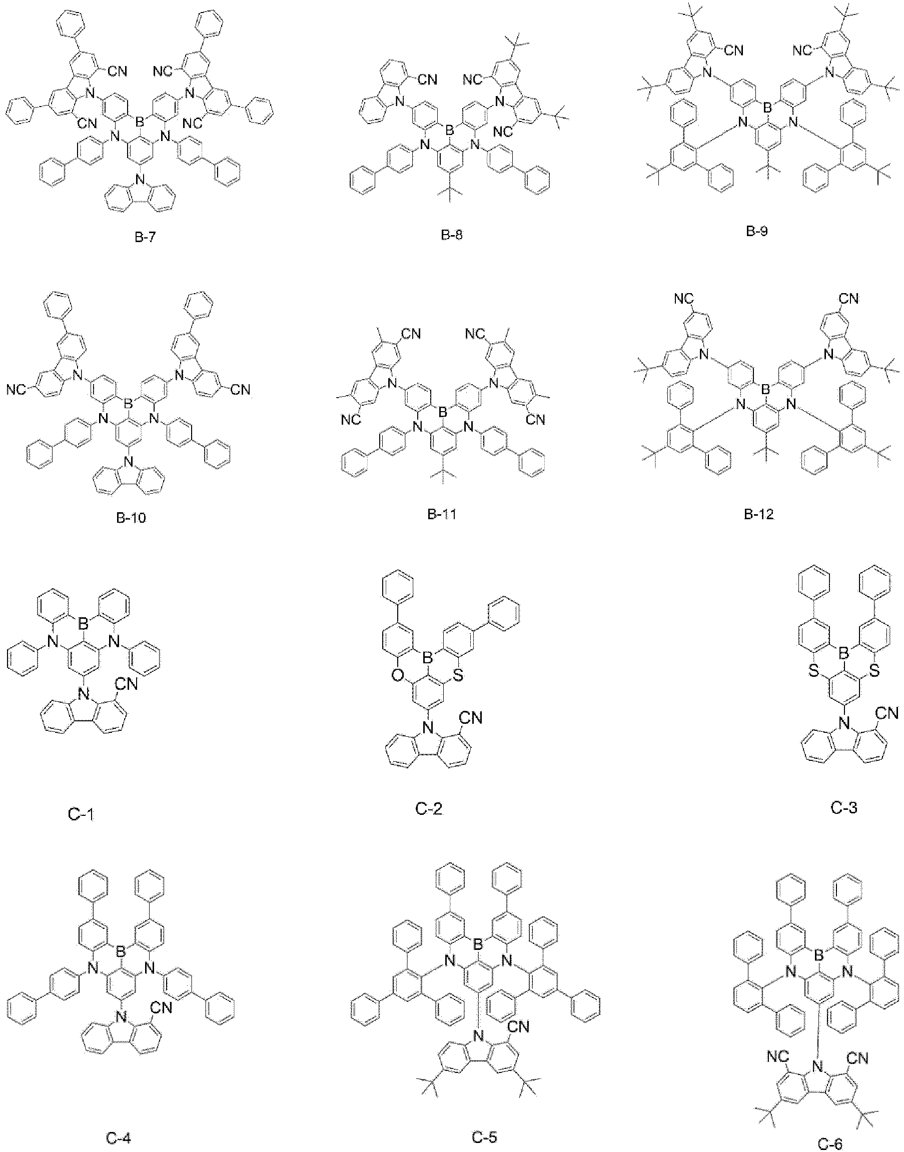

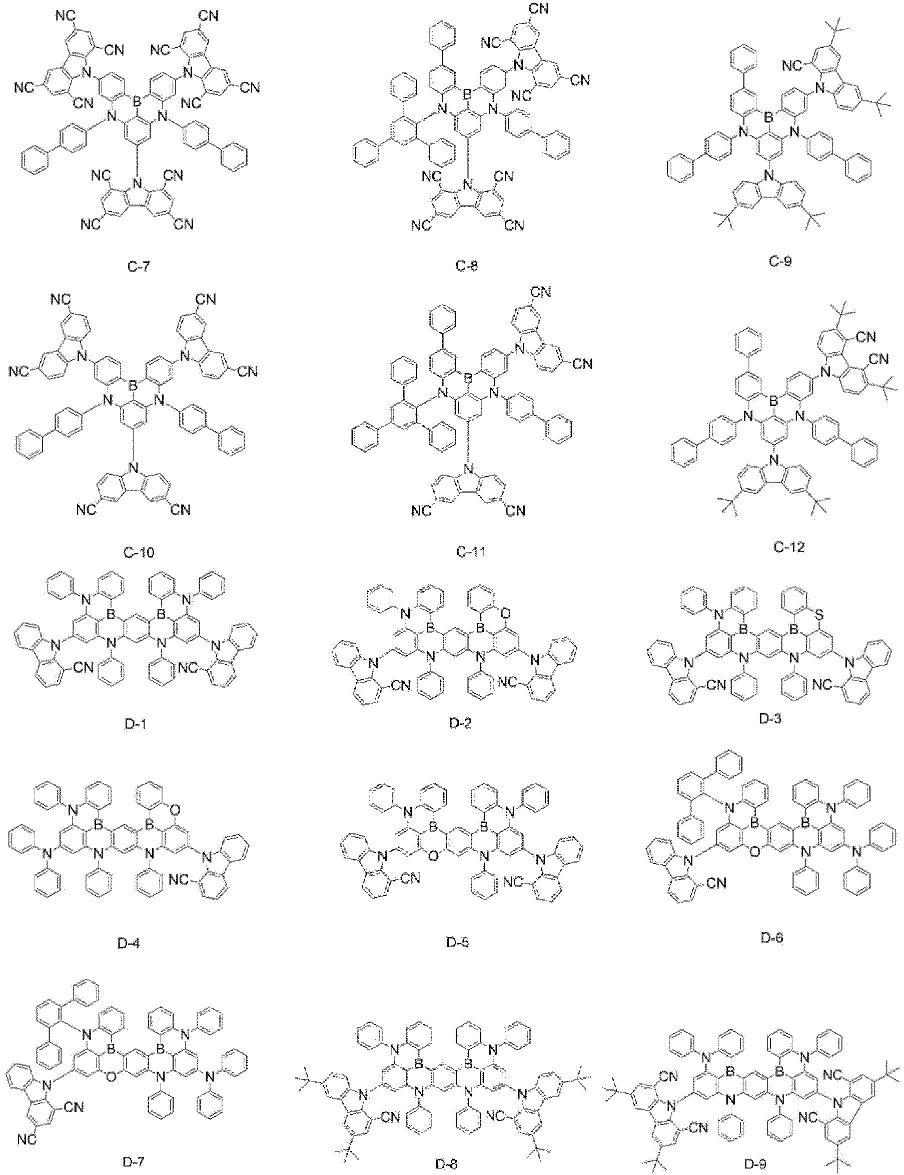

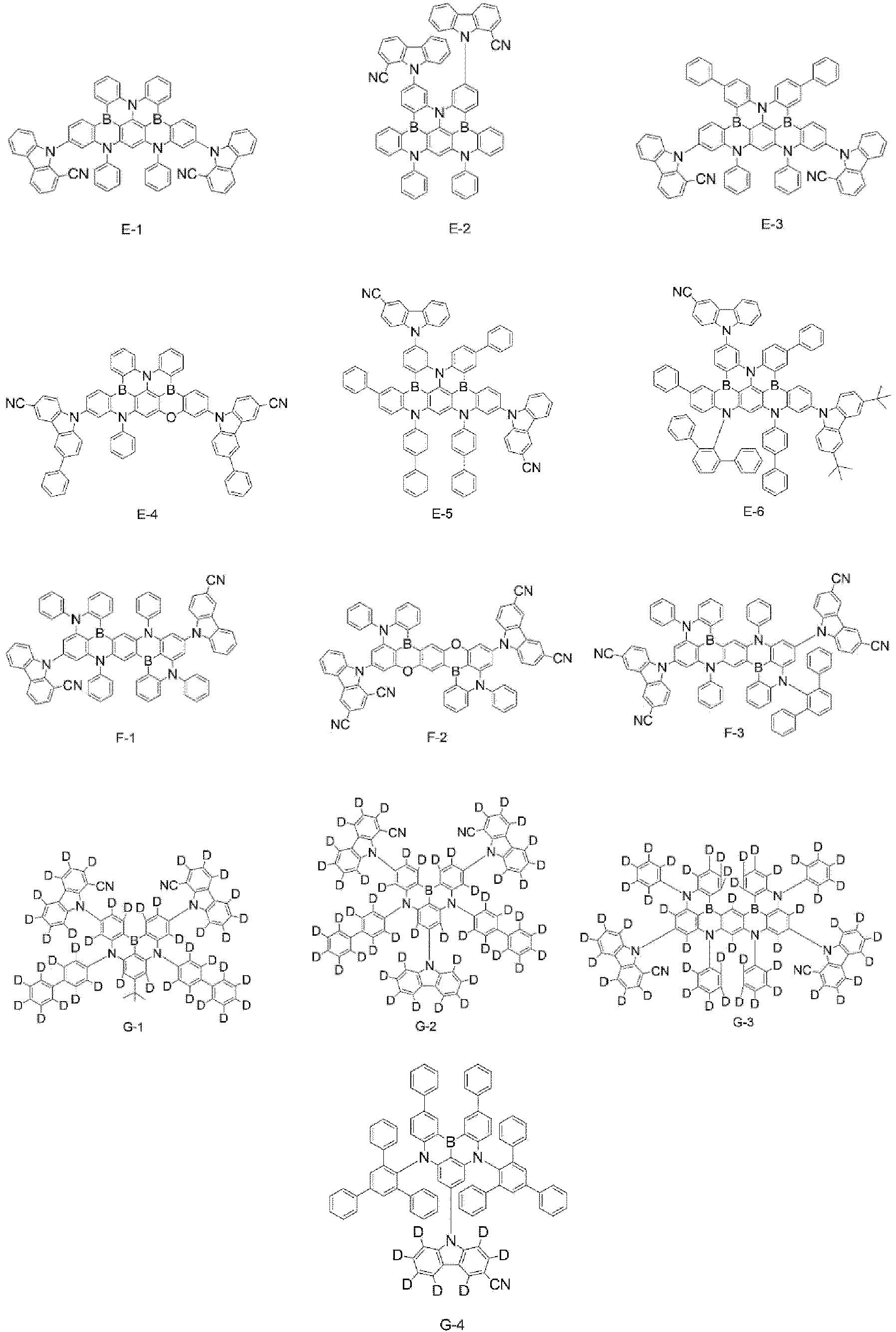

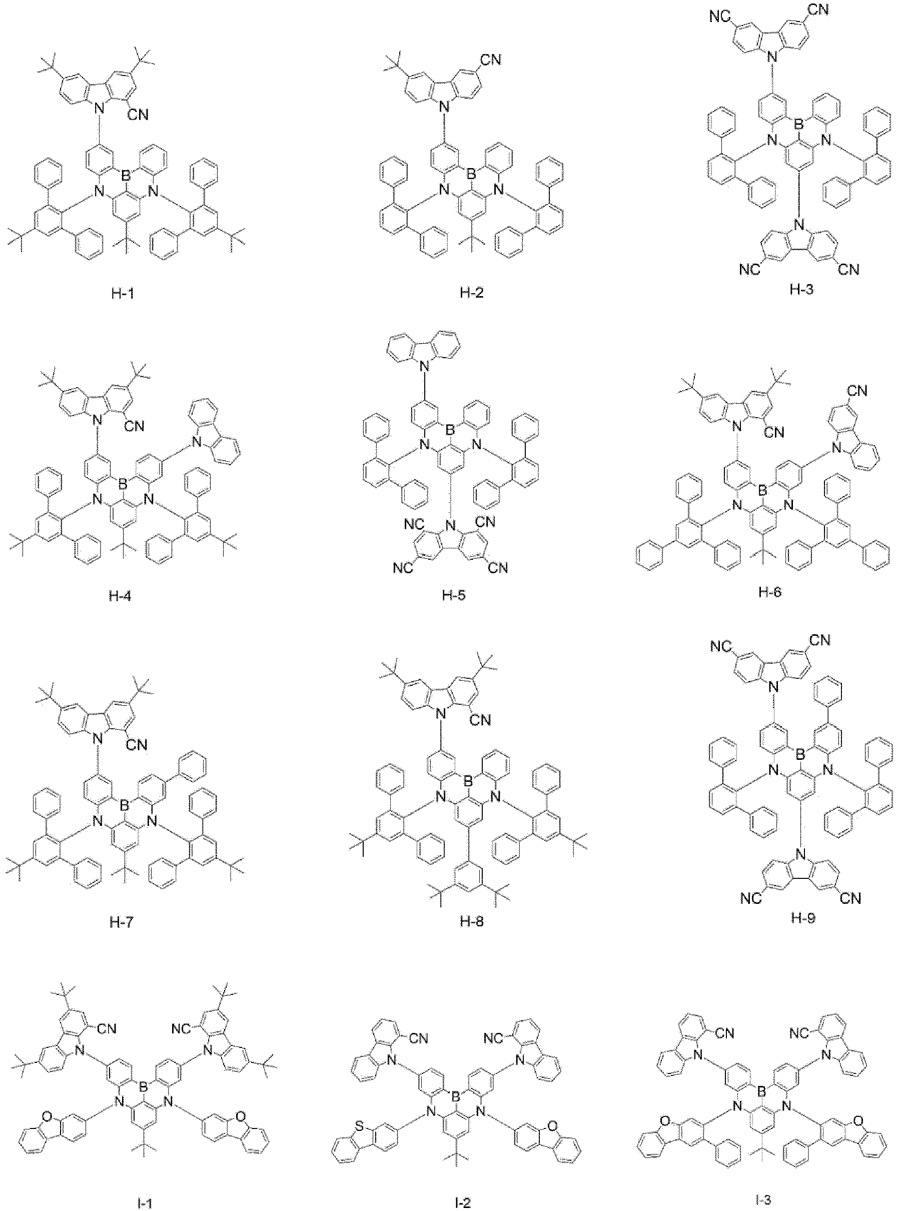

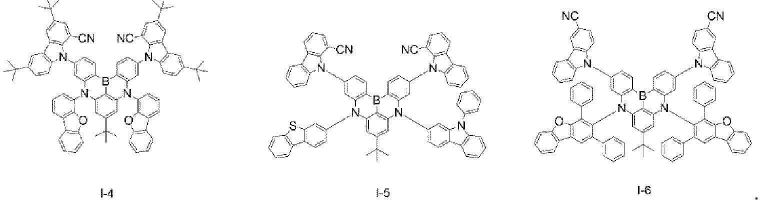

11. A light emitting element comprising:
a first electrode;
a second electrode on the first electrode; and
at least one functional layer between the first electrode and the second electrode and comprising the fused polycyclic compound according to any one of claims 1 to 10 as a first compound.

12. The light emitting element of claim 11, wherein the at least one functional layer comprises an emission layer, a hole transport region between the first electrode and the emission layer, and an electron transport region between the emission layer and the second electrode,
the emission layer comprising the fused polycyclic compound.

13. The light emitting element of claim 12, wherein the emission layer is configured to emit delayed fluorescence.

14. The light emitting element of claim 12 or claim 13, wherein the emission layer is configured to emit light having a central emission wavelength of about 430 nm to about 490 nm.

## Patentansprüche

1. Kondensierte polycyclische Verbindung, dargestellt durch Formel 1: 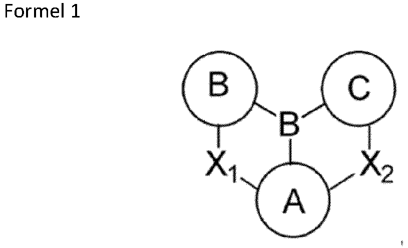 wobei in Formel 1
X₁ und X₂ jeweils unabhängig O, S oder NR₁ sind,
ein Fall, in dem X₁ und X₂ gleichzeitig O sind, ausgeschlossen ist,
R₁ eine substituierte oder unsubstituierte Arylgruppe, die 6 bis 30 ringbildende Kohlenstoffatome aufweist, oder eine substituierte oder unsubstituierte Heteroarylgruppe ist, die 2 bis 30 ringbildende Kohlenstoffatome aufweist, und/oder an eine benachbarte Gruppe gebunden ist, um einen Ring zu bilden,
wenn X₁ und X₂ gleichzeitig NR₁sind, ein Fall, in dem R₁ durch Formel a dargestellt ist, ausgeschlossen ist,
A- bis C-Ringe jeweils unabhängig ein substituierter oder unsubstituierter monocyclischer aromatischer Kohlenwasserstoffring, der 6 bis 30 ringbildende Kohlenstoffatome aufweist, oder ein substituierter oder unsubstituierter monocyclischer aromatischer Heterocyclus sind, der 2 bis 30 ringbildende Kohlenstoffatome aufweist, und/oder ein Substituent, der an einem von A- bis C-Ringen substituiert ist, an eine benachbarte Gruppe gebunden ist, um einen Ring zu bilden,
ein Fall, in dem ein 5-gliedriger Heterocyclus an einen von A- bis C-Ringen kondensiert ist, ausgeschlossen ist und
Formel 1 mindestens einen Substituenten umfasst, dargestellt durch Formel 2: 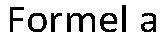 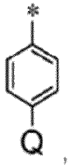 wobei in Formel a
Q eine substituierte oder unsubstituierte Alkylgruppe ist, 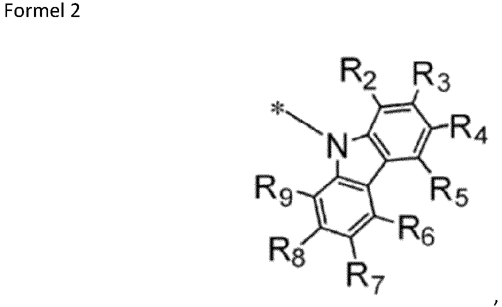 und
wobei in Formel 2
R₂ bis R₉ jeweils unabhängig Wasserstoff, Deuterium, ein Halogen, eine Cyanogruppe, eine Nitrogruppe, eine substituierte oder unsubstituierte Amingruppe, eine substituierte oder unsubstituierte Alkylgruppe, die 1 bis 20 Kohlenstoffatome aufweist, eine substituierte oder unsubstituierte Arylgruppe, die 6 bis 30 ringbildende Kohlenstoffatome aufweist, oder eine substituierte oder unsubstituierte Heteroarylgruppe, die 2 bis 30 ringbildende Kohlenstoffatome aufweist, sind,
mindestens eines ausgewählt aus R₂ bis R₉ eine Cyanogruppe ist und
**- *** eine mit der Formel 1 verknüpfte Stelle ist.

2. Kondensierte polycyclische Verbindung nach Anspruch 1, wobei die durch Formel 1 dargestellte kondensierte polycyclische Verbindung durch eine beliebige aus Formeln 1-1-1 bis 1-1-3 ausgewählte dargestellt ist: 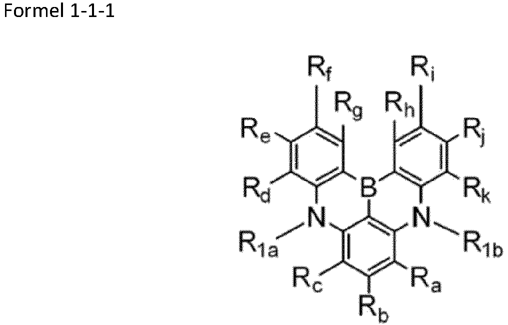 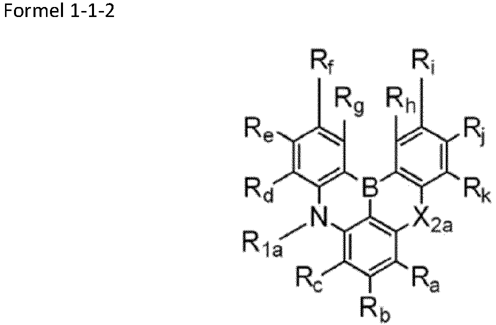 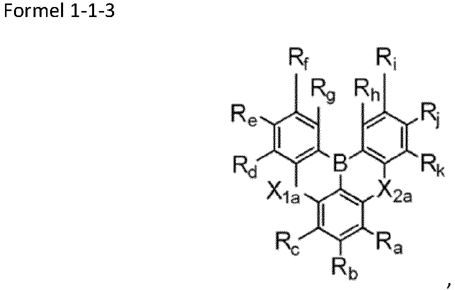 wobei in Formeln 1-1-1 bis 1-1-3
X₁ₐ und X₂ₐ jeweils unabhängig O oder S sind,
R₁ₐ und R_{1b} jeweils unabhängig eine substituierte oder unsubstituierte Arylgruppe, die 6 bis 30 ringbildende Kohlenstoffatome aufweist, oder eine substituierte oder unsubstituierte Heteroarylgruppe sind, die 2 bis 30 ringbildende Kohlenstoffatome aufweist, und/oder an eine benachbarte Gruppe gebunden sind, um einen aromatischen Ring zu bilden,
Rₐ bis Rₖ jeweils unabhängig Wasserstoff, Deuterium, ein Halogen, eine Cyanogruppe, eine Nitrogruppe, eine substituierte oder unsubstituierte Amingruppe, eine substituierte oder unsubstituierte Oxygruppe, eine substituierte oder unsubstituierte Thiogruppe, eine substituierte oder unsubstituierte Borgruppe, eine substituierte oder unsubstituierte Alkylgruppe, die 1 bis 20 Kohlenstoffatome aufweist, eine substituierte oder unsubstituierte Arylgruppe, die 6 bis 30 ringbildende Kohlenstoffatome aufweist, eine substituierte oder unsubstituierte Heteroarylgruppe, die 2 bis 30 ringbildende Kohlenstoffatome aufweist, sind, oder ein durch Formel 2 dargestellter Substituent und/oder an eine benachbarte Gruppe gebunden sind, um einen Ring zu bilden,
mindestens eines ausgewählt aus Rₐ bis Rₖ ein durch Formel 2 dargestellter Substituent ist,
Rₐ bis Rₖ, R₁ₐund R_{1b} jeweils nicht an eine benachbarte Gruppe gebunden sind, um einen 5-gliedrigen Heterocyclus zu bilden,
in Formel 1-1-1 ein Fall ausgeschlossen ist, in dem R₁ₐ und R_{1b} jeweils durch Formel a dargestellt sind, und
in Formel 1-1-3 ein Fall ausgeschlossen ist, in dem X₁ₐ und X₂ₐ gleichzeitig O sind.

3. Kondensierte polycyclische Verbindung nach Anspruch 2, wobei R₁ₐ und R_{1b} jeweils unabhängig durch eine beliebige aus Formeln A-1 bis A-4 ausgewählte dargestellt sind: 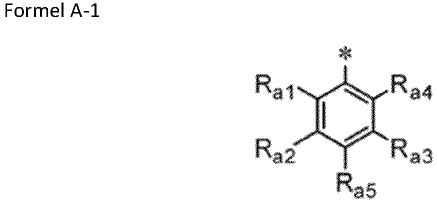 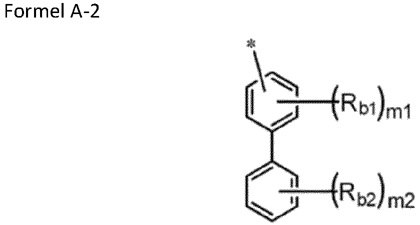 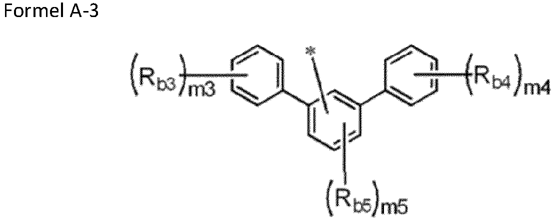 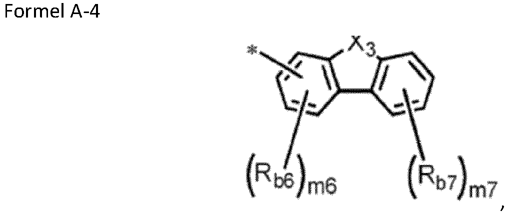 und
wobei in Formeln A-1 bis A-4
X₃ NR_{b8}, O oder S ist,
Rₐ₁ bis Rₐ₄, und R_{b1} bis R_{b7} jeweils unabhängig Wasserstoff, Deuterium, ein Halogen, eine Cyanogruppe, eine Nitrogruppe, eine substituierte oder unsubstituierte Amingruppe, eine substituierte oder unsubstituierte Alkylgruppe, die 1 bis 20 Kohlenstoffatome aufweist, eine substituierte oder unsubstituierte Arylgruppe, die 6 bis 30 ringbildende Kohlenstoffatome aufweist, oder eine substituierte oder unsubstituierte Heteroarylgruppe, die 2 bis 30 ringbildende Kohlenstoffatome aufweist, sind, und/oder an eine benachbarte Gruppe gebunden sind, um einen Ring zu bilden,
Rₐ₅ Wasserstoff, Deuterium, ein Halogen, eine Cyanogruppe, eine Nitrogruppe, eine substituierte oder unsubstituierte Amingruppe, eine substituierte oder unsubstituierte Arylgruppe, die 6 bis 30 ringbildende Kohlenstoffatome aufweist, oder eine substituierte oder unsubstituierte Heteroarylgruppe, die 2 bis 30 ringbildende Kohlenstoffatome aufweist, ist,
R_{b8} eine substituierte oder unsubstituierte Arylgruppe, die 6 bis 30 ringbildende Kohlenstoffatome aufweist, oder eine substituierte oder unsubstituierte Heteroarylgruppe ist, die 2 bis 30 ringbildende Kohlenstoffatome aufweist,
m1 und m7 jeweils unabhängig eine ganze Zahl von 0 bis 4 sind,
m2 bis m4 jeweils unabhängig eine ganze Zahl von 0 bis 5 sind,
m5 und m6 jeweils unabhängig eine ganze Zahl von 0 bis 3 sind und
- * eine mit der Formel 1 verknüpfte Stelle ist.

4. Kondensierte polycyclische Verbindung nach Anspruch 1, wobei ein durch Formel 2 dargestellter Substituent durch Formel B-1 oder Formel B-2 dargestellt ist: 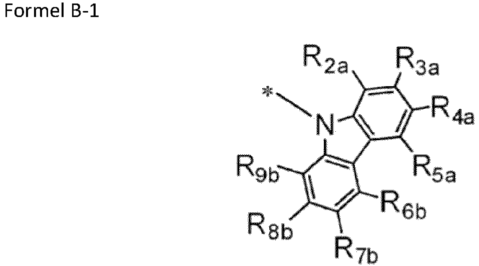 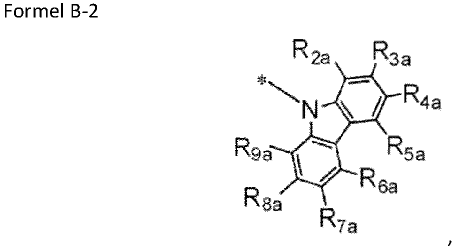 und
wobei in Formeln B-1 und B-2
R₂ₐ bis R₉ₐ jeweils unabhängig Wasserstoff, Deuterium, ein Halogen, eine Cyanogruppe, eine Nitrogruppe, eine substituierte oder unsubstituierte Amingruppe, eine substituierte oder unsubstituierte Alkylgruppe, die 1 bis 20 Kohlenstoffatome aufweist, eine substituierte oder unsubstituierte Arylgruppe, die 6 bis 30 ringbildende Kohlenstoffatome aufweist, oder eine substituierte oder unsubstituierte Heteroarylgruppe, die 2 bis 30 ringbildende Kohlenstoffatome aufweist, sind,
R_{6b} bis R_{9b} jeweils unabhängig Wasserstoff, Deuterium, ein Halogen, eine Nitrogruppe, eine substituierte oder unsubstituierte Amingruppe, eine substituierte oder unsubstituierte Alkylgruppe, die 1 bis 20 Kohlenstoffatome aufweist, eine substituierte oder unsubstituierte Arylgruppe, die 6 bis 30 ringbildende Kohlenstoffatome aufweist, oder eine substituierte oder unsubstituierte Heteroarylgruppe, die 2 bis 30 ringbildende Kohlenstoffatome aufweist, sind,
in Formel B-1
mindestens eines ausgewählt aus R₂ₐ bis R₅ₐ eine Cyanogruppe ist,
in Formel B-2
mindestens eines ausgewählt aus R₂ₐ bis R₅ₐ und mindestens eines ausgewählt aus R₆ₐ bis R₉ₐ jeweils eine Cyanogruppe sind, und
- * eine mit der Formel 1 verknüpfte Stelle ist.

5. Kondensierte polycyclische Verbindung nach Anspruch 1, wobei ein durch Formel 2 dargestellter Substituent durch eine beliebige aus Formeln C-1 bis C-9 ausgewählte dargestellt ist: 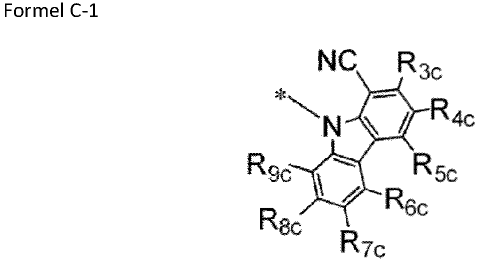 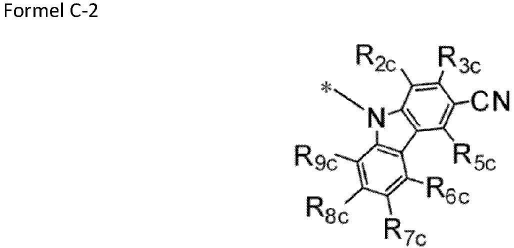 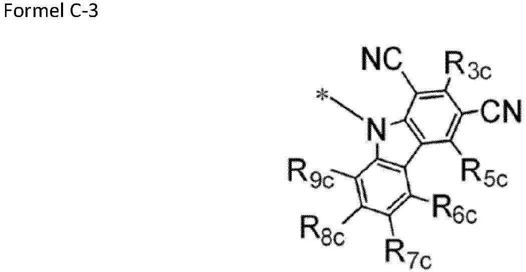 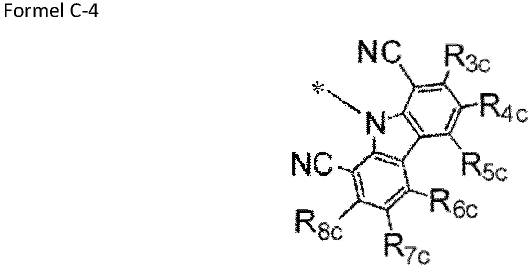 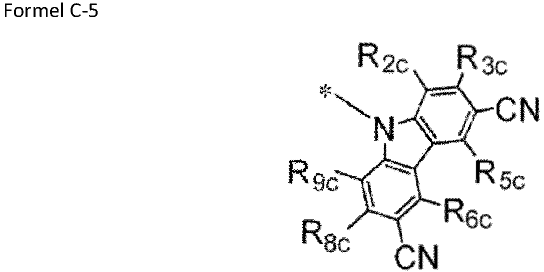 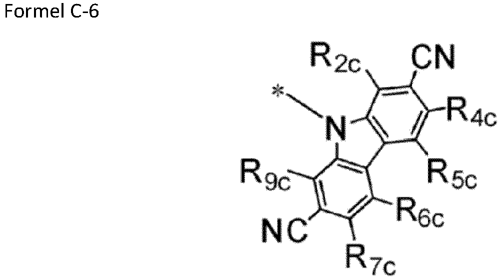 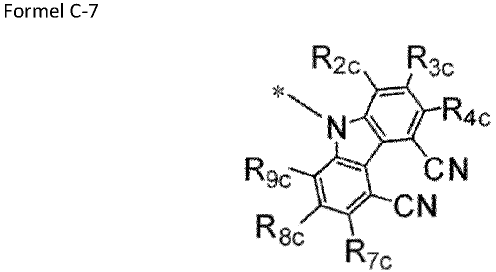 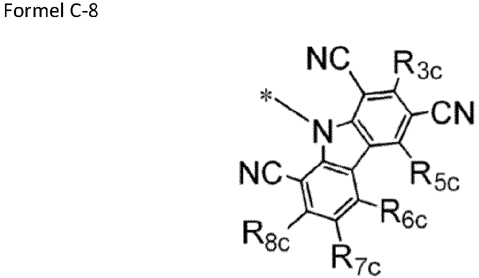 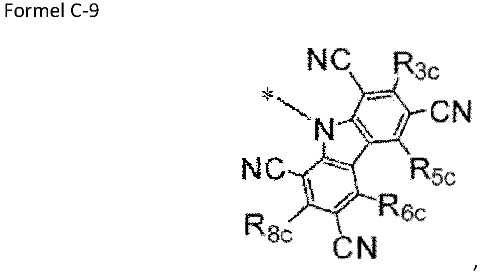 und
wobei in Formeln C-1 bis C-9
R_{2c} bis R_{9c} jeweils unabhängig Wasserstoff, Deuterium, ein Halogen, eine Cyanogruppe, eine Nitrogruppe, eine substituierte oder unsubstituierte Amingruppe, eine substituierte oder unsubstituierte Alkylgruppe, die 1 bis 20 Kohlenstoffatome aufweist, eine substituierte oder unsubstituierte Arylgruppe, die 6 bis 30 ringbildende Kohlenstoffatome aufweist, oder eine substituierte oder unsubstituierte Heteroarylgruppe, die 2 bis 30 ringbildende Kohlenstoffatome aufweist, sind, und
- * eine mit der Formel 1 verknüpfte Stelle ist.

6. Kondensierte polycyclische Verbindung nach Anspruch 1, wobei die durch Formel 1 dargestellte kondensierte polycyclische Verbindung durch eine beliebige aus Formeln 1-2-1 bis 1-2-8 ausgewählte dargestellt ist: 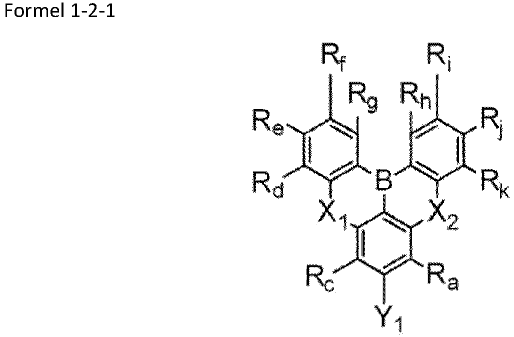 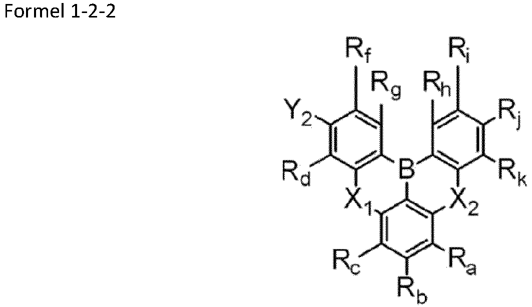 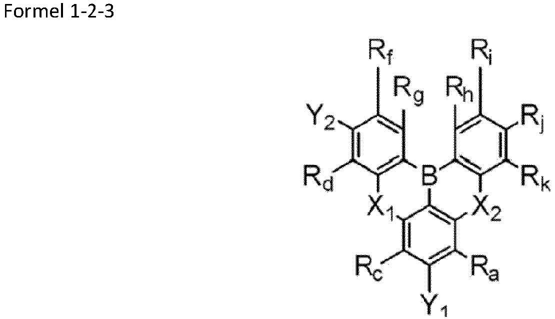 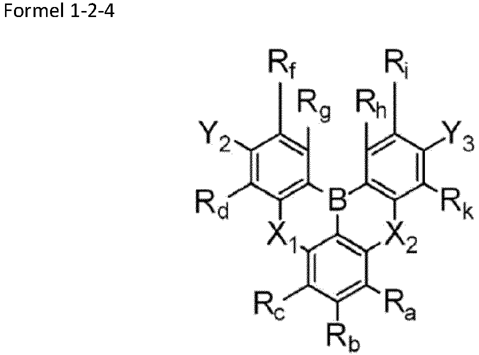 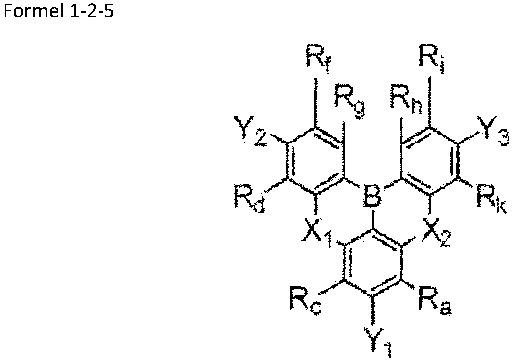 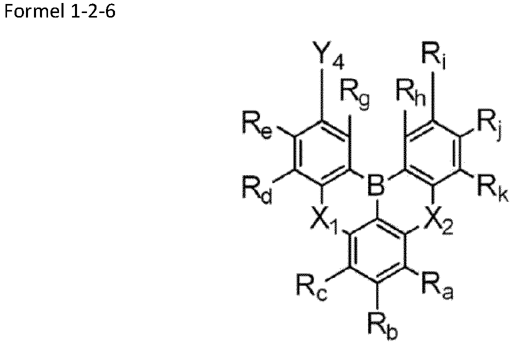 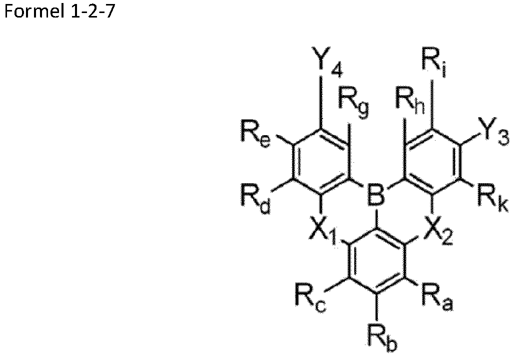 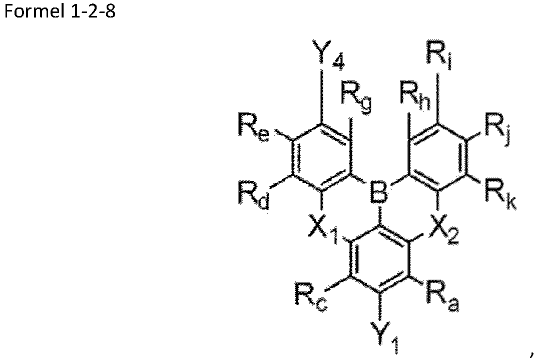 und
wobei in Formeln 1-2-1 bis 1-2-8
Rₐ bis Rₖ jeweils unabhängig Wasserstoff, Deuterium, ein Halogen, eine Cyanogruppe, eine Nitrogruppe, eine substituierte oder unsubstituierte Amingruppe, eine substituierte oder unsubstituierte Oxygruppe, eine substituierte oder unsubstituierte Thiogruppe, eine substituierte oder unsubstituierte Borgruppe, eine substituierte oder unsubstituierte Alkylgruppe, die 1 bis 20 Kohlenstoffatome aufweist, eine substituierte oder unsubstituierte Arylgruppe, die 6 bis 30 ringbildende Kohlenstoffatome aufweist, eine substituierte oder unsubstituierte Heteroarylgruppe, die 2 bis 30 ringbildende Kohlenstoffatome aufweist, sind, oder ein durch Formel 2 dargestellter Substituent und/oder an eine benachbarte Gruppe gebunden sind, um einen Ring zu bilden,
jedes von Rₐ bis Rₖ nicht an eine benachbarte Gruppe gebunden ist, um einen 5-gliedrigen Heterocyclus zu bilden,
Y₁ bis Y₄ durch Formel 2 dargestellt sind und
X₁ und X₂ dieselben wie in Formel 1 definiert sind.

7. Kondensierte polycyclische Verbindung nach Anspruch 1, wobei die durch Formel 1 dargestellte kondensierte polycyclische Verbindung durch eine beliebige aus Formeln 1-3-1 bis 1-3-3 ausgewählte dargestellt ist: 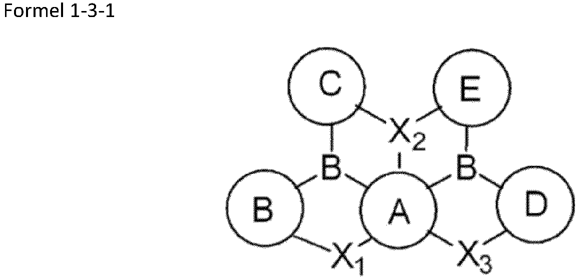 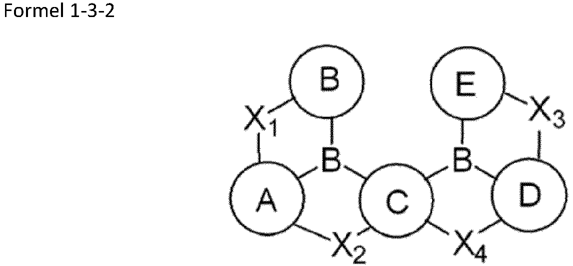 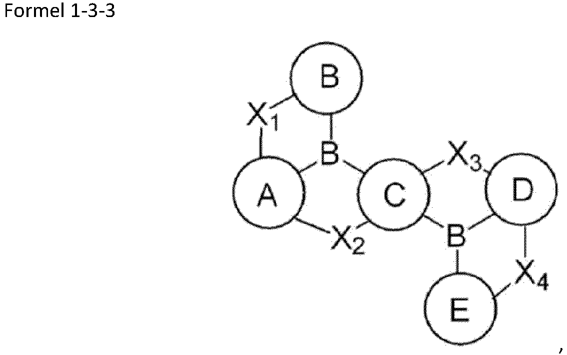 und
wobei in Formeln 1-3-1 bis 1-3-3
X₃ und X₄ jeweils unabhängig O, S oder NR₁₀sind,
R₁₀ eine substituierte oder unsubstituierte Arylgruppe, die 6 bis 30 ringbildende Kohlenstoffatome aufweist, oder eine substituierte oder unsubstituierte Heteroarylgruppe ist, die 2 bis 30 ringbildende Kohlenstoffatome aufweist, und/oder an eine benachbarte Gruppe gebunden ist, um einen Ring zu bilden,
D- und E-Ringe jeweils unabhängig ein substituierter oder unsubstituierter monocyclischer aromatischer Kohlenwasserstoffring, der 6 bis 30 ringbildende Kohlenstoffatome aufweist, oder ein substituierter oder unsubstituierter monocyclischer aromatischer Heterocyclus sind, der 2 bis 30 ringbildende Kohlenstoffatome aufweist, und/oder ein Substituent, der an einem von D- und E-Ringen substituiert ist, an eine benachbarte Gruppe gebunden ist, um einen Ring zu bilden,
jede von Formeln 1-3-1 bis 1-3-3 mindestens einen durch Formel 2 dargestellten Substituenten umfasst, und
X₁, X₂ und A- bis C-Ringe jeweils dieselben wie in Formel 1 definiert sind.

8. Kondensierte polycyclische Verbindung nach Anspruch 1, wobei die durch Formel 1 dargestellte kondensierte polycyclische Verbindung durch eine beliebige aus Formeln 1-4-1 bis 1-4-3 ausgewählte dargestellt ist: 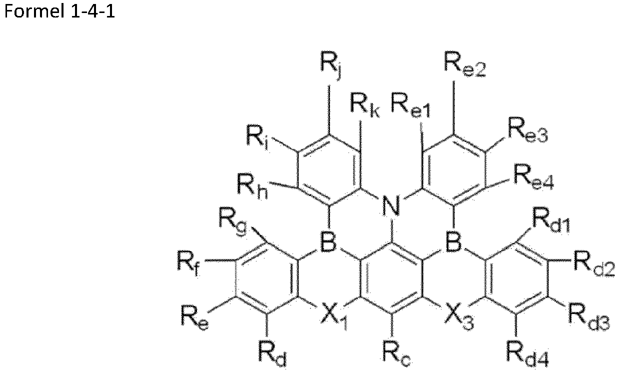 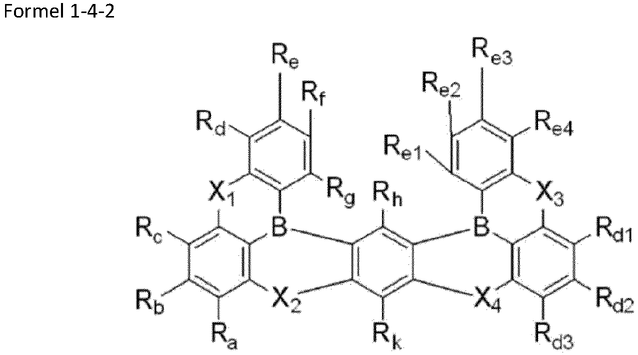 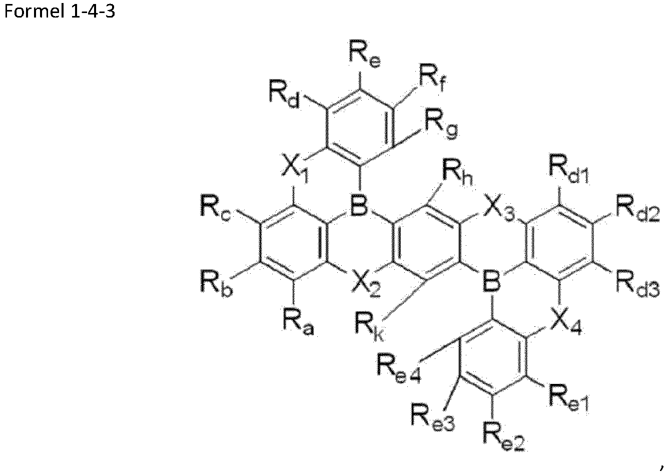 und
wobei in Formeln 1-4-1 bis 1-4-3
X₃ und X₄ jeweils unabhängig O, S oder NR₁₀sind,
R₁₀ eine substituierte oder unsubstituierte Arylgruppe, die 6 bis 30 ringbildende Kohlenstoffatome aufweist, oder eine substituierte oder unsubstituierte Heteroarylgruppe ist, die 2 bis 30 ringbildende Kohlenstoffatome aufweist, und/oder an eine benachbarte Gruppe gebunden ist, um einen Ring zu bilden,
Rₐ bis Rₖ, R_{d1} bis R_{d4}und Rₑ₁ bis Rₑ₄ jeweils unabhängig Wasserstoff, Deuterium, ein Halogen, eine Cyanogruppe, eine Nitrogruppe, eine substituierte oder unsubstituierte Amingruppe, eine substituierte oder unsubstituierte Oxygruppe, eine substituierte oder unsubstituierte Thiogruppe, eine substituierte oder unsubstituierte Borgruppe, eine substituierte oder unsubstituierte Alkylgruppe, die 1 bis 20 Kohlenstoffatome aufweist, eine substituierte oder unsubstituierte Arylgruppe, die 6 bis 30 ringbildende Kohlenstoffatome aufweist, eine substituierte oder unsubstituierte Heteroarylgruppe, die 2 bis 30 ringbildende Kohlenstoffatome aufweist, sind, oder ein durch Formel 2 dargestellter Substituent, und/oder an eine benachbarte Gruppe gebunden, um einen Ring zu bilden,
in Formel 1-4-1
mindestens eines, ausgewählt aus R_{c} bis Rₖ, R_{d1} bis R_{d4}, und Rₑ₁ bis Rₑ₄ durch Formel 2 dargestellt ist,
in Formel 1-4-2
mindestens eines, ausgewählt aus Rₐ bis Rₕ, Rₖ, R_{d1} bis R_{d3}und Rₑ₁ bis Rₑ₄, durch Formel 2 dargestellt ist,
in Formel 1-4-3
mindestens eines, ausgewählt aus Rₐ bis Rₕ, Rₖ, R_{d1} bis R_{d3}und Rₑ₁ bis Rₑ₄, durch Formel 2 dargestellt ist, und
in Formeln 1-4-1 bis 1-4-3
X₁ und X₂ dieselben wie in Formel 1 definiert sind.

9. Kondensierte polycyclische Verbindung nach Anspruch 1, wobei die durch Formel 1 dargestellte kondensierte polycyclische Verbindung durch eine beliebige aus Formeln 1-5-1 bis 1-5-6 ausgewählte dargestellt ist: 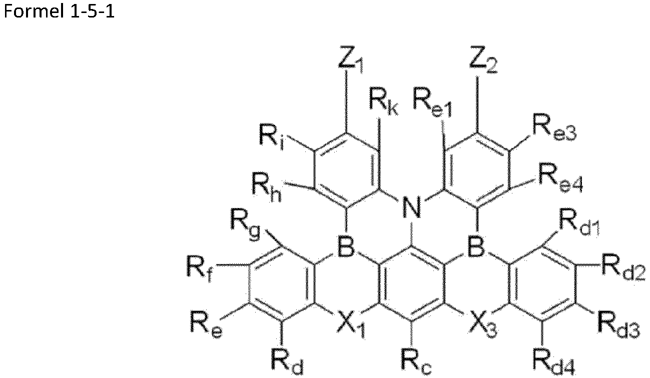 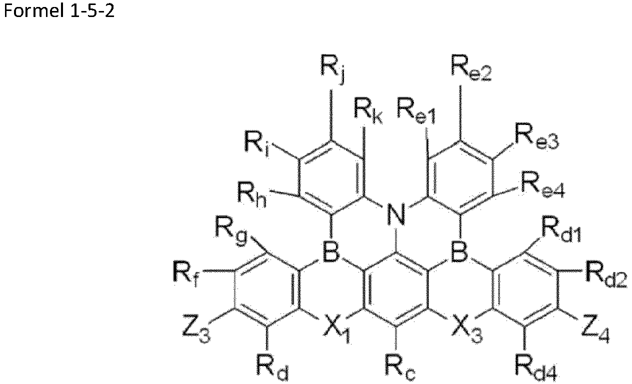 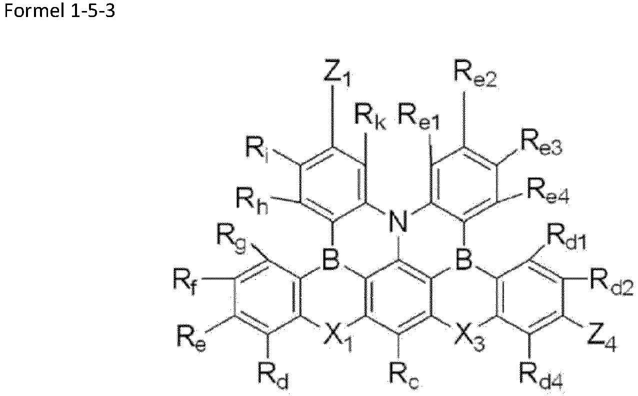 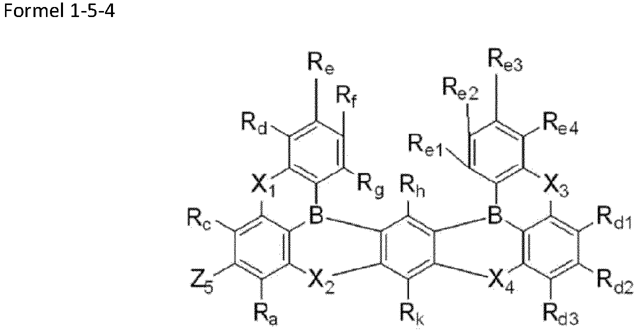 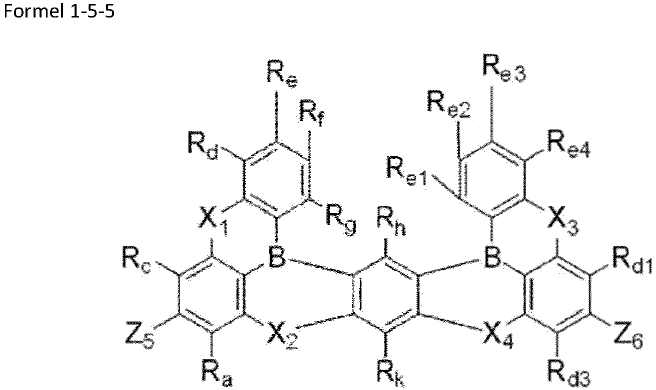 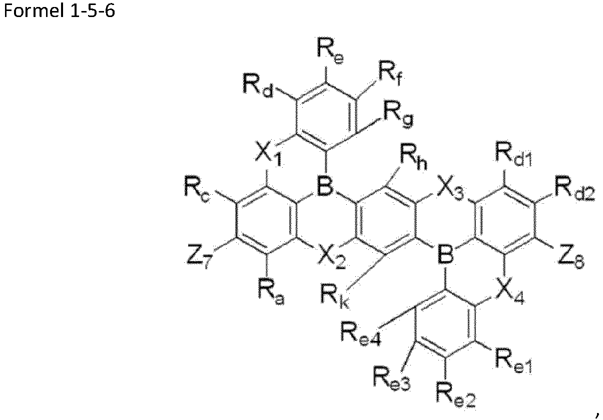 und
wobei in Formeln 1-5-1 bis 1-5-6
X₃ und X₄ jeweils unabhängig O, S oder NR₁₀sind,
R₁₀ eine substituierte oder unsubstituierte Arylgruppe, die 6 bis 30 ringbildende Kohlenstoffatome aufweist, oder eine substituierte oder unsubstituierte Heteroarylgruppe ist, die 2 bis 30 ringbildende Kohlenstoffatome aufweist, und/oder an eine benachbarte Gruppe gebunden ist, um einen Ring zu bilden,
Rₐ bis Rₖ, R_{d1} bis R_{d4} und Rₑ₁ bis Rₑ₄ jeweils unabhängig Wasserstoff, Deuterium, ein Halogen, eine Cyanogruppe, eine Nitrogruppe, eine substituierte oder unsubstituierte Amingruppe, eine substituierte oder unsubstituierte Oxygruppe, eine substituierte oder unsubstituierte Thiogruppe, eine substituierte oder unsubstituierte Borgruppe, eine substituierte oder unsubstituierte Alkylgruppe, die 1 bis 20 Kohlenstoffatome aufweist, eine substituierte oder unsubstituierte Arylgruppe, die 6 bis 30 ringbildende Kohlenstoffatome aufweist, eine substituierte oder unsubstituierte Heteroarylgruppe, die 2 bis 30 ringbildende Kohlenstoffatome aufweist, sind, oder ein durch Formel 2 dargestellter Substituent, und/oder an eine benachbarte Gruppe gebunden, um einen Ring zu bilden,
Z₁ bis Z₈ durch Formel 2 dargestellt sind und
X₁ und X₂ dieselben wie in Formel 1 definiert sind.

10. Kondensierte polycyclische Verbindung nach Anspruch 1, wobei die kondensierte polycyclische Verbindung mindestens eine ist, ausgewählt aus Verbindungen von Verbindung:

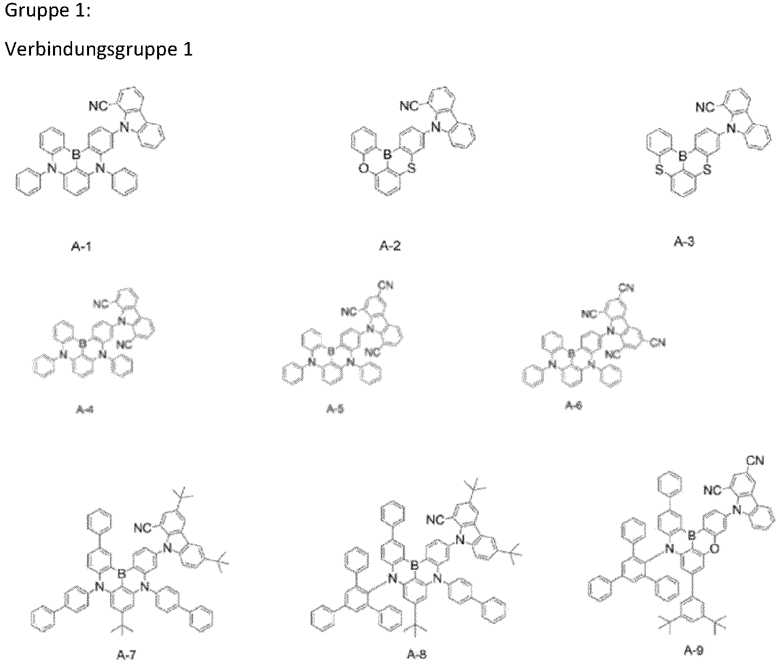

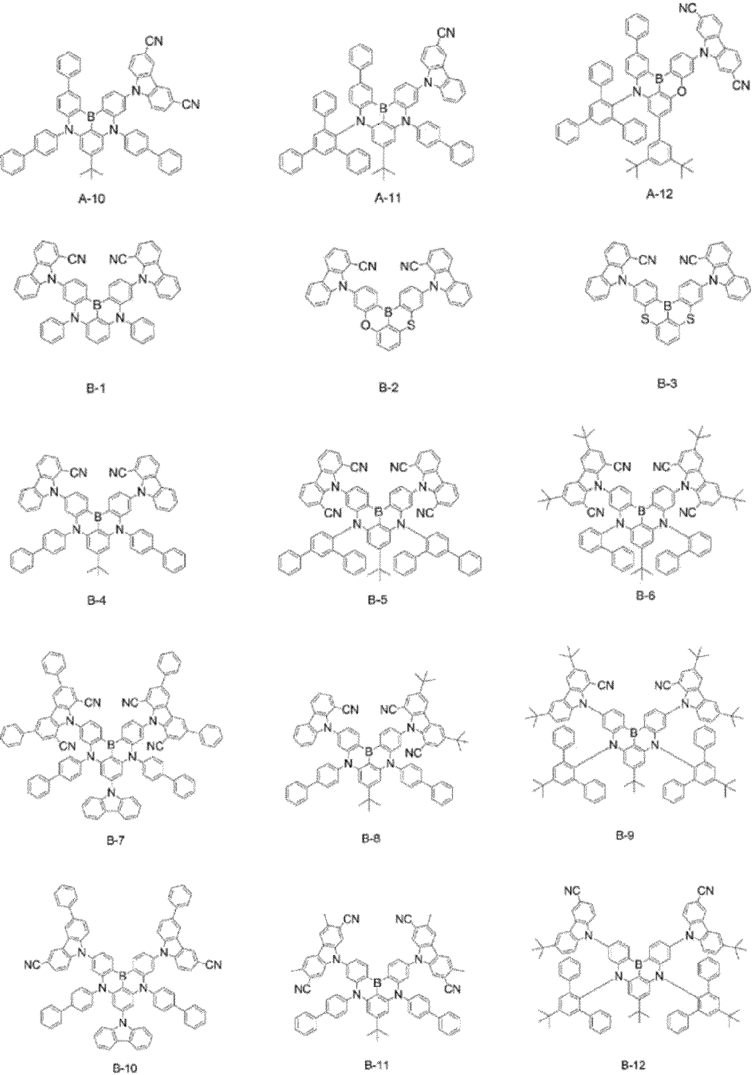

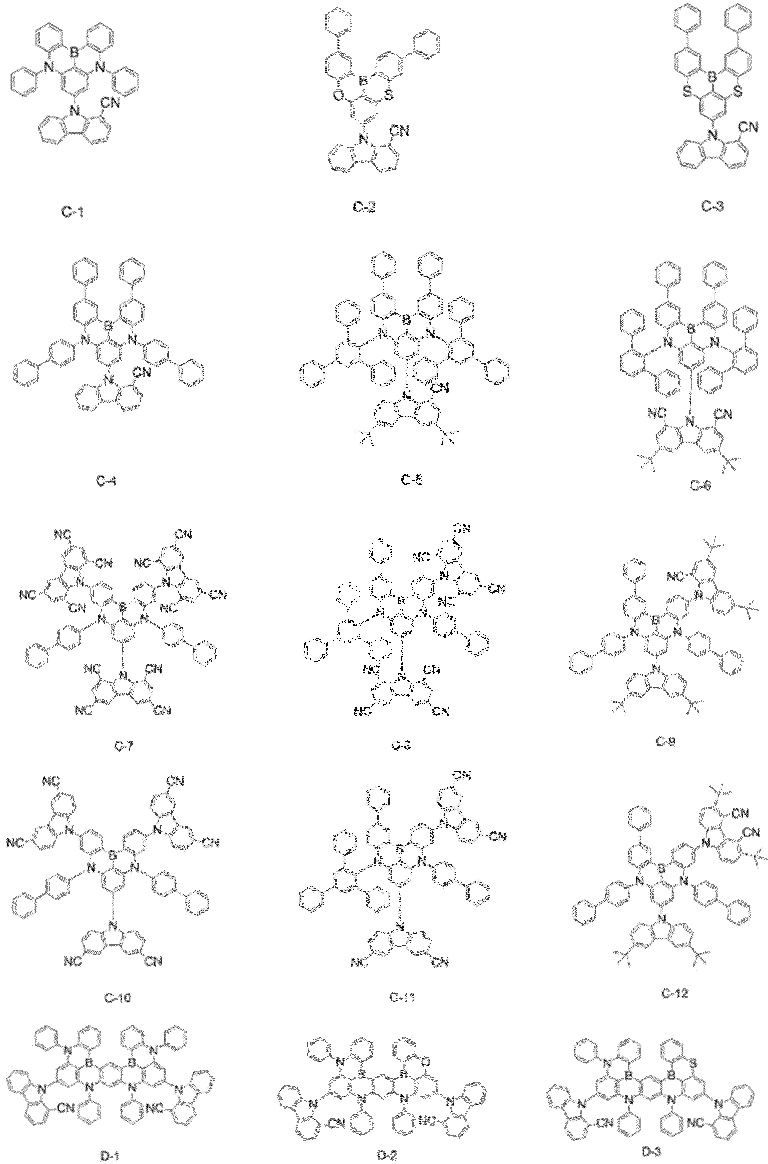

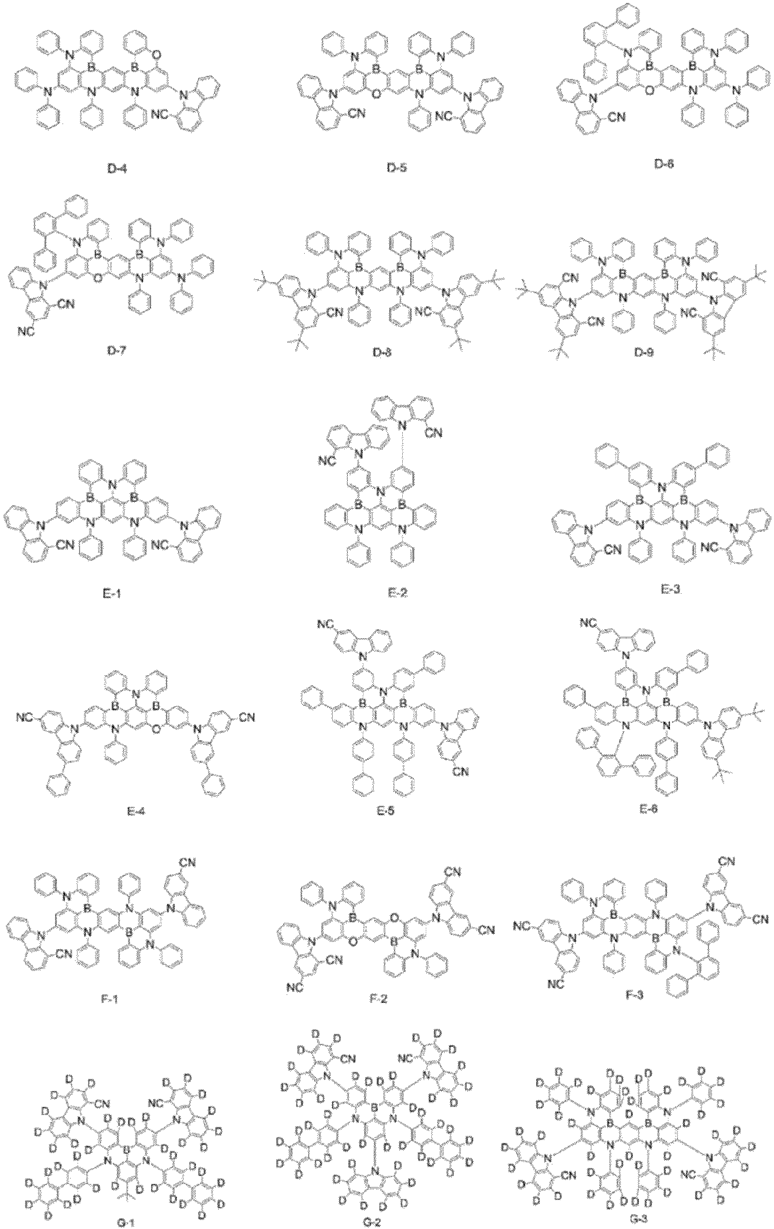

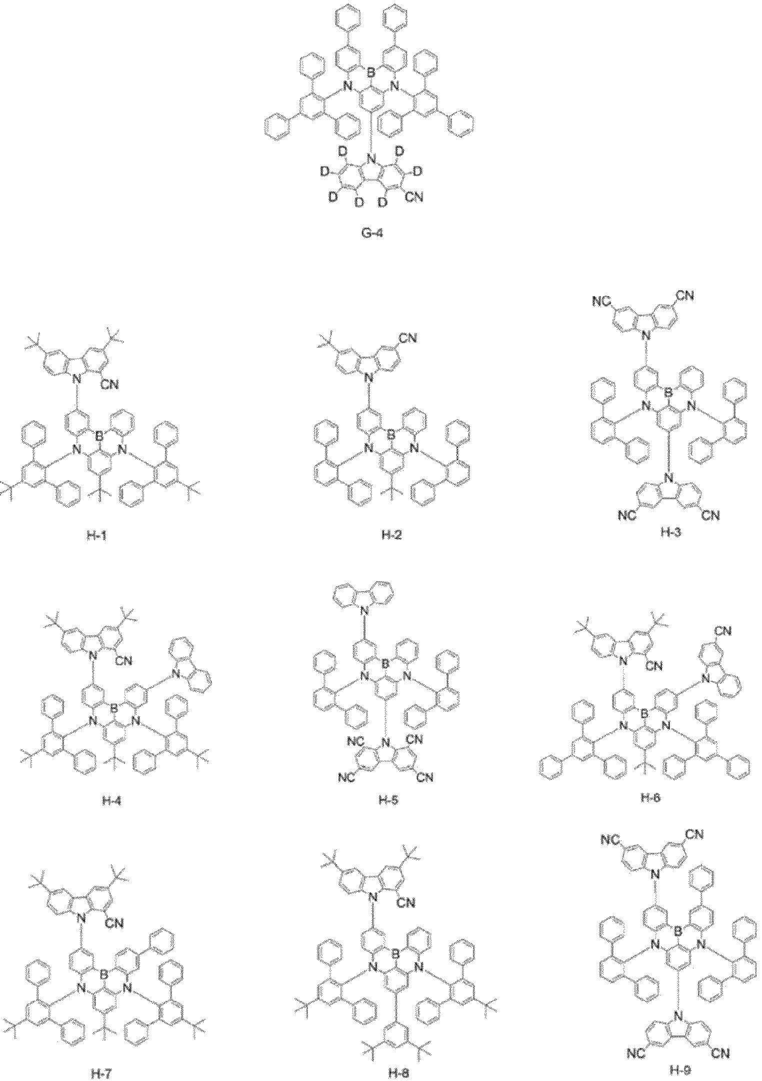

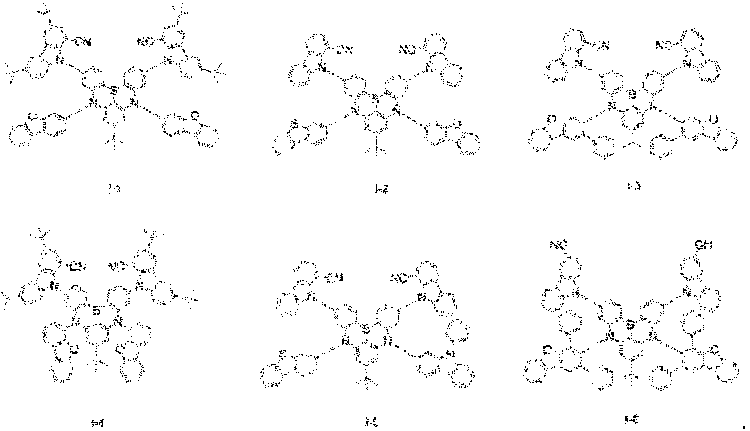

11. Lichtemittierendes Element, umfassend:
eine erste Elektrode;
eine zweite Elektrode auf der ersten Elektrode; und
mindestens eine Funktionsschicht zwischen der ersten Elektrode und der zweiten Elektrode, die als eine erste Verbindung die kondensierte polycyclische Verbindung nach einem der Ansprüche 1 bis 10 umfasst.

12. Lichtemittierendes Element nach Anspruch 11, wobei die mindestens eine Funktionsschicht eine Emissionsschicht, einen Lochtransportbereich zwischen der ersten Elektrode und der Emissionsschicht und einen Elektronentransportbereich zwischen der Emissionsschicht und der zweiten Elektrode umfasst,
wobei die Emissionsschicht die kondensierte polycyclische Verbindung umfasst.

13. Lichtemittierendes Element nach Anspruch 12, wobei die Emissionsschicht konfiguriert ist, um verzögerte Fluoreszenz zu emittieren.

14. Lichtemittierendes Element nach Anspruch 12 oder Anspruch 13, wobei die Emissionsschicht konfiguriert ist, um Licht zu emittieren, das eine zentrale Emissionswellenlänge von etwa 430 nm bis etwa 490 nm aufweist.

## Revendications

1. Composé polycyclique fusionné représenté par la formule 1 : 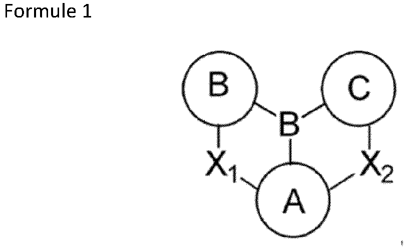 dans lequel, dans la formule 1,
X₁ et X₂ représentent chacun indépendamment O, S ou NR₁,
le cas dans lequel X₁ et X₂ représentent simultanément O est exclu,
R₁ est un groupe aryle substitué ou non substitué présentant de 6 à 30 atomes de carbone formant un cycle ou un groupe hétéroaryle substitué ou non substitué présentant de 2 à 30 atomes de carbone formant un cycle et/ou lié à un groupe adjacent pour former un cycle,
lorsque X₁ et X₂ représentent simultanément NR₁, le cas dans lequel R₁ est représenté par la formule a est exclu,
des cycles A à C représentent chacun indépendamment un cycle hydrocarboné aromatique monocyclique substitué ou non substitué présentant de 6 à 30 atomes de carbone formant un cycle ou un hétérocycle aromatique monocyclique substitué ou non substitué présentant de 2 à 30 atomes de carbone formant un cycle et/ou un substituant substitué sur l'un quelconque des cycles A à C est lié à un groupe adjacent pour former un cycle,
le cas dans lequel un hétérocycle à 5 chaînons est fusionné à l'un quelconque des cycles A à C est exclu, et
la formule 1 comprend au moins un substituant représenté par la formule 2 : 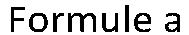 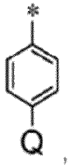 dans lequel, dans la formule a,
Q représente un groupe alkyle substitué ou non substitué. 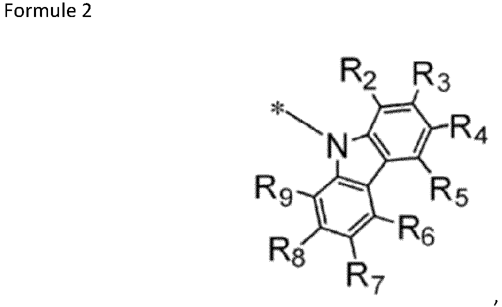 et
dans lequel, dans la formule 2,
R₂ à R₉ représentent chacun indépendamment un hydrogène, un deutérium, un halogène, un groupe cyano, un groupe nitro, un groupe amine substitué ou non substitué, un groupe alkyle substitué ou non substitué présentant de 1 à 20 atomes de carbone, un groupe aryle substitué ou non substitué présentant de 6 à 30 atomes de carbone formant un cycle ou un groupe hétéroaryle substitué ou non substitué présentant de 2 à 30 atomes de carbone formant un cycle,
au moins l'un choisi parmi R₂ à R₉ représente un groupe cyano, et
-* est un site lié à la formule 1.

2. Composé polycyclique fusionné selon la revendication 1, dans lequel le composé polycyclique fusionné représenté par la formule 1 est représenté par une formule quelconque choisie parmi les formules 1-1-1 à 1-1-3 : 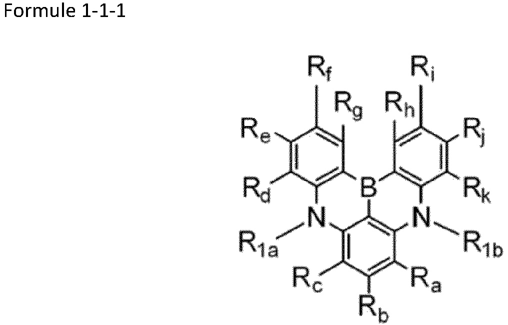 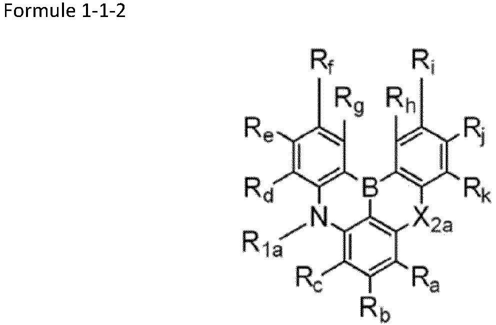 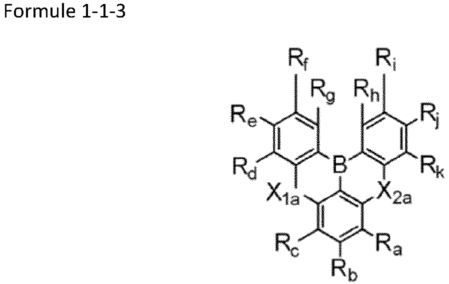 dans lequel dans les formules 1-1-1 à 1-1-3,
X₁ₐ et X₂ₐ représentent chacun indépendamment O ou S,
R₁ₐ et R_{1b} représentent chacun indépendamment un groupe aryle substitué ou non substitué présentant de 6 à 30 atomes de carbone formant un cycle ou un groupe hétéroaryle substitué ou non substitué présentant de 2 à 30 atomes de carbone formant un cycle et/ou lié à un groupe adjacent pour former un cycle aromatique,
Rₐ à Rₖ représentent chacun indépendamment un hydrogène, un deutérium, un halogène, un groupe cyano, un groupe nitro, un groupe amine substitué ou non substitué, un groupe oxy substitué ou non substitué, un groupe thio substitué ou non substitué, un groupe bore substitué ou non substitué, un groupe alkyle substitué ou non substitué présentant de 1 à 20 atomes de carbone, un groupe aryle substitué ou non substitué présentant de 6 à 30 atomes de carbone formant un cycle ou un groupe hétéroaryle substitué ou non substitué présentant de 2 à 30 atomes de carbone formant un cycle ou un substituant représenté par la formule 2 et/ou lié à un groupe adjacent pour former un cycle,
au moins l'un choisi parmi Rₐ à Rₖ représente un substituant représenté par la formule 2,
chacun parmi Rₐ à Rₖ, R₁ₐ et R_{1b} n'est pas lié à un groupe adjacent pour former un hétérocycle à 5 chaînons,
dans la formule 1-1-1, le cas dans lequel R₁ₐ et R_{1b} sont chacun représentés par la formule a est exclu, et
dans la formule 1-1-3, le cas dans lequel X₁ₐ et X₂ₐ représentent simultanément O est exclu.

3. Composé polycyclique fusionné selon la revendication 2, dans lequel R₁ₐ et R_{1b} sont représentés chacun indépendamment par une formule quelconque choisie parmi les formules A-1 à A-4 : 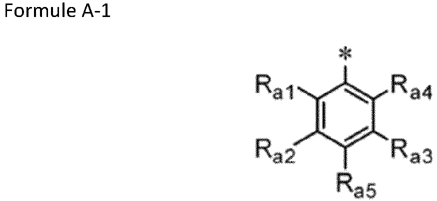 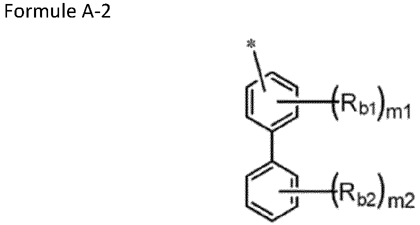 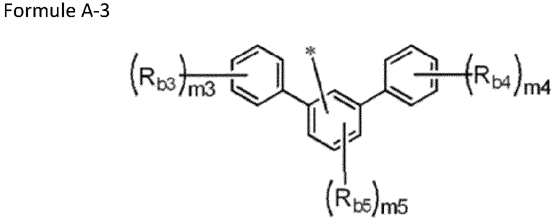 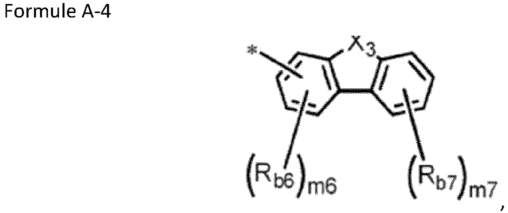 et
dans lequel dans les formules A-1 à A-4,
X₃ représente NR_{b8}, O ou S,
Rₐ₁ à Rₐ₄ et R_{b1} à R_{b7} représentent chacun indépendamment un hydrogène, un deutérium, un halogène, un groupe cyano, un groupe nitro, un groupe amine substitué ou non substitué, un groupe alkyle substitué ou non substitué présentant de 1 à 20 atomes de carbone, un groupe aryle substitué ou non substitué présentant de 6 à 30 atomes de carbone formant un cycle ou un groupe hétéroaryle substitué ou non substitué présentant de 2 à 30 atomes de carbone formant un cycle et/ou lié à un groupe adjacent pour former un cycle,
Rₐ₅ représente un hydrogène, un deutérium, un halogène, un groupe cyano, un groupe nitro, un groupe amine substitué ou non substitué, un groupe aryle substitué ou non substitué présentant de 6 à 30 atomes de carbone formant un cycle ou un groupe hétéroaryle substitué ou non substitué présentant de 2 à 30 atomes de carbone formant un cycle,
R_{b8} représente un groupe aryle substitué ou non substitué présentant de 6 à 30 atomes de carbone formant un cycle ou un groupe hétéroaryle substitué ou non substitué présentant de 2 à 30 atomes de carbone formant un cycle,
m1 et m7 représentent chacun indépendamment un nombre entier allant de 0 à 4,
m2 à m4 représentent chacun indépendamment un nombre entier allant de 0 à 5,
m5 et m6 représentent chacun indépendamment un nombre entier allant de 0 à 3, et
-* est un site lié à la formule 1.

4. Composé polycyclique fusionné selon la revendication 1, dans lequel un substituant représenté par la formule 2 est représenté par la formule B-1 ou la formule B-2 : 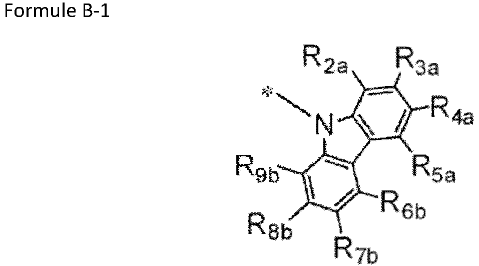 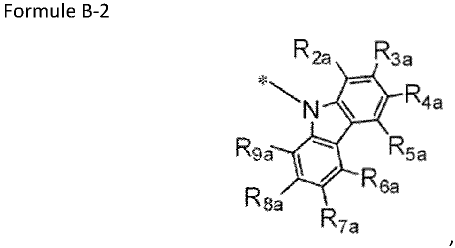 et
dans lequel dans les formules B-1 et B-2,
R₂ₐ à R₉ₐ représentent chacun indépendamment un hydrogène, un deutérium, un halogène, un groupe cyano, un groupe nitro, un groupe amine substitué ou non substitué, un groupe alkyle substitué ou non substitué présentant de 1 à 20 atomes de carbone, un groupe aryle substitué ou non substitué présentant de 6 à 30 atomes de carbone formant un cycle ou un groupe hétéroaryle substitué ou non substitué présentant de 2 à 30 atomes de carbone formant un cycle,
R_{6b} à R_{9b} représentent chacun indépendamment un hydrogène, un deutérium, un halogène, un groupe nitro, un groupe amine substitué ou non substitué, un groupe alkyle substitué ou non substitué présentant de 1 à 20 atomes de carbone, un groupe aryle substitué ou non substitué présentant de 6 à 30 atomes de carbone formant un cycle ou un groupe hétéroaryle substitué ou non substitué présentant de 2 à 30 atomes de carbone formant un cycle,
dans la formule B-1,
au moins l'un choisi parmi R₂ₐ à R₅ₐ représente un groupe cyano,
dans la formule B-2,
au moins l'un choisi parmi R₂ₐ à R₅ₐ et au moins l'un choisi parmi R₆ₐ à R₉ₐ représentent chacun un groupe cyano, et
-* est un site lié à la formule 1.

5. Composé polycyclique fusionné selon la revendication 1, dans lequel un substituant représenté par la formule 2 est représenté par une formule quelconque choisie parmi les formules C-1 à C-9 : 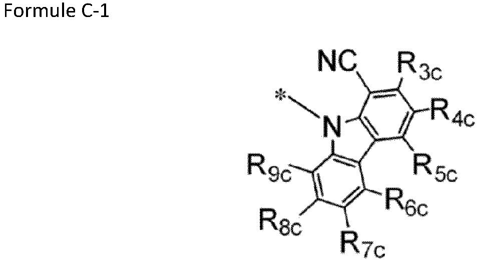 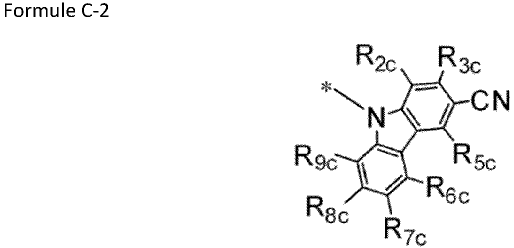 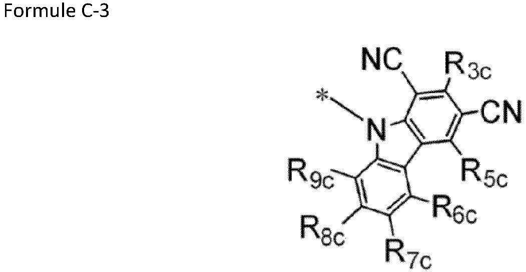 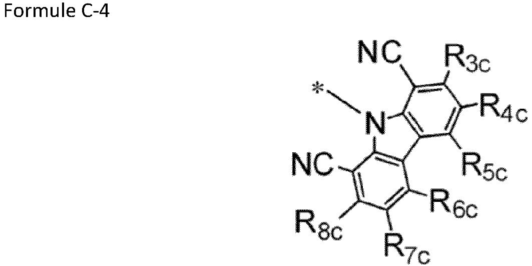 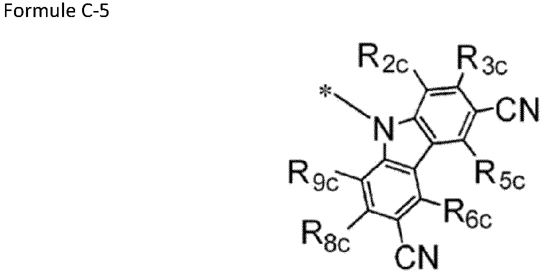 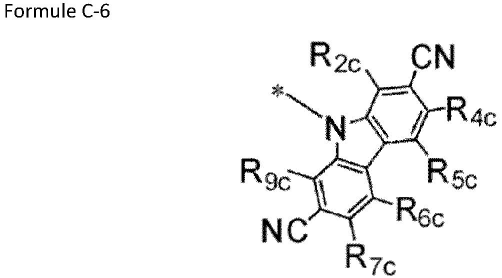 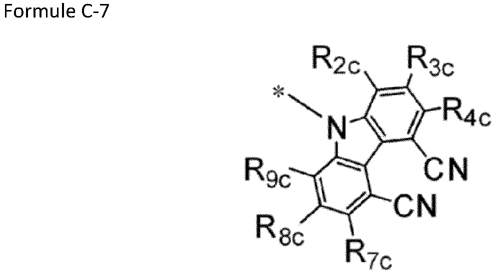 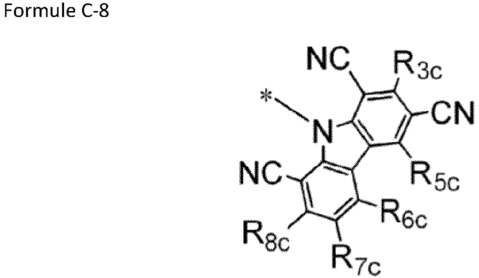 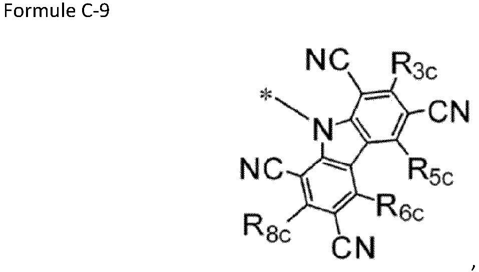 et
dans lequel dans les formules C-1 à C-9,
R_{2C} à R_{9c} représentent chacun indépendamment un hydrogène, un deutérium, un halogène, un groupe cyano, un groupe nitro, un groupe amine substitué ou non substitué, un groupe alkyle substitué ou non substitué présentant de 1 à 20 atomes de carbone, un groupe aryle substitué ou non substitué présentant de 6 à 30 atomes de carbone formant un cycle ou un groupe hétéroaryle substitué ou non substitué présentant de 2 à 30 atomes de carbone formant un cycle, et
-* est un site lié à la formule 1.

6. Composé polycyclique fusionné selon la revendication 1, dans lequel le composé polycyclique fusionné représenté par la formule 1 est représenté par une formule quelconque choisie parmi les formules 1-2-1 à 1-2-8 : 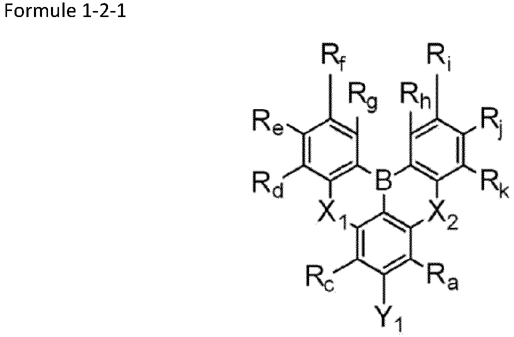 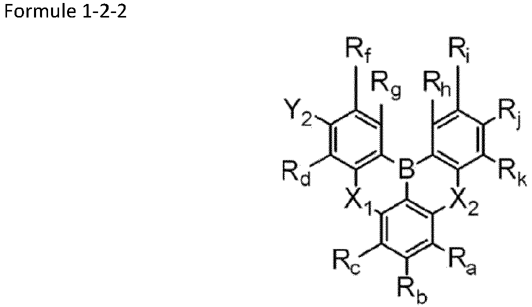 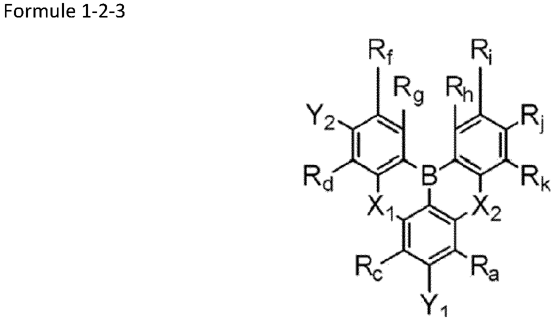 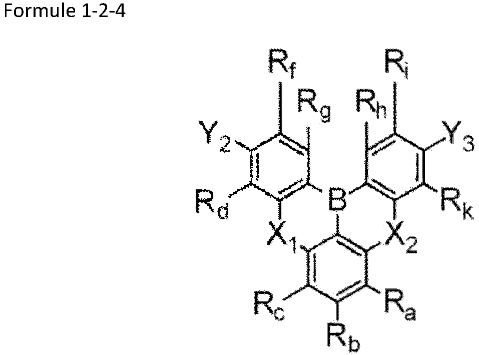 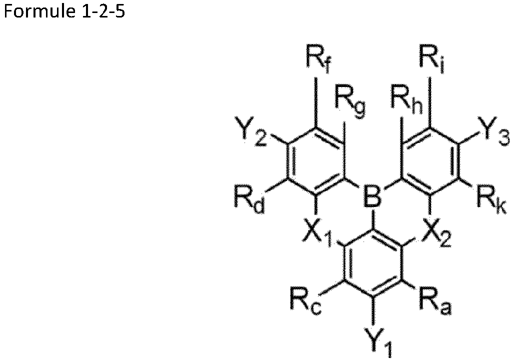 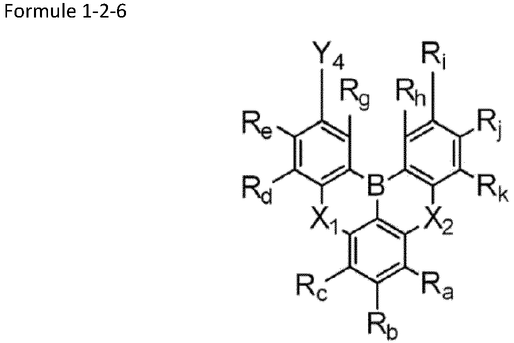 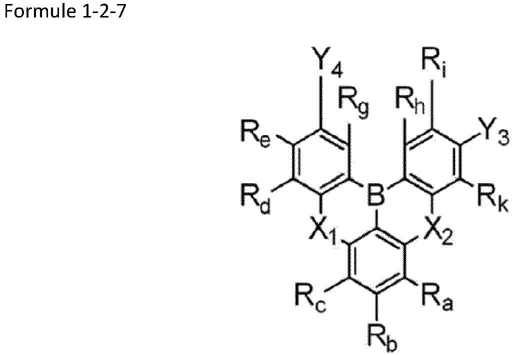 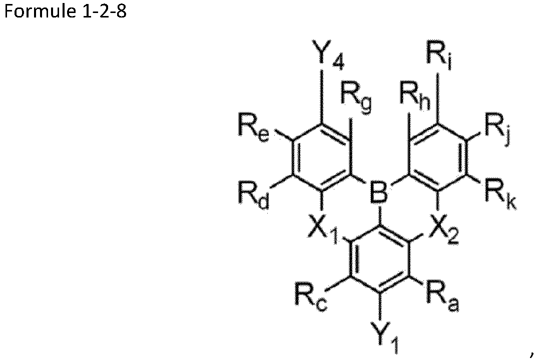 et
dans lequel dans les formules 1-2-1 à 1-2-8,
Rₐ à Rₖ représentent chacun indépendamment un hydrogène, un deutérium, un halogène, un groupe cyano, un groupe nitro, un groupe amine substitué ou non substitué, un groupe oxy substitué ou non substitué, un groupe thio substitué ou non substitué, un groupe bore substitué ou non substitué, un groupe alkyle substitué ou non substitué présentant de 1 à 20 atomes de carbone, un groupe aryle substitué ou non substitué présentant de 6 à 30 atomes de carbone formant un cycle ou un groupe hétéroaryle substitué ou non substitué présentant de 2 à 30 atomes de carbone formant un cycle ou un substituant représenté par la formule 2 et/ou lié à un groupe adjacent pour former un cycle,
chacun parmi Rₐ à Rₖ n'est pas lié à un groupe adjacent pour former un hétérocycle à 5 chaînons,
Y₁ à Y₄ sont représentés par la formule 2, et
X₁ et X₂ sont identiques à ceux définis dans la formule 1.

7. Composé polycyclique fusionné selon la revendication 1, dans lequel le composé polycyclique fusionné représenté par la formule 1 est représenté par une formule quelconque choisie parmi les formules 1-3-1 à 1-3-3 : 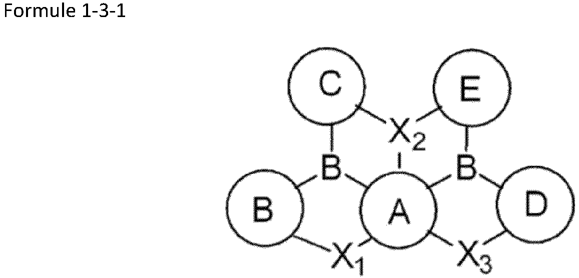 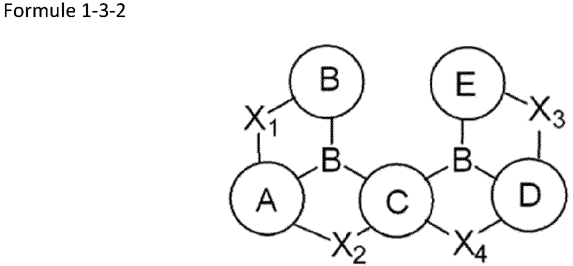 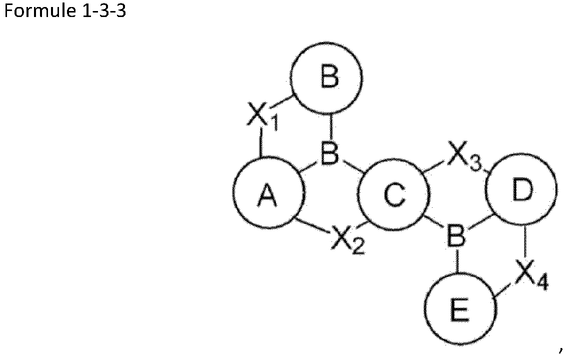 et
dans lequel dans les formules 1-3-1 à 1-3-3,
X₃ et X₄ représentent chacun indépendamment 0, S ou NR₁₀,
R₁₀ représente un groupe aryle substitué ou non substitué présentant de 6 à 30 atomes de carbone formant un cycle ou un groupe hétéroaryle substitué ou non substitué présentant de 2 à 30 atomes de carbone formant un cycle et/ou lié à un groupe adjacent pour former un cycle,
les cycles D et E représentent chacun indépendamment un cycle hydrocarboné aromatique monocyclique substitué ou non substitué présentant de 6 à 30 atomes de carbone formant un cycle ou un hétérocycle aromatique monocyclique substitué ou non substitué présentant de 2 à 30 atomes de carbone formant un cycle et/ou un substituant substitué sur l'un quelconque des cycles D et E est lié à un groupe adjacent pour former un cycle,
chacune de formules 1-3-1 à 1-3-3 comprend au moins un substituant représenté par la formule 2, et
X₁, X₂ et les cycles A à C sont chacun identiques à ceux définis dans la formule 1.

8. Composé polycyclique fusionné selon la revendication 1, dans lequel le composé polycyclique fusionné représenté par la formule 1 est représenté par une formule quelconque choisie parmi les formules 1-4-1 à 1-4-3 : 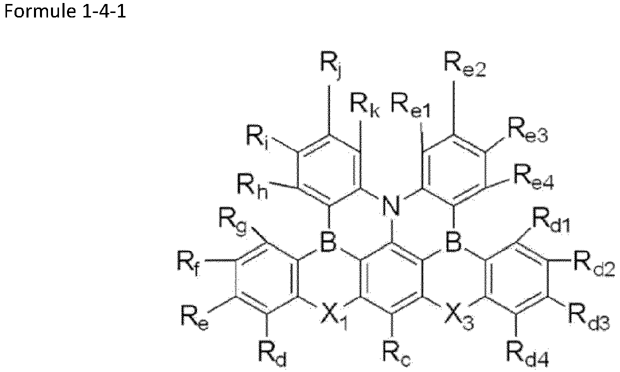 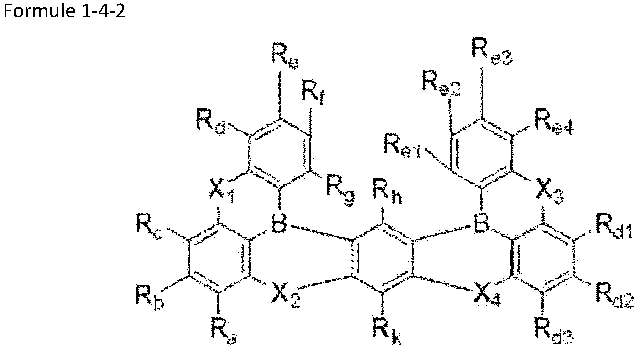 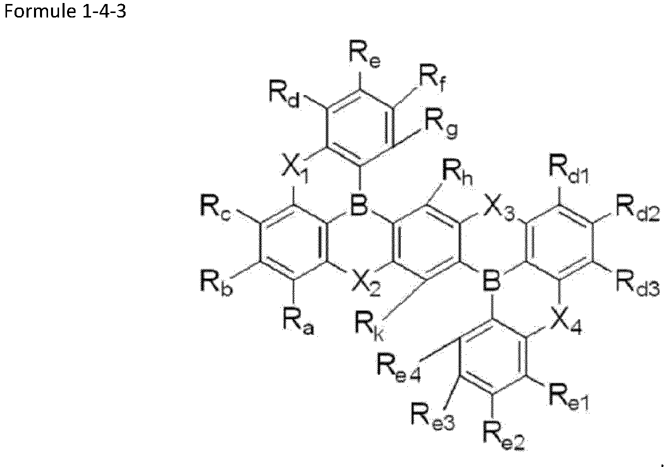 et
dans lequel dans les formules 1-4-1 à 1-4-3,
X₃ et X₄ représentent chacun indépendamment 0, S ou NR₁₀,
R₁₀ représente un groupe aryle substitué ou non substitué présentant de 6 à 30 atomes de carbone formant un cycle ou un groupe hétéroaryle substitué ou non substitué présentant de 2 à 30 atomes de carbone formant un cycle et/ou lié à un groupe adjacent pour former un cycle,
Rₐ à Rₖ, R_{d1} à R_{d4}, et Rₑ₁ à Rₑ₄ représentent chacun indépendamment un hydrogène, un deutérium, un halogène, un groupe cyano, un groupe nitro, un groupe amine substitué ou non substitué, un groupe oxy substitué ou non substitué, un groupe thio substitué ou non substitué, un groupe bore substitué ou non substitué, un groupe alkyle substitué ou non substitué présentant de 1 à 20 atomes de carbone, un groupe aryle substitué ou non substitué présentant de 6 à 30 atomes de carbone formant un cycle ou un groupe hétéroaryle substitué ou non substitué présentant de 2 à 30 atomes de carbone formant un cycle ou un substituant représenté par la formule 2 et/ou lié à un groupe adjacent pour former un cycle,
dans la formule 1-4-1,
au moins l'un choisi parmi R_{c} à Rₖ, R_{d1} à R_{d4} et Rₑ₁ à Rₑ₄ est représenté par la formule 2,
dans la formule 1-4-2,
au moins l'un choisi parmi Rₐ à Rₕ, Rₖ, R_{d1} à R_{d3} et Rₑ₁ à Rₑ₄ est représenté par la formule 2,
dans la formule 1-4-3,
au moins l'un choisi parmi Rₐ à Rₕ, Rₖ, R_{d1} à R_{d3} et Rₑ₁ à Rₑ₄ est représenté par la formule 2, et
dans les formules 1-4-1 à 1-4-3,
X₁ et X₂ sont identiques à ceux définis dans la formule 1.

9. Composé polycyclique fusionné selon la revendication 1, dans lequel le composé polycyclique fusionné représenté par la formule 1 est représenté par une formule quelconque choisie parmi les formules 1-5-1 à 1-5-6 : 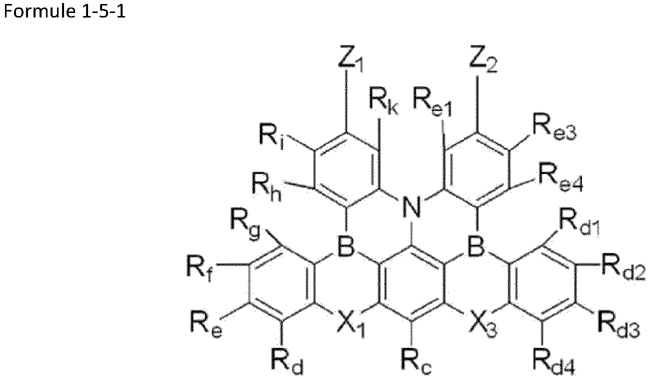 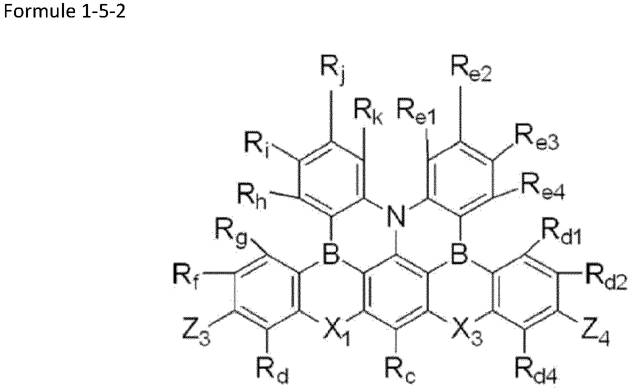 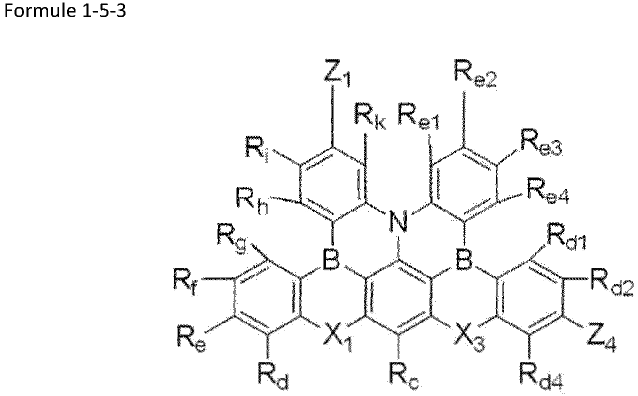 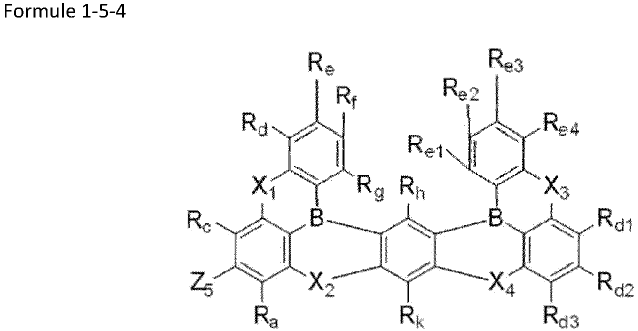 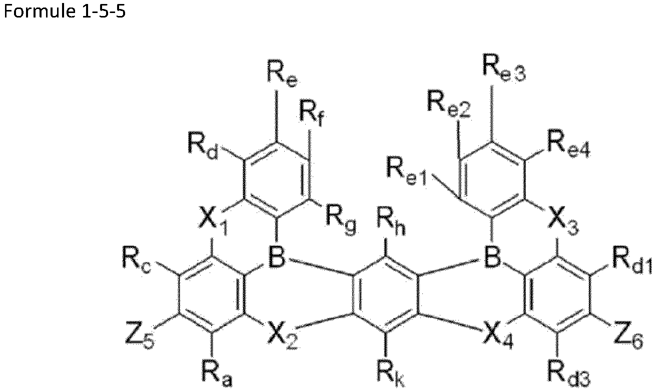 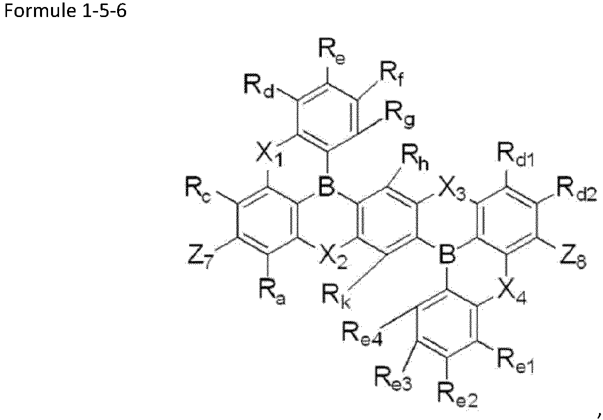 et
dans lequel dans les formules 1-5-1 à 1-5-6,
X₃ et X₄ représentent chacun indépendamment 0, S ou NR₁₀,
R₁₀ représente un groupe aryle substitué ou non substitué présentant de 6 à 30 atomes de carbone formant un cycle ou un groupe hétéroaryle substitué ou non substitué présentant de 2 à 30 atomes de carbone formant un cycle et/ou lié à un groupe adjacent pour former un cycle,
Rₐ à Rₖ, R_{d1} à R_{d4}, et Rₑ₁ à Rₑ₄ représentent chacun indépendamment un hydrogène, un deutérium, un halogène, un groupe cyano, un groupe nitro, un groupe amine substitué ou non substitué, un groupe oxy substitué ou non substitué, un groupe thio substitué ou non substitué, un groupe bore substitué ou non substitué, un groupe alkyle substitué ou non substitué présentant de 1 à 20 atomes de carbone, un groupe aryle substitué ou non substitué présentant de 6 à 30 atomes de carbone formant un cycle ou un groupe hétéroaryle substitué ou non substitué présentant de 2 à 30 atomes de carbone formant un cycle ou un substituant représenté par la formule 2 et/ou lié à un groupe adjacent pour former un cycle,
Z₁ à Z₈ sont représentés par la formule 2, et
X₁ et X₂ sont identiques à ceux définis dans la formule 1.

10. Composé polycyclique fusionné selon la revendication 1, dans lequel le composé polycyclique fusionné comprend au moins un composé choisi parmi les composés du composé :

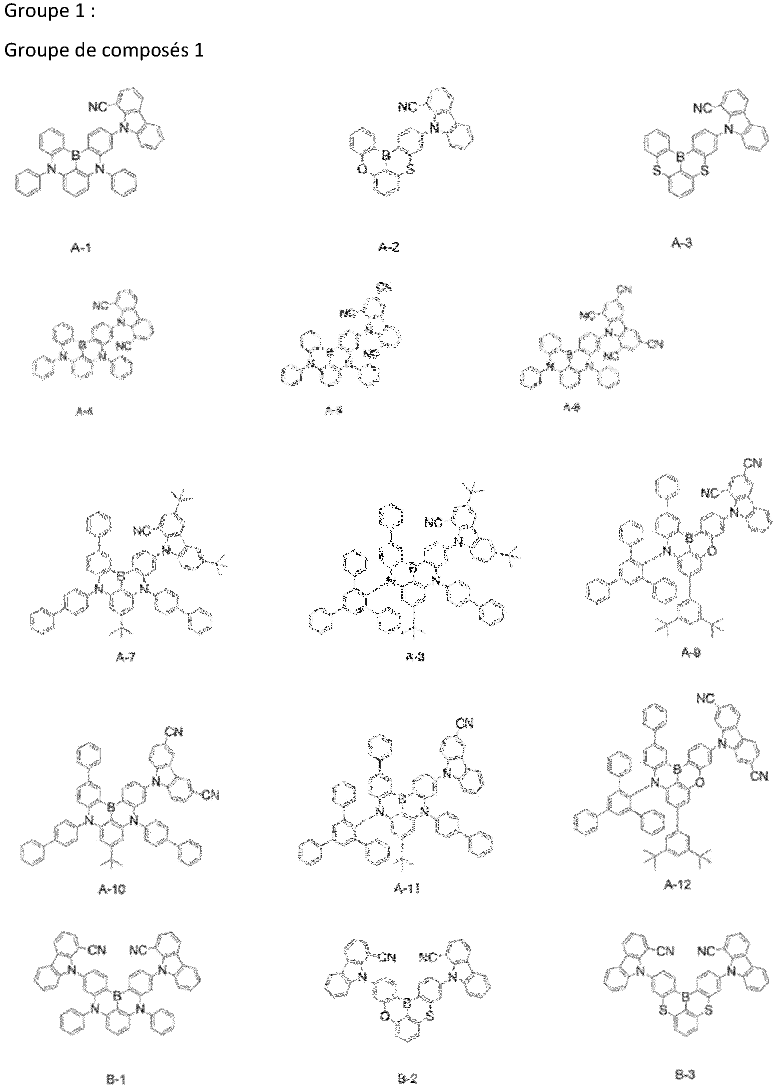

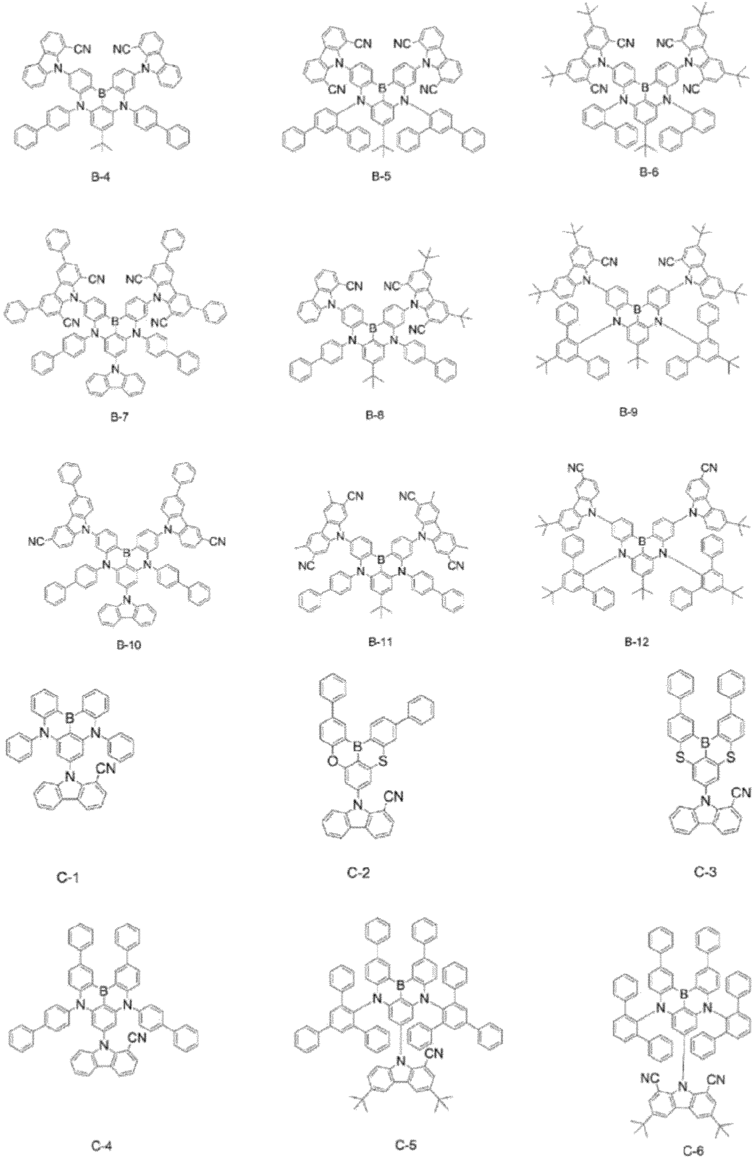

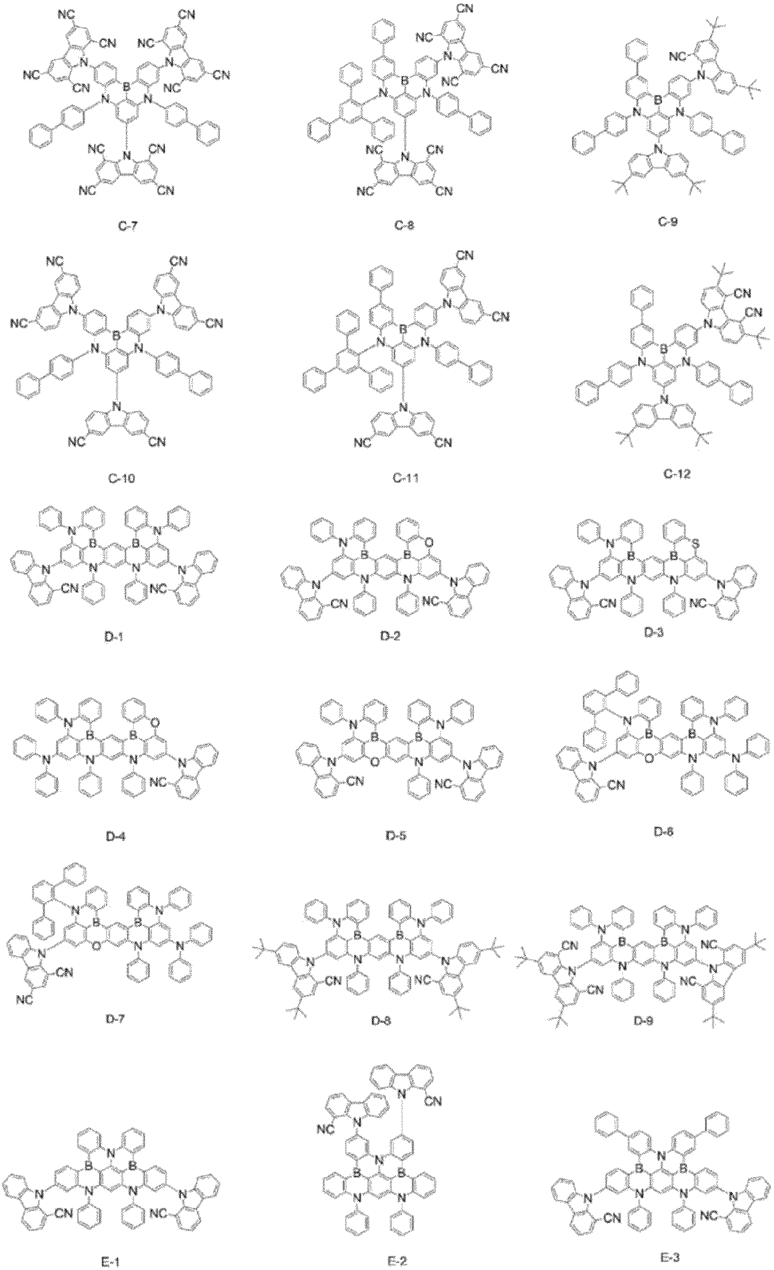

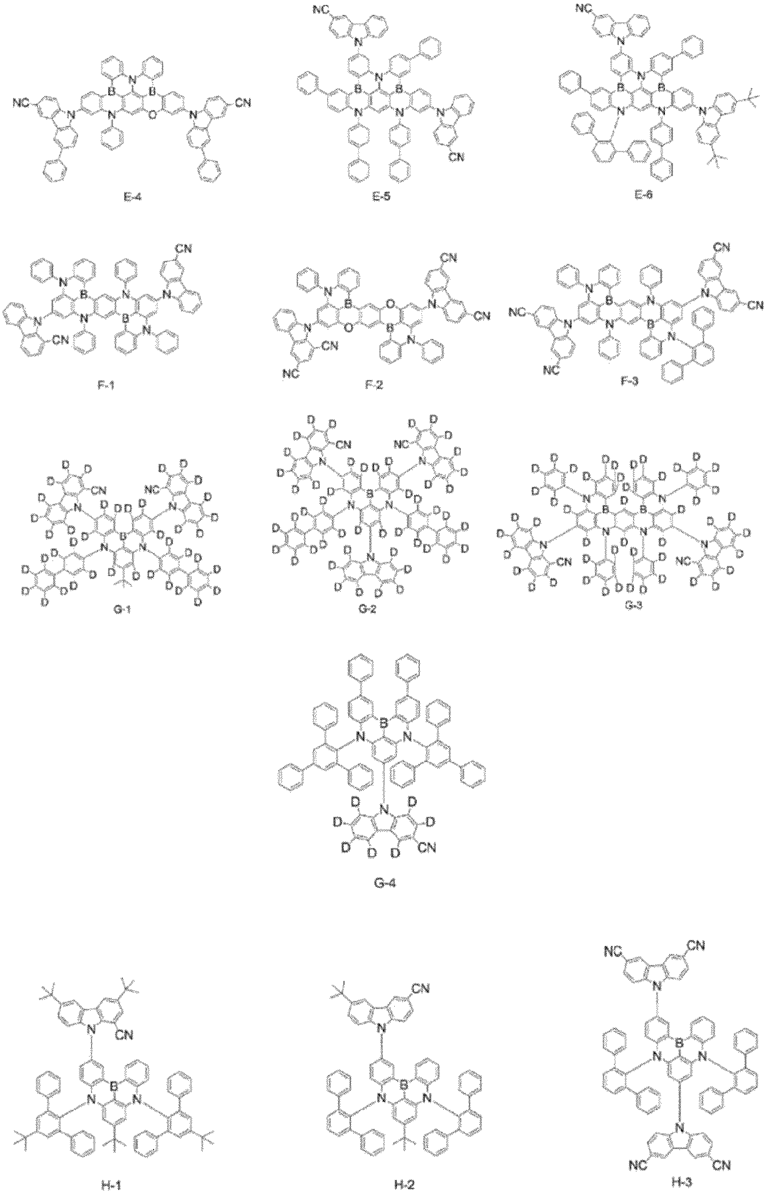

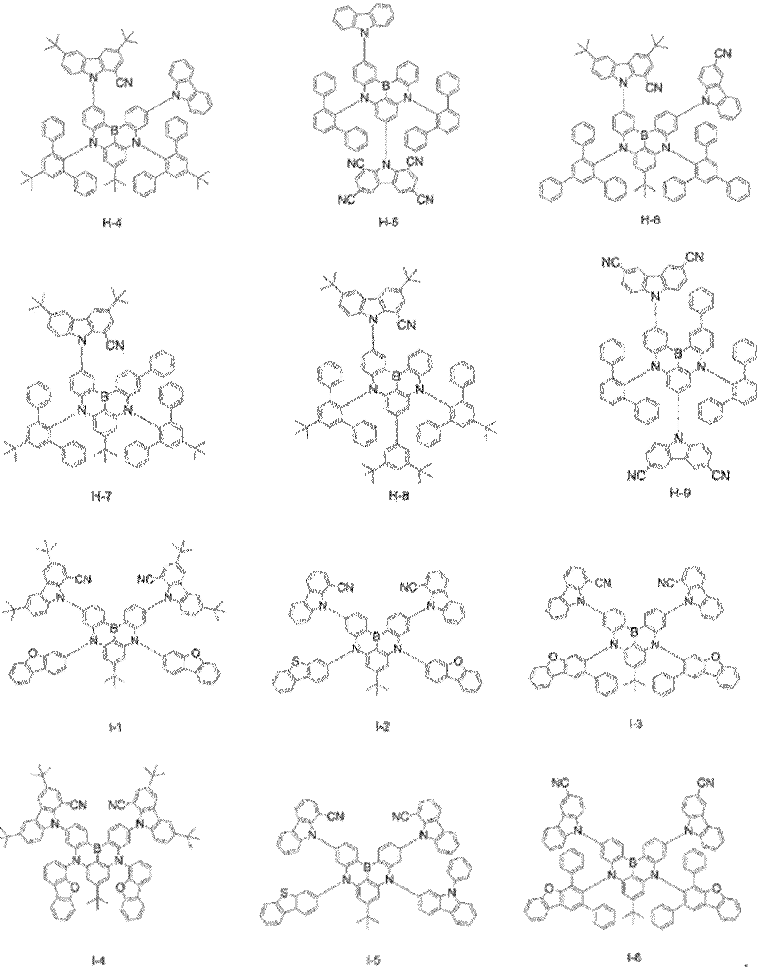

11. Élément électroluminescent comprenant :
une première électrode ;
une seconde électrode sur la première électrode ; et
au moins une couche fonctionnelle située entre la première électrode et la seconde électrode et comprenant le composé polycyclique fusionné selon l'une quelconque des revendications 1 à 10 comme premier composé.

12. Élément électroluminescent selon la revendication 11, dans lequel la au moins une couche fonctionnelle comprend une couche d'émission, une zone de transport de trous située entre la première électrode et la couche d'émission et une zone de transport d'électrons située entre la couche d'émission et la seconde électrode,
la couche d'émission comprenant le composé polycyclique fusionné.

13. Élément électroluminescent selon la revendication 12, dans lequel la couche d'émission est configurée pour émettre une fluorescence retardée.

14. Élément électroluminescent selon la revendication 12 ou la revendication 13, dans lequel la couche d'émission est configurée pour émettre de la lumière présentant une longueur d'onde d'émission centrale allant d'environ 430 nm à environ 490 nm.
